# EUROPEAN PATENT APPLICATION

(11) **EP 4 852 688 A2**
(43) Date of publication of application: **09.12.2026**
(21) Application number: 26204779.8
(22) Date of filing: 15.05.2018
(51) Int. Cl.: H10K 85/60

(54) **POLYCYCLIC AROMATIC COMPOUND**

(30) Priority: 16.05.2017 JP 2017097142; 25.12.2017 JP 2017248014
(62) Document number(s) of the earlier application(s) in accordance with Art. 76 EPC: 18801284.3 / 3 626 722
(71) Applicant: Kwansei Gakuin Educational Foundation, Nishinomiya-shi, Hyogo 662-8501 (JP); SK Materials JNC Co., Ltd., Hwaseong-si, Gyeonggi-do (KR)
(72) Inventor: HATAKEYAMA, Takuji, 669-1337 Sanda-shi Hyogo (JP); KONDO, Yasuhiro, 290-8551 Ichihara-shi Chiba (JP); SASADA, Yasuyuki, 290-8551 Ichihara-shi Chiba (JP); YANAI, Motoki, 290-8551 Ichihara-shi Chiba (JP); IKUTA, Toshiaki, 100-8105 Chiyoda-ku Tokyo (JP)
(74) Representative: Hoffmann Eitle

(57) **Abstract**

The present invention provides a novel polycyclic aromatic compound having a plurality of aromatic rings linked by a boron atom, a nitrogen atom, and the like, and thus increases the number of alternatives of a material for an organic electroluminescent (EL) device. Furthermore, the present invention provides an excellent organic EL device by using a novel polycyclic aromatic compound as a material for an organic EL device.

## Description

### Technical Field

The present invention relates to a polycyclic aromatic compound, and an organic device such as an organic electroluminescent element, an organic field effect transistor, and an organic thin film solar cell using the polycyclic aromatic compound, as well as a display apparatus and a lighting apparatus.

### Background Art

Conventionally, a display apparatus employing a luminescent element that is electroluminescent can be subjected to reduction in power consumption and reduction in thickness, and therefore various studies have been conducted thereon. Moreover, an organic electroluminescent element formed of an organic material has been studied actively because reduction in weight and expansion in size are easily achieved. Particularly, active research has been hitherto conducted on development of an organic material having luminescence characteristics for blue light, which is one of the three primary colors of light, and development of an organic material having charge transport capability for holes, electrons, and the like (having a potential for serving as a semiconductor or a superconductor), irrespective of whether the organic material is a polymer compound or a low molecular weight compound.

An organic EL element has a structure having a pair of electrodes composed of a positive electrode and a negative electrode, and a single layer or a plurality of layers which are disposed between the pair of electrodes and contain an organic compound. The layer containing an organic compound includes a light emitting layer, a charge transport/injection layer for transporting or injecting charges such as holes or electrons, and the like, and various organic materials suitable for these layers have been developed.

As a material for the light emitting layer, for example, a benzofluorene-based compound or the like has been developed (WO 2004/061047 A). Furthermore, as a hole transport material, for example, a triphenylamine-based compound or the like has been developed (JP 2001-172232 A). Furthermore, as an electron transport material, for example, an anthracene-based compound or the like has been developed (JP 2005-170911 A).

Furthermore, in recent years, a material obtained by improving a triphenylamine derivative has also been reported as a material used in an organic EL element or an organic thin film solar cell (WO 2012/118164 A). This material is characterized in that flatness thereof has been increased by linking aromatic rings constituting triphenylamine with reference to N,N'-diphenyl-N,N'-bis(3-methylphenyl)-1,1'-biphenyl-4,4' -diamine (TPD) which has been already put to practical use. In this literature, for example, evaluation of the charge transporting characteristics of a NO-linked system compound (compound 1 of page 63) has been made. However, there is no description on a method for manufacturing materials other than the NO-linked system compound. Furthermore, when elements to be linked are different, the overall electron state of the compound is different. Therefore, the characteristics obtainable from materials other than the NO-linked system compound are not known. Examples of such a compound are also found elsewhere (WO 2011/107186 A). For example, since a compound having a conjugated structure involving high energy of triplet exciton (T1) can emit phosphorescent light having a shorter wavelength, the compound is useful as a material for a blue light emitting layer. Furthermore, there is also a demand for a novel compound having a conjugated structure with high T1 as each of an electron transport material and a hole transport material with a light emitting layer interposed therebetween.

A host material for an organic EL element is generally a molecule in which a plurality of existing aromatic rings of benzene, carbazole, and the like is linked to one another via a single bond, a phosphorus atom, or a silicon atom. This is because a large HOMO-LUMO gap required for a host material (band gap Eg in a thin film) is secured by linking many aromatic rings each having a relatively small conjugated system. Furthermore, a host material for an organic EL element, using a phosphorescent material or a thermally activated delayed fluorescent (TADF) material needs high triplet excitation energy (E_{T}). However, the triplet excitation energy (E_{T}) can be increased by localizing SOMO1 and SOMO2 in a triplet excited state (T1) by linking a donor-like or acceptor-like aromatic ring or substituent to a molecule, and thereby reducing an exchange interaction between the two orbitals. However, an aromatic ring having a small conjugated system does not have sufficient redox stability, and an element using a molecule obtained by linking existing aromatic rings as a host material does not have a sufficient lifetime. Meanwhile, a polycyclic aromatic compound having an extended π-conjugated system generally has excellent redox stability. However, since the HOMO-LUMO gap (band gap Eg in a thin film) or triplet excitation energy (E_{T}) is low, the polycyclic aromatic compound has been considered to be unsuitable as a host material.

In recent years, a compound having a plurality of aromatic rings fused with a boron atom or the like as a central atom has also been reported (WO 2015/102118 A). In this literature, an organic EL element using the compound having a plurality of aromatic rings fused as a dopant material of a light emitting layer is evaluated. This literature discloses a very large number of compounds. Among these compounds, it is particularly useful to study a compound having excellent organic EL characteristics such as luminescence characteristics.

Further, as a method for forming an organic layer constituting the organic EL element, a wet film forming method is used in addition to the vacuum vapor deposition method. In particular, development of an ink for forming a hole injection layer, a hole transport layer, and a light emitting layer has been positively carried out for material development for a wet film formation method. Among these developments, regarding inks for a hole injection layer and a hole transport layer, characteristics of each layer formed by the wet film formation method using these inks have reached a practical level. Regarding an ink for forming a light emitting layer, development of inks for a red light-emitting layer and a green light-emitting layer is progressing toward improvement of characteristics. However, regarding an ink for a blue light-emitting layer, in general, development of a composition using a polycyclic aromatic compound having an aromatic ring, such as anthracene, a styryl derivative, or the like has been carried out, but has not obtained practical characteristics. In particular, at present, an ink for a blue light-emitting layer having high color purity has not been developed.

### Citation List

### Patent Literature

| | |
|---|---|
| Patent Literature 1: | WO 2004/061047 A |
| Patent Literature 2: | JP 2001-172232 A |
| Patent Literature 3: | JP 2005-170911 A |
| Patent Literature 4: | WO 2012/118164 A |
| Patent Literature 5: | WO 2011/107186 A |
| Patent Literature 6: | WO 2015/102118 A |
| Patent Literature 7: | WO 2001/072673 A |
| Patent Literature 8: | WO 2012/102333 A |
| Patent Literature 9: | JP 2006-045503 A |
| Patent Literature 10: | JP 2013-168411 A |
| Patent Literature 11: | JP 2013-247179 A |
| Patent Literature 12: | US 2013/214259 A |

### Summary of Invention

### Technical Problem

As described above, various materials have been developed as a material used in an organic EL element. However, in order to further enhance organic EL characteristics such as luminescence characteristics or to increase options of an organic EL material such as a material for a light emitting layer, it is desired to develop a compound that has not been specifically known hitherto.

### Solution to Problem

As a result of intensive studies to solve the above problems, the present inventors have found that an excellent organic EL element can be obtained by using a compound having a specific structure among polycyclic aromatic compounds each having a plurality of aromatic rings linked with a boron atom and a nitrogen atom or an oxygen atom, and have completed the present invention. That is, the present invention provides such a polycyclic aromatic compound as described below and further provides an organic device material containing such a polycyclic aromatic compound as described below, for example.
Item 1. A polycyclic aromatic compound represented by the following general formula (1). 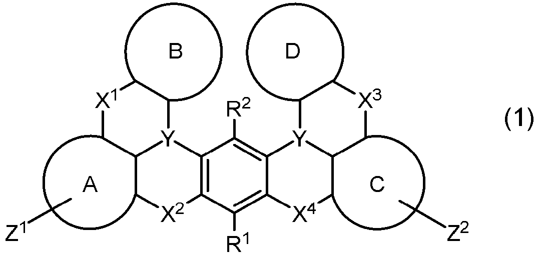
   (In the above formula (1),
   ring A, ring B, ring C, and ring D each independently represent an aryl ring or a heteroaryl ring; and at least one hydrogen atom in these rings may be substituted;
   Y represents B (boron),
   X¹, X², X³, and X⁴ each independently represent >O, >N-R, >S, or >Se; R in the moiety >N-R represents an optionally substituted aryl, an optionally substituted heteroaryl, or an optionally substituted alkyl; and R in the moiety >N-R may be bonded to the ring A, ring B, ring C, and/or ring D via a linking group or a single bond;
   R¹ and R² each independently represent a hydrogen atom, an alkyl having 1 to 6 carbon atoms, an aryl having 6 to 12 carbon atoms, a heteroaryl having 2 to 15 carbon atoms, or a diarylamino (the aryl is an aryl having 6 to 12 carbon atoms) ;
   Z¹ and Z² each independently represent an optionally substituted aryl, an optionally substituted heteroaryl, an optionally substituted diarylamino, an optionally substituted diheteroarylamino, an optionally substituted arylheteroarylamino, an optionally substituted alkyl, an optionally substituted cycloalkyl, an optionally substituted aryloxy, an optionally substituted heteroaryloxy, an optionally substituted arylthio, or an optionally substituted heteroarylthio; Z¹ may be bonded to the ring A via a linking group or a single bond; and Z² may be bonded to the ring C via a linking group or a single bond; and
   at least one hydrogen atom in the compound represented by formula (1) may be substituted by cyano, a halogen atom, or a deuterium atom.)
Item 2. The polycyclic aromatic compound according to Item 1, in which
   the ring A, ring B, ring C, and ring D each independently represent an aryl ring or a heteroaryl ring; at least one hydrogen atom in these rings may be substituted by an aryl, a heteroaryl, a diarylamino, a diheteroarylamino, an arylheteroarylamino, an alkyl, a cycloalkyl, an alkoxy, an aryloxy, a heteroaryloxy, an arylthio, a heteroarylthio, or an alkyl-substituted silyl; at least one hydrogen atom in these may be substituted by an aryl, a heteroaryl, or an alkyl; the ring A and ring B have a 5-membered or 6-membered ring sharing a bond with a fused bicyclic structure at the left of the above formula constituted by Y, X¹, and X²; and the ring C and ring D have a 5-membered or 6-membered ring sharing a bond with a fused bicyclic structure at the right of the above formula constituted by Y, X³, and X⁴;
   Y represents B (boron);
   X¹, X², X³, and X⁴ each independently represent >O, >N-R, >S, or >Se; R in the moiety >N-R represents an aryl, a heteroaryl, or an alkyl; at least one hydrogen atom in the R may be substituted by an aryl, a heteroaryl, a diarylamino, a diheteroarylamino, an arylheteroarylamino, an alkyl, a cycloalkyl, an alkoxy, an aryloxy, a heteroaryloxy, an arylthio, a heteroarylthio, or an alkyl-substituted silyl; and R in the moiety >N-R may be bonded to the ring A, ring B, ring C and/or ring D via -O-, -S-, -C(-R)₂-, or a single bond; and R in the -C(-R)₂- represents a hydrogen atom or an alkyl;
   R¹ and R² each independently represent a hydrogen atom, an alkyl having 1 to 6 carbon atoms, an aryl having 6 to 12 carbon atoms, a heteroaryl having 2 to 15 carbon atoms, or a diarylamino (the aryl is an aryl having 6 to 12 carbon atoms) ;
   Z¹ and Z² each independently represent an aryl, a heteroaryl, a diarylamino, a diheteroarylamino, an arylheteroarylamino, an alkyl, a cycloalkyl, an aryloxy, a heteroaryloxy, an arylthio, or a heteroarylthio; at least one hydrogen atom in these may be substituted by an aryl, a heteroaryl, a diarylamino, an alkyl, a cycloalkyl, an alkoxy, an aryloxy, or an alkyl-substituted silyl; Z¹ may be bonded to the ring A via -O-, -S-, -C(-R)₂-, or a single bond; Z² may be bonded to the ring C via -O-, -S-, -C(-R)₂-, or a single bond; and R in the -C(-R)₂- represents a hydrogen atom or an alkyl; and
   at least one hydrogen atom in the compound represented by formula (1) may be substituted by cyano, a halogen atom, or a deuterium atom.)
Item 3. The polycyclic aromatic compound according to Item 1, represented by the following general formula (2). 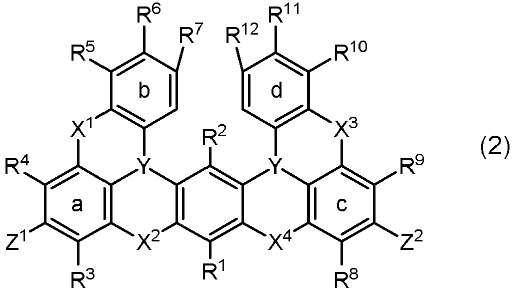
   (In the above formula (2),
   R³, R⁴, R⁵, R⁶, R⁷, R⁸, R⁹, R¹⁰, R¹¹, and R¹² each independently represent a hydrogen atom, an aryl, a heteroaryl, a diarylamino, a diheteroarylamino, an arylheteroarylamino, an alkyl, a cycloalkyl, an alkoxy, an aryloxy, a heteroaryloxy, an arylthio, a heteroarylthio, or an alkyl-substituted silyl; at least one hydrogen atom in these may be substituted by an aryl, a heteroaryl, or an alkyl; and adjacent groups among R⁵ to R⁷ and R¹⁰ to R¹² may be bonded to each other to form an aryl ring or a heteroaryl ring together with the ring b and/or ring d; at least one hydrogen atom in the ring thus formed may be substituted by an aryl, a heteroaryl, a diarylamino, a diheteroarylamino, an arylheteroarylamino, an alkyl, a cycloalkyl, an alkoxy, an aryloxy, a heteroaryloxy, an arylthio, a heteroarylthio, or an alkyl-substituted silyl; and at least one hydrogen atom in these may be substituted by an aryl, a heteroaryl, or an alkyl;
   Y represents B (boron);
   X¹, X², X³, and X⁴ each independently represent >O, >N-R, >S, or >Se; R in the moiety >N-R represents an aryl having 6 to 12 carbon atoms, a heteroaryl having 2 to 15 carbon atoms, or an alkyl having 1 to 6 carbon atoms; and R in the moiety >N-R may be bonded to the ring a, ring b, ring c and/or ring d via -O-, -S-, -C(-R)₂-, or a single bond; and R in the -C(-R)₂-represents a hydrogen atom or an alkyl having 1 to 6 carbon atoms;
   R¹ and R² each independently represent a hydrogen atom, an alkyl having 1 to 6 carbon atoms, or an aryl having 6 to 12 carbon atoms;
   Z¹ and Z² each independently represent an aryl, a heteroaryl, a diarylamino, a diheteroarylamino, an arylheteroarylamino, an alkyl, a cycloalkyl, an aryloxy, a heteroaryloxy, an arylthio, or a heteroarylthio; at least one hydrogen atom in these may be substituted by an aryl, a heteroaryl, an alkyl, or an alkyl-substituted silyl; Z¹ may be bonded to the ring a via -O-, -S-, -C(-R)₂-, or a single bond; Z² may be bonded to the ring c via -O-, -S-, -C(-R)₂-, or a single bond; and R in the -C(-R)₂- represents a hydrogen atom or an alkyl having 1 to 6 carbon atoms; and
   at least one hydrogen atom in the compound represented by formula (2) may be substituted by cyano, a halogen atom, or a deuterium atom.)
Item 4. The polycyclic aromatic compound according to Item 3, in which
   R³, R⁴, R⁵, R⁶, R⁷, R⁸, R⁹, R¹⁰, R¹¹, and R¹² each independently represent a hydrogen atom, an aryl having 6 to 30 carbon atoms, a heteroaryl having 2 to 30 carbon atoms, a diarylamino (the aryl is an aryl having 6 to 12 carbon atoms), an alkyl having 1 to 6 carbon atoms, an aryloxy having 6 to 12 carbon atoms, or an arylthio having 6 to 12 carbon atoms; at least one hydrogen atom in these may be substituted by an aryl having 6 to 12 carbon atoms or an alkyl having 1 to 6 carbon atoms; and adjacent groups among R⁵ to R⁷ and R¹⁰ to R¹² may be bonded to each other to form an aryl ring having 9 to 16 carbon atoms or a heteroaryl ring having 6 to 15 carbon atoms together with the ring b and/or ring d; at least one hydrogen atom in the ring thus formed may be substituted by an aryl having 6 to 12 carbon atoms or an alkyl having 1 to 6 carbon atoms;
   Y represents B (boron);
   X¹, X², X³, and X⁴ each independently represent >O or >N-R; R in the moiety >N-R represents an aryl having 6 to 10 carbon atoms or an alkyl having 1 to 4 carbon atoms;
   R¹ and R² each independently represent a hydrogen atom, an alkyl having 1 to 6 carbon atoms, or an aryl having 6 to 12 carbon atoms;
   Z¹ and Z² each independently represent an aryl having 6 to 30 carbon atoms, a heteroaryl having 2 to 30 carbon atoms, a diarylamino (the aryl is an aryl having 6 to 12 carbon atoms), an alkyl having 1 to 12 carbon atoms, a cycloalkyl having 3 to 12 carbon atoms, an aryloxy having 6 to 30 carbon atoms, a heteroaryloxy having 2 to 30 carbon atoms, an arylthio having 6 to 30 carbon atoms, or a heteroarylthio having 2 to 30 carbon atoms; at least one hydrogen atom in these may be substituted by an aryl having 6 to 12 carbon atoms, a heteroaryl having 2 to 15 carbon atoms, an alkyl having 1 to 12 carbon atoms, or trialkyl-substituted silyl (the alkyl is an alkyl having 1 to 6 carbon atoms); and
   at least one hydrogen atom in the compound represented by formula (2) may be substituted by cyano, a halogen atom, or a deuterium atom.
Item 5. The polycyclic aromatic compound according to Item 3, in which
   R³, R⁴, R⁵, R⁶, R⁷, R⁸, R⁹, R¹⁰, R¹¹, and R¹² each independently represent a hydrogen atom, an aryl having 6 to 10 carbon atoms, or an alkyl having 1 to 6 carbon atoms;
   Y represents B (boron);
   X¹, X², X³, and X⁴ each independently represent >O or >N-R; R in the moiety >N-R represents an aryl having 6 to 10 carbon atoms or an alkyl having 1 to 4 carbon atoms;
   R¹ and R² each independently represent a hydrogen atom, an alkyl having 1 to 6 carbon atoms, or an aryl having 6 to 12 carbon atoms;
   Z¹ and Z² each independently represent an aryl having 6 to 16 carbon atoms, a heteroaryl having 2 to 15 carbon atoms, a diarylamino (the aryl is an aryl having 6 to 10 carbon atoms), an alkyl having 1 to 6 carbon atoms, a cycloalkyl having 3 to 10 carbon atoms, an aryloxy having 6 to 12 carbon atoms, or an arylthio having 6 to 12 carbon atoms; at least one hydrogen atom in these may be substituted by an aryl having 6 to 10 carbon atoms or an alkyl having 1 to 6 carbon atoms; and
   at least one hydrogen atom in the compound represented by formula (2) may be substituted by cyano, a halogen atom, or a deuterium atom.
Item 6. The polycyclic aromatic compound according to Item 1, represented by any one of the following structural formulas. 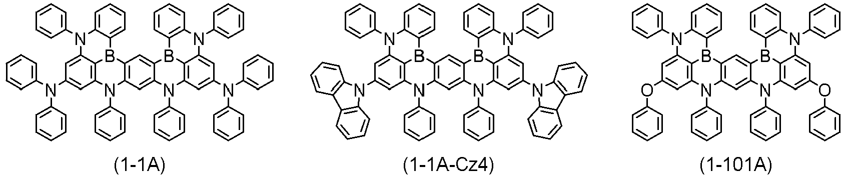 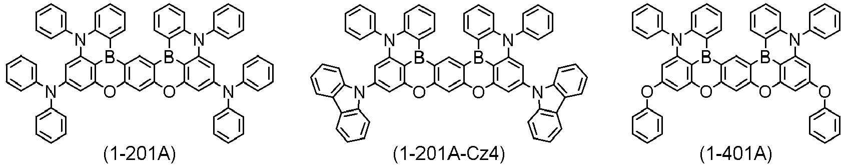 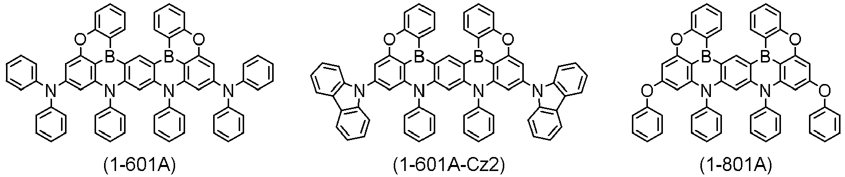 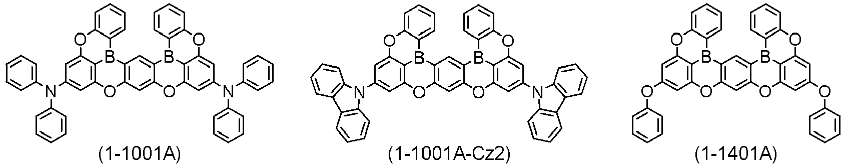 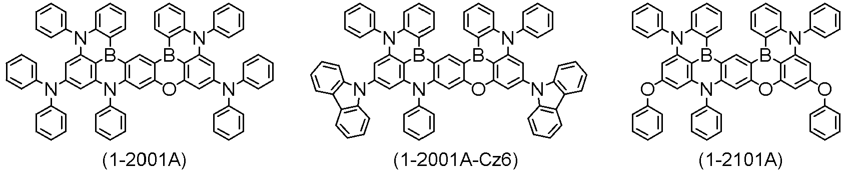 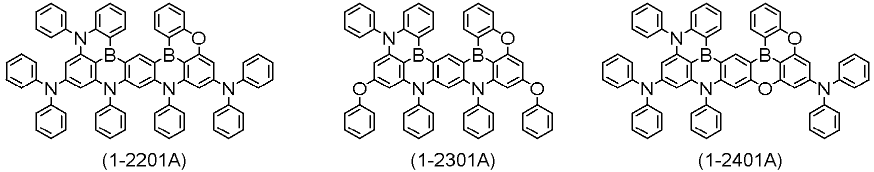 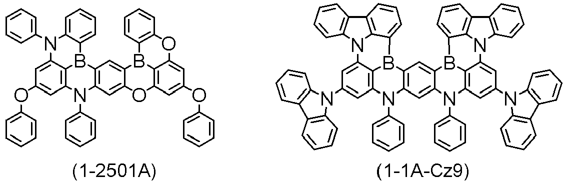 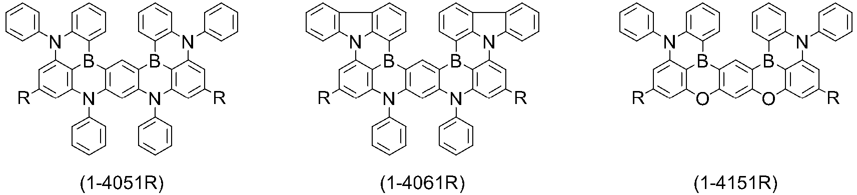 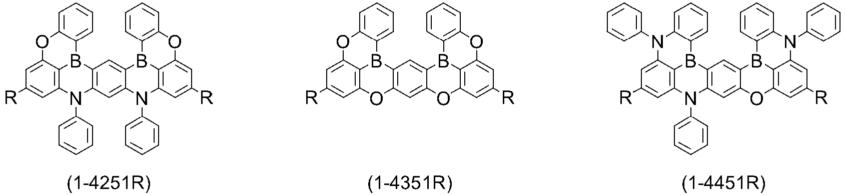 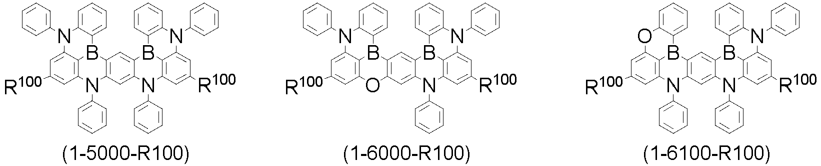 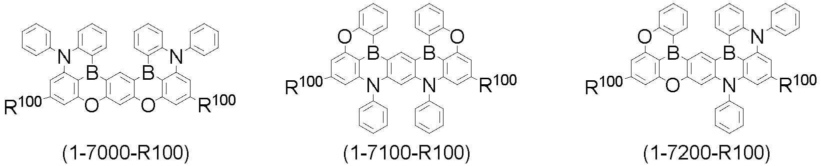 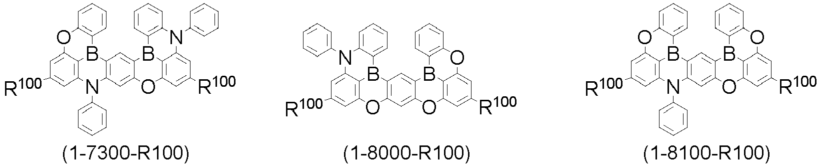 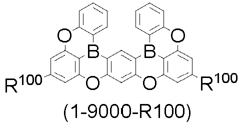 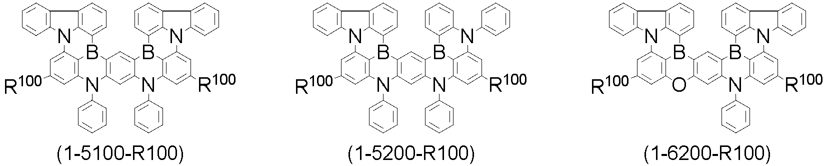 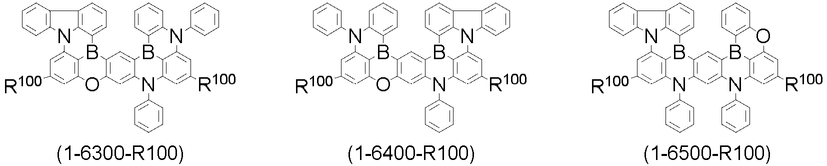 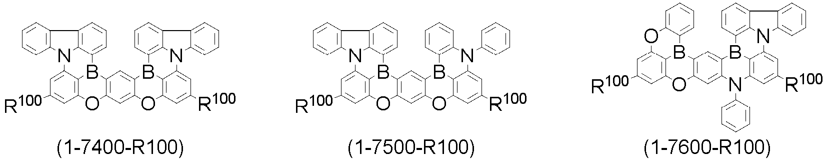 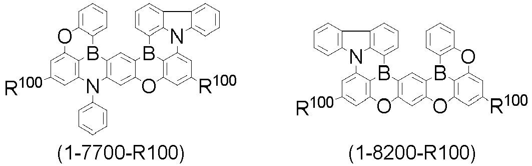 (at least one hydrogen atom in compounds represented by the above formulas may be substituted by an alkyl having 1 to 6 carbon atoms, an aryl having 6 to 10 carbon atoms, cyano, an halogen atom, or a deuterium atom; R in the formulas each independently represents an alkyl having 1 to 6 carbon atoms or an aryl having 6 to 10 carbon atoms; R¹⁰⁰ in the formulas each independently represents an aryl having 6 to 10 carbon atoms, a carbazolyl, a diarylamino (the aryl is an aryl having 6 to 10 carbon atoms), an alkyl having 1 to 6 carbon atoms, a cycloalkyl having 3 to 10 carbon atoms, or an aryloxy having 6 to 10 carbon atoms; the aryl may be substituted by an alkyl having 1 to 6 carbon atoms; and the carbazolyl may be substituted by an aryl having 6 to 10 carbon atoms or an alkyl having 1 to 6 carbon atoms.)
Item 7. A material for an organic device, comprising the polycyclic aromatic compound according to any one of Items 1 to 6.
Item 8. The material for an organic device according to Item 7, wherein the material for an organic device is a material for an organic electroluminescent element, a material for an organic field effect transistor, or a material for an organic thin film solar cell.
Item 9. The material for an organic device according to Item 8, wherein the material for an organic electroluminescent element is a material for a light emitting layer.
Item 10. A light emitting layer-forming composition for applying and forming a light emitting layer of an organic electroluminescent element, comprising:
   at least one polycyclic aromatic compound according to any one of Items 1 to 6 as a first component;
   at least one host material as a second component; and
   at least one organic solvent as a third component.
Item 11. An organic electroluminescent element comprising: a pair of electrodes composed of a positive electrode and a negative electrode; and a light emitting layer disposed between the pair of electrodes and comprising the material for a light emitting layer according to Item 9.
Item 12. An organic electroluminescent element comprising: a pair of electrodes composed of a positive electrode and a negative electrode; and a light emitting layer disposed between the pair of electrodes and formed by applying and drying the light emitting layer-forming composition according to Item 10.
Item 13. The organic electroluminescent element according to Item 11 or 12, wherein the light emitting layer further comprising a compound represented by the following general formula (3) and/or a compound represented by the following general formula (4). 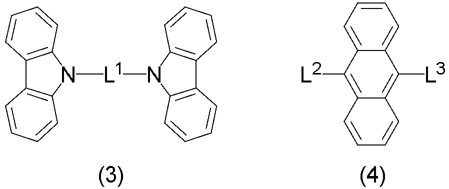
   In the above formula (3), L¹ represents an arylene having 6 to 24 carbon atoms;
   in the above formula (4), L² and L³ each independently represents an aryl having 6 to 30 carbon atoms or a heteroaryl having 2 to 30 carbon atoms; and
   at least one hydrogen atom in the compound represented by the above formulas may be substituted by an alkyl having 1 to 6 carbon atoms, cyano, a halogen atom, or a deuterium atom.
Item 14. The organic electroluminescent element according to Items 11 to 13, wherein the light emitting layer further comprising a compound represented by the following general formula (5) 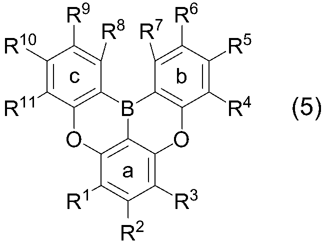
   (In general formula (5),
   R¹ to R¹¹ each independently represent a hydrogen atom, an aryl, a heteroaryl, a diarylamino, a diheteroarylamino, an arylheteroarylamino, or an alkyl; and at least one hydrogen atom in these may be further substituted by an aryl, a heteroaryl, a diarylamino, or a alkyl;
   adjacent groups among R¹ to R¹¹ may be bonded to each other to form an aryl ring or a heteroaryl ring together with ring a, ring b, or ring c; at least one hydrogen atom in the ring thus formed may be substituted by an aryl, a heteroaryl, a diarylamino, a diheteroarylamino, an arylheteroarylamino, or an alkyl; and at least one hydrogen atom in these may be further substituted by an aryl, a heteroaryl, a diarylamino, or an alkyl;
   at least one hydrogen atom in a compound represented by the above formula (5) each independently may be substituted by a halogen atom or a deuterium atom.)
Item 15. The organic electroluminescent element according to any one of Items 11 to 14, further comprising an electron transport layer and/or an electron injection layer disposed between the negative electrode and the light emitting layer, wherein at least one of the electron transport layer and the electron injection layer contains at least one selected from the group consisting of a borane derivative, a pyridine derivative, a fluoranthene derivative, a BO-based derivative, an anthracene derivative, a benzofluorene derivative, a phosphine oxide derivative, a pyrimidine derivative, a carbazole derivative, a triazine derivative, a benzimidazole derivative, a phenanthroline derivative, and a quinolinol-based metal complex.
Item 16. The organic electroluminescent element according to Item 15, wherein the electron transport layer and/or electron injection layer further include/includes at least one selected from the group consisting of an alkali metal, an alkaline earth metal, a rare earth metal, an oxide of an alkali metal, a halide of an alkali metal, an oxide of an alkaline earth metal, a halide of an alkaline earth metal, an oxide of a rare earth metal, a halide of a rare earth metal, an organic complex of an alkali metal, an organic complex of an alkaline earth metal, and an organic complex of a rare earth metal.
Item 17. A display apparatus or a lighting apparatus comprising the organic electroluminescent element according to any one of Items 11 to 16.

### Advantageous Effects of Invention

According to a preferred embodiment of the present invention, by using the polycyclic aromatic compound represented by formula (1), which has not been specifically known hitherto, it is possible to further enhance organic EL characteristics such as luminescence characteristics or to increase options of an organic EL material such as a material for a light emitting layer.

### Brief Description of Drawings

Fig. 1 is a schematic cross-sectional view illustrating an organic EL element according to the present embodiment.
FIG. 2 illustrates an absorption, fluorescence, and phosphorescence spectrum of compound (1-1).
FIG. 3 illustrates an absorption, fluorescence, and phosphorescence spectrum of compound (1-201).
FIG. 4 illustrates an absorption, fluorescence, and phosphorescence spectrum of compound (1-101).
FIG. 5 illustrates an absorption, fluorescence, and phosphorescence spectrum of compound (1-9).
FIG. 6 illustrates an organic EL characteristic (a luminance) of compound (1-1).
FIG. 7 illustrates an organic EL characteristic (an external quantum efficiency) of compound (1-1).
FIG. 8 illustrates an organic EL characteristic (an emission spectrum) of compound (1-1).
Fig. 9 is a diagram for explaining a method for manufacturing an organic EL element on a substrate having a bank by an ink jet method.

### Description of Embodiments

### 1. Polycyclic aromatic compound represented by formula (1)

The polycyclic aromatic compound represented by general formula (1) is preferably a polycyclic aromatic compound represented by the following general formula (2).

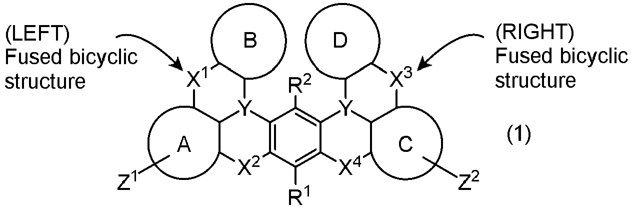

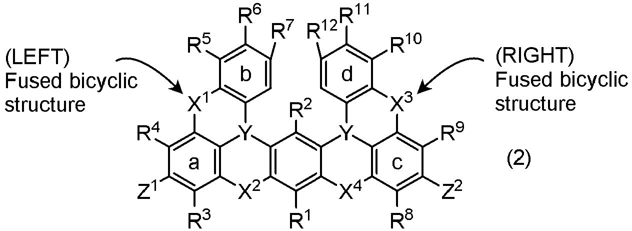

For example, three kinds of materials, that is, a fluorescent material, a phosphorescent material, and a thermally activated delayed fluorescent (TADF) material are used as a light emitting material for an organic EL display. However, the fluorescent material has a low luminous efficiency of about 25 to 62.5%. Meanwhile, the phosphorescent material and the TADF material may each have a luminous efficiency of 100%, but both have low color purity (wide emission spectrum width) disadvantageously. A display expresses various colors by mixing three light primary colors of red, green, and blue. However, when the color purity of each color is low, some colors cannot be reproduced, and the image quality of the display is largely deteriorated. Therefore, a commercially available display removes an unnecessary color from an emission spectrum by using an optical filter to increase color purity (narrow a spectrum width) for use. Therefore, a removal ratio increases when the original spectral width is wide. Therefore, a substantial efficiency is largely reduced even when a luminous efficiency is high. For example, a blue emission spectrum of a commercially available smartphone has a half width of about 20 to 25 nm. However, a general fluorescent material, a phosphorescent material, and a TADF material have half widths of about 40 to 60 nm, about 60 to 90 nm, and about 70 to 100 nm, respectively. When a fluorescent material is used, the half width is relatively narrow, and therefore it is only required to partially remove some unnecessary colors. However, when a phosphorescent material or a TADF material is used, it is necessary to remove a half or more of the colors. From such a background, development of a light emitting material having both a luminous efficiency and color purity has been desired.

In general, a TADF material is designed such that efficient reverse intersystem crossing occurs by localizing HOMO and LUMO in a molecule using an electron-donating substituent called a donor and an electron-accepting substituent called an acceptor. However, when the donor and the acceptor are used, structural relaxation in an excited state increases (in some molecules, a stable structure is different between a ground state and an excited state, and therefore by conversion from the ground state to the excited state due to an external stimulation, the structure changes to a stable structure in the excited state), resulting in a wide emission spectrum with low color purity.

Therefore, Patent Literature 6 (WO 2015/102118 A) proposes a new molecular design that dramatically improves the color purity of a TADF material. For example, in compound (1-401) disclosed in this literature, by using a multiple resonance effect of boron (electron-donating) and nitrogen (electron-withdrawing), successfully, HOMO is localized in three carbon atoms (black circles) on a benzene ring consisting of six carbon atoms, and LUMO is localized in the remaining three carbon atoms (white circles). Due to this efficient inverse intersystem crossing, the luminous efficiency of the compound reaches 100% at maximum. Furthermore, boron and nitrogen in compound (1-401) not only localize HOMO and LUMO but also fuse three benzene rings, and thereby maintain a solid planar structure and suppress structural relaxation in the excited state. As a result, an emission spectrum having high color purity with small Stokes shift of absorption and emission peaks is obtained successfully. The emission spectrum has a half width of 28 nm, which indicates a level of color purity surpassing that of a high-color purity fluorescent material in practical use. In such a dimer compound as represented by formula (1-422), two boron atoms and two nitrogen atoms are bonded to the central benzene ring, and a multiple resonance effect is thereby further enhanced in the central benzene ring. As a result, light emission having a very narrow emission peak width is possible.

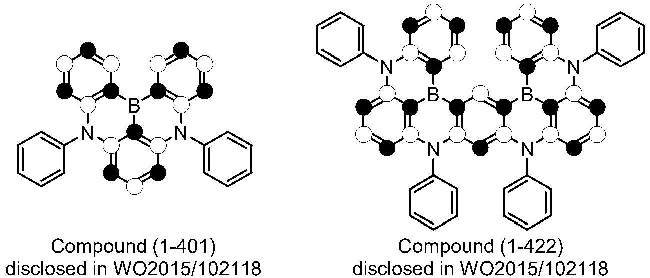

Meanwhile, in such a dimer compound as represented by formula (1-422), since planarity of a molecule is high and resonance is broad, an emission wavelength is long and away from a practical blue wavelength. In addition, probably because intermolecular stacking is induced due to high planarity, an efficiency in a light emitting element is not sufficiently satisfactory disadvantageously.

Therefore, as a result of intensive studies, by introducing a substituent that adjusts a multiple resonance effect into an appropriate position, a shorter emission wavelength and a higher element efficiency have been achieved. Specifically, the polycyclic aromatic compound represented by general formula (1) of the present invention has two Zs (Z1 and Z2). An electron-withdrawing or electron-donating functional group as Z affects a resonance structure and/or multiple resonance effect of the entire molecule through resonance of ring A and ring C. For example, if an electron-withdrawing group is introduced, an emission wavelength can be shortened by reducing the electron density of LUMO. Regardless of an electron-withdrawing property or an electron-donating property, introduction of a substituent into Z reduces the ratio of structures existing on the same plane in the entire molecule. Therefore, intermolecular stacking can be reduced. As a result, by significantly shortening the emission wavelength and, in addition, reducing intermolecular stacking by introducing a substituent, it has also become possible to increase an element efficiency. However, the effect of the polycyclic aromatic compound of the present invention is not restricted by the above principle.

Ring A, ring B, ring C, and ring D in general formula (1) each independently represent an aryl ring or a heteroaryl ring, and at least one hydrogen atom in these rings may be substituted by a substituent. This substituent is preferably a substituted or unsubstituted aryl, a substituted or unsubstituted heteroaryl, a substituted or unsubstituted diarylamino, a substituted or unsubstituted diheteroarylamino, a substituted or unsubstituted arylheteroarylamino (an amino group having an aryl and a heteroaryl), a substituted or unsubstituted alkyl, a substituted or unsubstituted cycloalkyl, a substituted or unsubstituted alkoxy, a substituted or unsubstituted aryloxy, a substituted or unsubstituted heteroaryloxy, a substituted or unsubstituted arylthio, a substituted or unsubstituted heteroarylthio, or an alkyl-substituted silyl. In a case where these groups have substituents, examples of the substituents include an aryl, a heteroaryl, or an alkyl.

The ring A and ring B have a 5-membered or 6-membered ring sharing a bond with a fused bicyclic structure at the left of the above formula (1) constituted by "Y", "X¹", and "X²", and the ring C and ring D have a 5-membered or 6-membered ring sharing a bond with a fused bicyclic structure at the right of the above formula (1) constituted by "Y", "X³", and "X⁴".

Here, the "fused bicyclic structure" means a structure in which two saturated hydrocarbon rings including "Y", "X¹", and "X²" and indicated at the left of general formula (1) are fused. The "6-membered ring sharing a bond with a fused bicyclic structure" means, for example, ring a (benzene ring (6-membered ring)) fused to the fused bicyclic structure as represented by the above general formula (2). The phrase "aryl ring or heteroaryl ring (which is ring A) has this 6-membered ring" means that the ring A is formed only from this 6-membered ring, or other rings and the like are further fused to this 6-membered ring so as to include this 6-membered ring to form the ring A. In other words, the "aryl ring or heteroaryl ring (which is ring A) having a 6-membered ring" as used herein means that the 6-membered ring constituting the entirety or a part of the ring A is fused to the fused bicyclic structure. The same description applies to the "ring B (ring b)", "ring C (ring c)", "ring D (ring d)", and the "5-membered ring".

The ring A (or ring B, ring C, or ring D) in general formula (1) corresponds to ring a and its substituents R³ and R⁴ in general formula (2) (or ring b and its substituents R⁵ to R⁷, ring c and its substituents R⁸ and R⁹, and ring d and its substituents R¹⁰ to R¹²). That is, general formula (2) corresponds to a structure in which "rings A to D each having a 6-membered ring" have been selected as the rings A to D of general formula (1). For this meaning, the rings of general formula (2) are represented by small letters a to d.

R³, R⁴, R⁵, R⁶, R⁷, R⁸, R⁹, R¹⁰, R¹¹, and R¹² in general formula (2) each independently represent a hydrogen atom, an aryl, a heteroaryl, a diarylamino, a diheteroarylamino, an arylheteroarylamino, an alkyl, a cycloalkyl, an alkoxy, an aryloxy, a heteroaryloxy, an arylthio, a heteroarylthio, or an alkyl-substituted silyl; at least one hydrogen atom in these may be substituted by an aryl, a heteroaryl, or an alkyl.

In general formula (2), adjacent groups among the substituents R⁵ to R⁷ of ring b and/or substituents R¹⁰ to R¹² of ring d may be bonded to each other to form an aryl ring or a heteroaryl ring together with the ring b and/or ring d, at least one hydrogen atom in the ring thus formed may be substituted by an aryl, a heteroaryl, a diarylamino, a diheteroarylamino, an arylheteroarylamino, an alkyl, a cycloalkyl, an alkoxy, an aryloxy, a heteroaryloxy, an arylthio, a heteroarylthio, or an alkyl-substituted silyl, and at least one hydrogen atom in these may be substituted by an aryl, a heteroaryl, or an alkyl. Therefore, in the compound represented by general formula (2), a ring structure constituting the compound changes as represented by the following formula (2-1) according to a mutual bonding form of substituents in ring b and ring d. Ring B' and ring D' in the formula (2-1) correspond to ring B and ring D in general formula (1), respectively. The definitions of each symbols in the formula (2-1) are the same as the definitions in general formula (2).

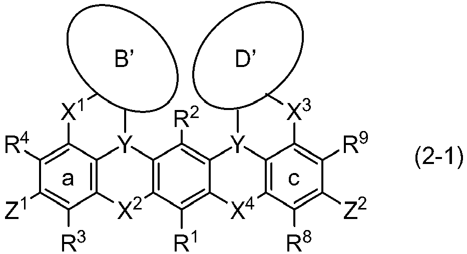

Ring B' and ring D' in the above formula (2-1) represent, to be described in connection with general formula (2), an aryl ring or a heteroaryl ring formed by bonding adjacent groups among the substituents R⁵ to R⁷ and R¹⁰ to R¹² together with ring b and ring d, respectively (may also be referred to as a fused ring formed by fusing another ring structure to the ring b or ring d). As apparent from the above formula (2-1), R⁷ of ring b and R¹² of ring d do not correspond to "adjacent groups", and these groups are not bonded to each other. That is, the term "adjacent groups" means adjacent groups on the same ring. Note that Z¹ may be bonded to ring A (ring a) via a linking group or a single bond, and Z² may be bonded to ring C (ring c) via a linking group or a single bond. When Z¹ and Z² are bonded thereto, the ring structure changes in a similar manner to the ring B' and ring D'.

A compound represented by the above formula (2-1) corresponds to, for example, a compound represented by formula (1-5) listed as specific compounds described below. That is, for example, the compound represented by formula (2-1) is a compound having ring B' (or ring D') formed by fusing a benzene ring, an indole ring, a pyrrole ring, a benzofuran ring or a benzothiophene ring and the like to a benzene ring which is ring b (or ring d), and the fused ring B' (or fused ring D') that has been formed is a naphthalene ring, a carbazole ring, an indole ring, a dibenzofuran ring, or a dibenzothiophene ring and the like.

Y represents B (boron).

X¹, X², X³, and X⁴ in general formula (1) each independently represent >O, >N-R, >S, or >Se, R in the moiety >N-R represents an optionally substituted aryl, an optionally substituted heteroaryl, or an optionally substituted alkyl, and R in the moiety >N-R may be bonded to the ring A, ring B, ring C and/or ring D via a linking group or a single bond, the linking group is preferably -O-, -S-, or -C(-R)₂-. Incidentally, R in the moiety "-C (-R) ₂-" represents a hydrogen atom or an alkyl. This description also applies to X¹, X², X³, and X⁴ in general formula (2).

Here, the provision that "R in the moiety >N-R is bonded to the ring A, ring B, ring C, and/or ring D via a linking group or a single bond" in general formula (1) corresponds to the provision that "R in the moiety >N-R is bonded to the ring a, ring b, ring c, and/or ring d via -O-, -S-, -C(-R)₂-, or a single bond" in general formula (2).

This provision can be expressed by a compound having a ring structure represented by the following formula (2-3), in which X¹ or X³ is incorporated into the fused ring B' or D'. That is, for example, the compound is a compound having ring B' (or ring D') formed by fusing another ring to a benzene ring which is ring b (or ring d) in general formula (2) so as to incorporate X¹ (or X³). This compound corresponds to, for example, a compound represented by formula (1-11) listed as specific compounds described below, the formed fused ring B' (or fused ring D') is, for example, a carbazole ring, a phenoxazine ring, a phenothiazine ring, or an acridine ring. The definitions of each symbols in the formula (2-3) are the same as the definitions in general formula (2).

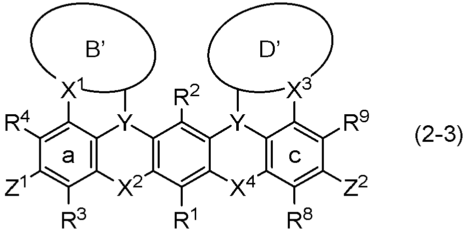

Formula (2-3) indicates a ring structure in which X¹ and X³ are incorporated into fused ring B' and fused ring D', respectively. However, R of >N-R as X² or X⁴ can also be bonded to ring a or ring c. When R is bonded thereto, the ring structure changes in a similar manner to the ring B' and ring D'.

Substitution positions of substituents Z¹ and Z² in general formula (2) are limited to the para positions with respect to positions where Ys (boron atoms) in ring a and ring c are bonded. Ring A and ring C in general formula (1) are not limited to benzene rings, but are various aryl rings or heteroaryl rings. Substitution positions of substituents Z¹ and Z² on these rings are not limited, but are preferably positions relatively far from positions where Ys are bonded, and more preferably positions farthest from the positions where Ys are bonded as in general formula (2). For example, when ring A is a naphthalene ring, a fluorene ring, or the like, preferred substitution positions of Z¹ (and Z²) are exemplified below. The definitions of symbols in each structure are the same as those in general formula (2). Symbol A represents >CR₂, >NR₂, >O, or >S, and symbol R represents a hydrogen atom, an alkyl (preferably an alkyl having 1 to 4 carbon atoms), or phenyl.

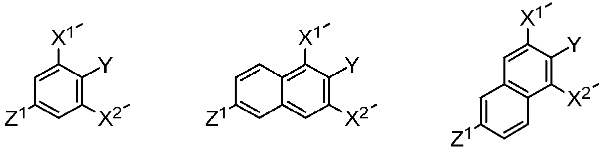

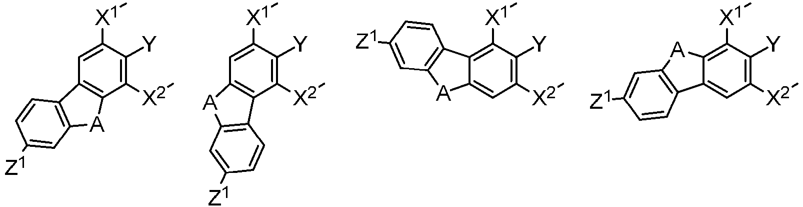

R¹ and R² in the general formula (1) or (2) each independently represent a hydrogen atom, an alkyl having 1 to 6 carbon atoms, an aryl having 6 to 12 carbon atoms, a heteroaryl having 2 to 15 carbon atoms, or a diarylamino (the aryl is an aryl having 6 to 12 carbon atoms).

Z¹ and Z² in the general formula (1) or (2) each independently represent an aryl, a heteroaryl, a diarylamino, a diheteroarylamino, an arylheteroarylamino, an alkyl, an aryloxy, a heteroaryloxy, an arylthio, or a heteroarylthio, at least one hydrogen atom in these may be substituted by an aryl, a heteroaryl, a diarylamino, an alkyl, a cycloalkyl, an alkoxy, an aryloxy, or an alkyl-substituted silyl, Z¹ may be bonded to the ring A (ring a) via a linking group or a single bond, and Z² may be bonded to the ring C (ring c) via a linking group or a single bond. The linking group is, for example, -O-, -S-, -C(-R)₂-, or the like, and R in the -C(-R)₂-represents a hydrogen atom or an alkyl.

The "aryl ring" as ring A, ring B, ring C or ring D in general formula (1) is, for example, an aryl ring having 6 to 30 carbon atoms, and the aryl ring is preferably an aryl ring having 6 to 16 carbon atoms, more preferably an aryl ring having 6 to 12 carbon atoms, and particularly preferably an aryl ring having 6 to 10 carbon atoms. Incidentally, this "aryl ring" corresponds to the "aryl ring formed by bonding adjacent groups among R⁵ to R⁷ and R¹⁰ to R¹² together with the ring b and/or ring d" defined by general formula (2). Ring b (or ring d) is already constituted by a benzene ring having 6 carbon atoms, and therefore the carbon number of 9 in total of a fused ring formed by fusing a 5-membered ring to this benzene ring becomes a lower limit of the carbon number. The same applies to an aryl ring formed by bonding Z¹ to ring A (ring a) via a linking group or a single bond, and an aryl ring formed by bonding Z² to ring C (ring c) via a linking group or a single bond.

Specific examples of the "aryl ring" include: a benzene ring which is a monocyclic system; a biphenyl ring which is a bicyclic system; a naphthalene ring which is a fused bicyclic system; a terphenyl ring (m-terphenyl, o-terphenyl, or p-terphenyl) which is a tricyclic system; an acenaphthylene ring, a fluorene ring, a phenalene ring, and a phenanthrene ring which are fused tricyclic systems; a triphenylene ring, a pyrene ring, and a naphthacene ring which are fused tetracyclic systems; and a perylene ring and a pentacene ring which are fused pentacyclic systems.

The "heteroaryl ring" as ring A, ring B, ring C, and ring D in general formula (1) is, for example, a heteroaryl ring having 2 to 30 carbon atoms, and the heteroaryl ring is preferably a heteroaryl ring having 2 to 25 carbon atoms, more preferably a heteroaryl ring having 2 to 20 carbon atoms, still more preferably a heteroaryl ring having 2 to 15 carbon atoms, and particularly preferably a heteroaryl ring having 2 to 10 carbon atoms. Examples of the "heteroaryl ring" include a heterocyclic ring containing 1 to 5 heteroatoms selected from an oxygen atom, a sulfur atom, and a nitrogen atom in addition to a carbon atom as a ring-constituting atom. Incidentally, this "heteroaryl ring" corresponds to the "heteroaryl ring formed by bonding adjacent groups among R⁵ to R⁷ and R¹⁰ to R¹² together with ring b and/or ring d" defined by general formula (2). Ring b (or ring d) is already constituted by a benzene ring having 6 carbon atoms, and therefore the carbon number of 6 in total of a fused ring formed by fusing a 5-membered ring to this benzene ring becomes a lower limit of the carbon number. The same applies to a heteroaryl ring formed by bonding Z¹ to ring A (ring a) via a linking group or a single bond, and a heteroaryl ring formed by bonding Z² to ring C (ring c) via a linking group or a single bond.

Specific examples of the "heteroaryl ring" include a pyrrole ring, an oxazole ring, an isoxazole ring, a thiazole ring, an isothiazole ring, an imidazole ring, an oxadiazole ring, a thiadiazole ring, a triazole ring, a tetrazole ring, a pyrazole ring, a pyridine ring, a pyrimidine ring, a pyridazine ring, a pyrazine ring, a triazine ring, an indole ring, an isoindole ring, a 1H-indazole ring, a benzimidazole ring, a benzoxazole ring, a benzothiazole ring, a 1H-benzotriazole ring, a quinoline ring, an isoquinoline ring, a cinnoline ring, a quinazoline ring, a quinoxaline ring, a phthalazine ring, a naphthyridine ring, a purine ring, a pteridine ring, a carbazole ring, an acridine ring, a phenoxathiin ring, a phenoxazine ring, a phenothiazine ring, a phenazine ring, an indolizine ring, a furan ring, a benzofuran ring, an isobenzofuran ring, a dibenzofuran ring, a thiophene ring, a benzothiophene ring, a dibenzothiophene ring, a furazane ring, an oxadiazole ring, and a thianthrene ring.

At least one hydrogen atom in the above "aryl ring" or "heteroaryl ring" may be substituted by a substituted or unsubstituted "aryl", a substituted or unsubstituted "heteroaryl", a substituted or unsubstituted "diarylamino", a substituted or unsubstituted "diheteroarylamino", a substituted or unsubstituted "arylheteroarylamino", a substituted or unsubstituted "alkyl", a substituted or unsubstituted "cycloalkyl", a substituted or unsubstituted "alkoxy", a substituted or unsubstituted "aryloxy", a substituted or unsubstituted "heteroaryloxy", a substituted or unsubstituted "arylthio", a substituted or unsubstituted "heteroarylthio", or an alkyl-substituted silyl, which is a primary substituent. Examples of the aryl of the "aryl", "heteroary", and "diarylamino", the heteroaryl of the "diheteroarylamino", the aryl and the heteroaryl of the "arylheteroarylamino", the aryl of the "aryloxy", the heteroaryl of the "heteroaryloxy", the aryl of the "arylthio", and the heteroaryl of the "heteroarylthio", as primary substituents include a monovalent group of the "aryl ring" or "heteroaryl ring" described above.

The "alkyl" as a primary substituent may be either linear or branched, and examples thereof include a linear alkyl having 1 to 24 carbon atoms and a branched alkyl having 3 to 24 carbon atoms. An alkyl having 1 to 18 carbon atoms (branched alkyl having 3 to 18 carbon atoms) is preferable, an alkyl having 1 to 12 carbon atoms (branched alkyl having 3 to 12 carbon atoms) is more preferable, an alkyl having 1 to 6 carbon atoms (branched alkyl having 3 to 6 carbon atoms) is still more preferable, and an alkyl having 1 to 4 carbon atoms (branched alkyl having 3 or 4 carbon atoms) is particularly preferable.

Specific examples of the alkyl include methyl, ethyl, n-propyl, isopropyl, n-butyl, isobutyl, s-butyl, t-butyl, n-pentyl, isopentyl, neopentyl, t-pentyl, n-hexyl, 1-methylpentyl, 4-methyl-2-pentyl, 3,3-dimethylbutyl, 2-ethylbutyl, n-heptyl, 1-methylhexyl, n-octyl, t-octyl, 1-methylheptyl, 2-ethylhexyl, 2-propylpentyl, n-nonyl, 2,2-dimethylheptyl, 2,6-dimethyl-4-heptyl, 3,5,5-trimethylhexyl, n-decyl, n-undecyl, 1-methyldecyl, n-dodecyl, n-tridecyl, 1-hexylheptyl, n-tetradecyl, n-pentadecyl, n-hexadecyl, n-heptadecyl, n-octadecyl, and n-eicosyl.

Examples of the "cycloalkyl" as a primary substituent include a cycloalkyl having 3 to 12 carbon atoms. A cycloalkyl having 3 to 10 carbon atoms is preferable, a cycloalkyl having 3 to 8 carbon atoms is more preferable, and a cycloalkyl having 3 to 6 carbon atoms is still more preferable.

Specific examples of the cycloalkyl include cyclopropyl, cyclobutyl, cyclopentyl, cyclohexyl, methylcyclopentyl, cycloheptyl, methylcyclohexyl, cyclooctyl, dimethylcyclohexyl, and adamantyl.

Examples of the "alkoxy" as a primary substituent include a linear alkoxy having 1 to 24 carbon atoms and a branched alkoxy having 3 to 24 carbon atoms. An alkoxy having 1 to 18 carbon atoms (branched alkoxy having 3 to 18 carbon atoms) is preferable, an alkoxy having 1 to 12 carbon atoms (branched alkoxy having 3 to 12 carbon atoms) is more preferable, an alkoxy having 1 to 6 carbon atoms (branched alkoxy having 3 to 6 carbon atoms) is still more preferable, and an alkoxy having 1 to 4 carbon atoms (branched alkoxy having 3 or 4 carbon atoms) is particularly preferable.

Specific examples of the alkoxy include methoxy, ethoxy, propoxy, isopropoxy, butoxy, isobutoxy, s-butoxy, t-butoxy, pentyloxy, hexyloxy, heptyloxy, and octyloxy.

The "alkyl-substituted silyl" as a primary substituent is preferably a trialkyl-substituted silyl. For the alkyl to be substituted, the description of "alkyl" as a primary substituent described above can be referred to.

At least one hydrogen atom in the substituted or unsubstituted "aryl", the substituted or unsubstituted "heteroaryl", the substituted or unsubstituted "diarylamino", the substituted or unsubstituted "diheteroarylamino", the substituted or unsubstituted "arylheteroarylamino", the substituted or unsubstituted "alkyl", the substituted or unsubstituted "cycloalkyl", the substituted or unsubstituted "alkoxy", the substituted or unsubstituted "aryloxy", the substituted or unsubstituted "heteroaryloxy", the substituted or unsubstituted "arylthio", or the substituted or unsubstituted "heteroarylthio", as a primary substituent may be substituted by a secondary substituent as described to be substituted or unsubstituted. Examples of this secondary substituent include an aryl, a heteroaryl, or an alkyl. As specific examples thereof, the above description on the monovalent group of the "aryl ring" or "heteroaryl ring" and the "alkyl" as a primary substituent can be referred to. The aryl or the heteroaryl as a secondary substituent includes a structure in which at least one hydrogen atom in the aryl or the heteroaryl is substituted by an aryl such as phenyl (specific examples are the groups described above) or an alkyl such as methyl (specific examples are the groups described above). For example, when the secondary substituent is a carbazolyl group, a carbazolyl group in which at least one hydrogen atom at the 9-position is substituted by an aryl such as phenyl or an alkyl such as methyl is also included in the heteroaryl as the secondary substituent.

Examples of the aryl, the heteroaryl, the aryl of the diarylamino, the heteroaryl of the diheteroarylamino, the aryl and the heteroaryl of the arylheteroarylamino, the aryl of the aryloxy, the heteroaryl of the heteroaryloxy, the aryl of the arylthio, or the heteroaryl of the heteroarylthio in R³ to R¹² in general formula (2) include the monovalent groups of the "aryl ring" or the "heteroaryl ring" described in general formula (1). As the alkyl, the cycloalkyl, the alkoxy, or the alkyl-substituted silyl in R³ to R¹², the description on the "alkyl", the "cycloalkyl", the "alkoxy", or the "alkyl-substituted silyl" as a primary substituent in the above description of general formula (1) can be referred to. The same also applies to an aryl, a heteroaryl, or an alkyl as a substituent on these groups. The same also applies to a aryl, a heteroaryl, a diarylamino, a diheteroarylamino, an arylheteroarylamino, an alkyl, a cycloalkyl, an alkoxy, an aryloxy, a heteroaryloxy, an aryltiho, a heteroaryltiho, or an alkyl-substituted silyl as a substituent on these rings in a case of forming an aryl ring or a heteroaryl ring by bonding adjacent groups among R⁵ to R⁷ and R¹⁰ to R¹² together with ring b or ring d, and an aryl, a heteroaryl, or an alkyl as a further substituent.

R in the moiety >N-R in X¹, X², X³ and X⁴ in general formula (1) represents an aryl, a heteroaryl, or an alkyl, at least one hydrogen atom in these groups may be substituted by an aryl, a heteroaryl, a diarylamino, a diheteroarylamino, an arylheteroarylamino, an alkyl, a cycloalkyl, an alkoxy, an aryloxy, a heteroaryloxy, an arylthio, a heteroarylthio, or an alkyl-substituted silyl. Examples of these groups and such substituents include the examples described above. Particularly, an aryl having 6 to 10 carbon atoms (for example, phenyl or naphthyl), a heteroaryl having 2 to 15 carbon atoms (for example, carbazolyl), and an alkyl having 1 to 4 carbon atoms (for example, methyl or ethyl) are preferable. This description also applies to X¹, X², X³ and X⁴ in general formula (2).

R in "-C(-R)₂-" which is a linking group in general formula (1) represents a hydrogen atom or an alkyl, and examples of this alkyl include the groups described above. Particularly an alkyl having 1 to 6 carbon atoms, further an alkyl having 1 to 4 carbon atoms (for example, methyl or ethyl) are preferable. This description also applies to "-C(-R)₂-" which is a linking group in general formula (2).

For further detailed description of an alkyl having 1 to 6 carbon atoms, an aryl having 6 to 12 carbon atoms, and a heteroaryl or a diarylamino having 2 to 15 carbon atoms (in which an aryl has 6 to 12 carbon atoms) in R¹ and R² in general formula (1) or (2), the above description of "alkyl", "aryl", "heteroaryl", or "diarylamino" can be referred to.

For an aryl, a heteroaryl, a diarylamino, a diheteroarylamino, an arylheteroarylamino, an alkyl, a cycloalkyl, an aryloxy, a heteroaryloxy, an arylthio, or a heteroarylthio in Z¹ and Z² of general formula (1) or (2), and an aryl, a heteroaryl, a diarylamino, an alkyl, a cycloalkyl, an alkoxy, an aryloxy, or an alkyl-substituted silyl as a substituent thereon, the above description of "aryl", "heteroaryl", "diarylamino", "diheteroarylamino", "arylheteroarylamino", "aryloxy", "heteroaryloxy", "arylthio", "heteroarylthio", "alkyl", "cycloalkyl", "alkoxy", or "alkyl-substituted silyl" can be referred to. Preferred examples of Z¹ and Z² include a diarylamino, an alkyl, a cycloalkyl, an aryloxy, and a heteroaryl such as carbazole.

All or some of hydrogen atoms in the compound represented by general formula (1) or (2) may be substituted by cyanos, halogen atoms, or deuterium atoms. For example, in formula (1), a hydrogen atom in ring A, ring B, ring C, ring D (ring A to ring D are aryl rings or heteroaryl rings), substituents on ring A to ring D, R of N-R that is any one of X¹ to X⁴ (R = aryl, heteroaryl, or alkyl), R¹, R², Z¹, and Z² may be substituted by cyano, a halogen atom, or a deuterium atom. Among these forms, a form in which all or some of hydrogen atoms in an aryl or a heteroaryl are substituted by cyanos, halogen atoms, or deuterium atoms may be mentioned. The halogen is fluorine, chlorine, bromine, or iodine, preferably fluorine, chlorine, or bromine, and more preferably chlorine.

Specific examples of the polycyclic aromatic compound represented by the formula (1) include compounds represented by the following structural formulas.

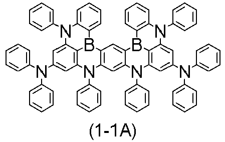

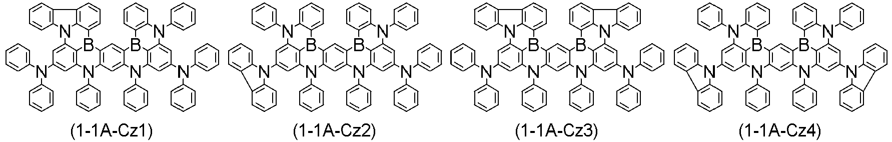

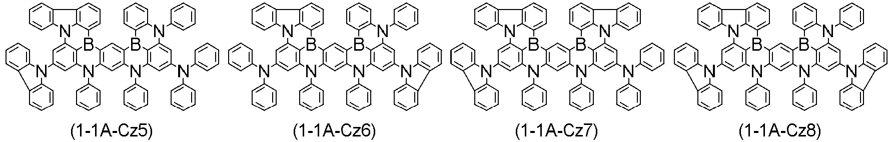

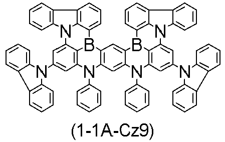

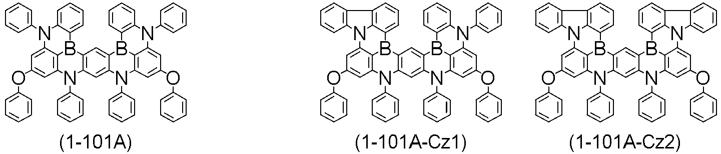

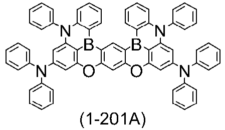

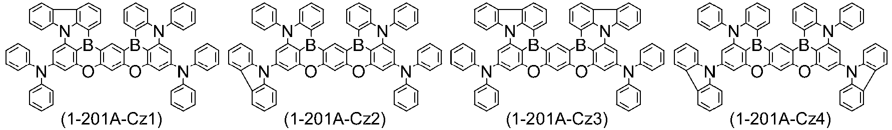

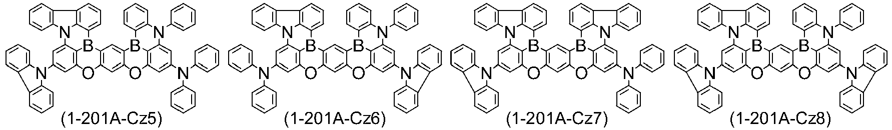

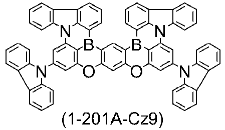

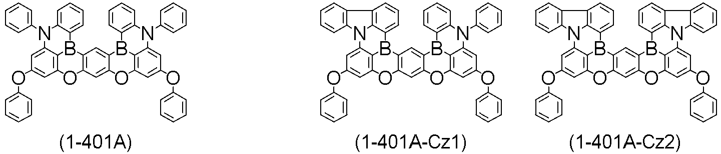

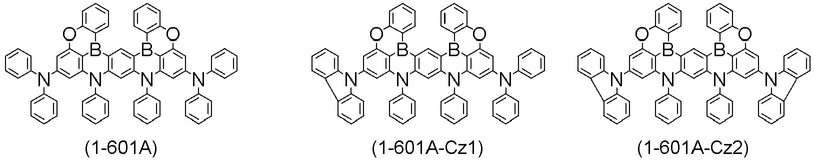

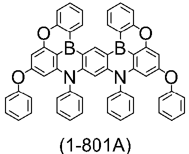

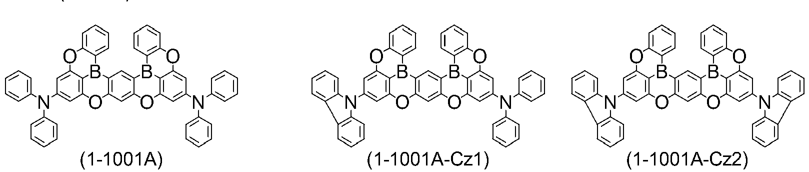

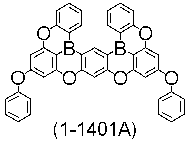

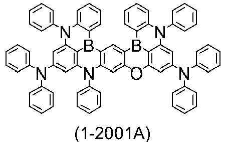

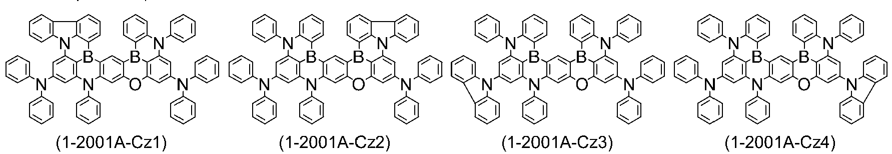

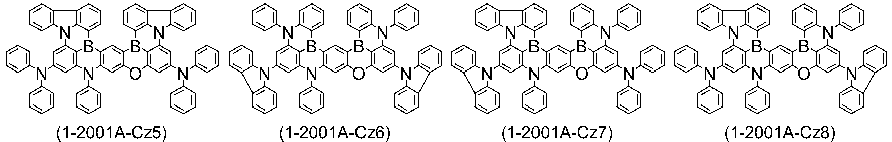

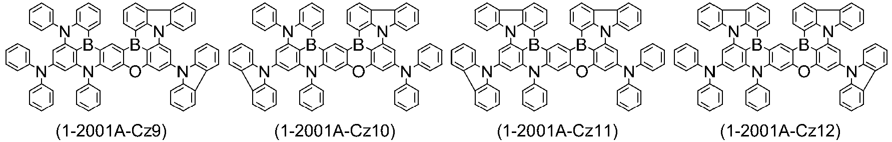

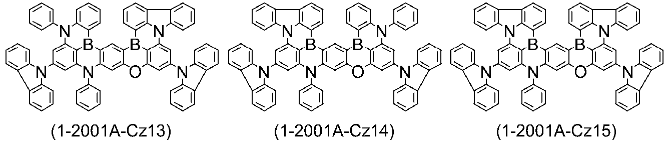

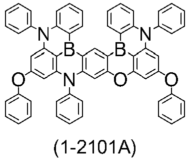

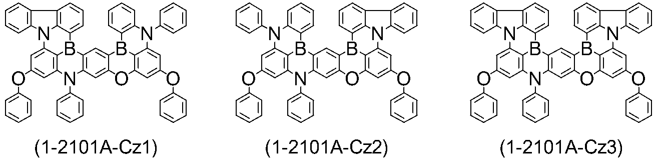

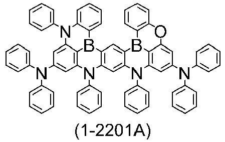

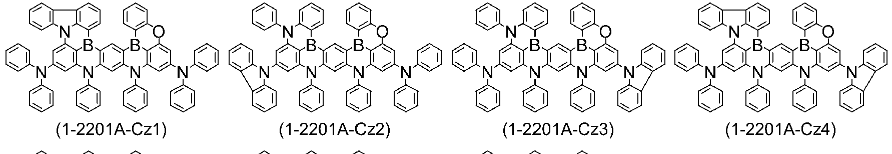

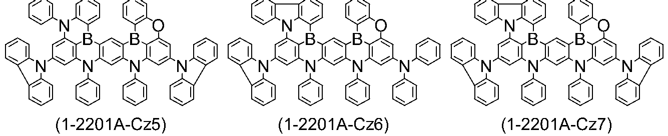

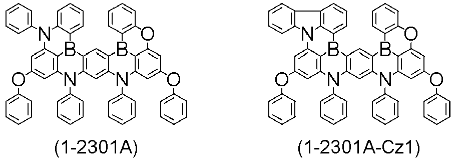

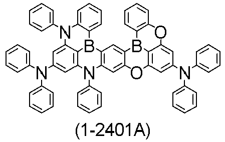

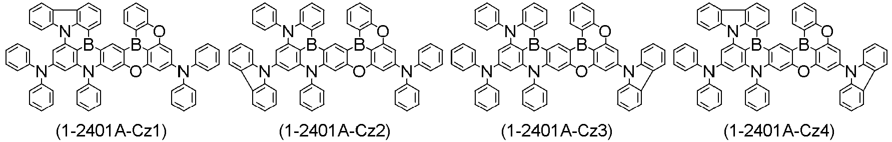

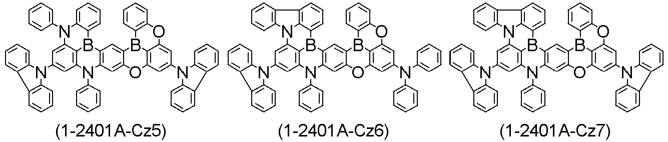

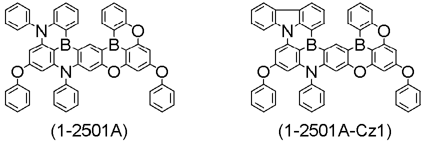

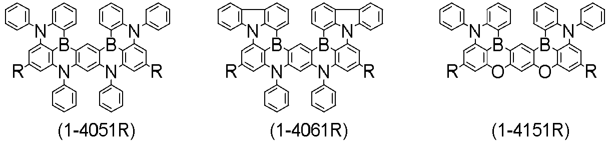

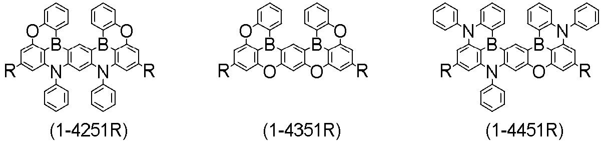

(At least one hydrogen atom in compounds represented by the above formulas may be substituted by an alkyl having 1 to 6 carbon atoms, an aryl having 6 to 10 carbon atoms, cyano, an halogen atom, or a deuterium atom, R in the formulas each independently represents an alkyl having 1 to 6 carbon atoms or an aryl having 6 to 10 carbon atoms, preferably phenyl, methyl or t-butyl.)

Other specific examples of the polycyclic aromatic compound represented by the formula (1) include compounds represented by the following structural formulas.

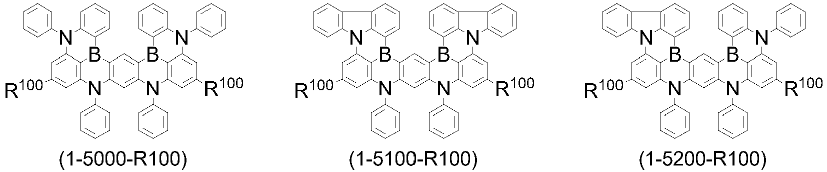

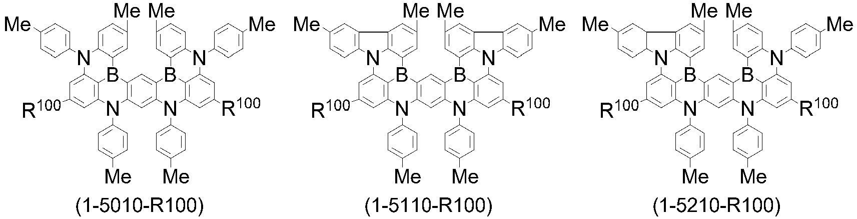

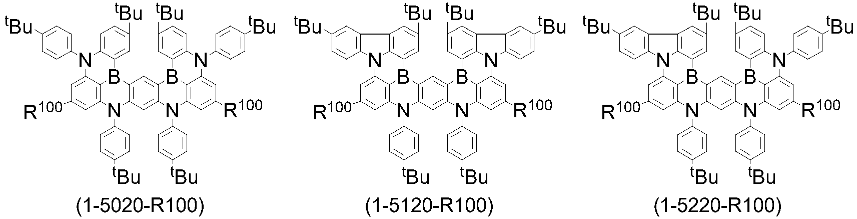

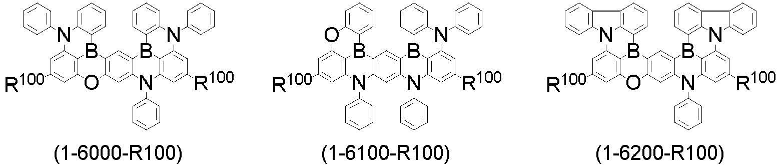

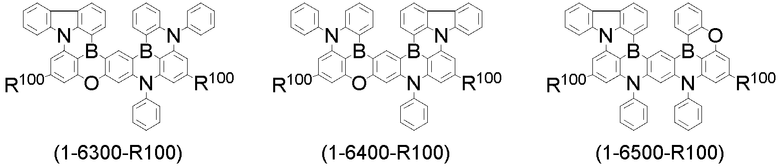

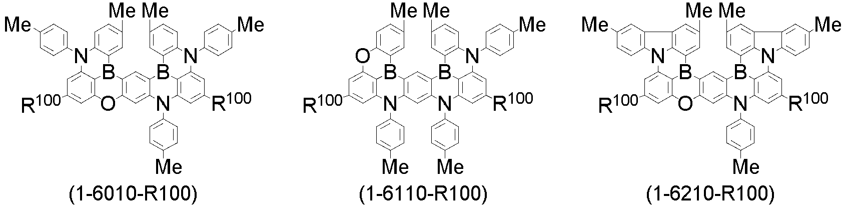

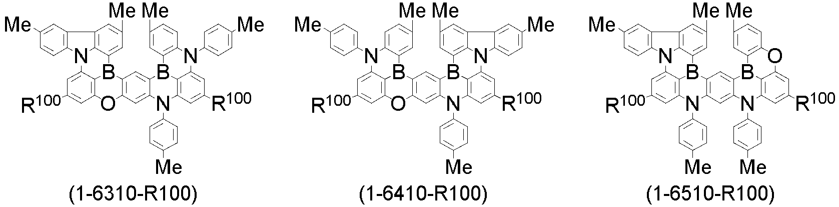

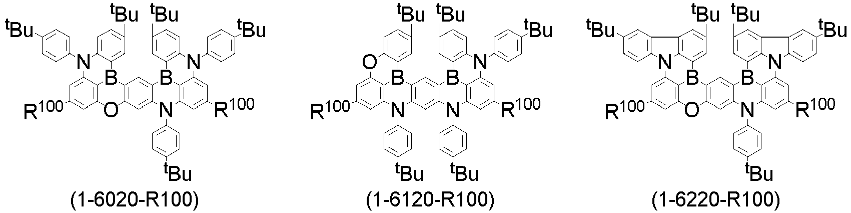

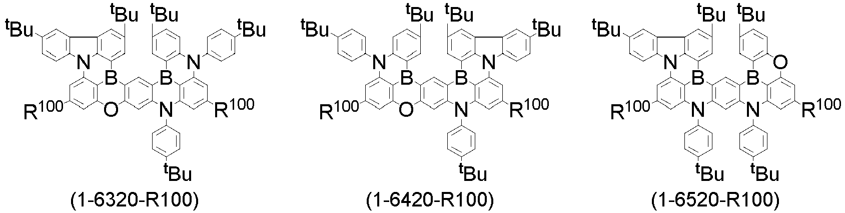

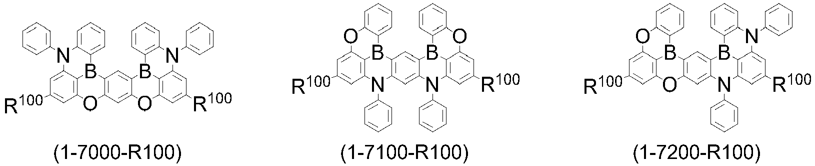

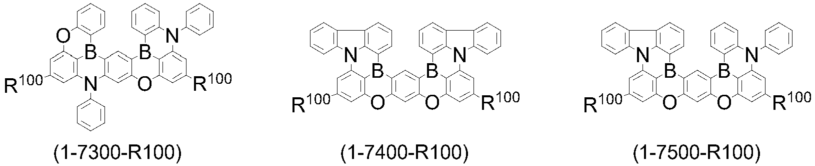

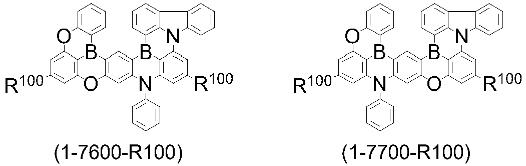

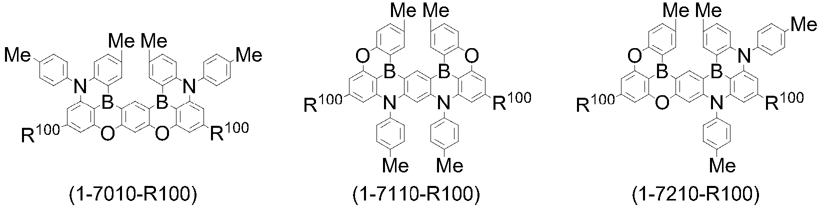

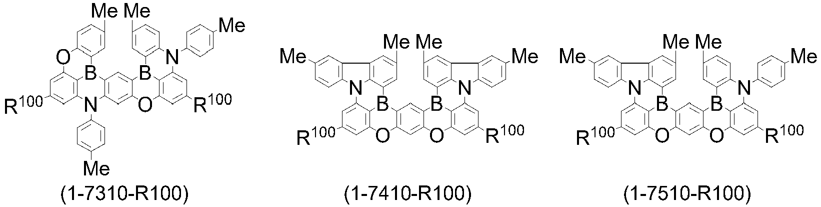

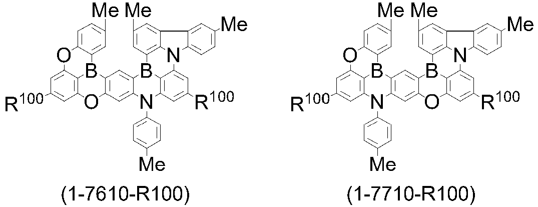

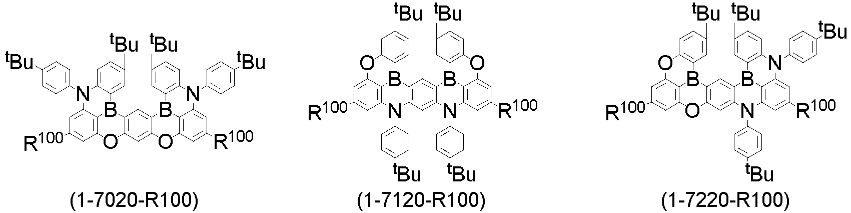

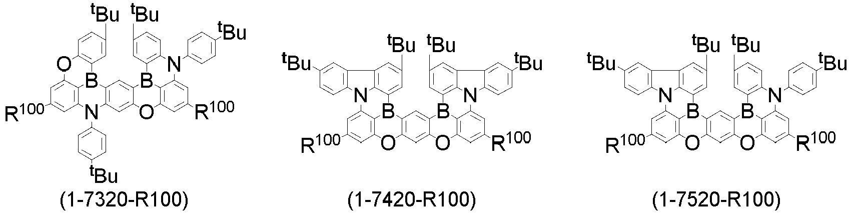

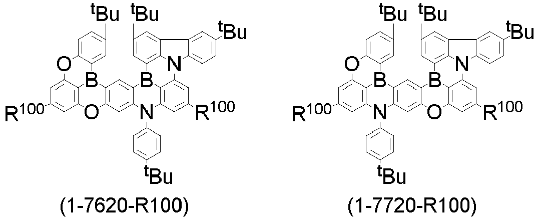

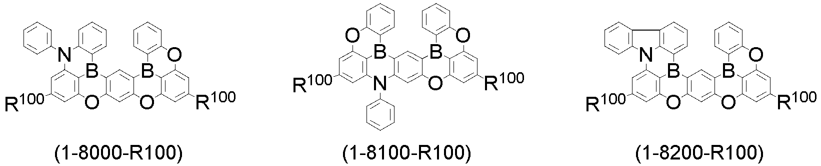

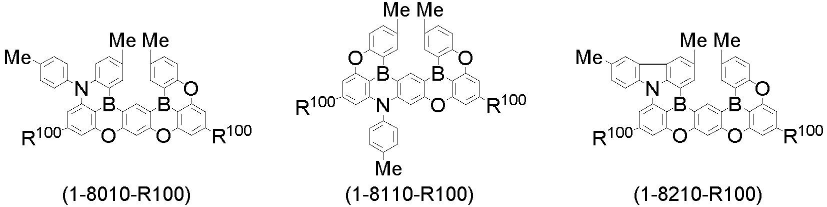

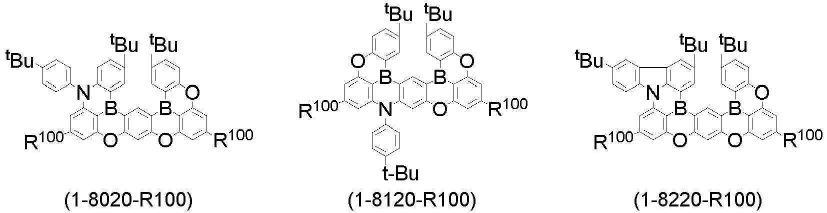

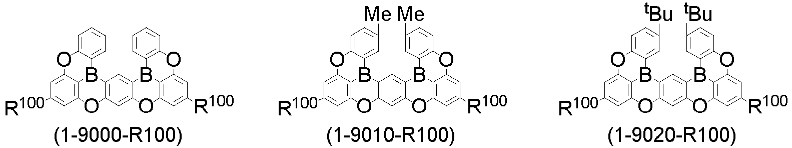

At least one hydrogen atom in compounds represented by the above formulas may be substituted by an alkyl having 1 to 6 carbon atoms, an aryl having 6 to 10 carbon atoms, cyano, an halogen atom, or a deuterium atom, R¹⁰⁰ in the formulas each independently represents an aryl having 6 to 10 carbon atoms, a carbazolyl, a diarylamino (the aryl is an aryl having 6 to 10 carbon atoms), an alkyl having 1 to 6 carbon atoms, a cycloalkyl having 3 to 10 carbon atoms, or an aryloxy having 6 to 10 carbon atoms, The "aryl", the "aryl" in the "diarylamino", and the "aryl" in the "aryloxy" may be substituted by an alkyl having 1 to 6 carbon atoms, and the carbazolyl may be substituted by an aryl having 6 to 10 carbon atoms or an alkyl having 1 to 6 carbon atoms.

An emission wavelength can adjusted by steric hindrance, an electron donating property, and an electron withdrawing property of the structure of R¹⁰⁰, and R¹⁰⁰ is preferably a group represented by any one of the following structural formulas, more preferably methyl, t-butyl, phenyl, o-tolyl, p-tolyl, 2,4-xylyl, 2,5-xylyl, 2,6-xylyl, 2,4,6-mesityl, diphenylamino, di-p-tolylamino, bis(p-(t-butyl) phenyl)amino, carbazolyl, 3,6-dimethylcarbazolyl, 3,6-di-t-butylcarbazolyl, or phenoxy, and more preferably methyl, t-butyl, phenyl, o-tolyl, 2,6-xylyl, 2,4,6-mesityl, diphenylamino, di-p-tolylamino, bis(p-(t-butyl) phenyl)amino, carbazolyl, 3,6-dimethylcarbazolyl, or 3,6-di-t-butylcarbazolyl. Larger steric hindrance is more preferable for selective synthesis from a viewpoint of easiness of synthesis. Specifically, t-butyl, o-tolyl, p-tolyl, 2,4-xylyl, 2,5-xylyl, 2,6-xylyl, 2,4,6-mesityl, di-p-tolylamino, bis(p-(t-butyl) phenyl)amino, 3,6-dimethylcarbazolyl, and 3,6-di-t-butylcarbazolyl are preferable.

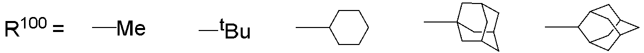

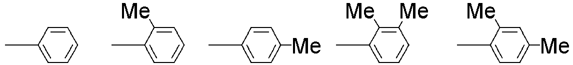

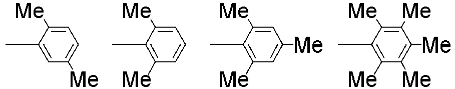

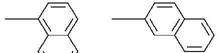

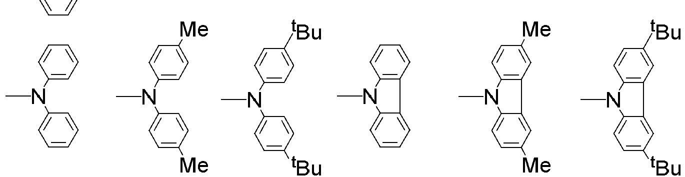

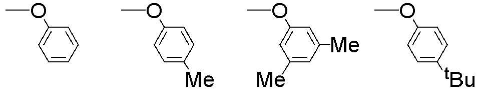

A highly symmetric structure and/or a structure having a substituent at the p-position with respect to a bonding site of N are/is preferred from a viewpoint of difficulty in synthesis. Specifically, formulas (1-5000-R100), (1-5010-R100), (1-5020-R100), (1-5100-R100), (1-5110-R100), (1-5120-R100), (1-7000-R100), (1-7010-R100), (1-7020-R100), (1-7100-R100), (1-7110-R100), (1-7120-R100), (1-7200-R100), (1-7210-R100), (1-7220-R100), (1-7400-R100), (1-7410-R100), (1-7420-R100), and (1-9000-R100) are preferred, and formulas (1-5000-R100), (1-5010-R100), (1-5020-R100), (1-5100-R100), (1-5110-R100), and (1-5120-R100) are more preferred.

A structure having many N-aryl groups and/or a structure having many carbazolyl structures are/is preferred from a viewpoint of blue light emission and/or a high luminous efficiency. Specifically, formulas (1-5000-R100), (1-5010-R100), (1--5020-R100), (1-5100-R100), (1-5110-R100), (1--5120-R100), (1-6000-R100), (1-6010-R100), (1-6020-R100), (1-6200-R100), (1-6210-R100), (1-6220-R100), (1-7400-R100), (1-7410-R100), and (1-7420-R100) are preferred.

It is preferable that more N atoms are bonded to the central aromatic ring from a viewpoint of enhancing a multiple resonance effect. Specifically, formulas (1-5000-R100), (1-5010-R100), (1-5020-R100), (1-5100-R100), (1-5110-R100), (1-5120-R100), (1-6100-R100), (1-6110-R100), (1-6120-R100), (1-6500-R100), (1-6510-R100), (1-6520-R100), (1-7100-R100), (1-7110-R100), and (1-7120-R100) are preferred.

More specific examples of the polycyclic aromatic compound represented by formula (1) include a compound represented by a structural formula starting from the following (1-1), a compound having a structural formula in which a t-butyl group is substituted by a methyl group in the structural formula starting from the following formula (1-1), a compound having a structural formula in which phenyl groups of R¹ and R² are both substituted by methyl groups in a structural formula in which portions corresponding to R¹ and R² in general formula (1) are phenyl groups, a compound having a structural formula in which a phenyl group of R¹ is substituted by a hydrogen atom and only R² is a phenyl group, a compound having a structural formula in which a phenyl group of R² is substituted by a hydrogen atom and only R¹ is a phenyl group, a compound having a structural formula in which a phenyl group of R¹ is substituted by a methyl group and a phenyl group of R² is substituted by a hydrogen atom, and a compound having a structural formula in which a phenyl group of R¹ is substituted by a hydrogen atom and a phenyl group of R² is substituted by a methyl group. For example, the structural formula of formula (1-2) and the structural formula of formula (1-6) are as follows. Note that "Me" represents a methyl group, "^{t}Bu" represents a t-butyl group, and "Ph" represents a phenyl group in each formula.

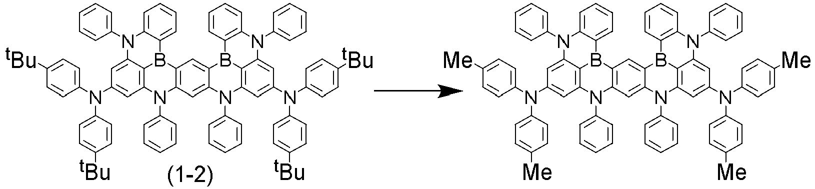

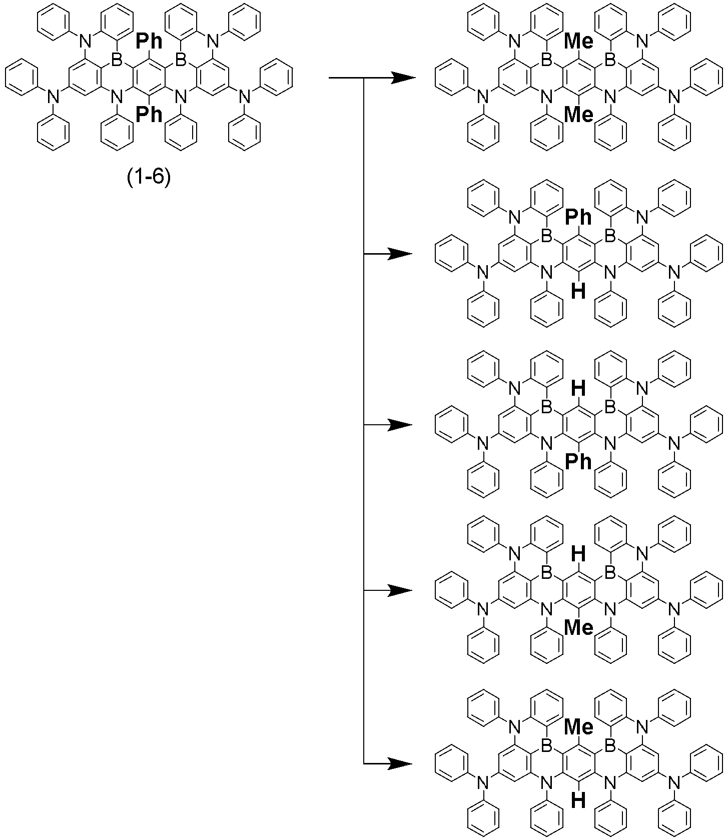

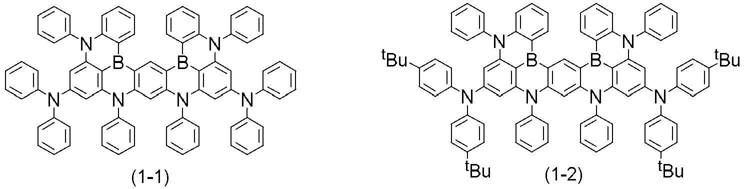

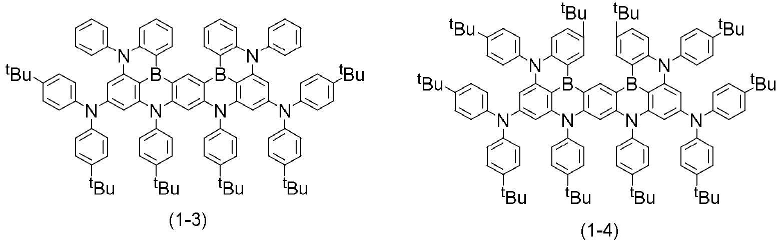

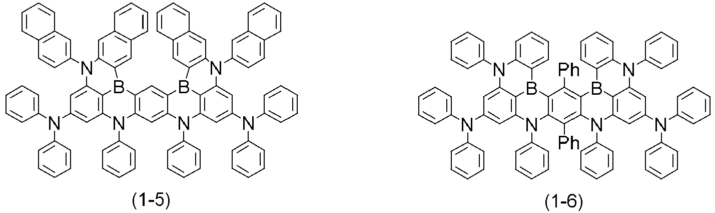

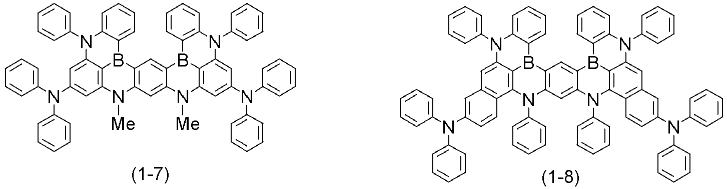

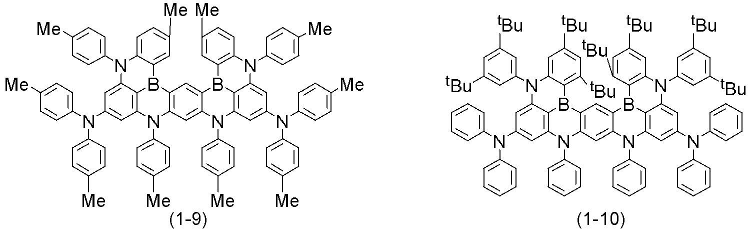

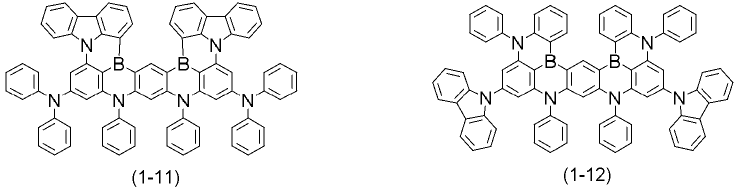

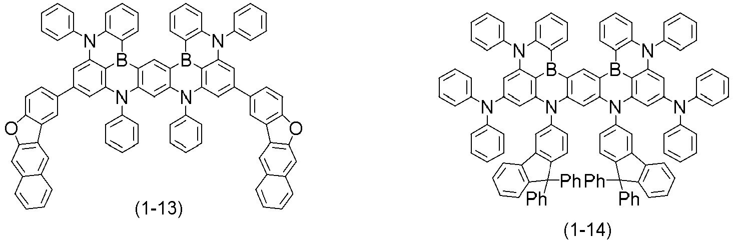

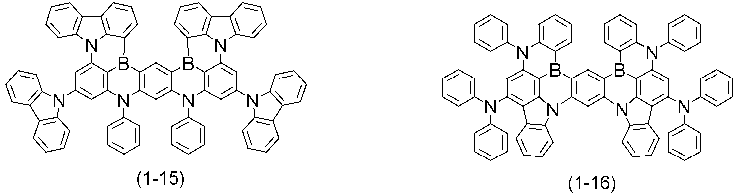

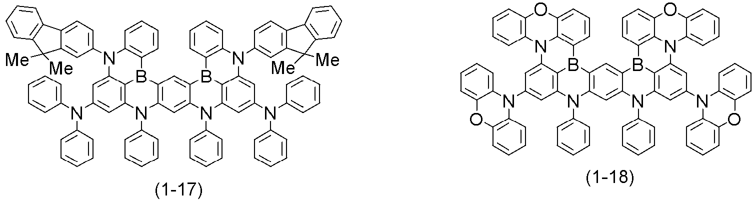

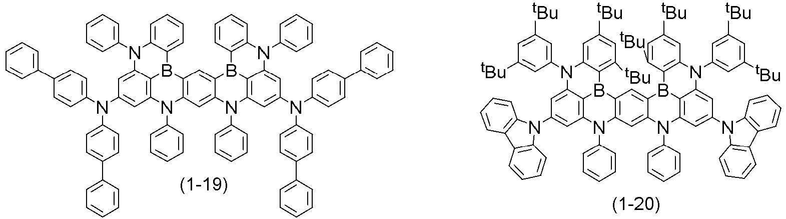

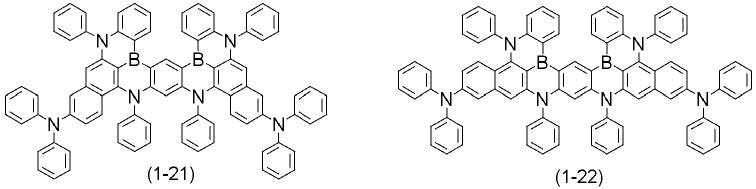

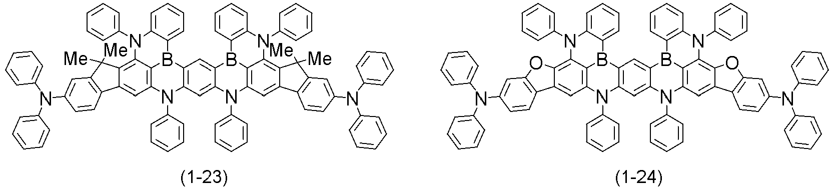

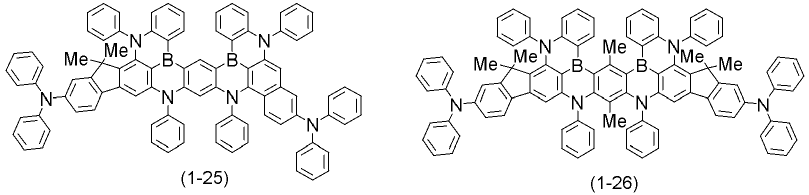

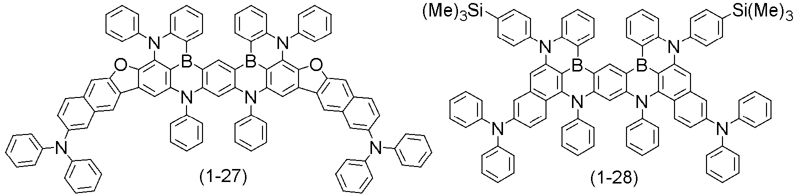

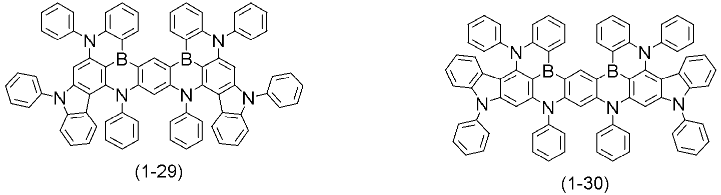

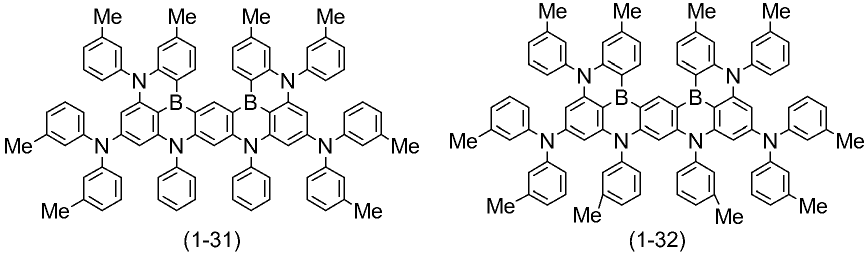

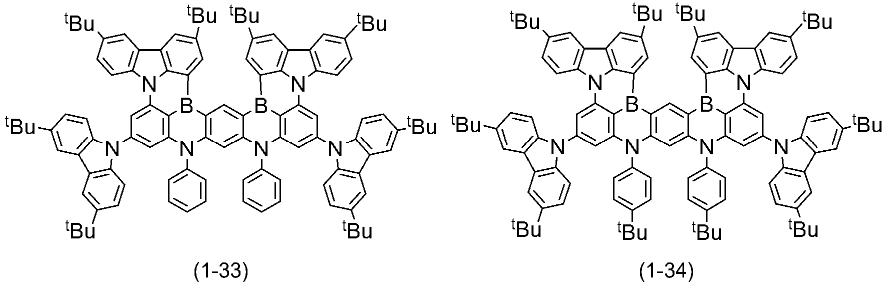

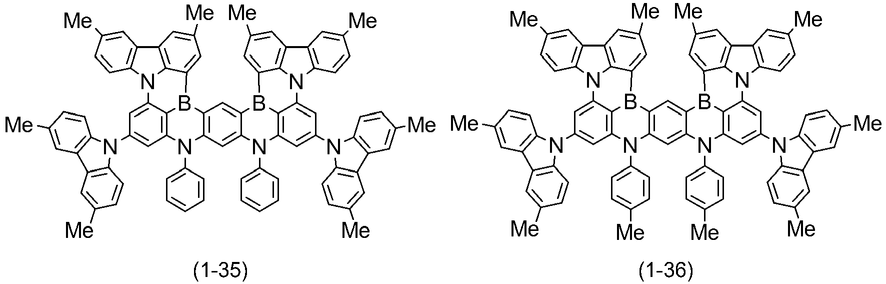

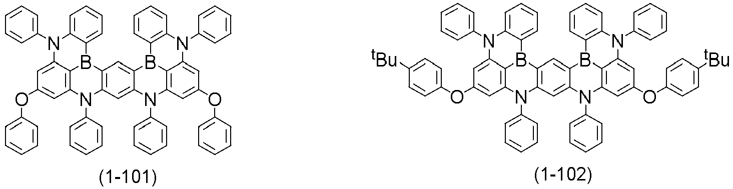

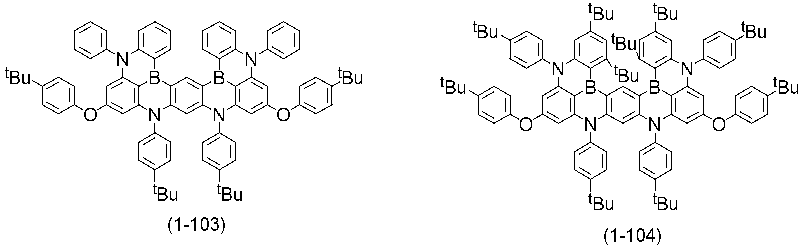

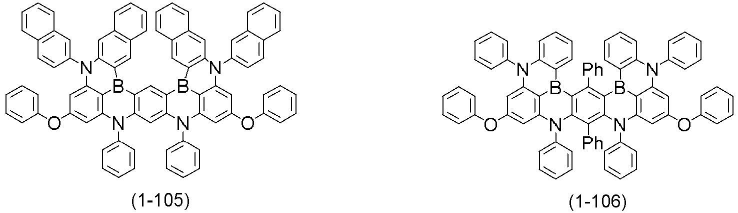

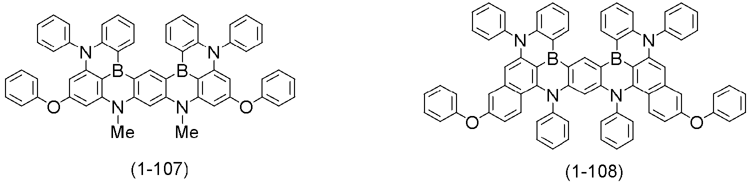

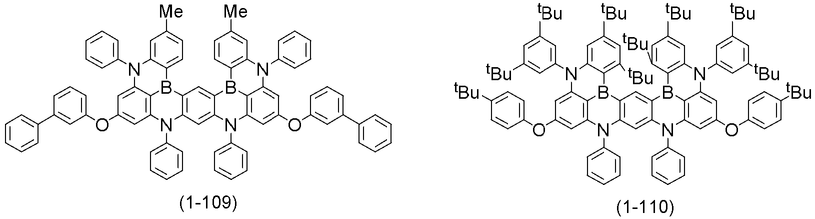

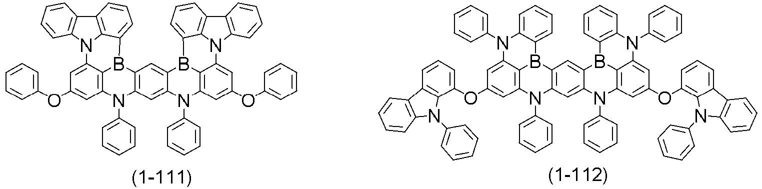

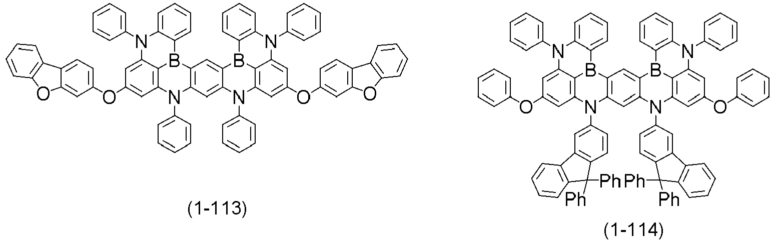

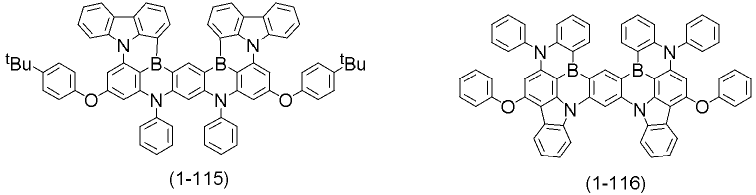

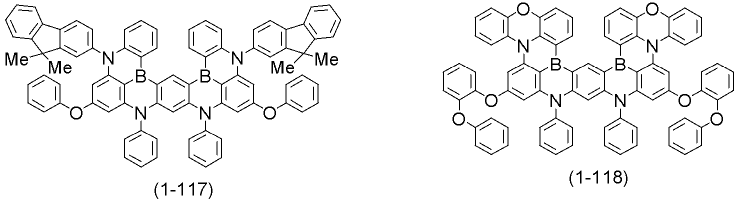

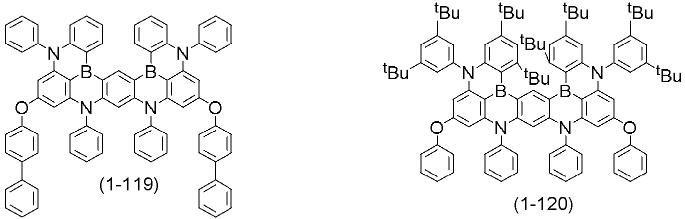

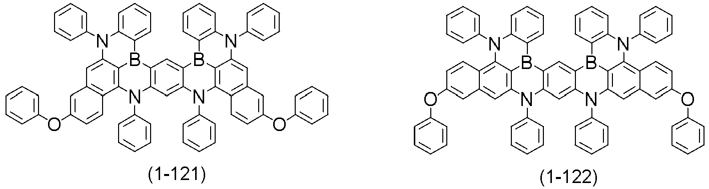

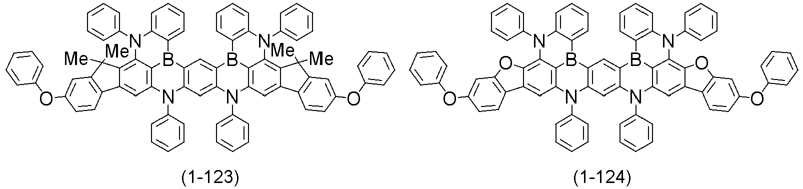

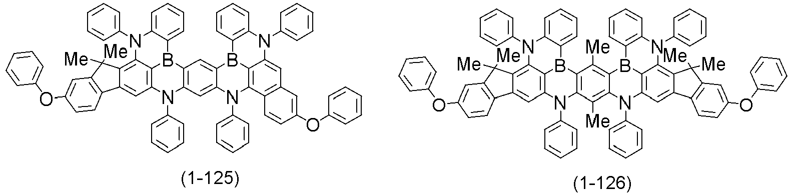

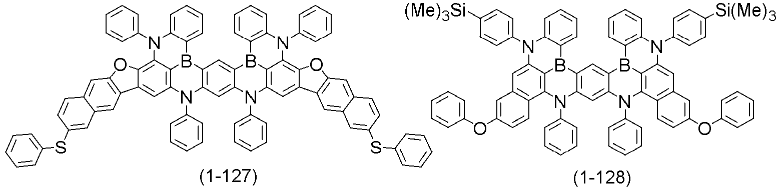

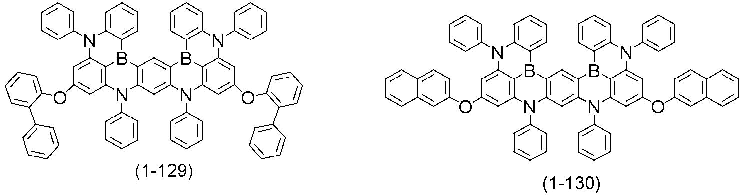

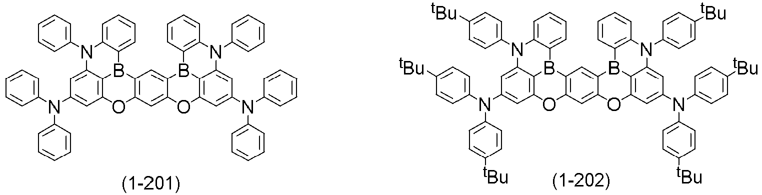

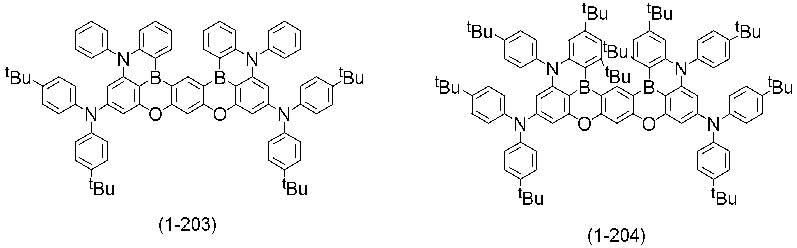

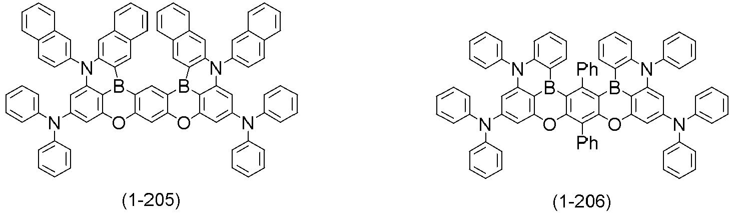

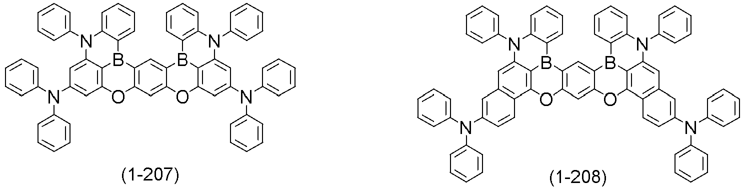

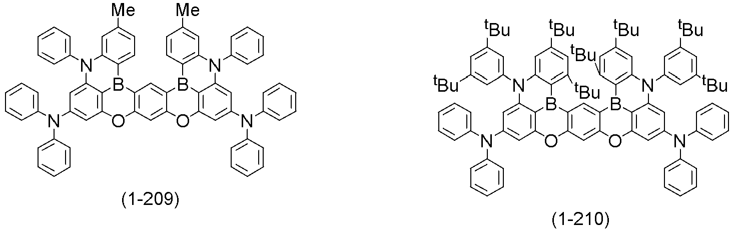

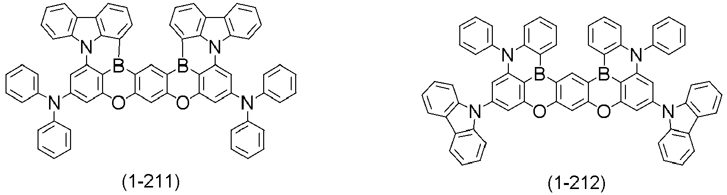

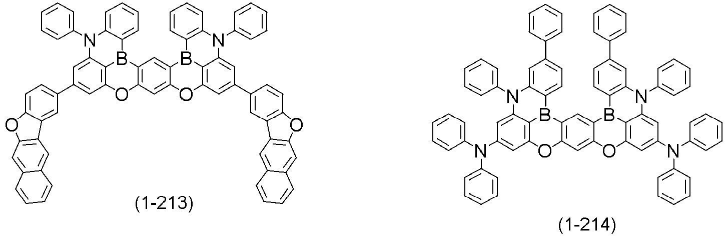

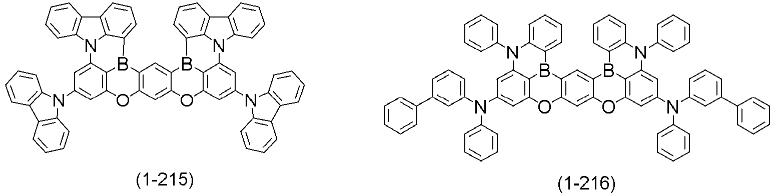

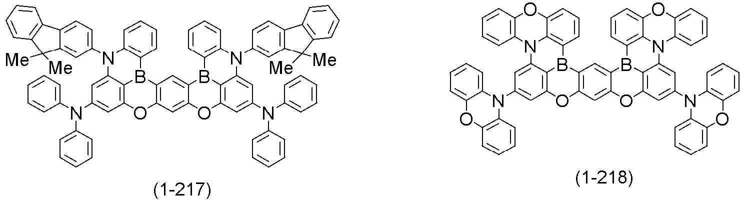

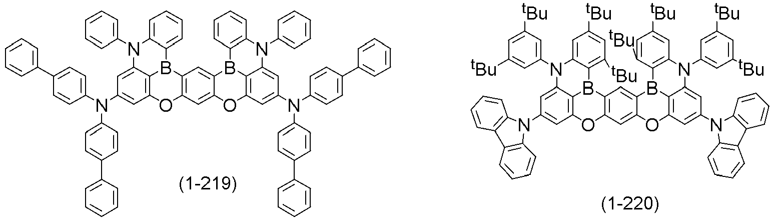

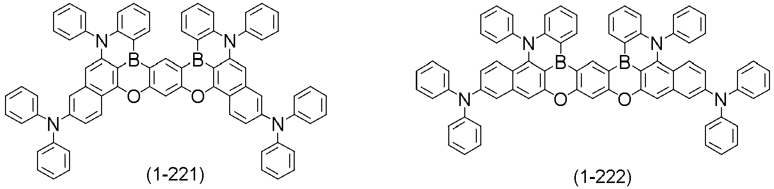

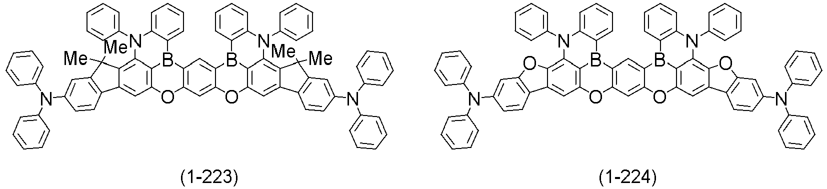

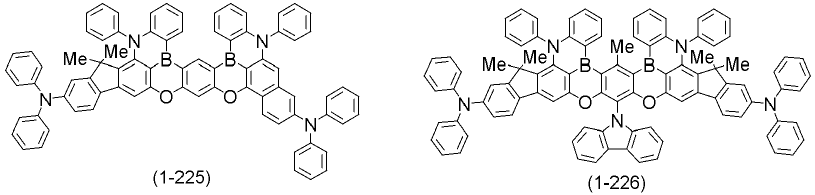

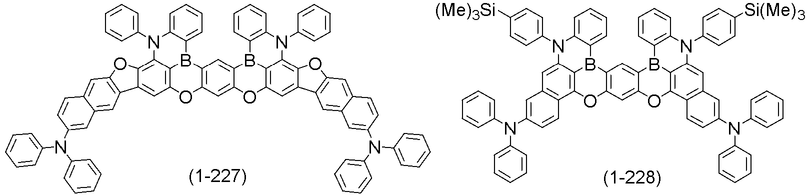

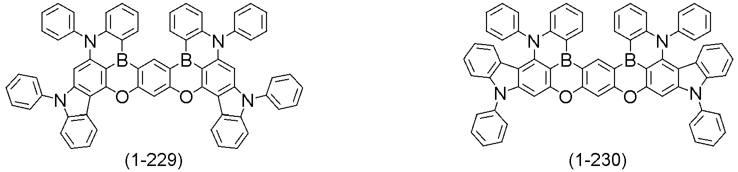

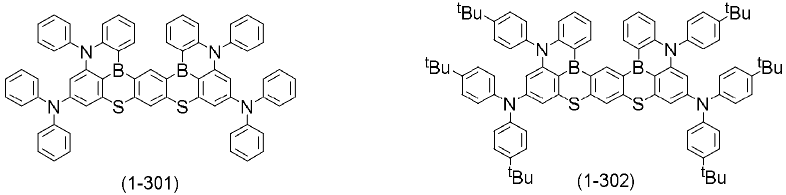

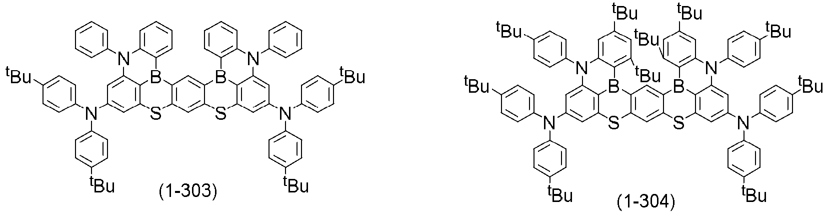

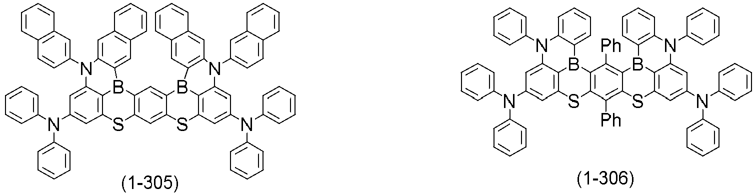

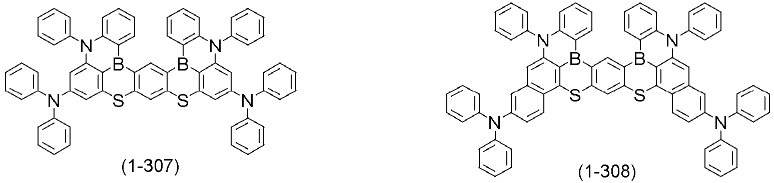

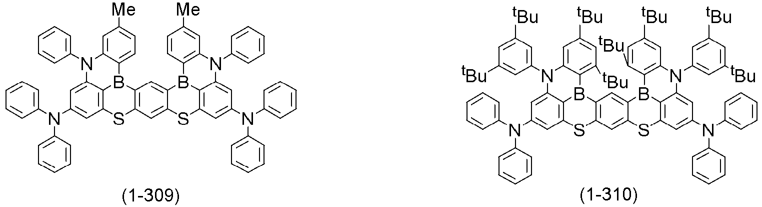

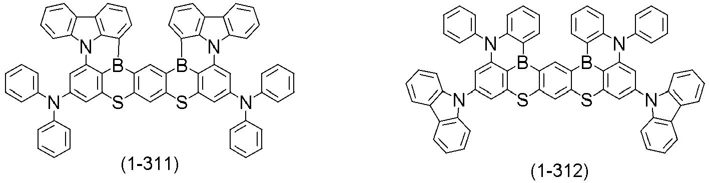

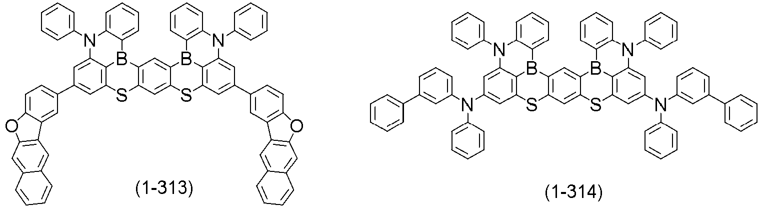

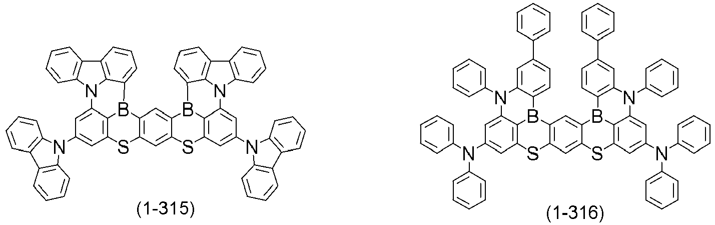

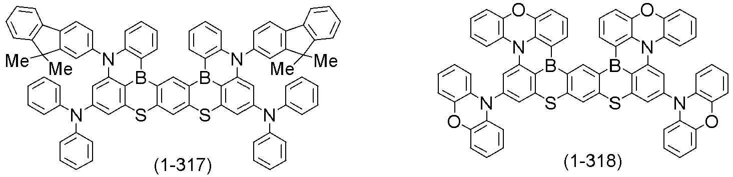

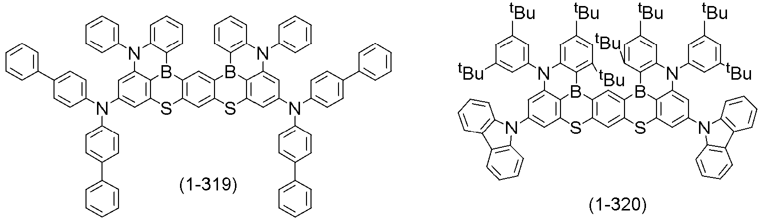

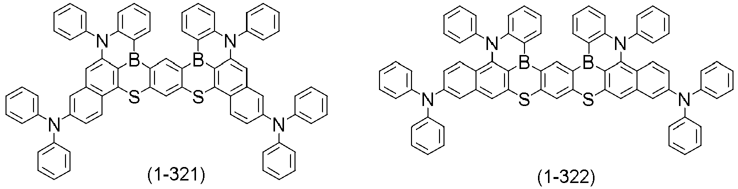

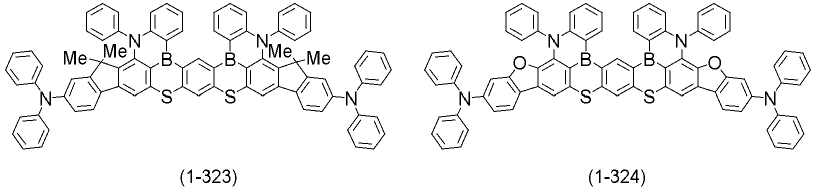

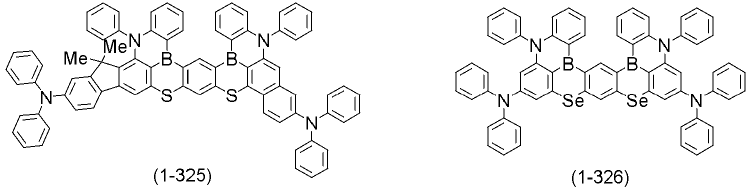

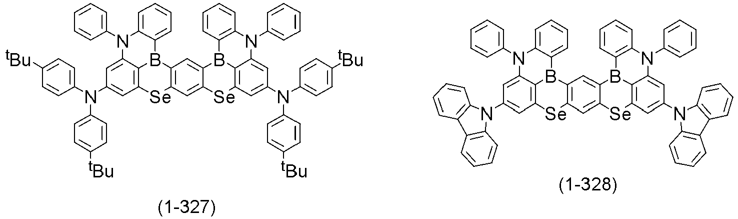

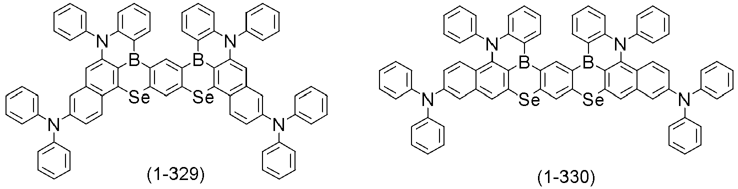

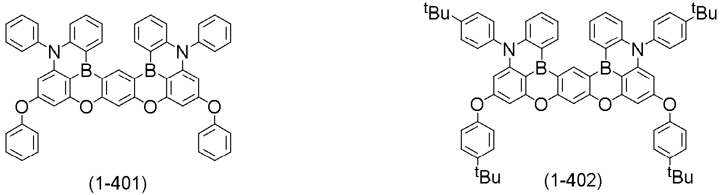

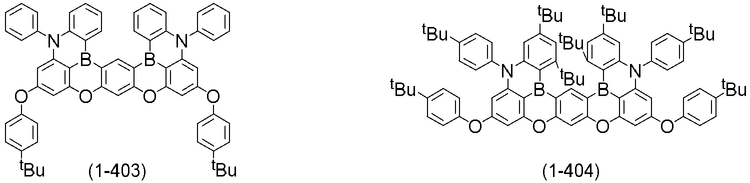

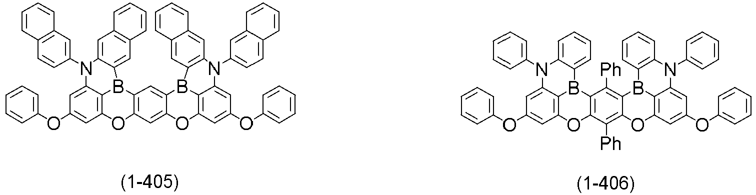

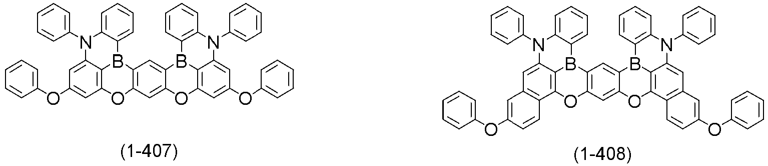

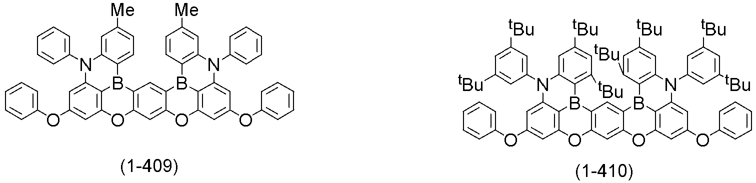

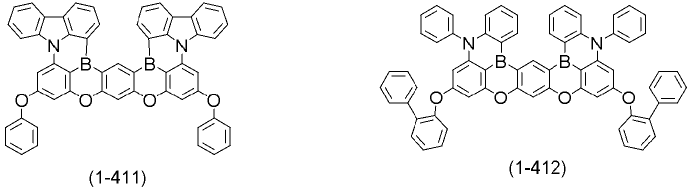

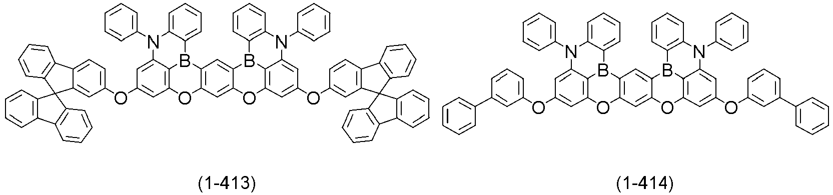

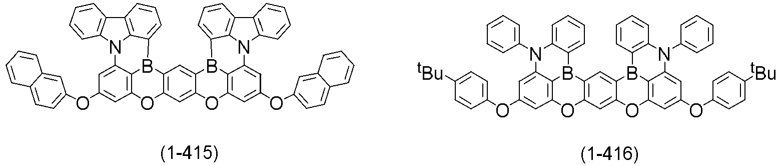

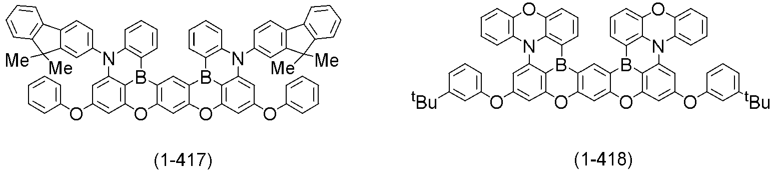

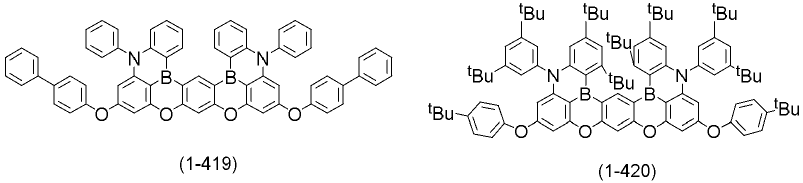

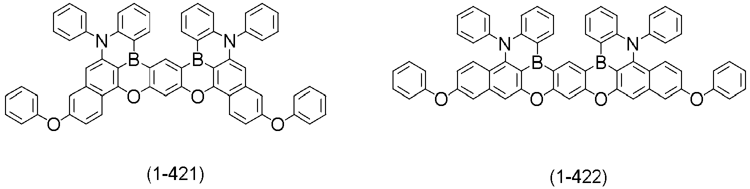

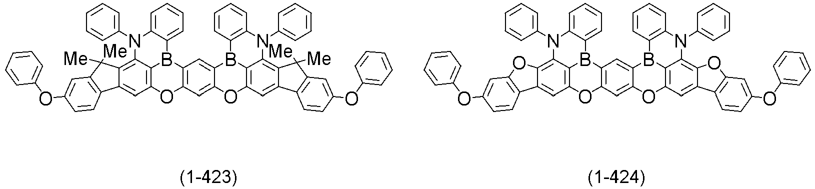

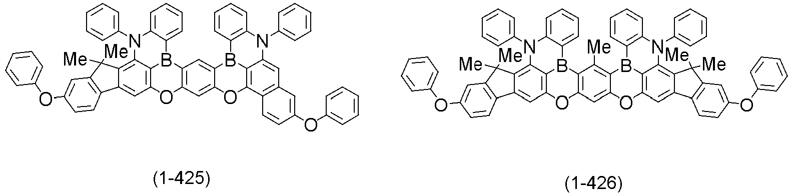

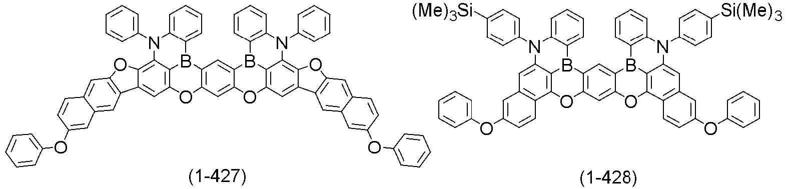

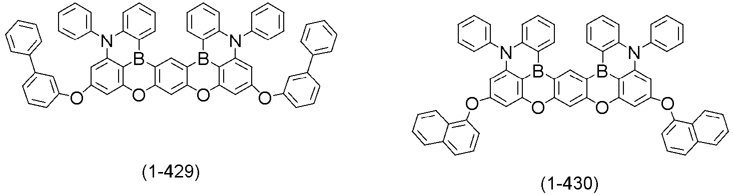

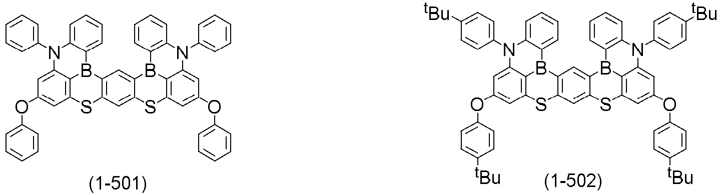

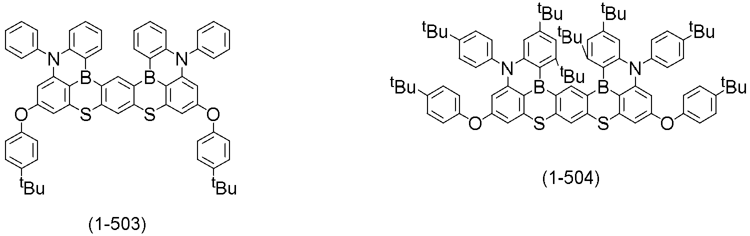

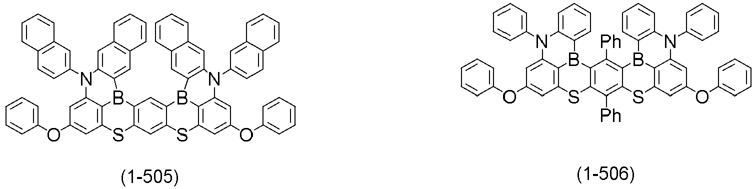

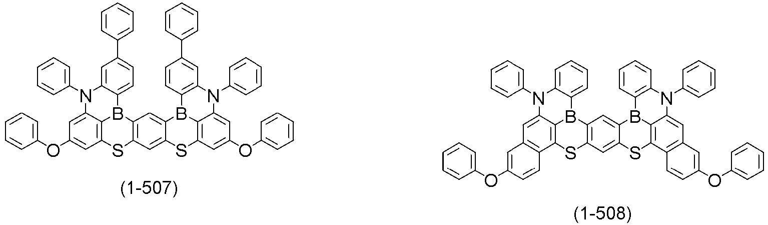

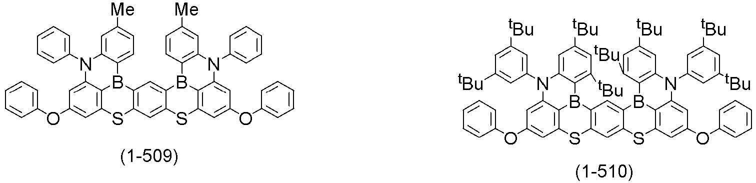

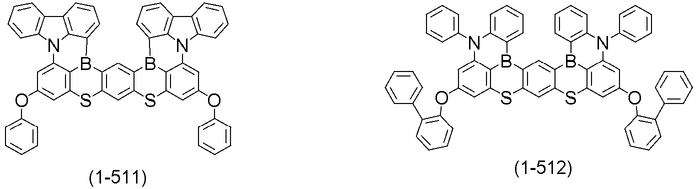

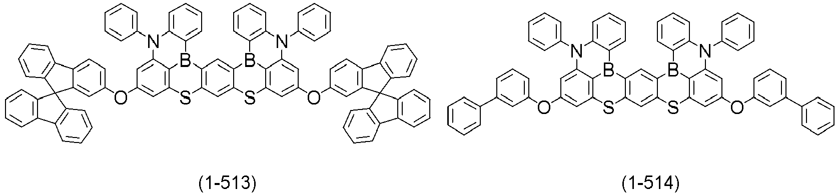

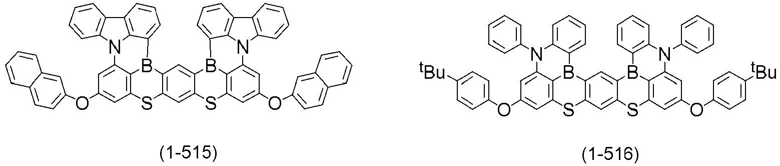

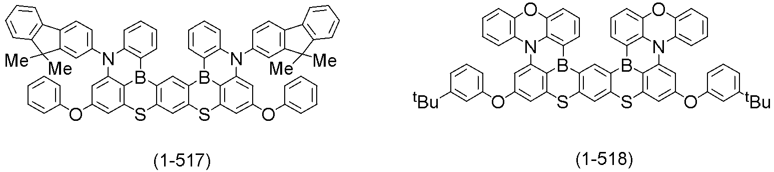

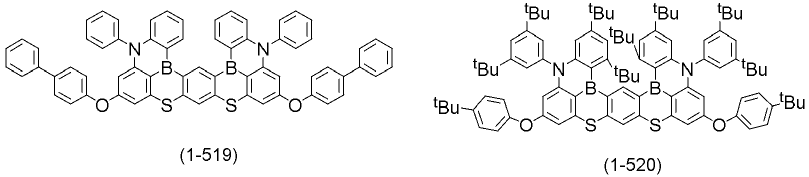

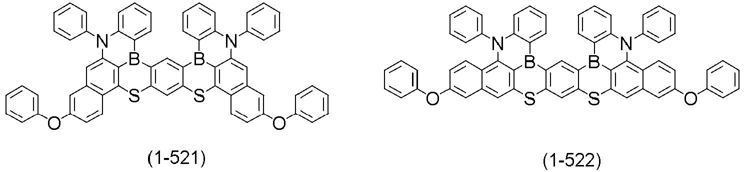

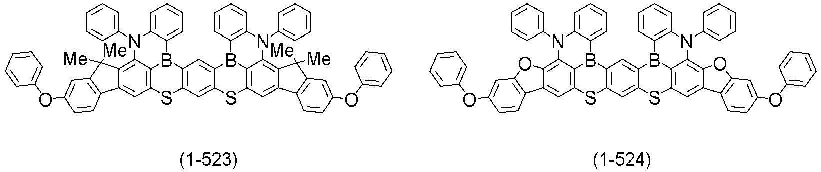

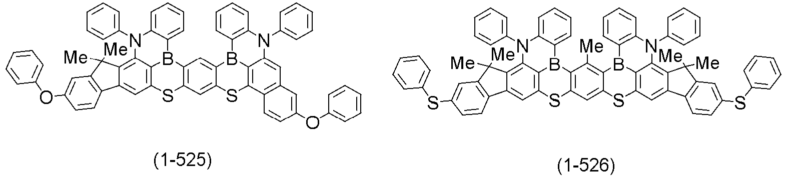

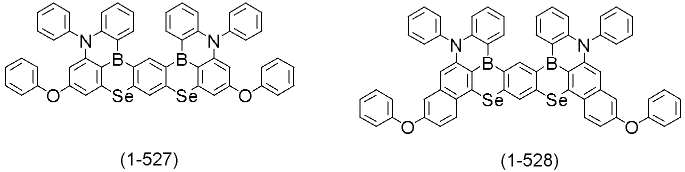

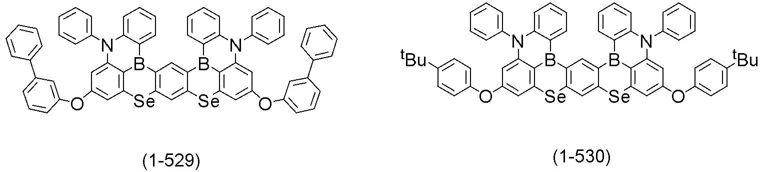

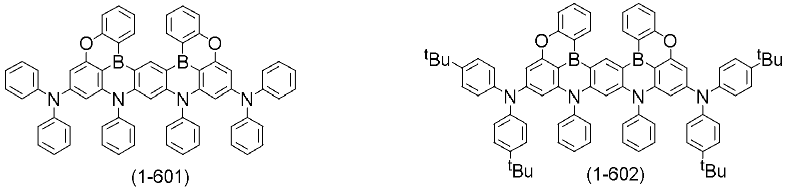

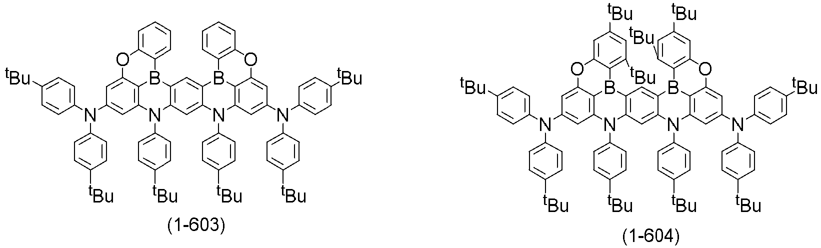

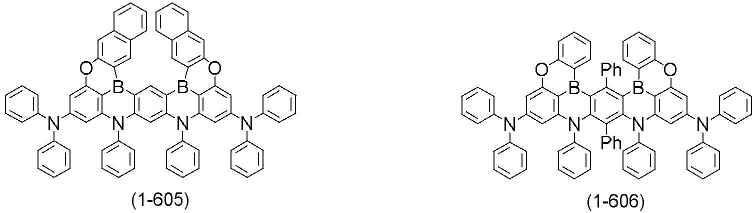

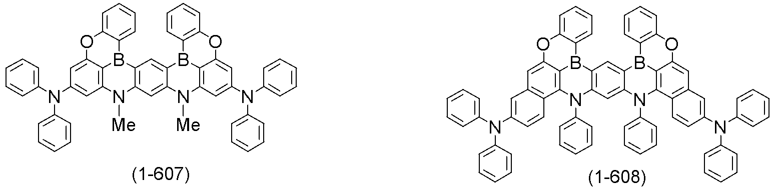

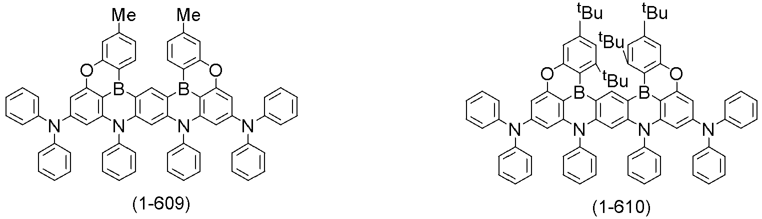

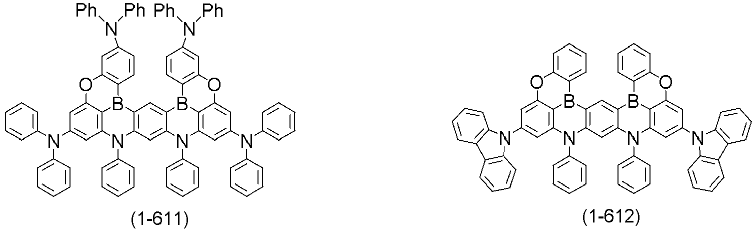

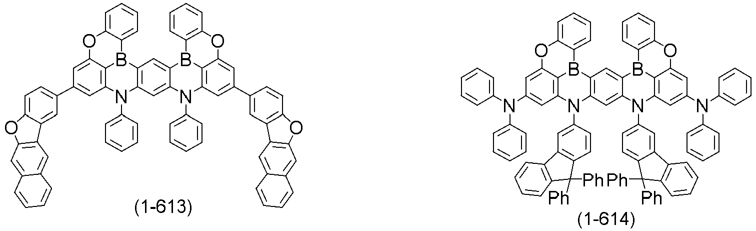

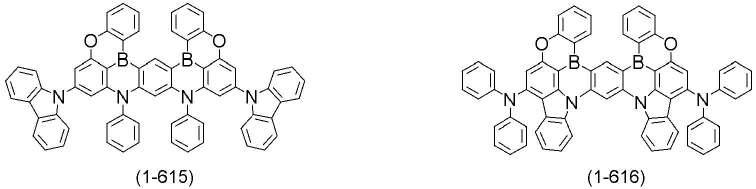

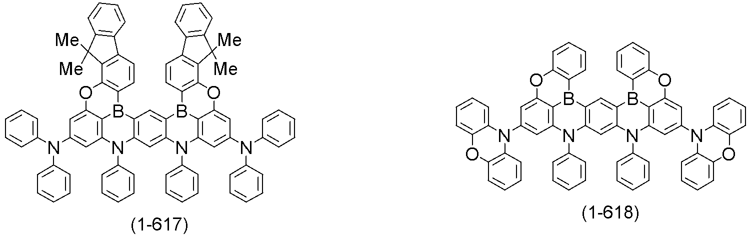

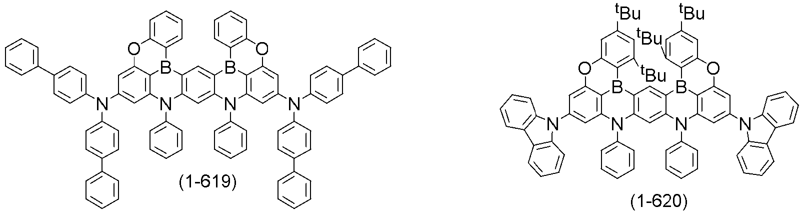

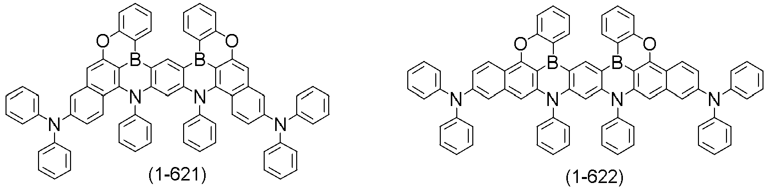

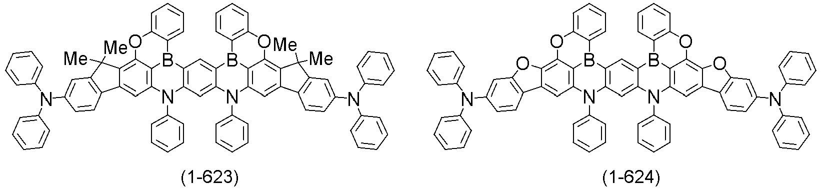

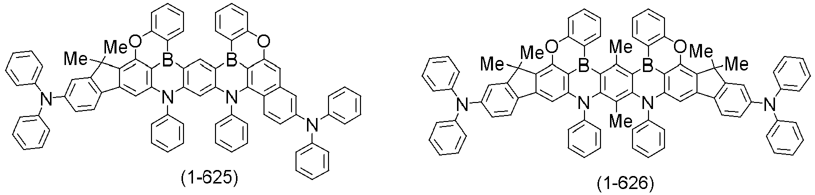

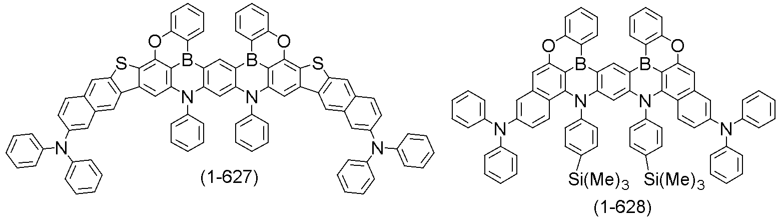

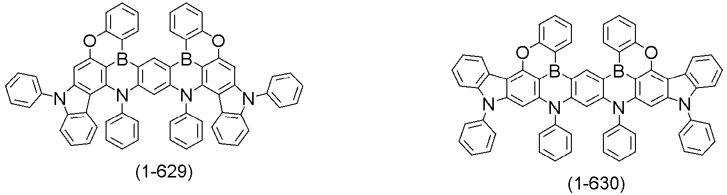

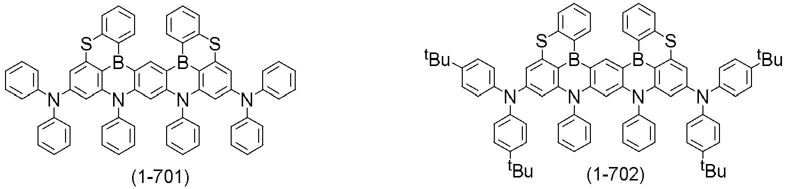

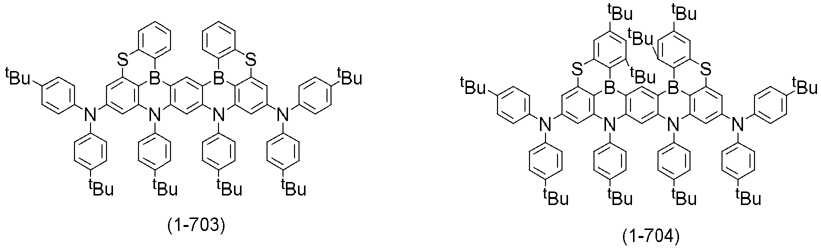

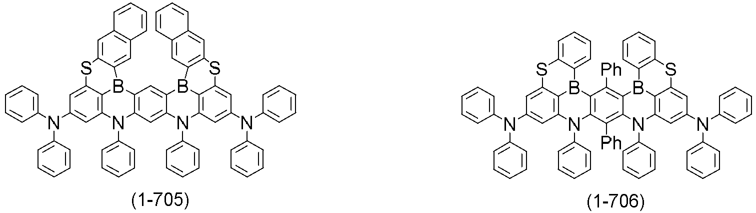

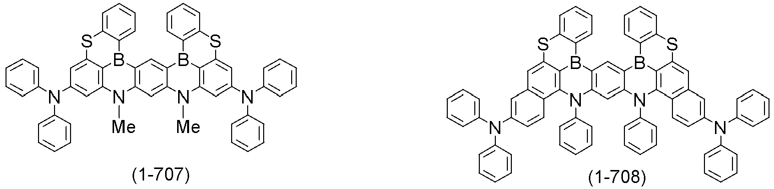

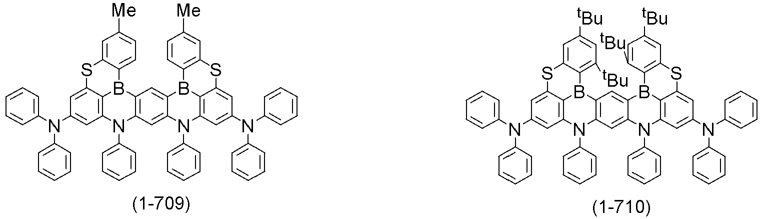

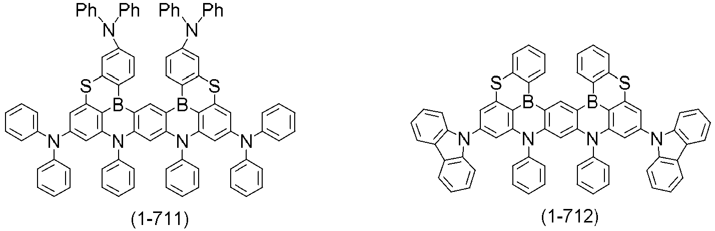

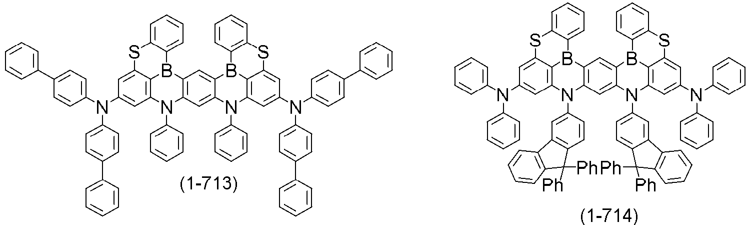

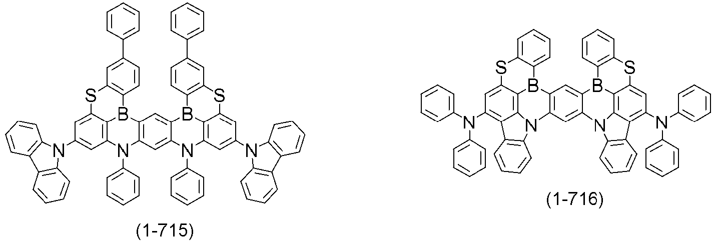

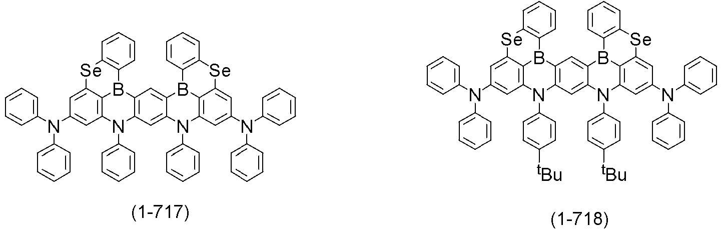

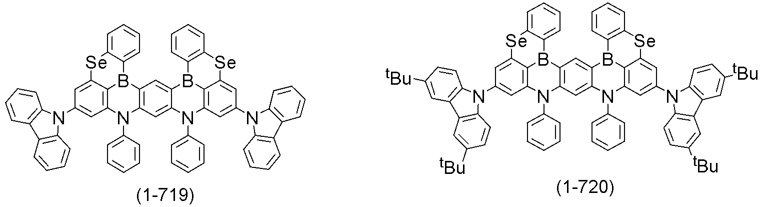

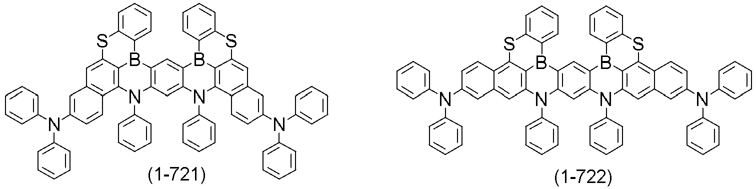

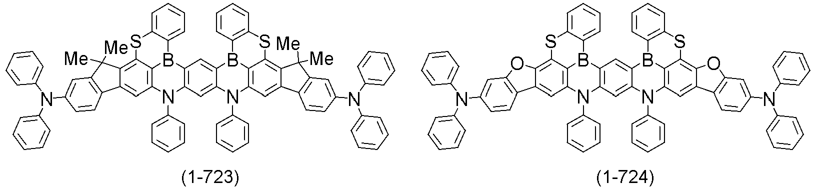

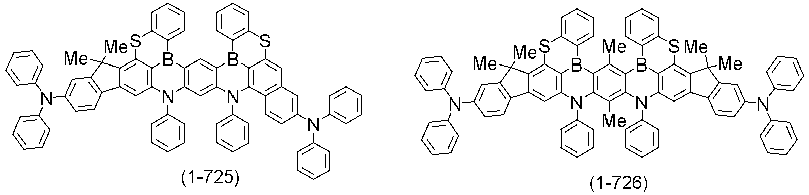

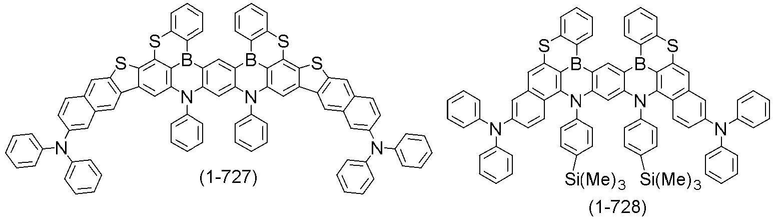

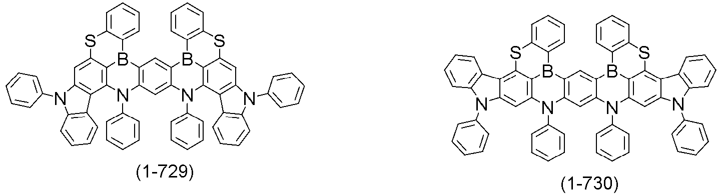

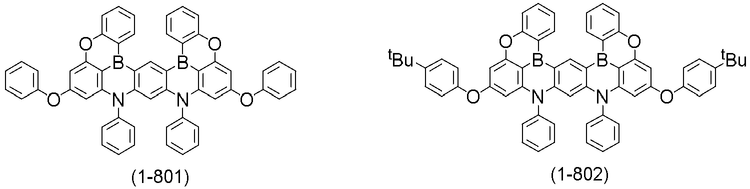

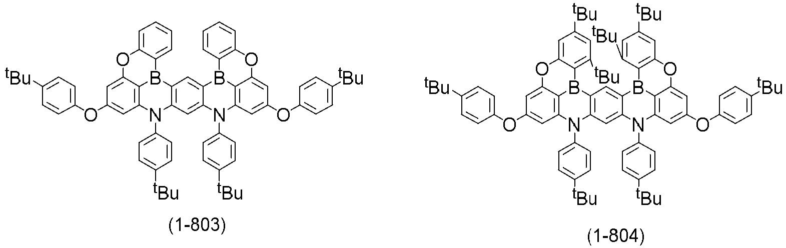

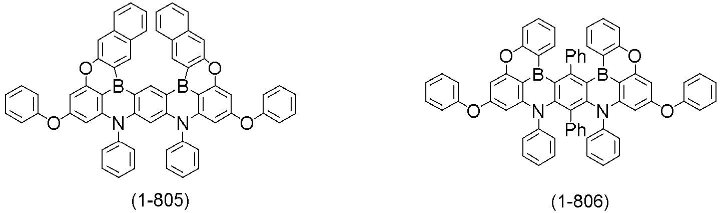

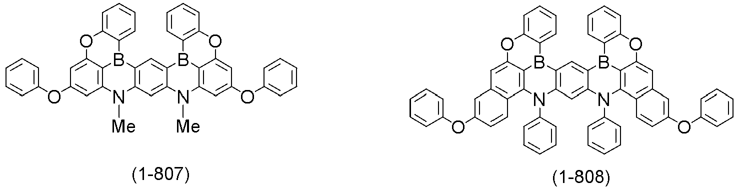

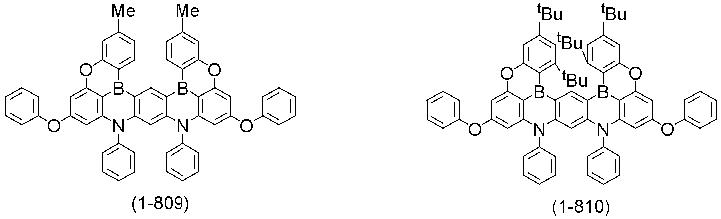

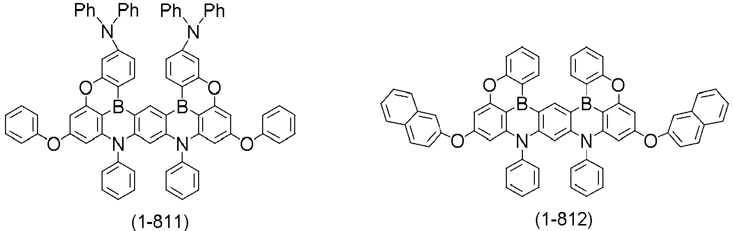

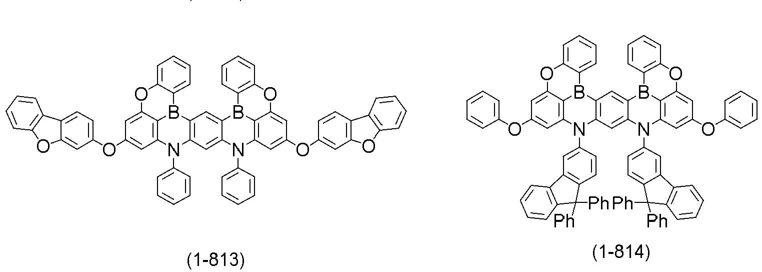

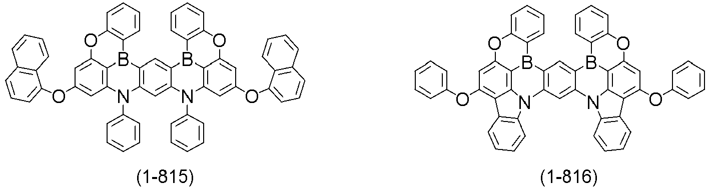

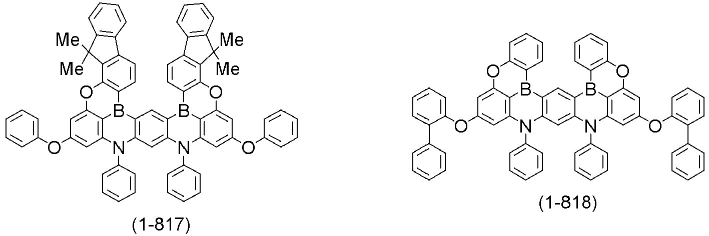

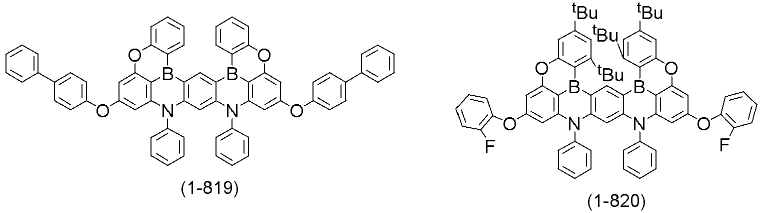

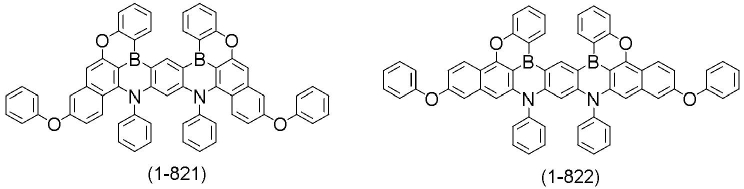

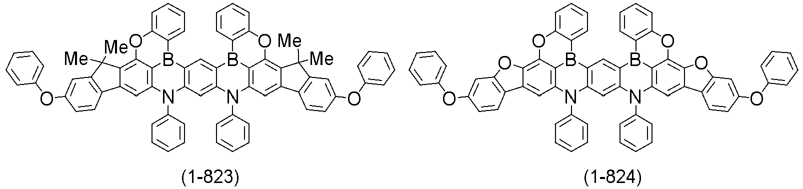

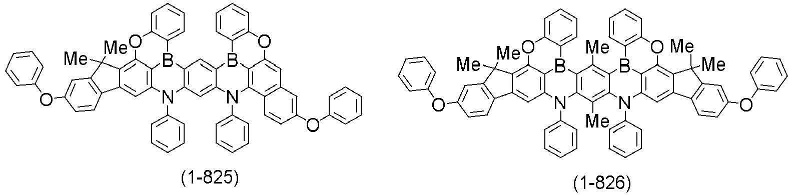

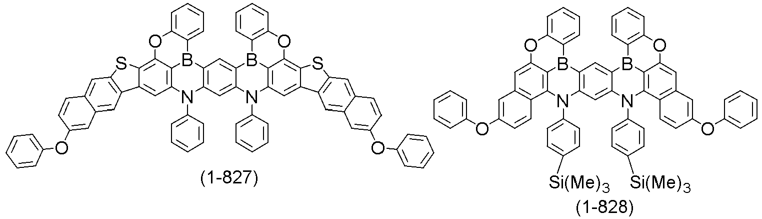

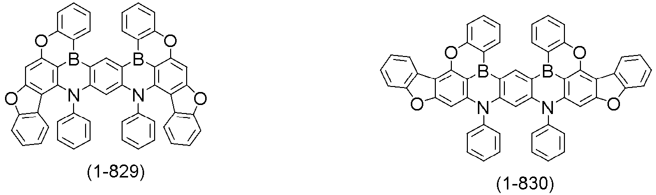

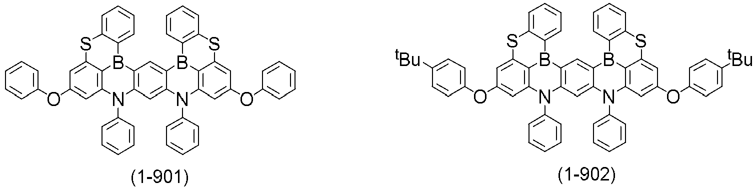

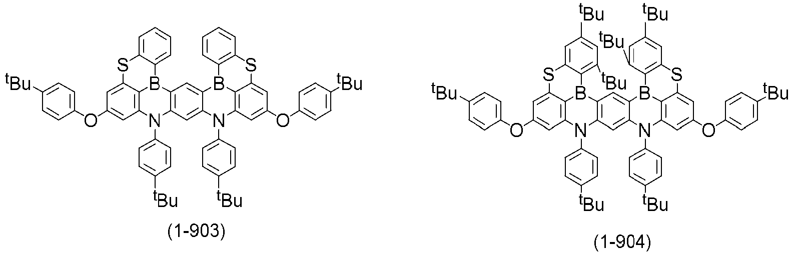

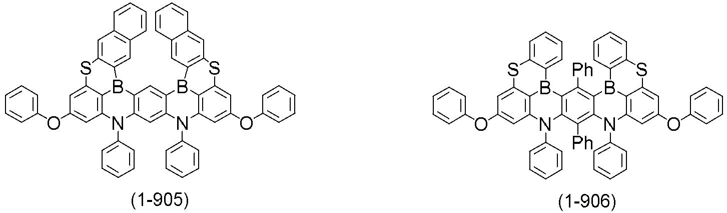

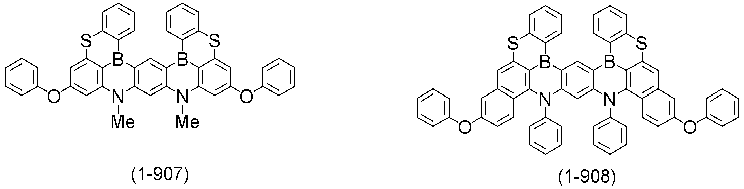

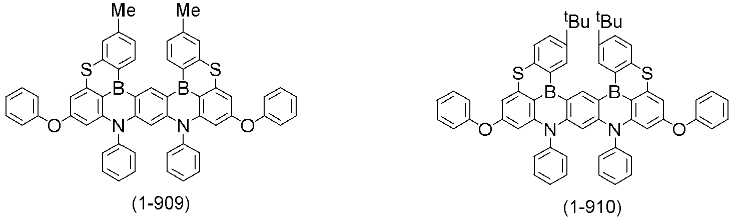

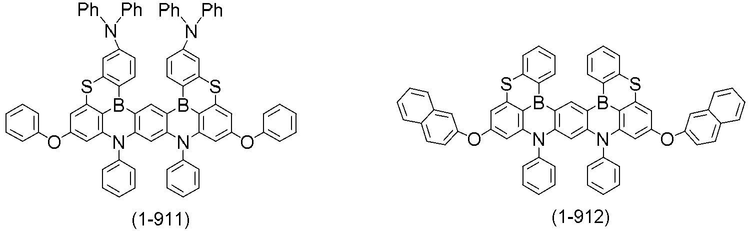

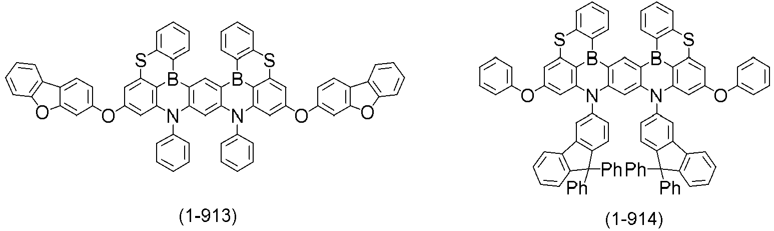

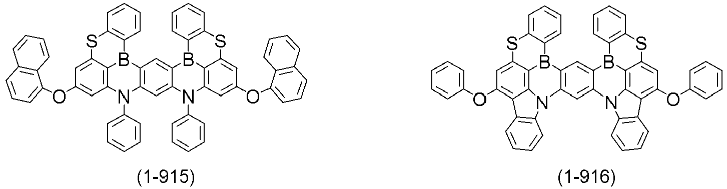

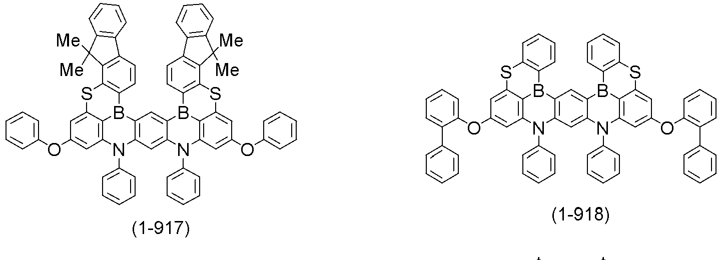

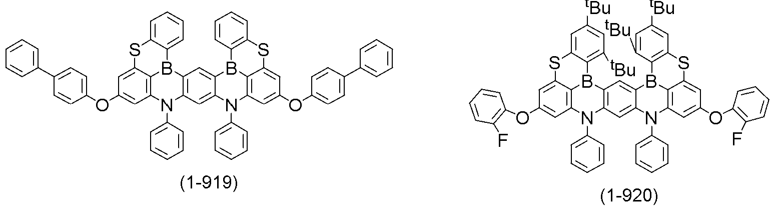

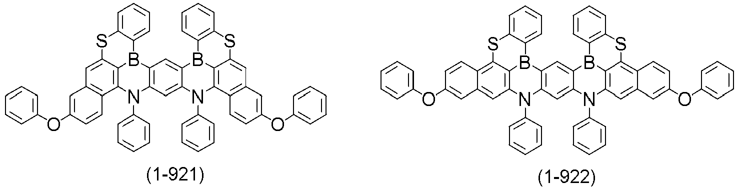

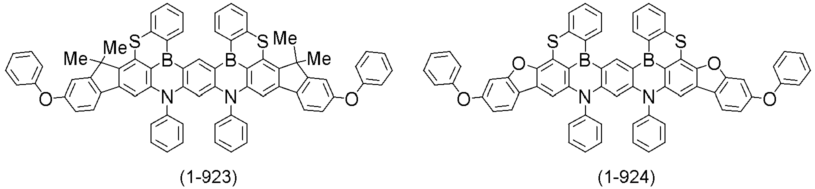

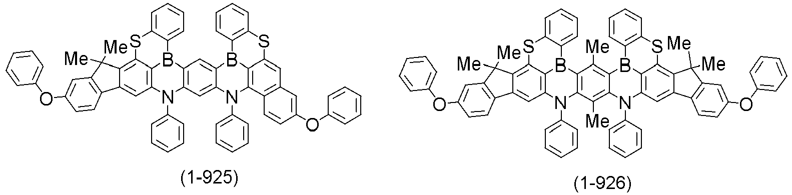

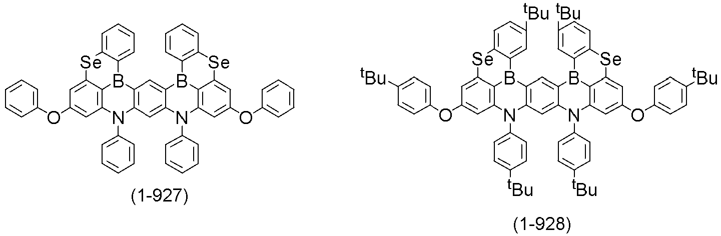

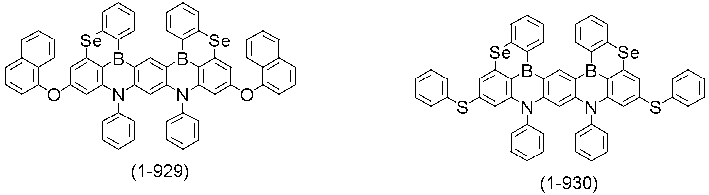

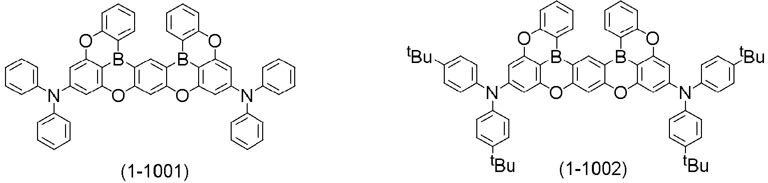

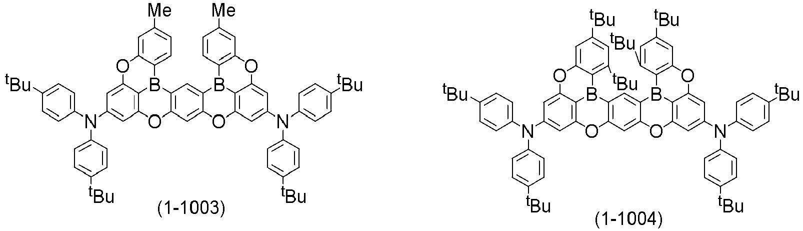

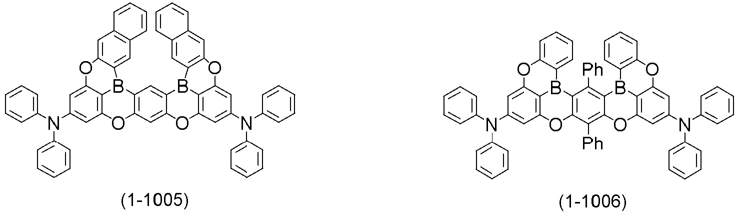

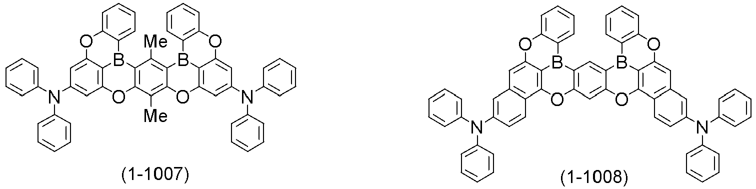

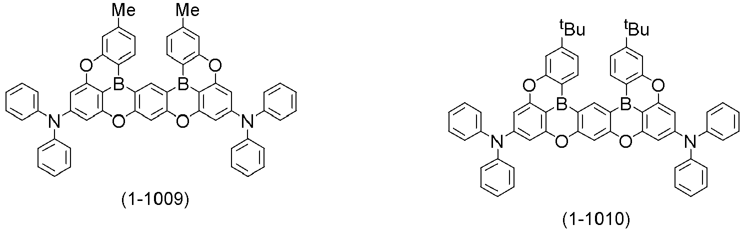

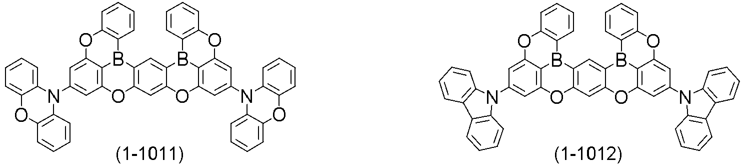

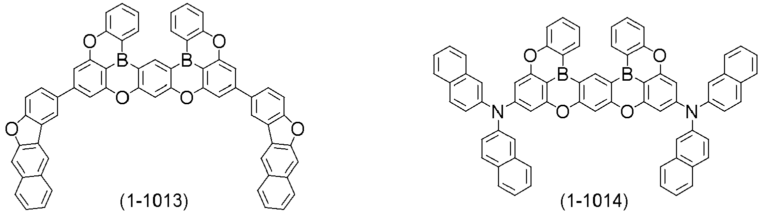

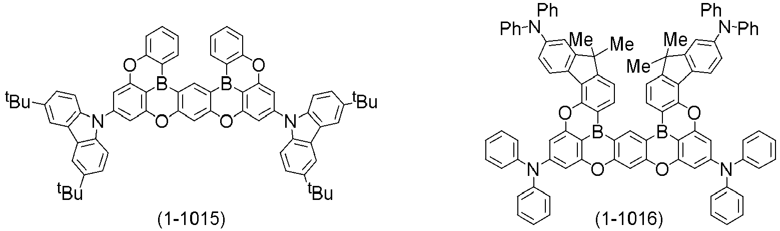

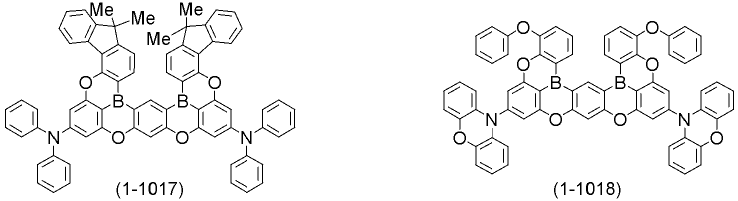

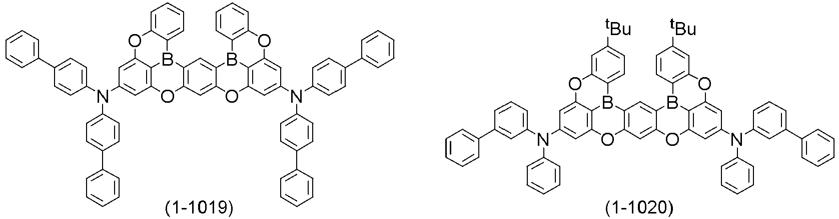

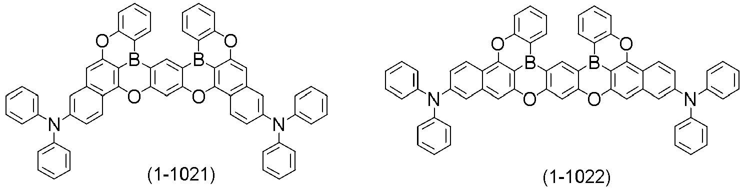

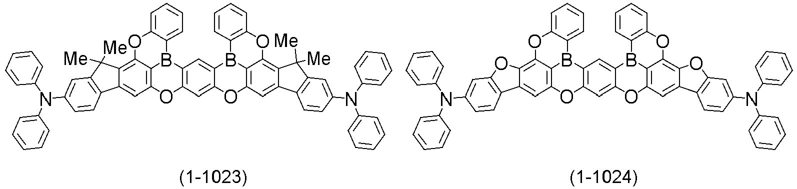

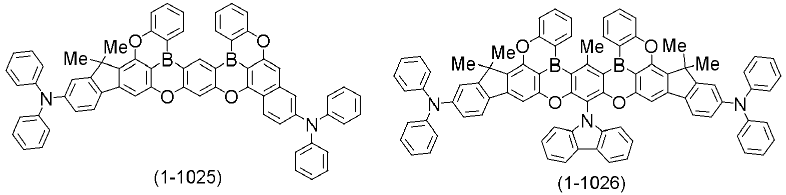

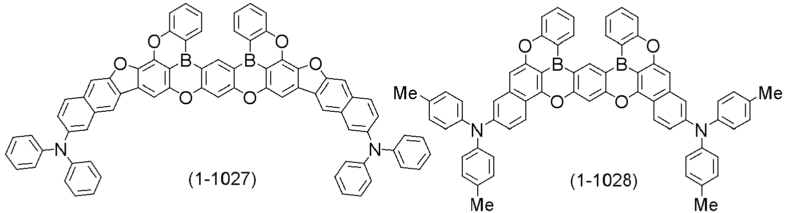

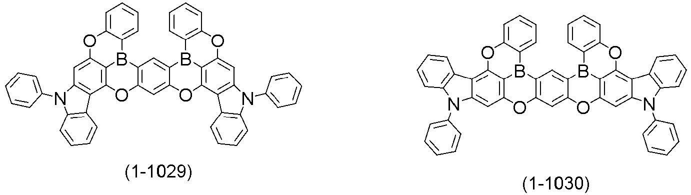

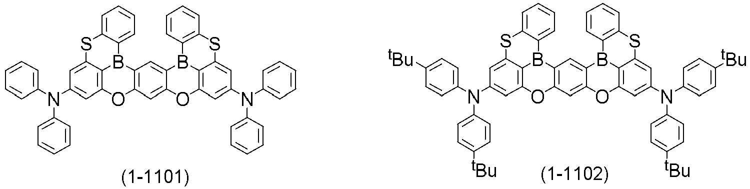

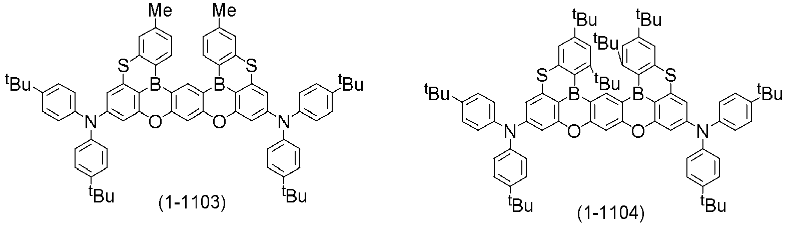

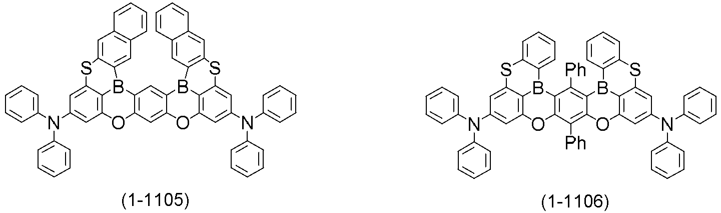

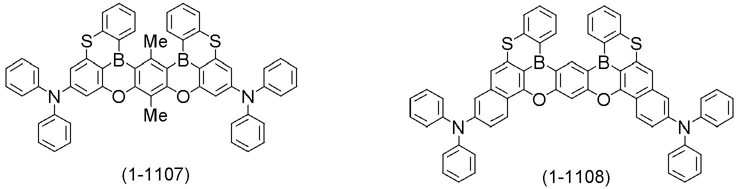

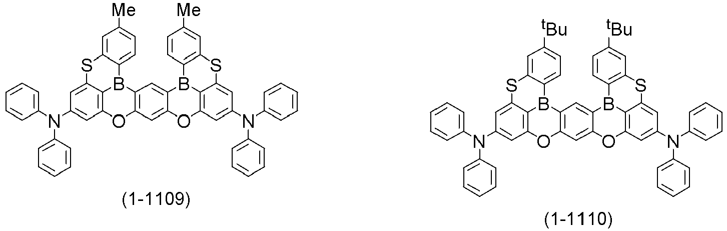

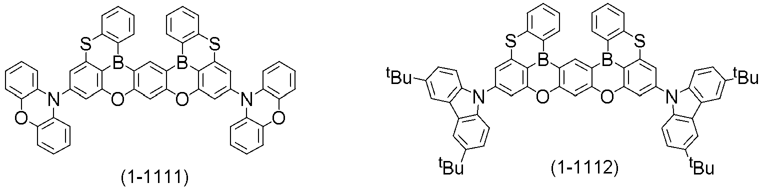

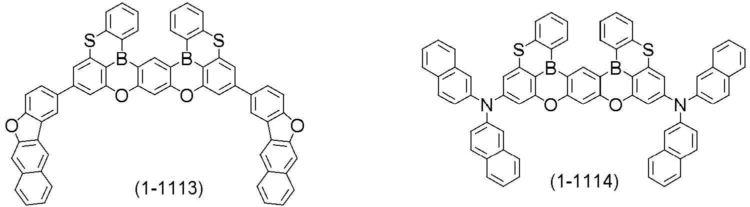

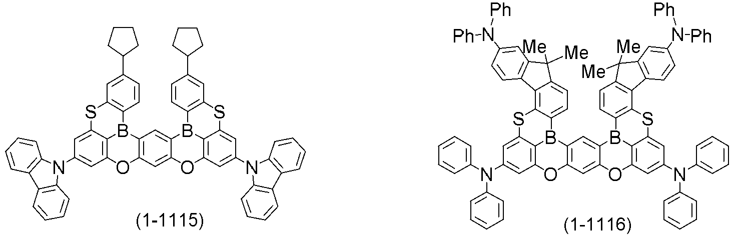

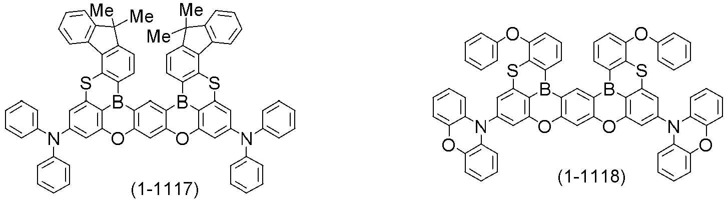

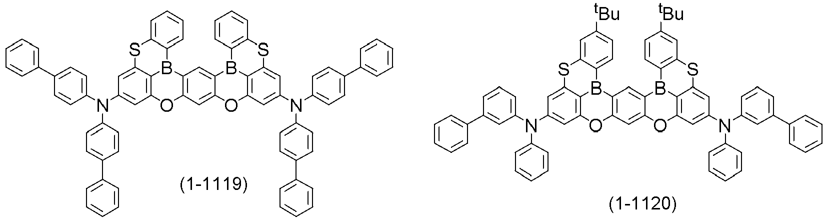

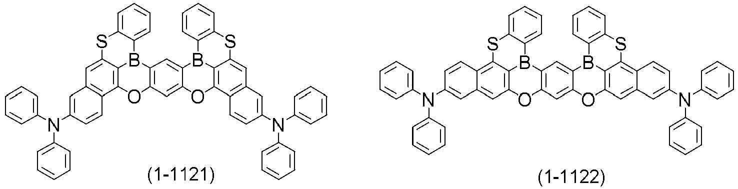

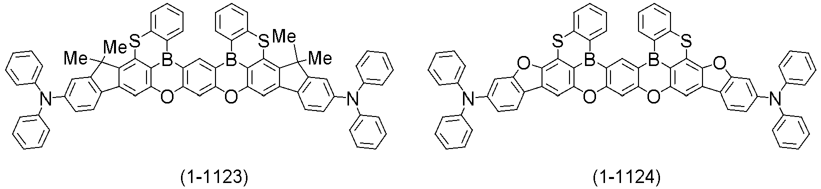

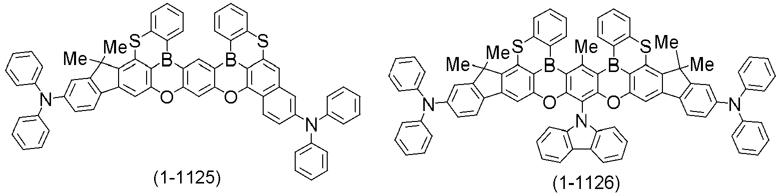

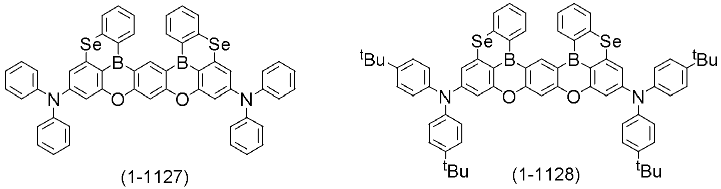

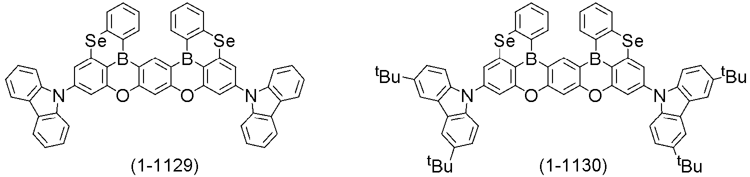

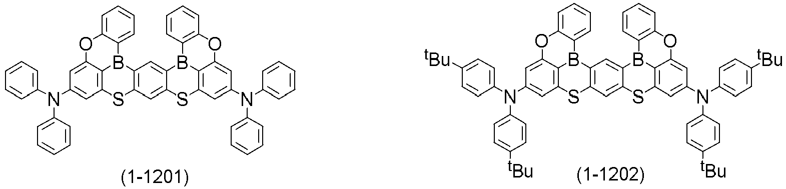

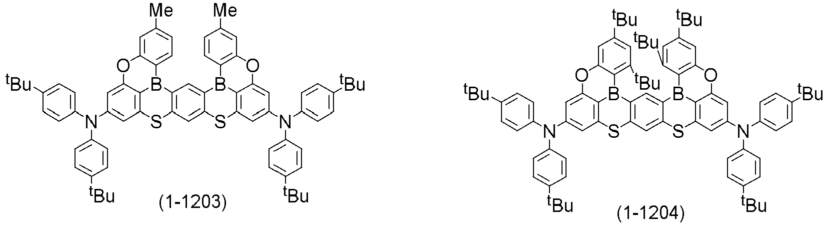

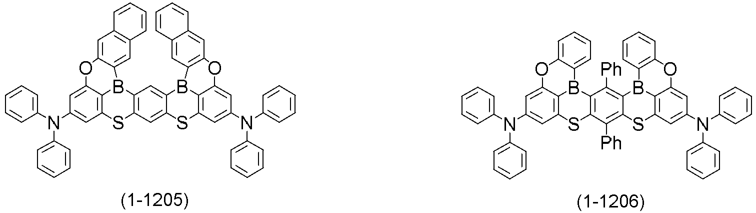

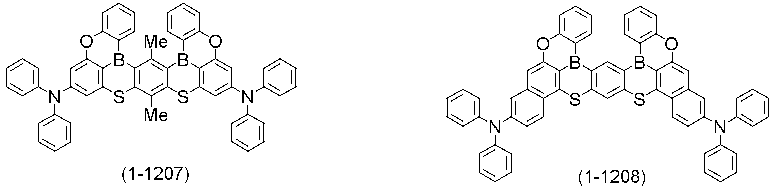

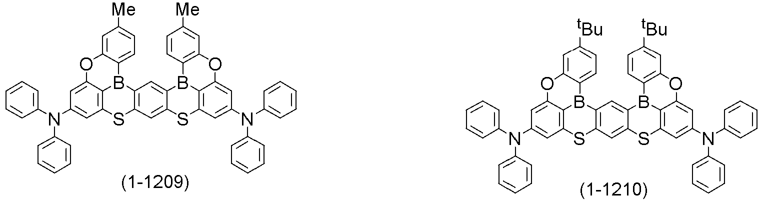

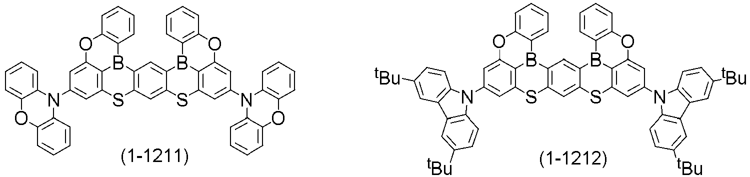

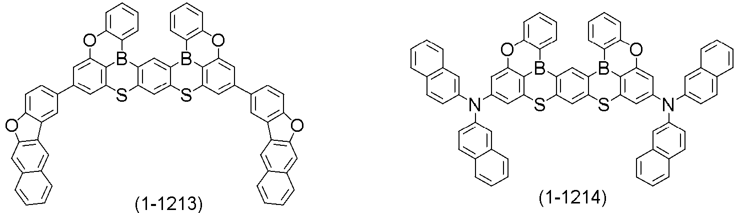

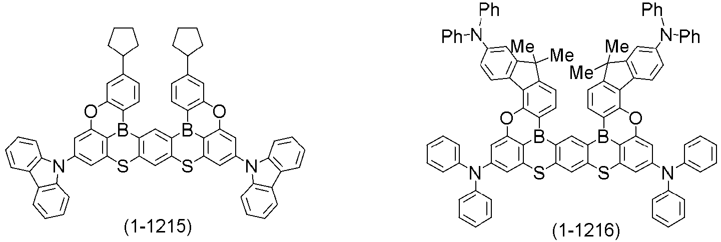

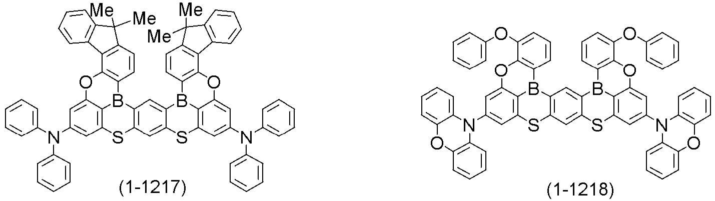

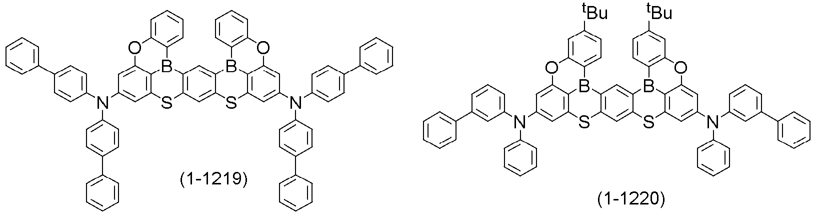

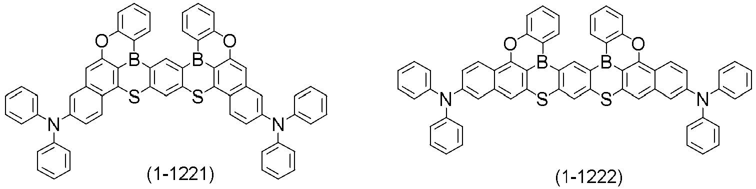

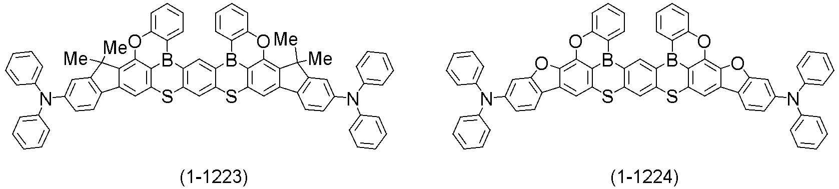

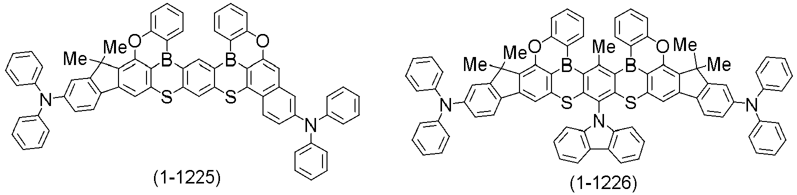

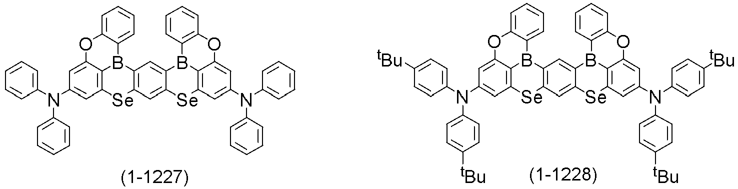

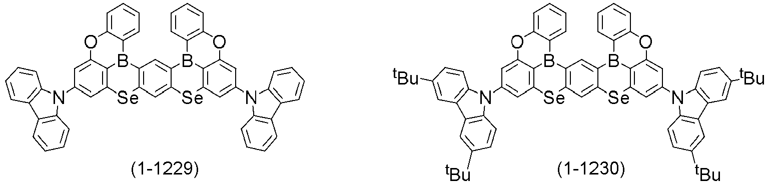

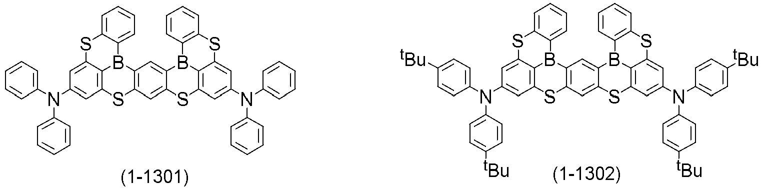

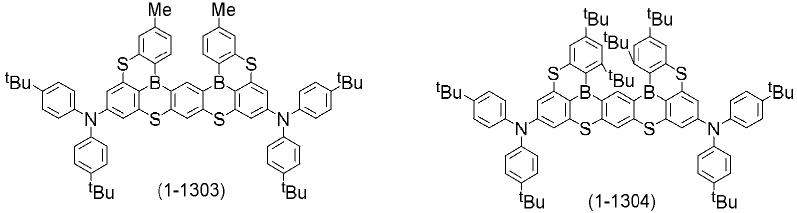

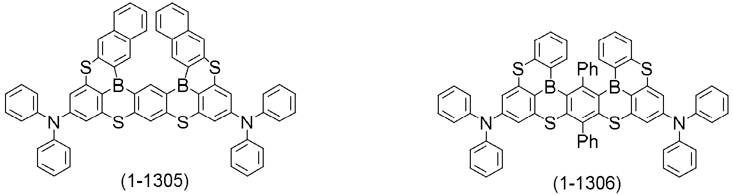

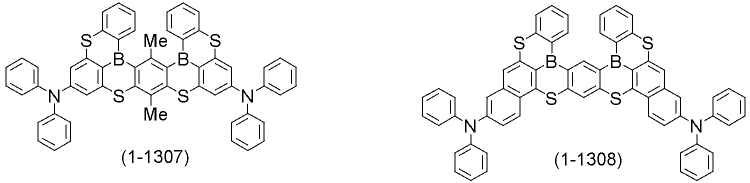

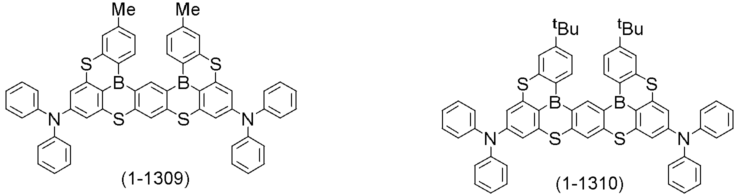

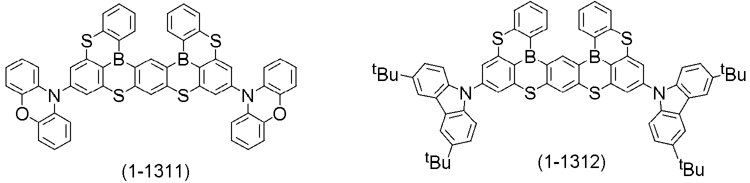

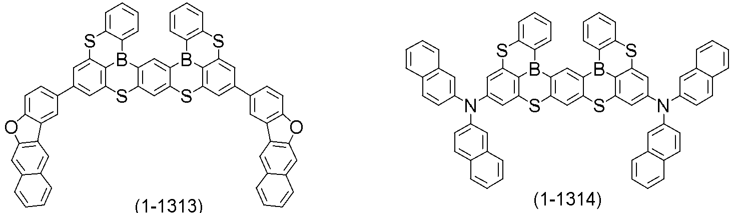

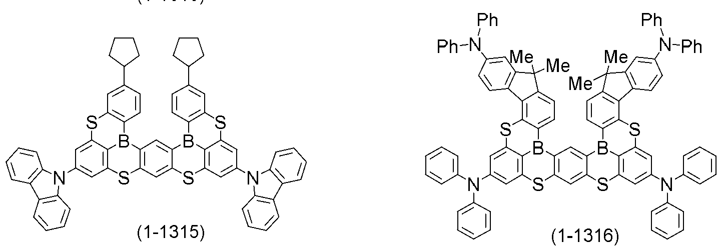

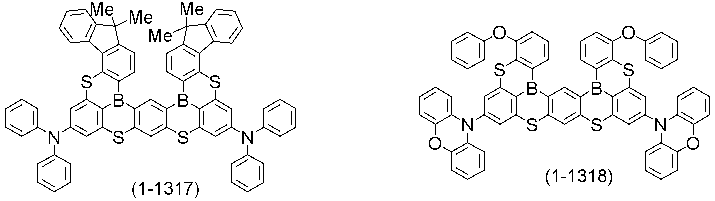

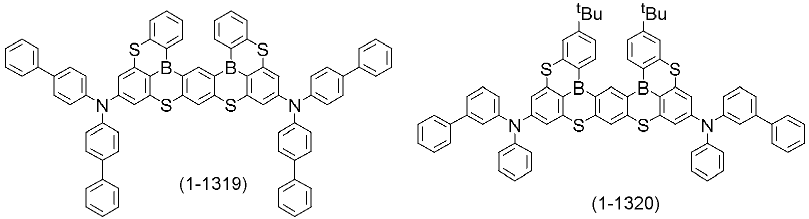

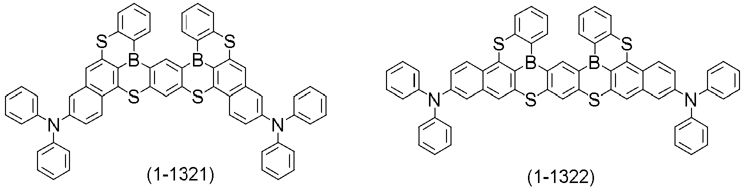

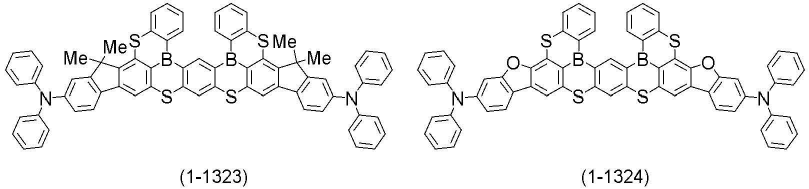

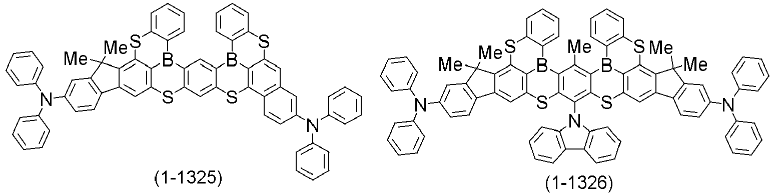

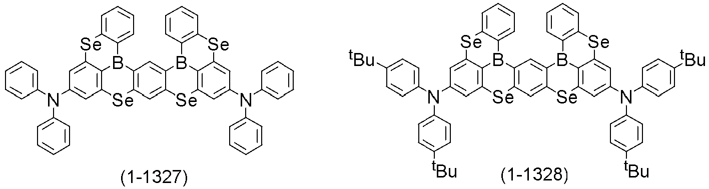

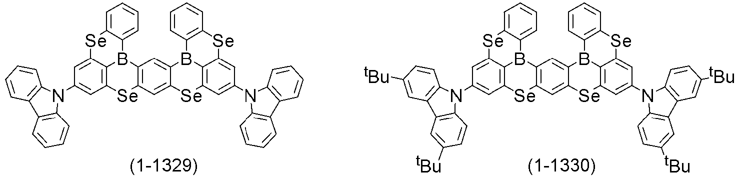

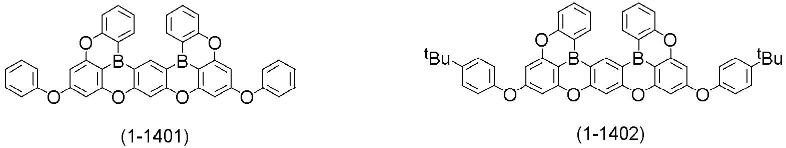

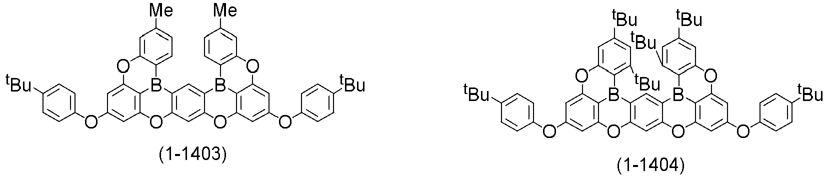

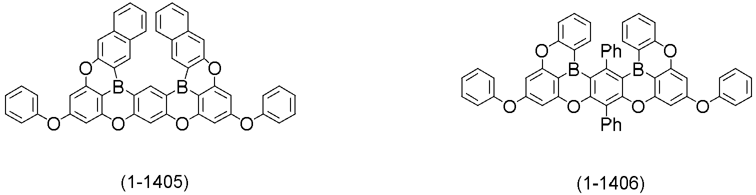

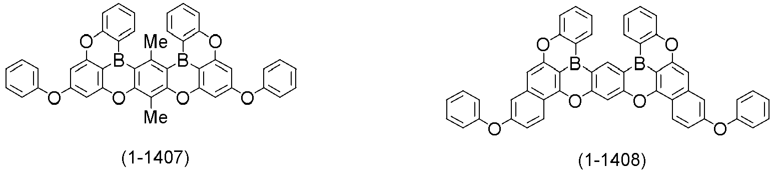

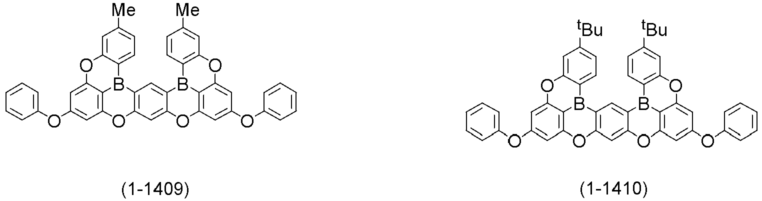

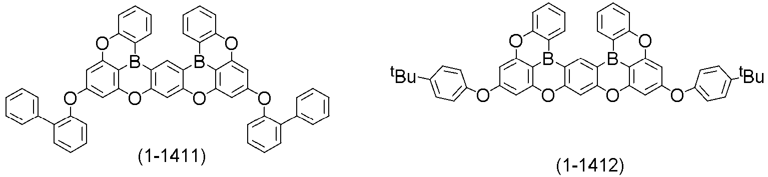

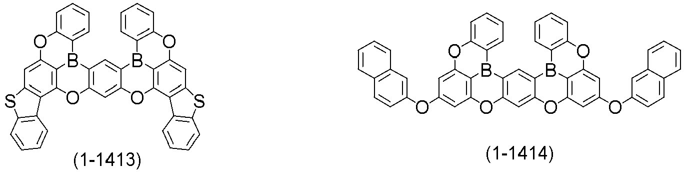

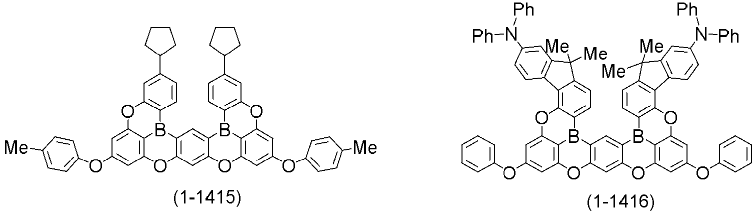

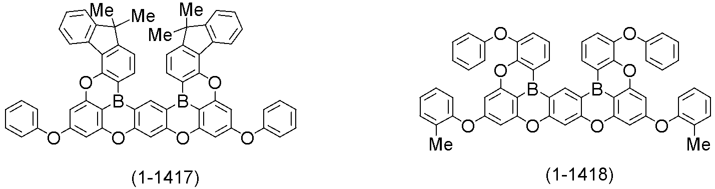

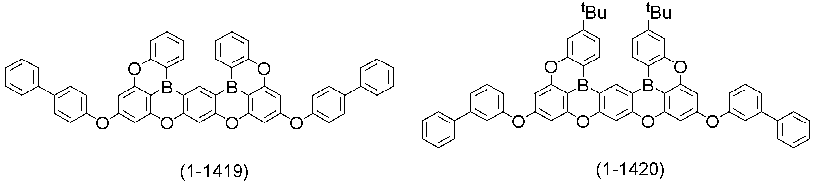

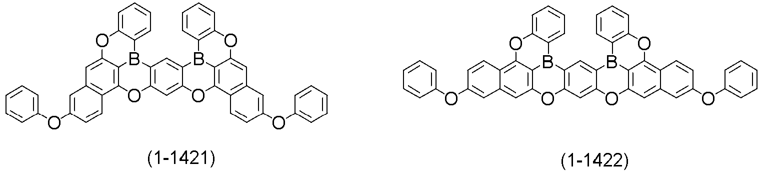

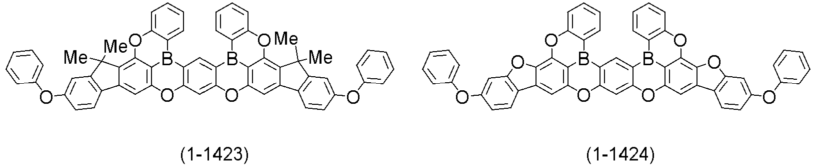

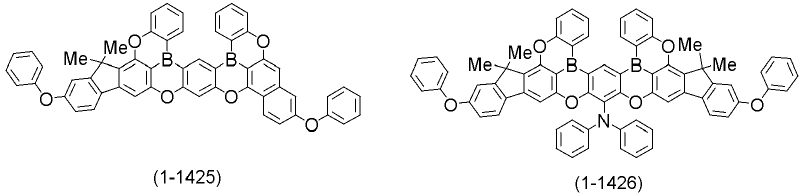

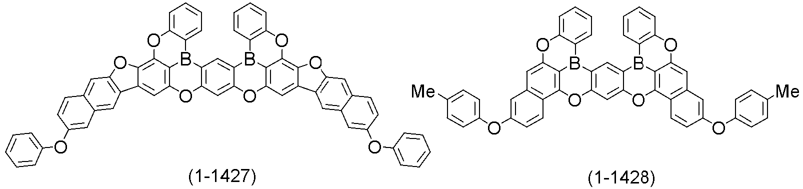

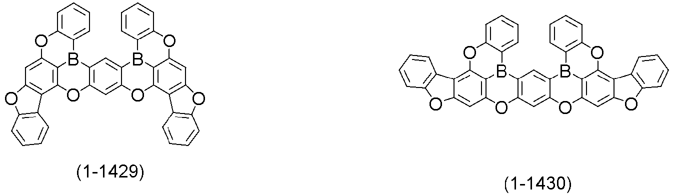

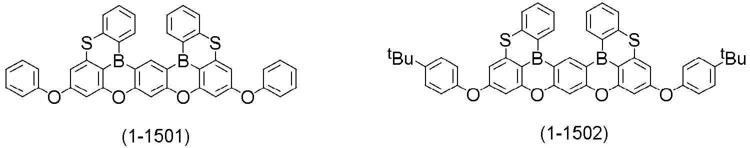

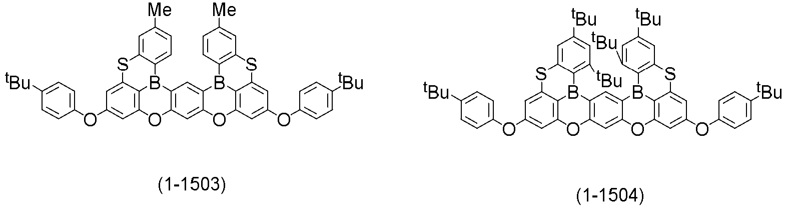

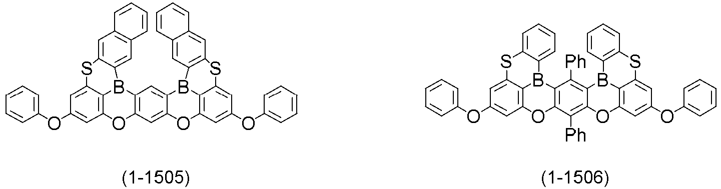

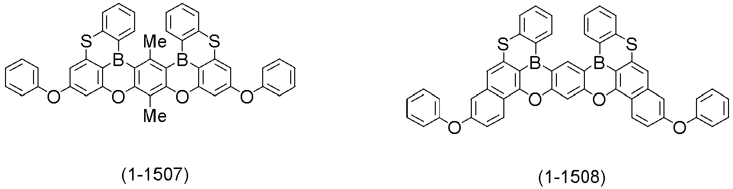

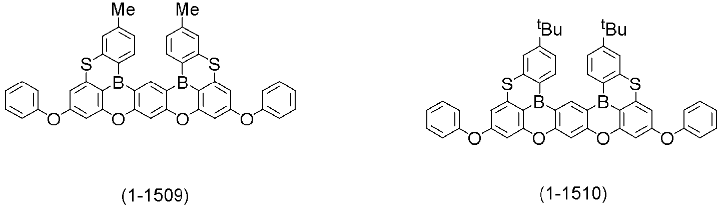

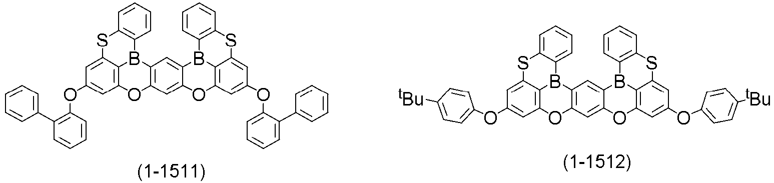

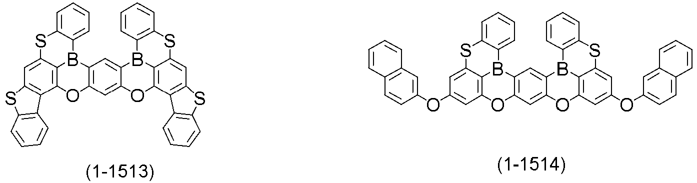

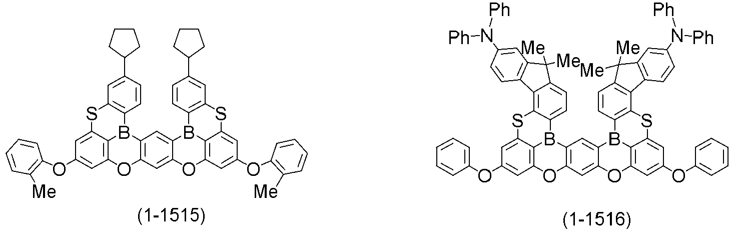

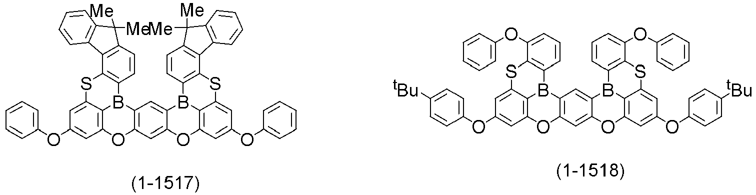

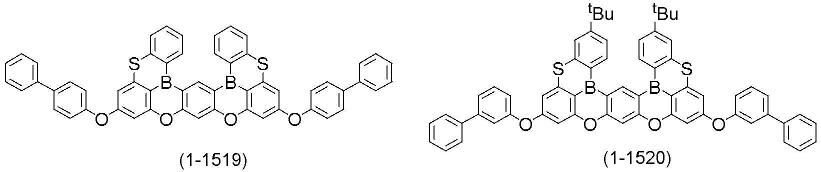

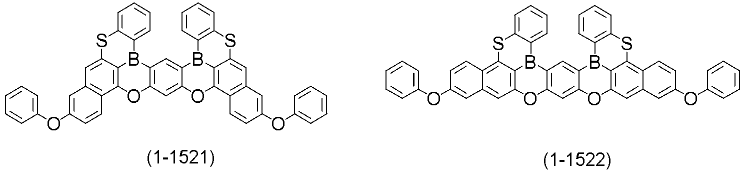

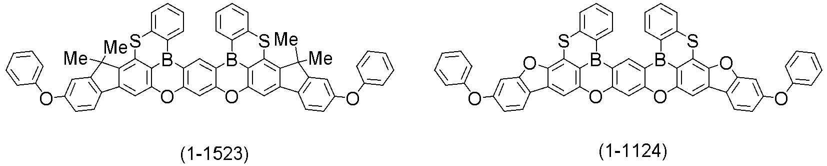

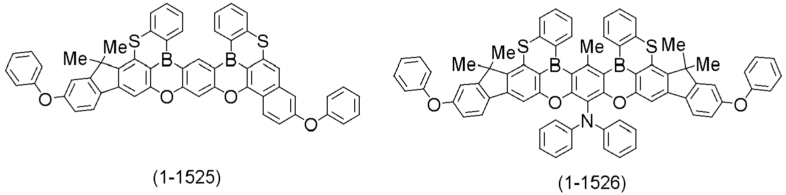

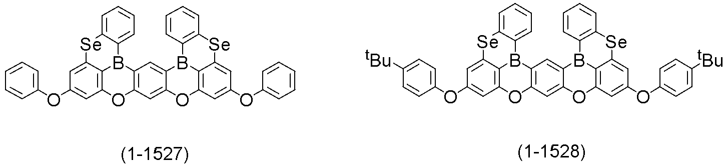

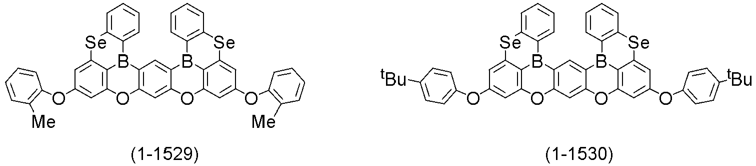

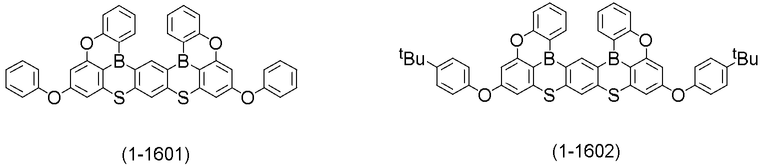

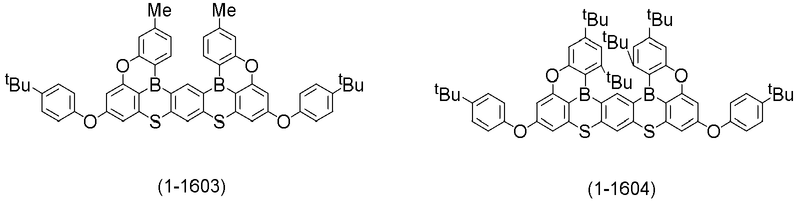

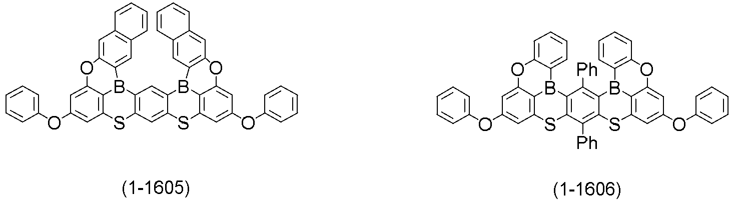

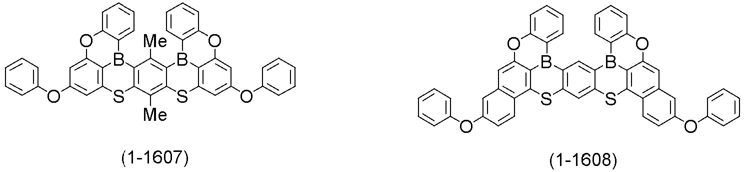

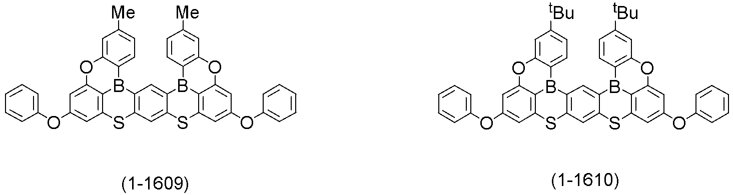

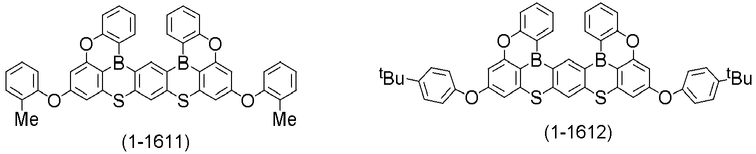

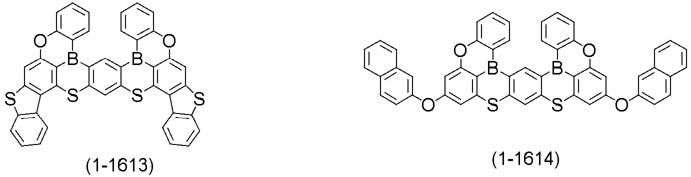

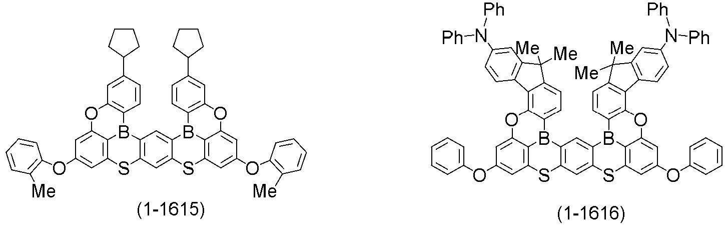

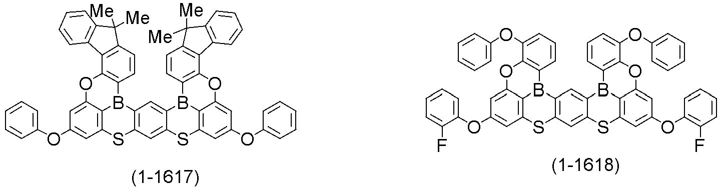

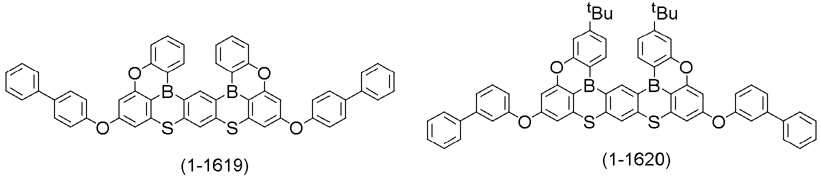

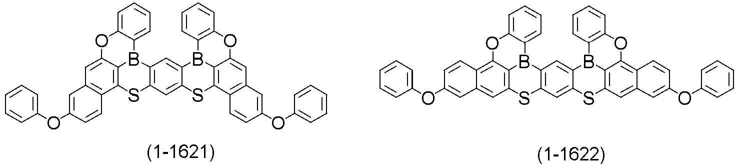

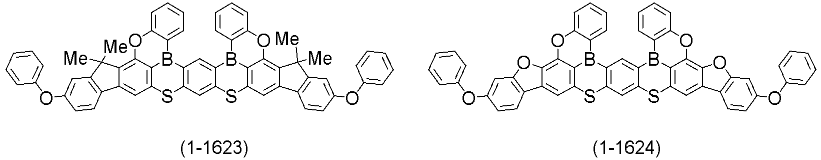

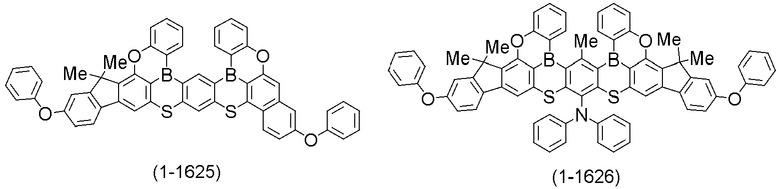

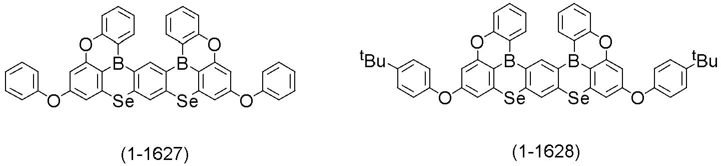

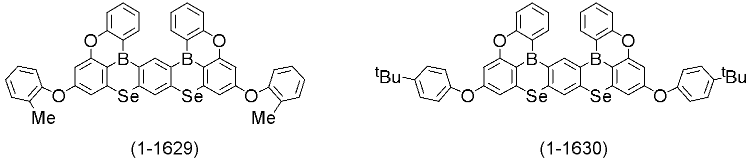

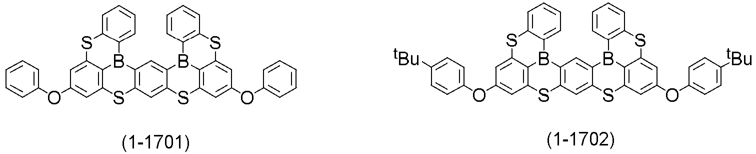

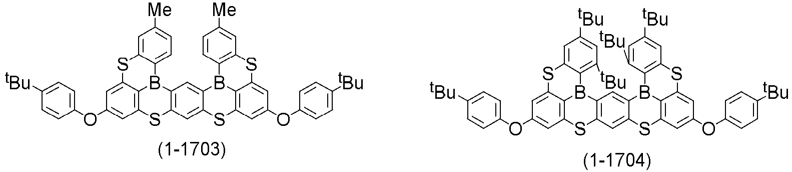

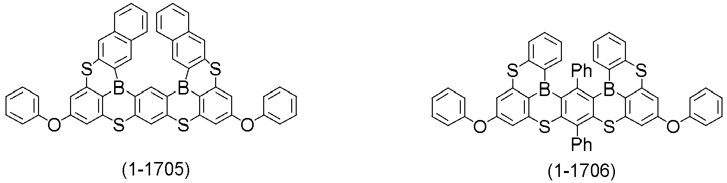

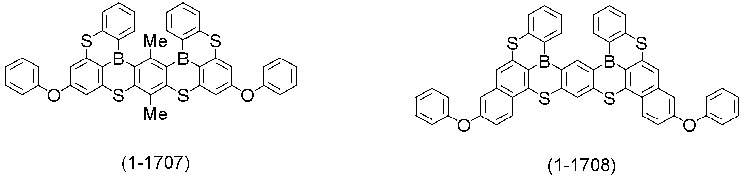

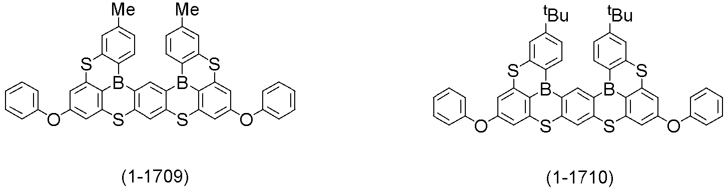

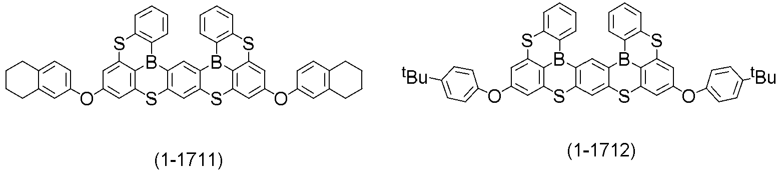

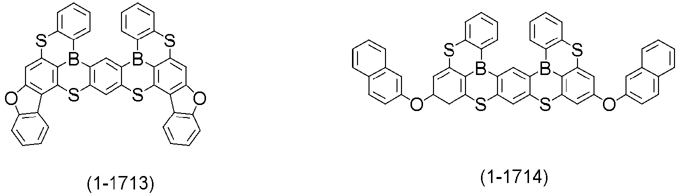

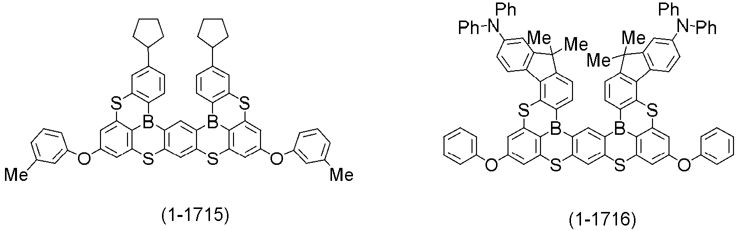

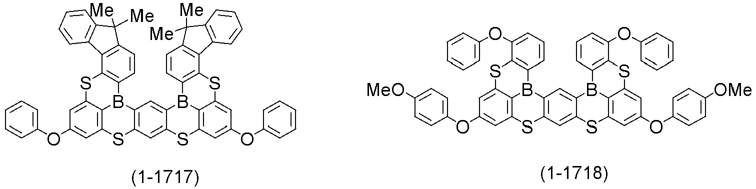

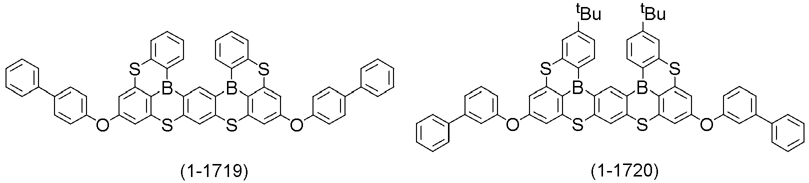

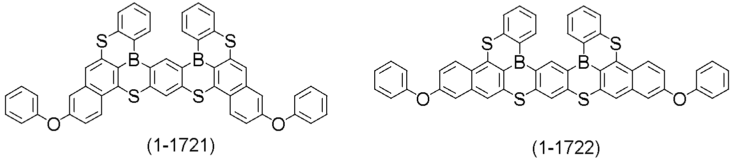

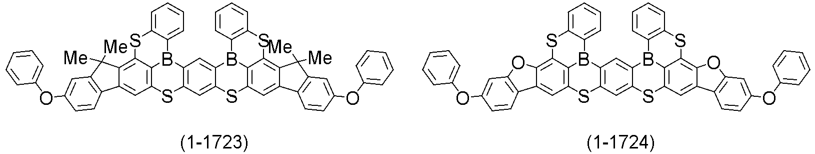

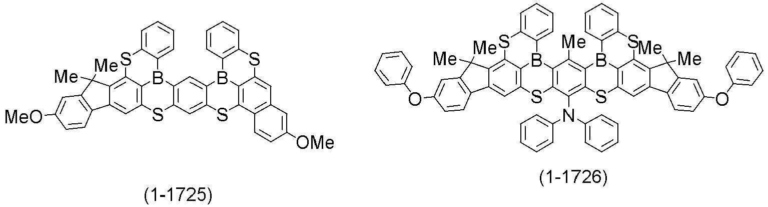

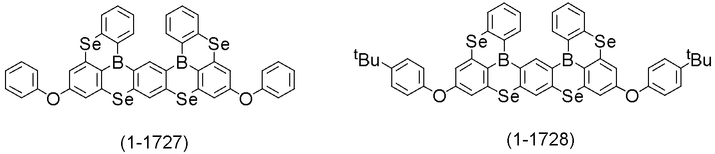

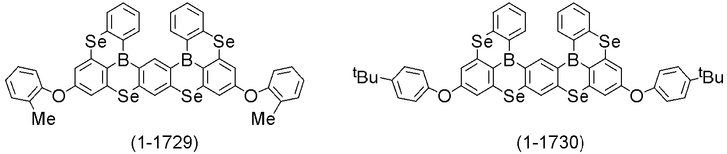

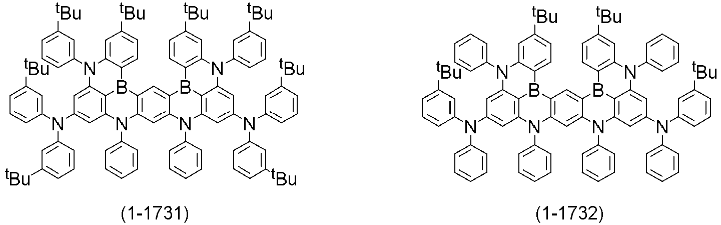

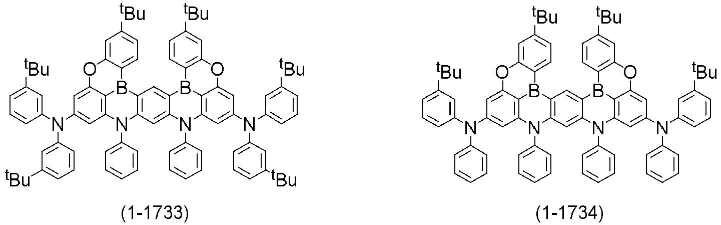

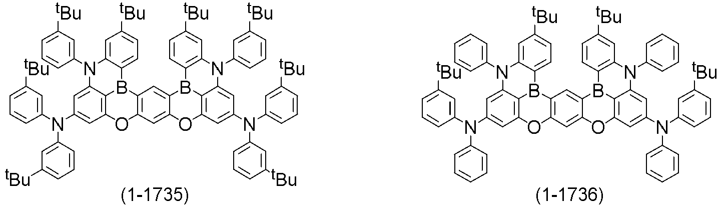

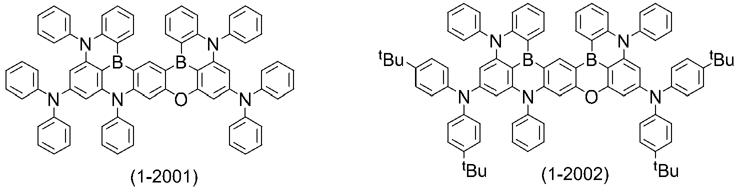

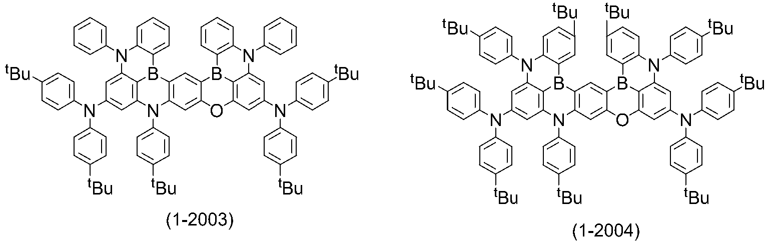

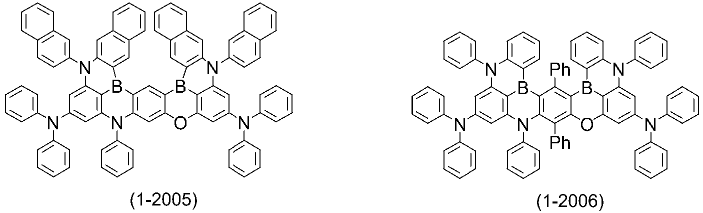

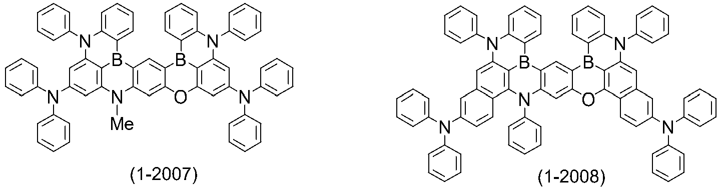

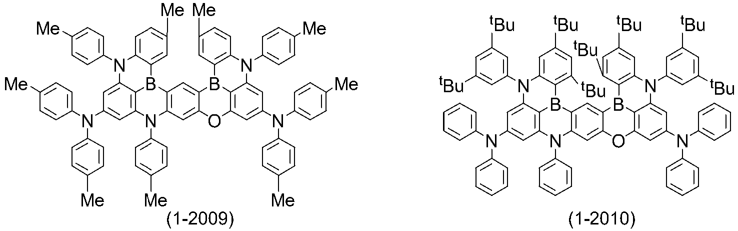

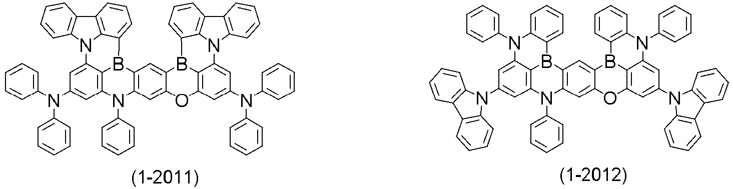

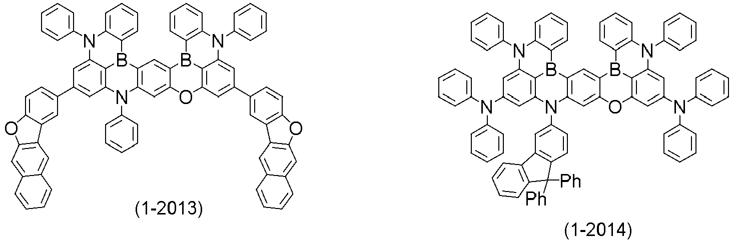

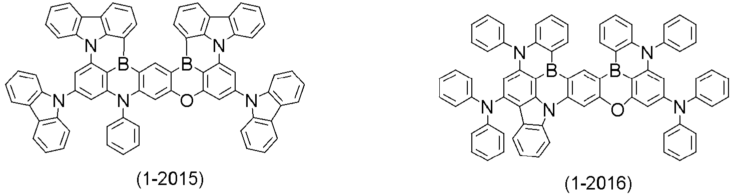

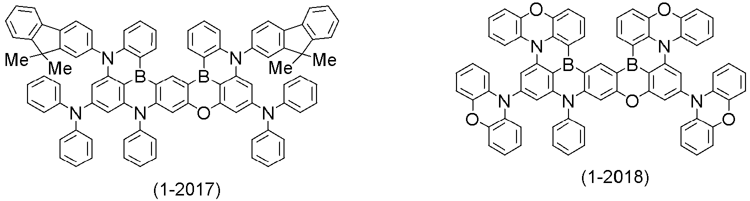

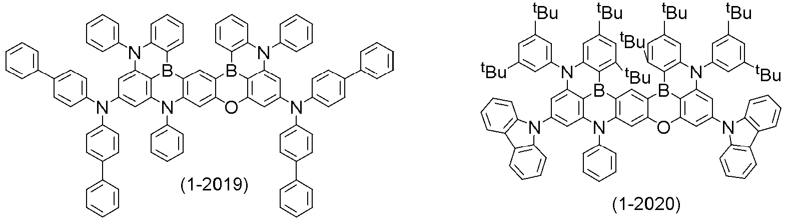

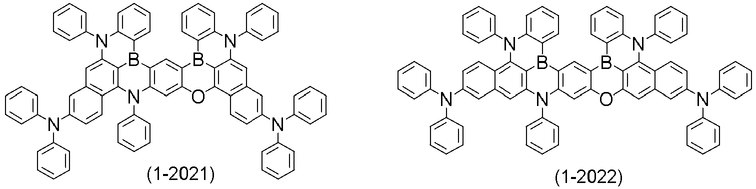

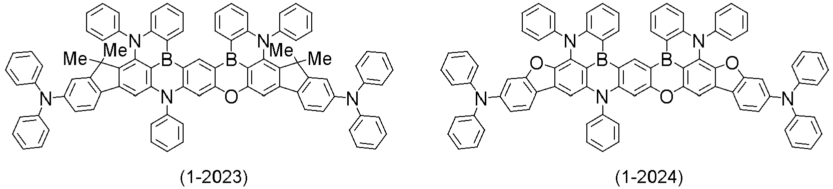

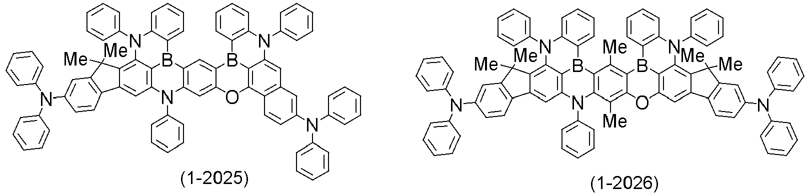

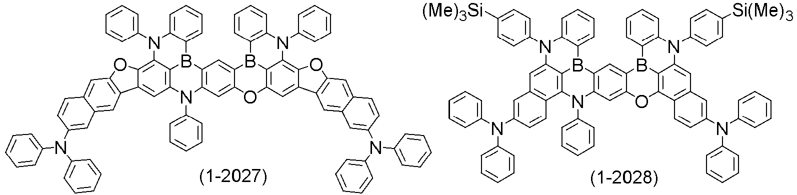

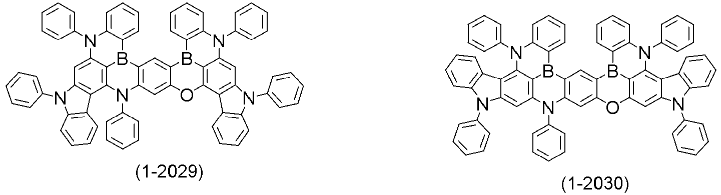

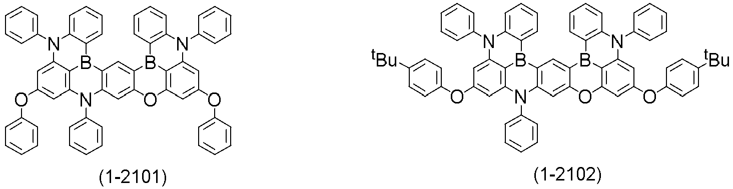

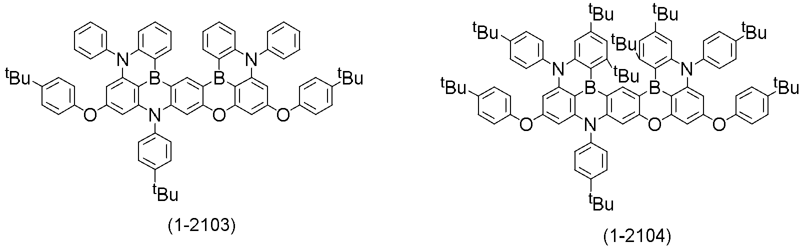

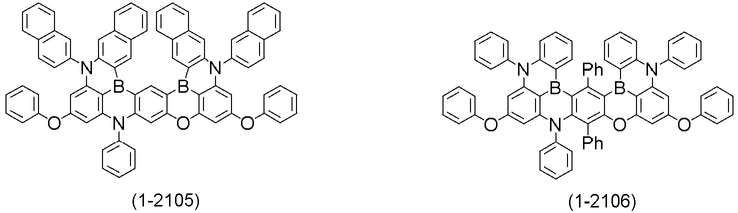

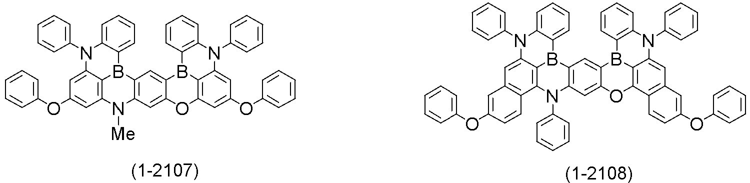

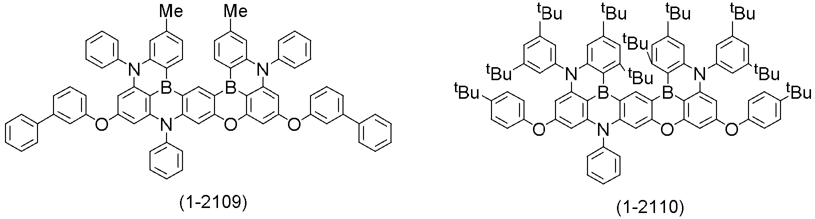

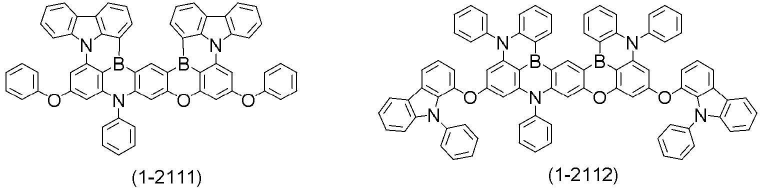

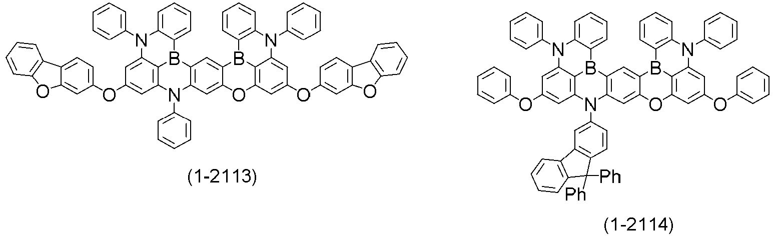

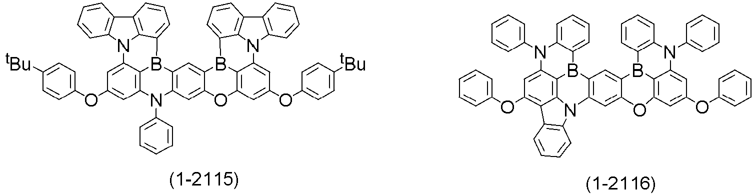

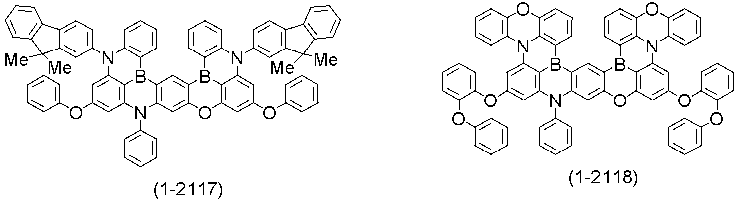

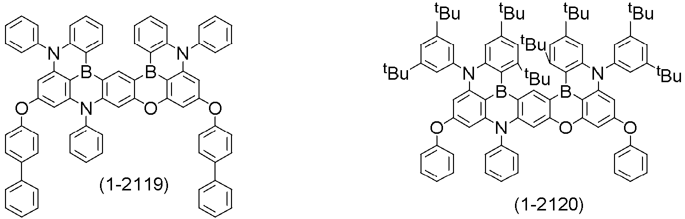

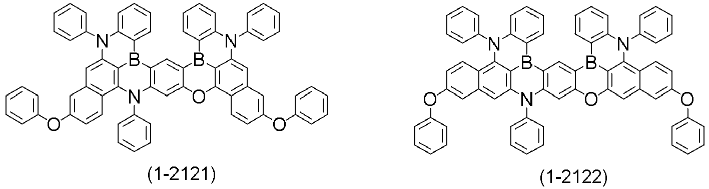

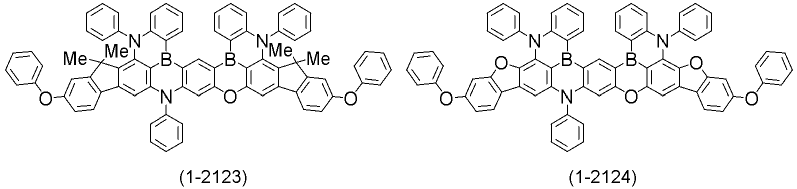

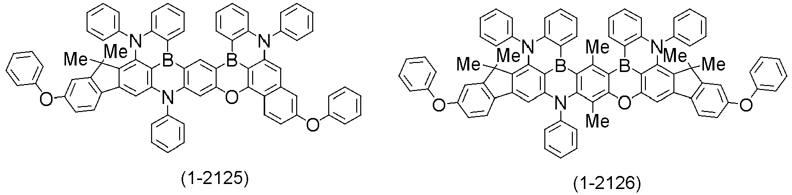

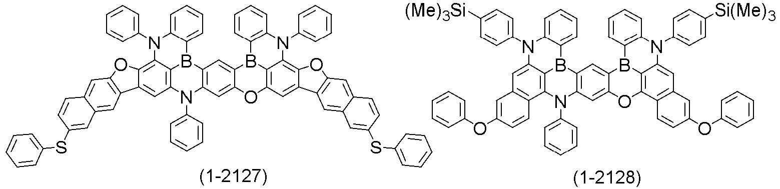

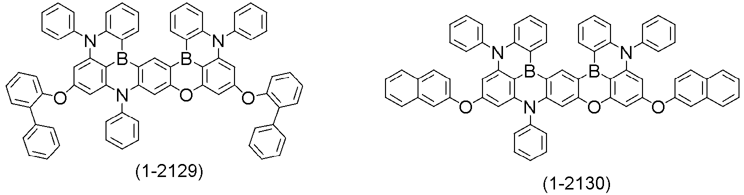

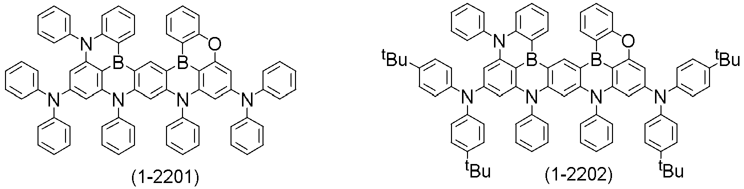

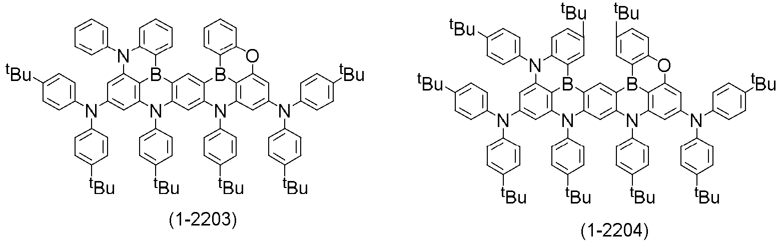

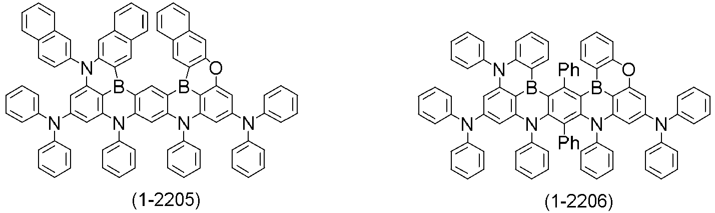

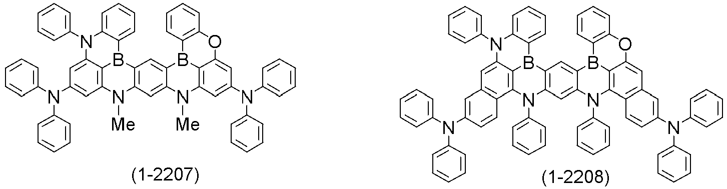

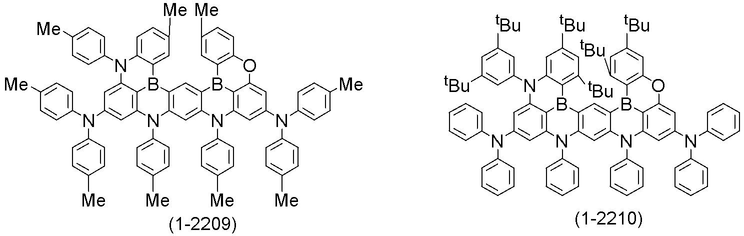

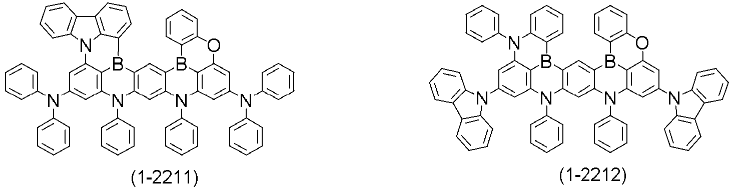

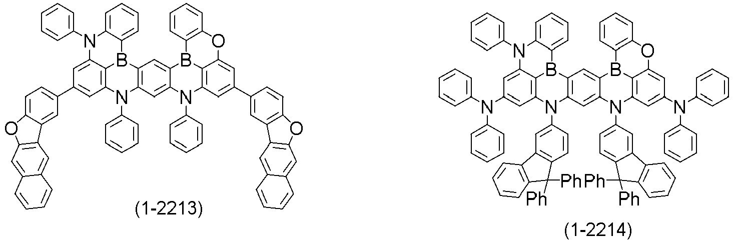

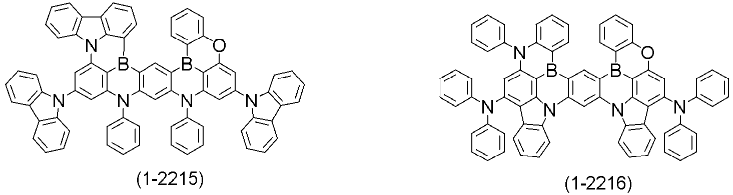

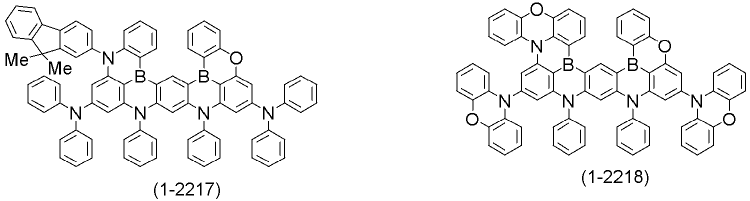

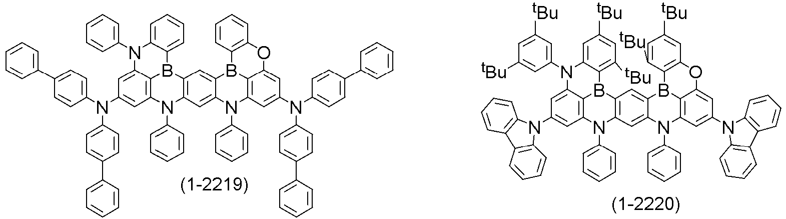

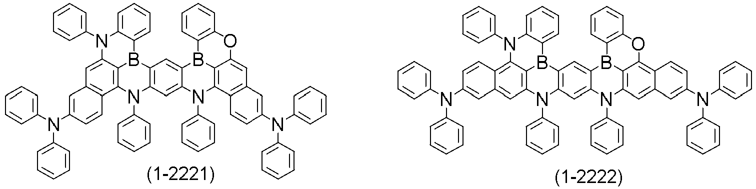

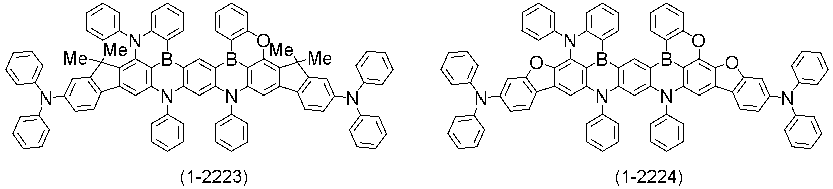

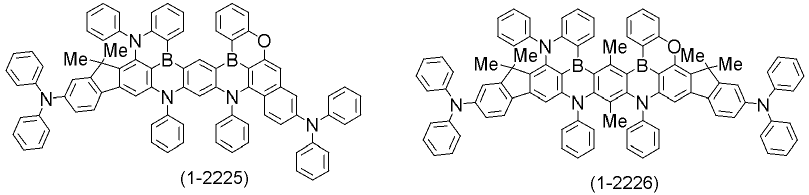

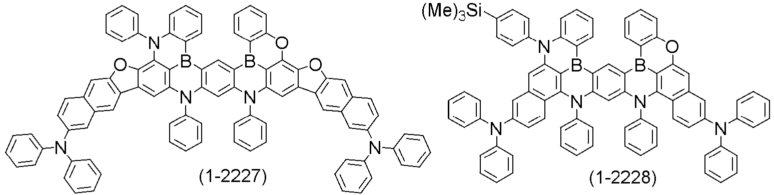

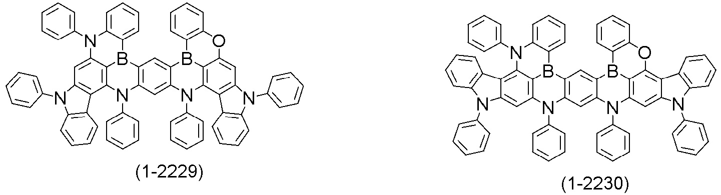

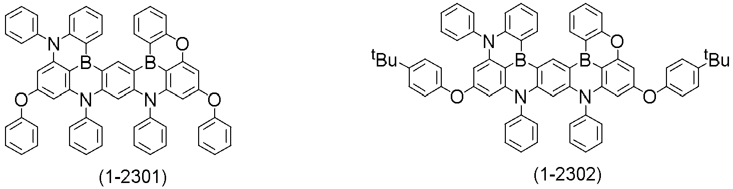

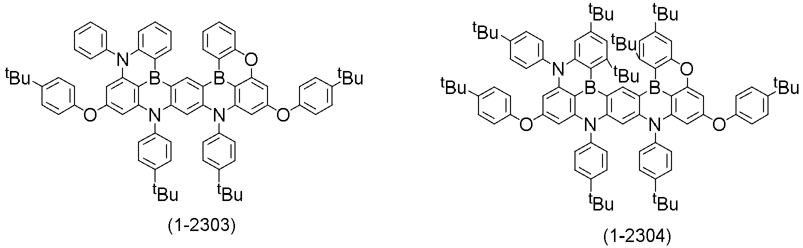

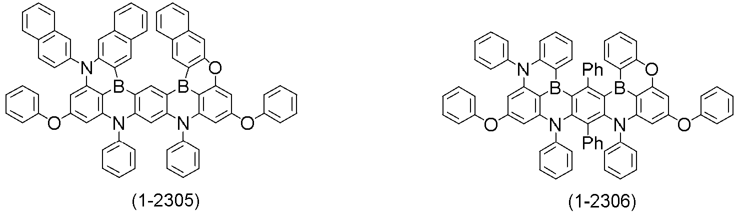

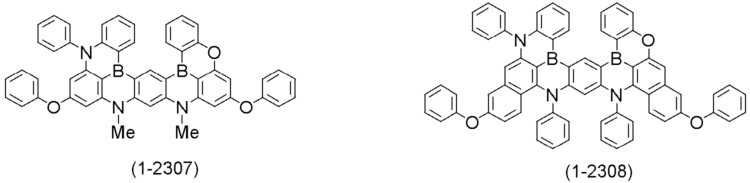

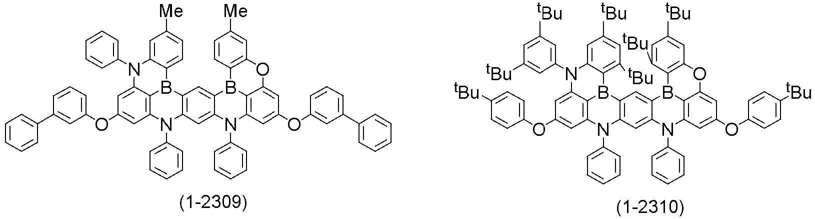

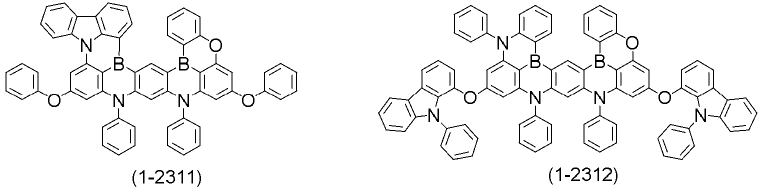

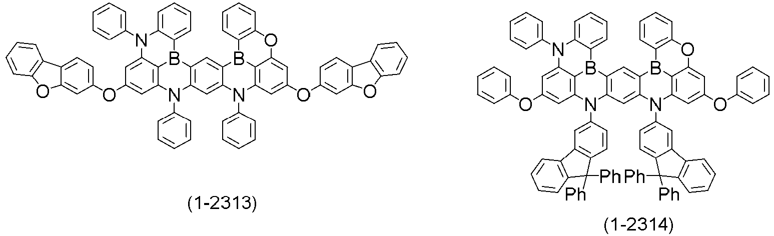

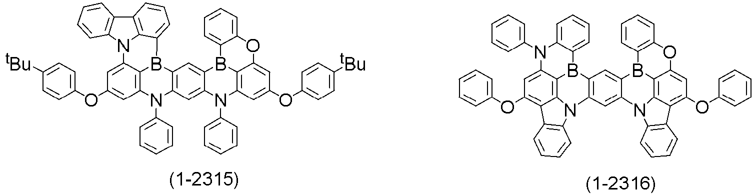

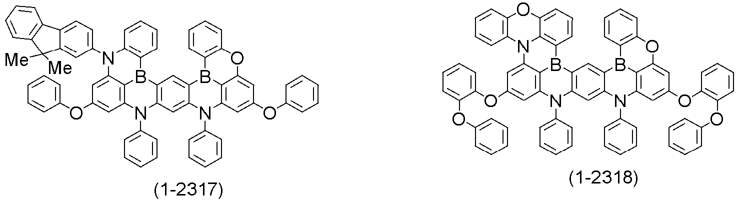

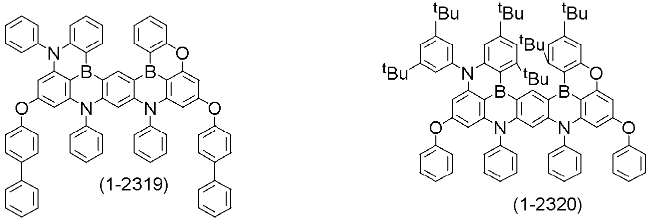

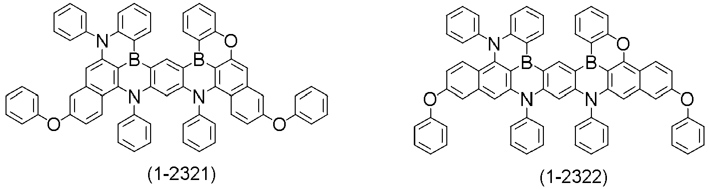

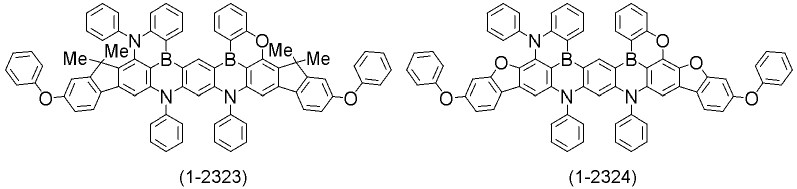

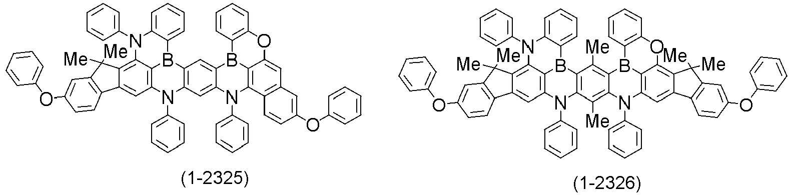

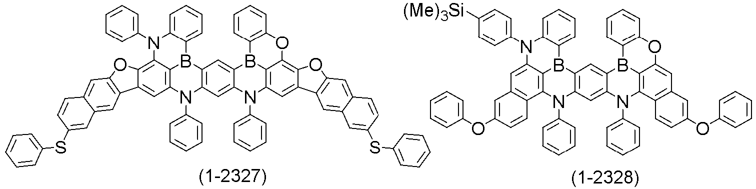

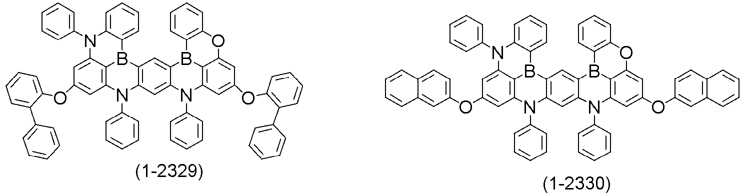

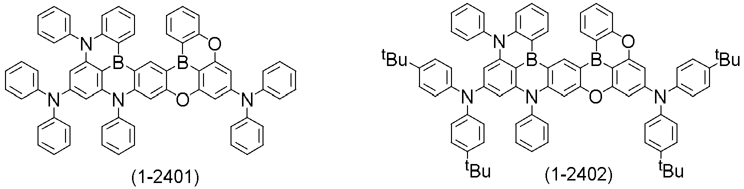

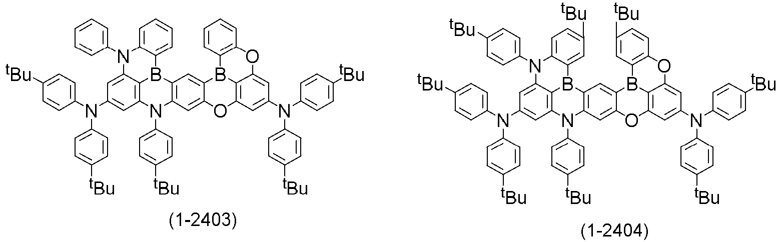

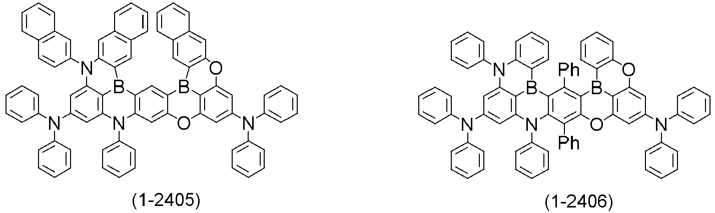

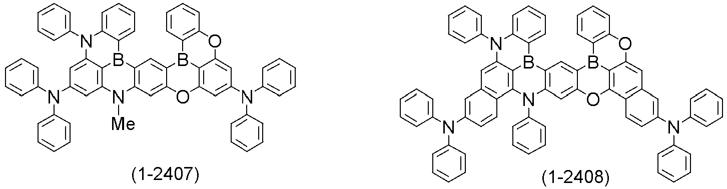

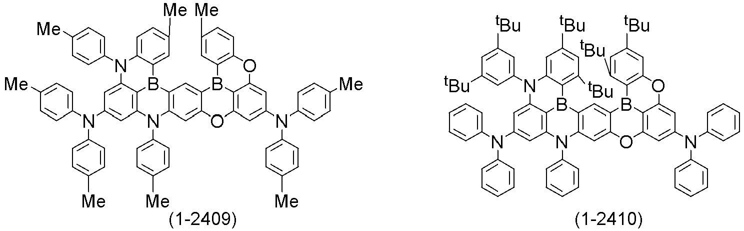

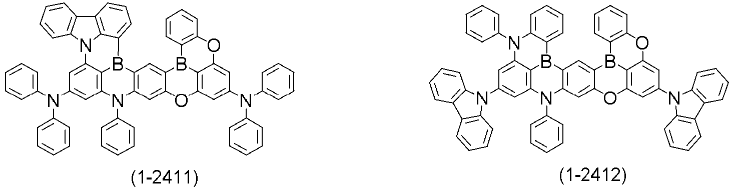

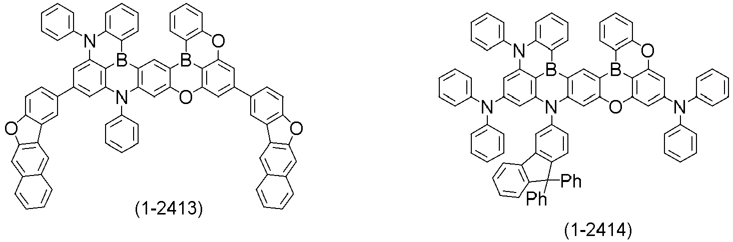

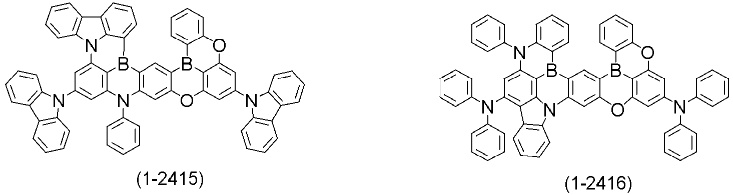

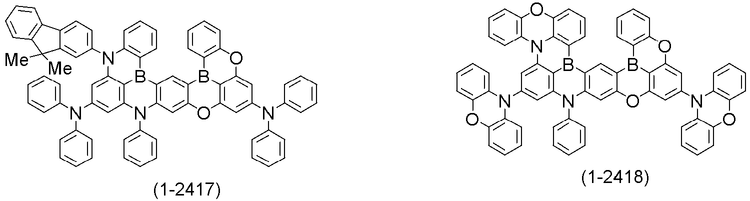

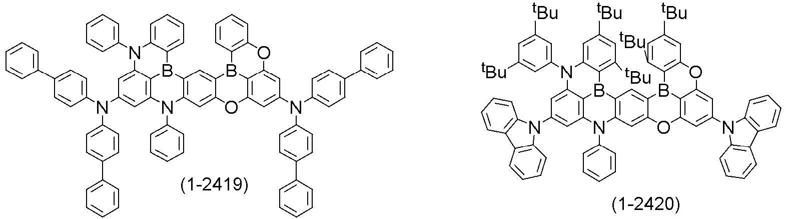

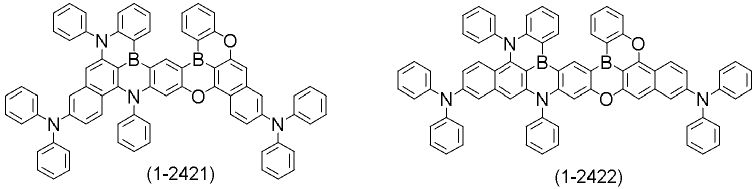

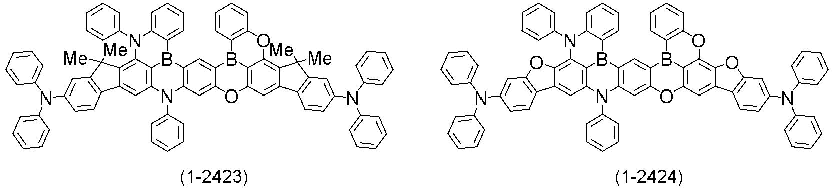

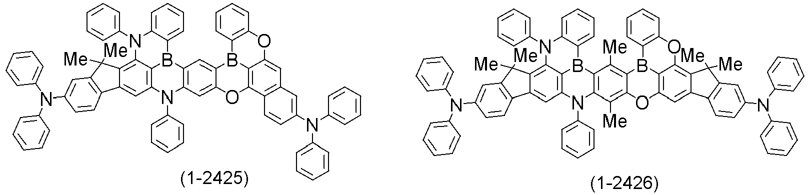

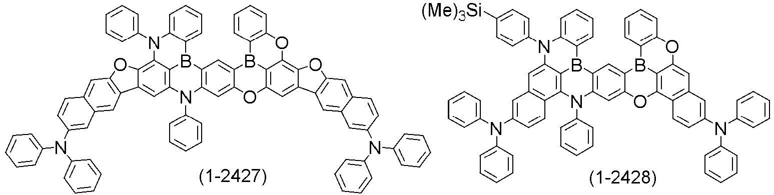

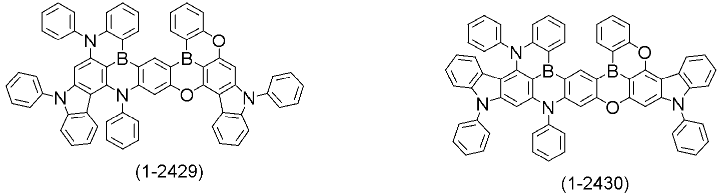

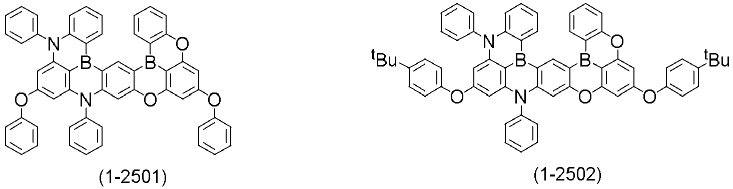

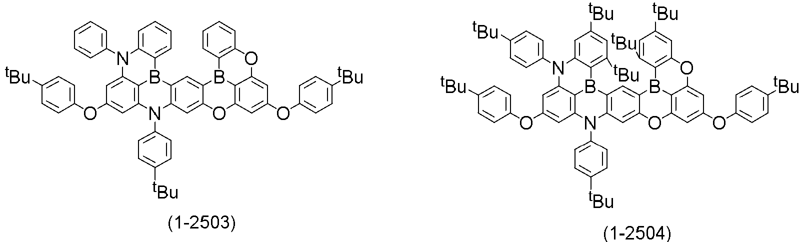

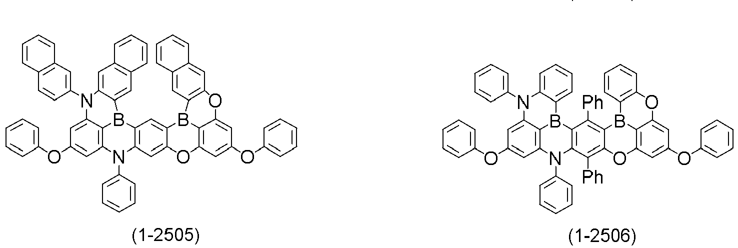

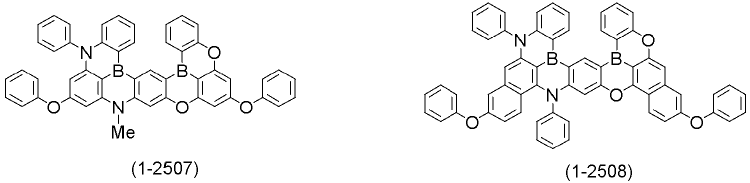

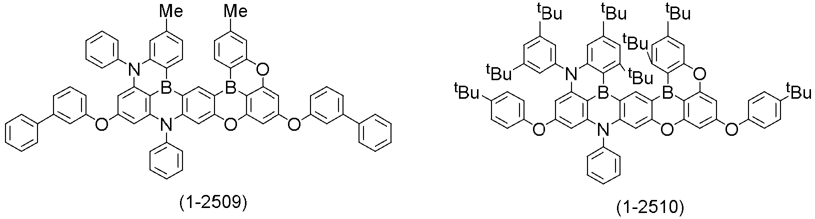

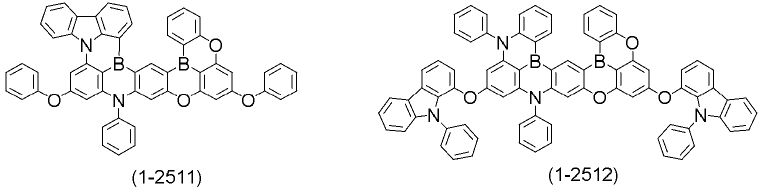

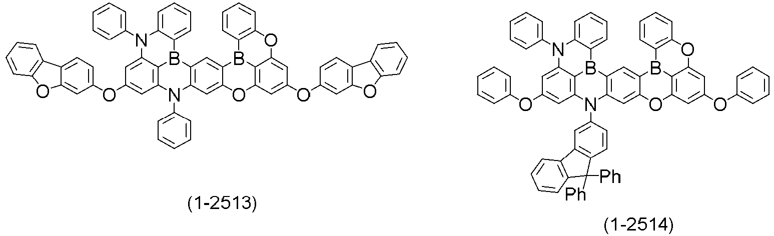

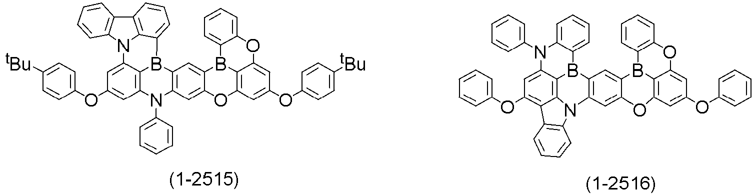

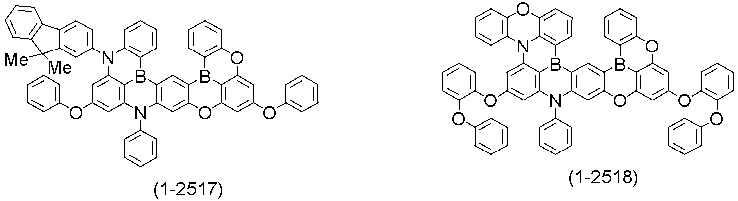

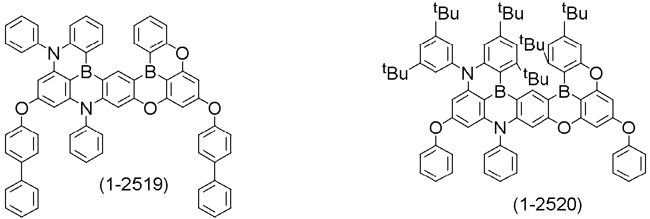

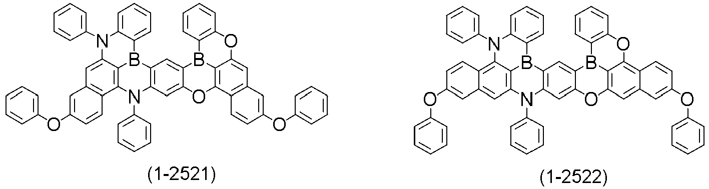

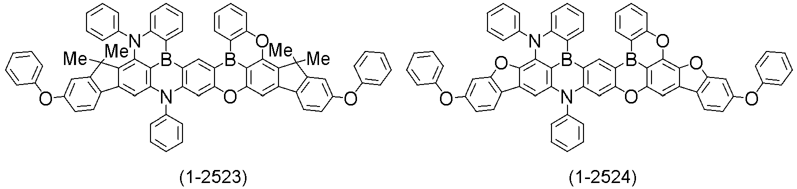

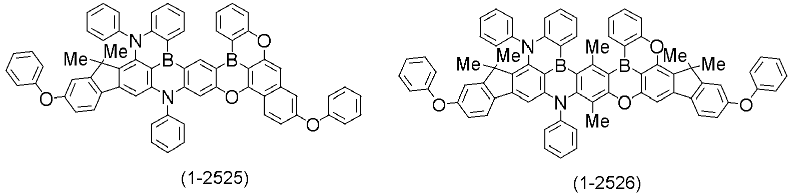

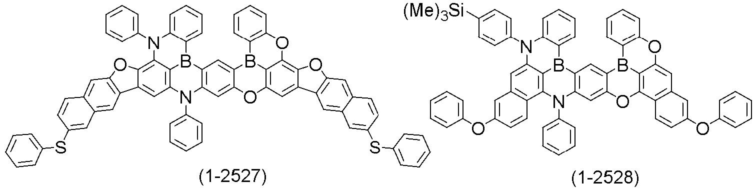

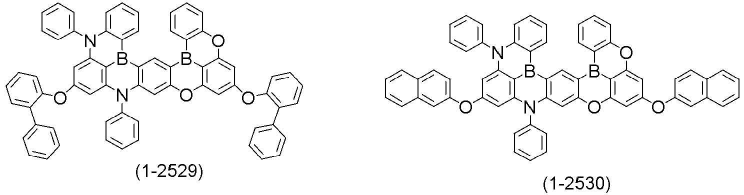

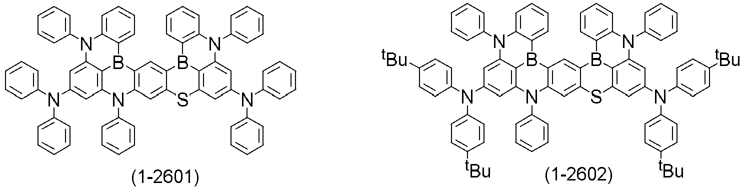

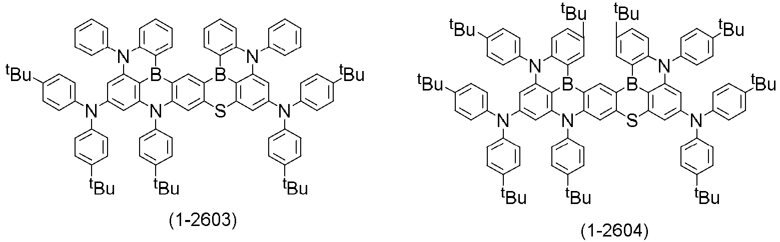

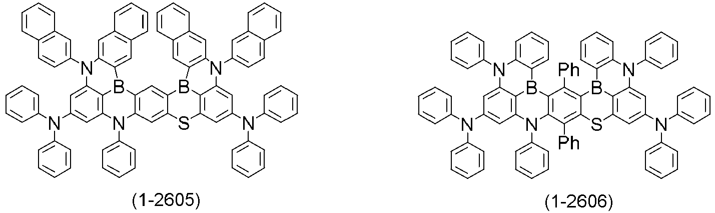

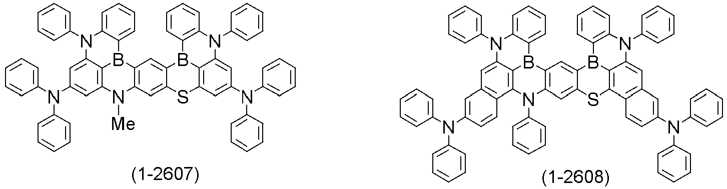

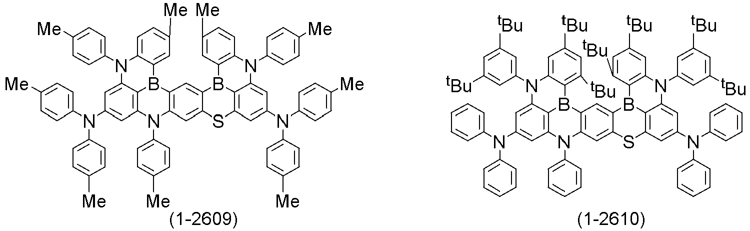

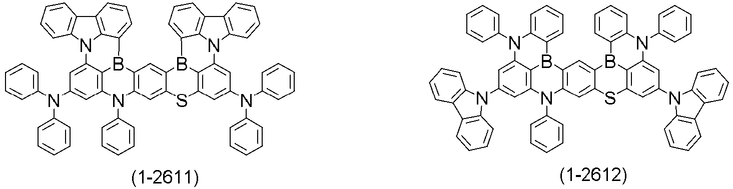

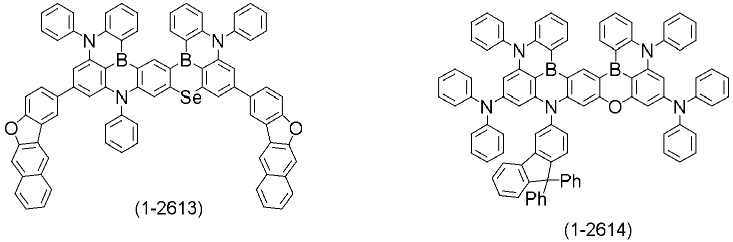

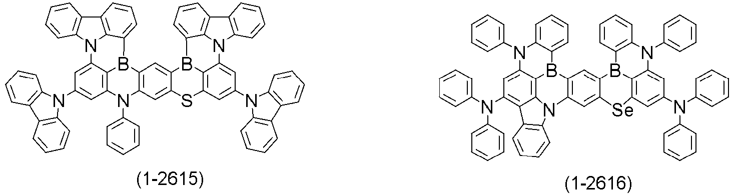

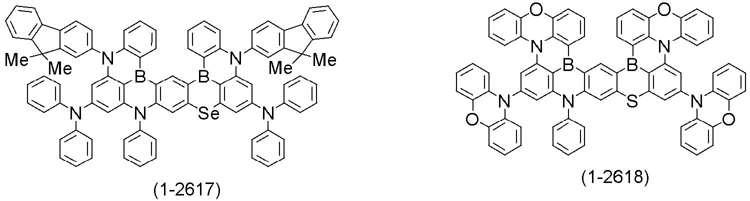

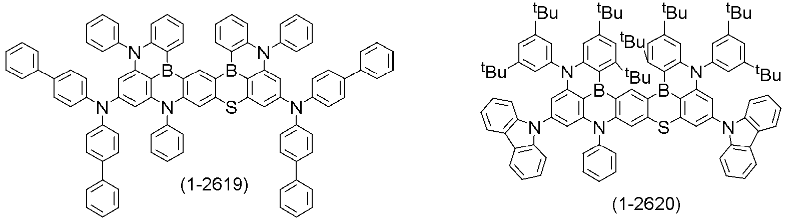

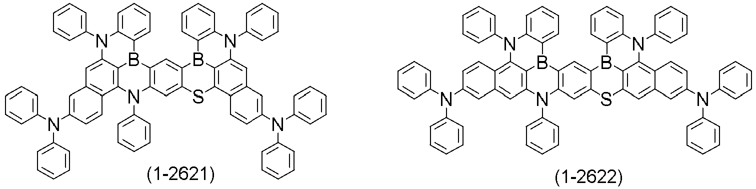

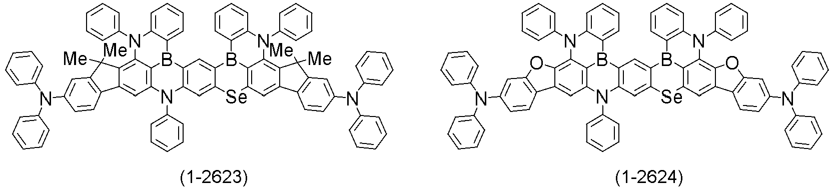

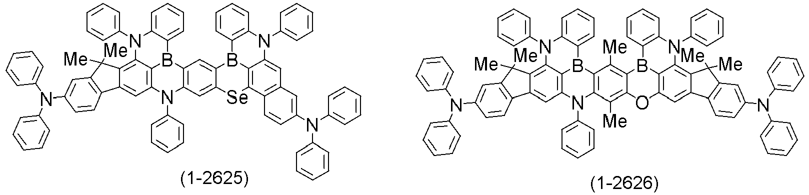

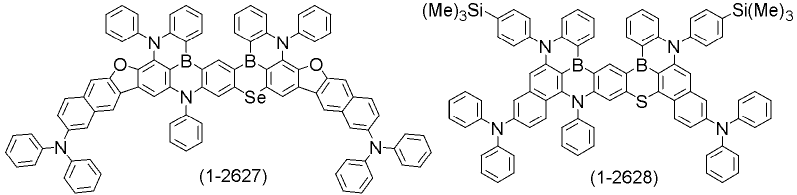

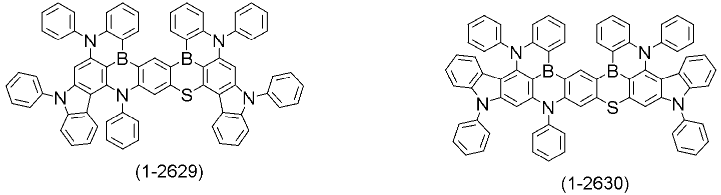

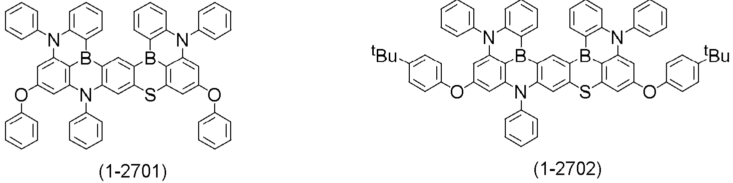

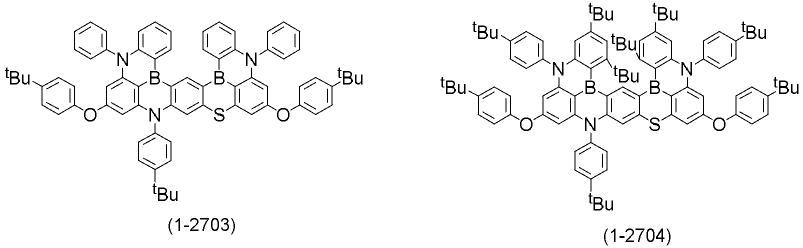

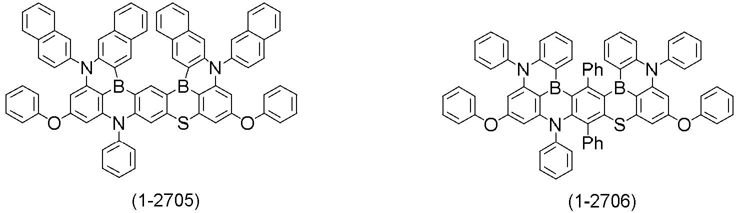

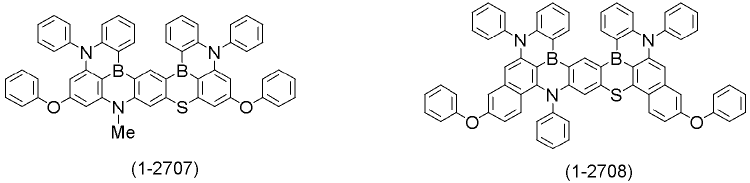

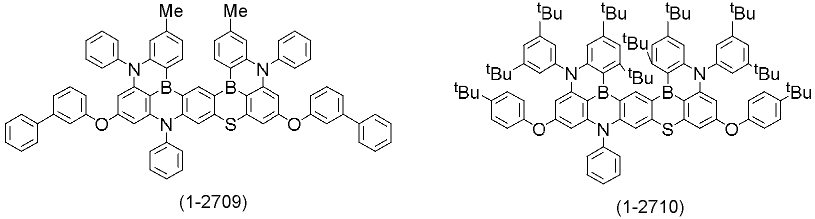

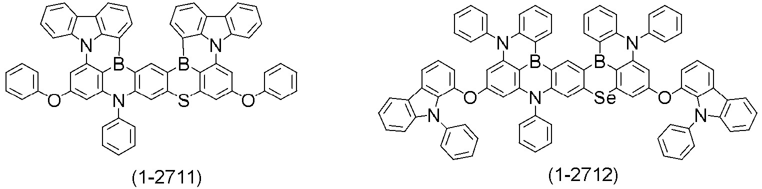

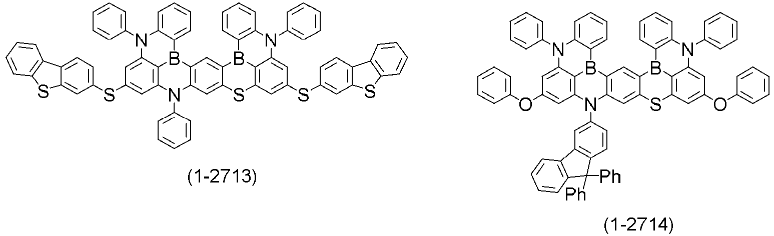

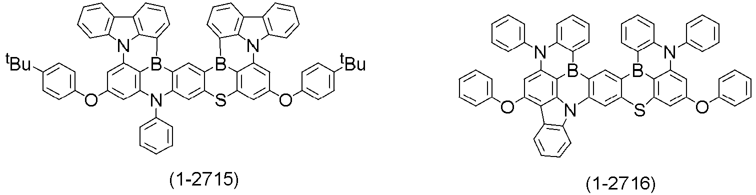

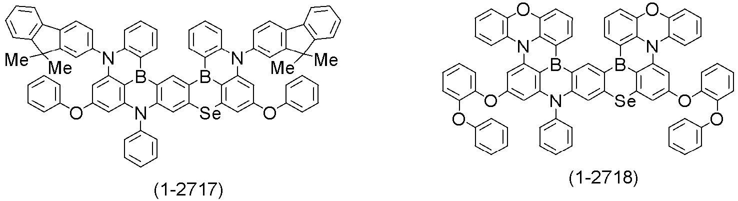

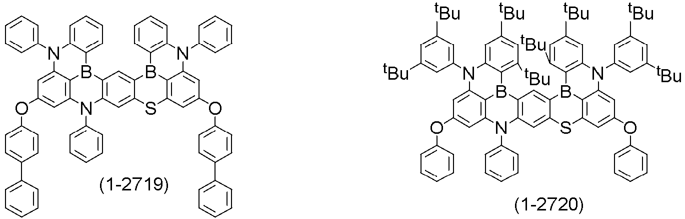

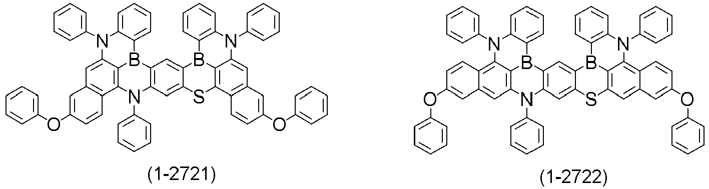

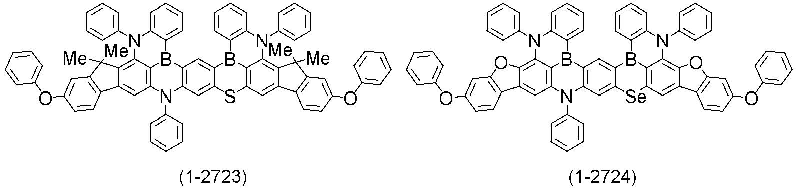

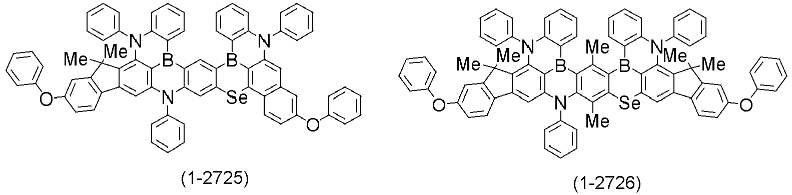

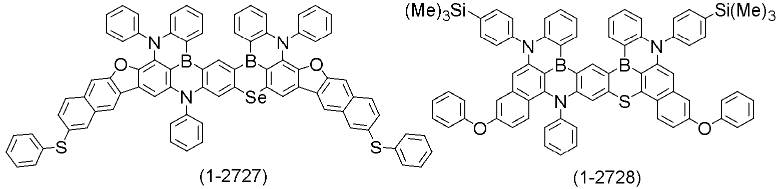

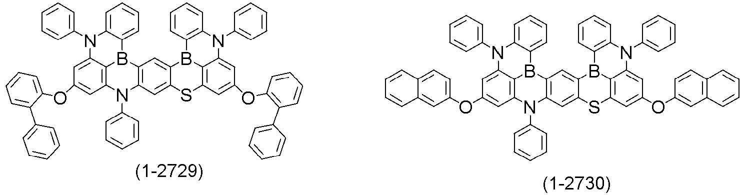

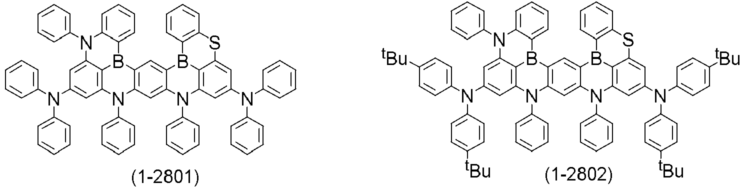

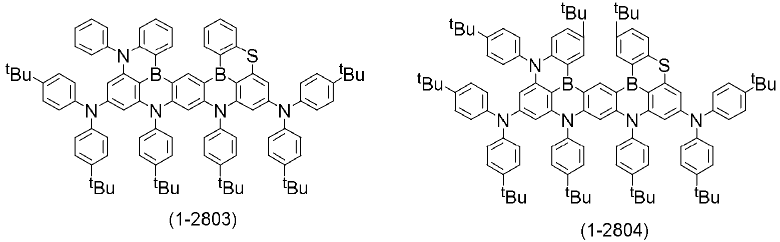

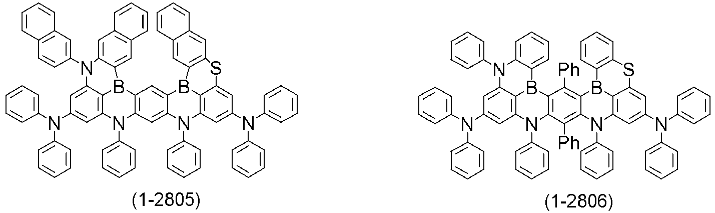

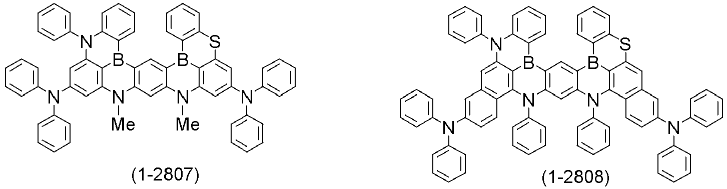

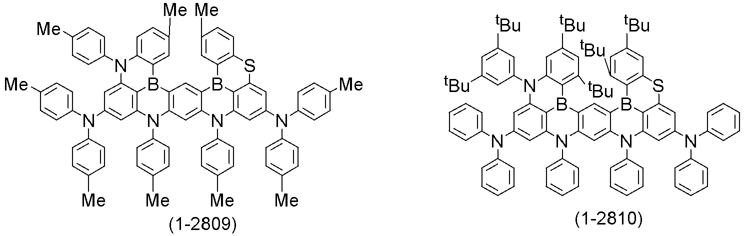

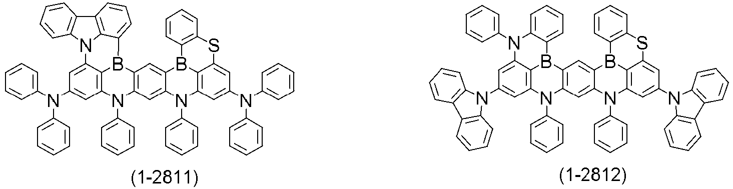

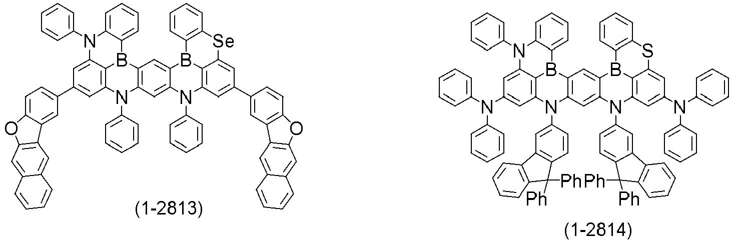

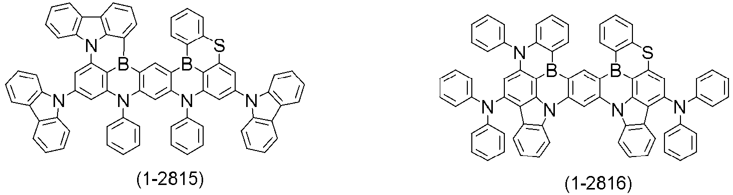

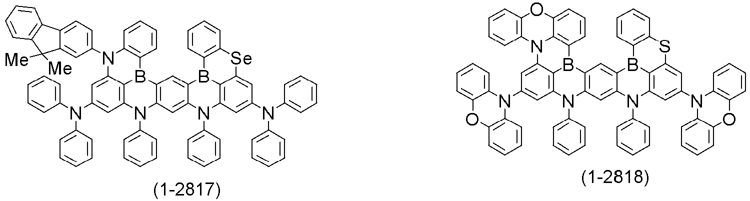

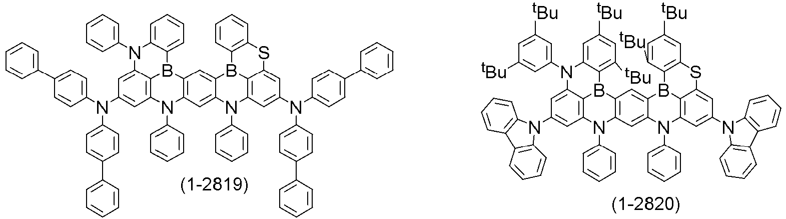

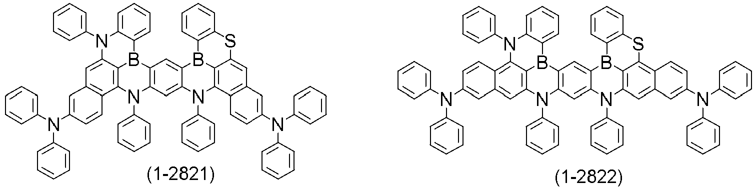

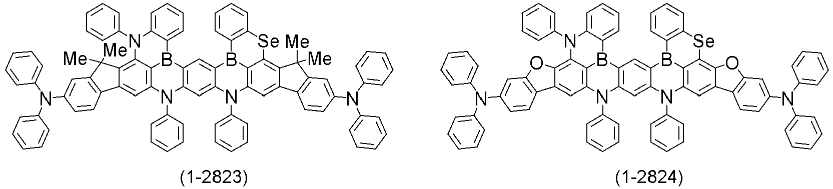

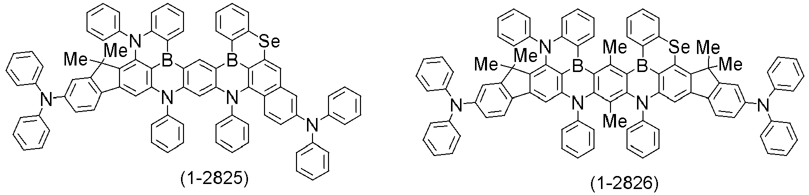

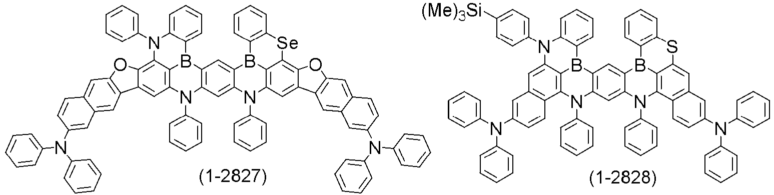

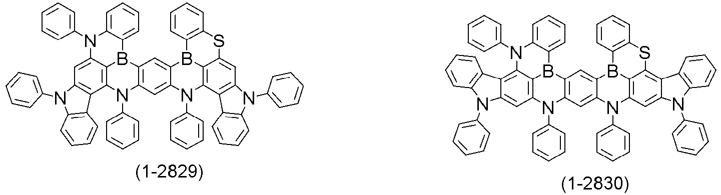

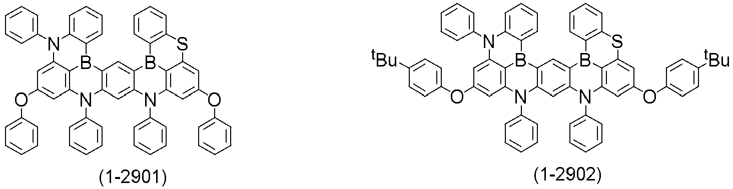

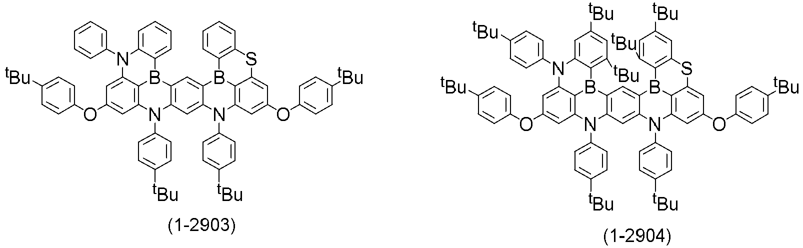

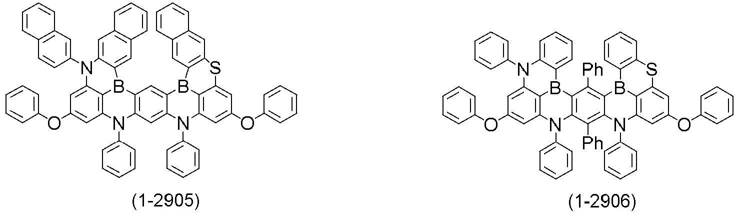

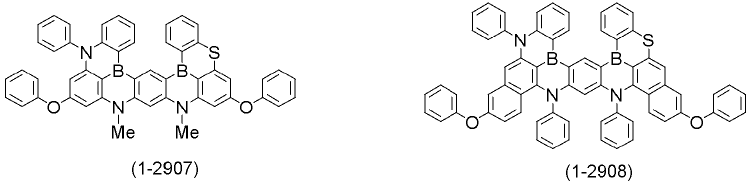

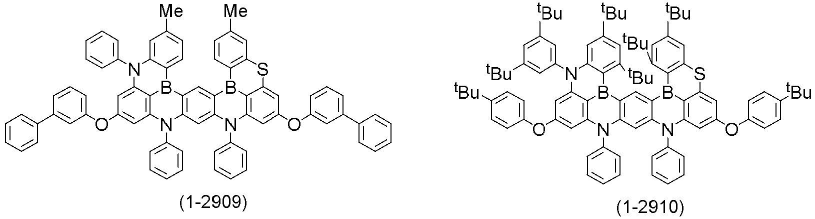

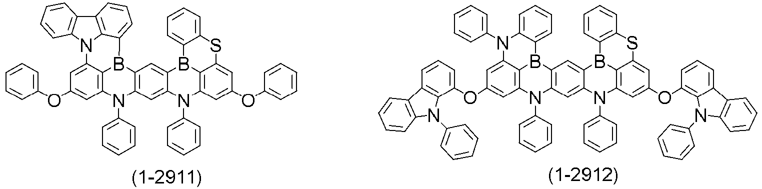

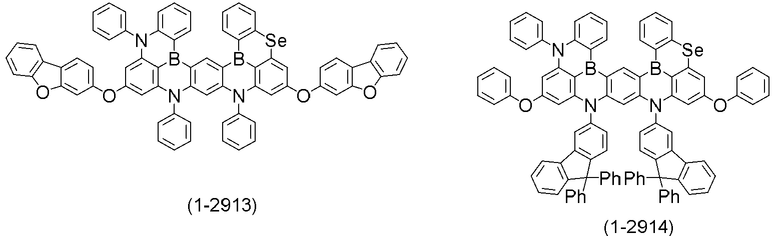

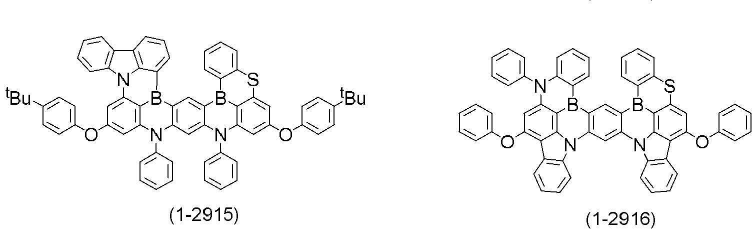

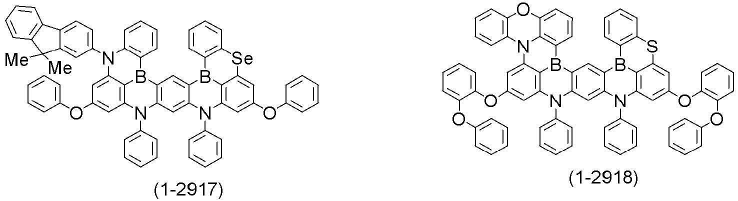

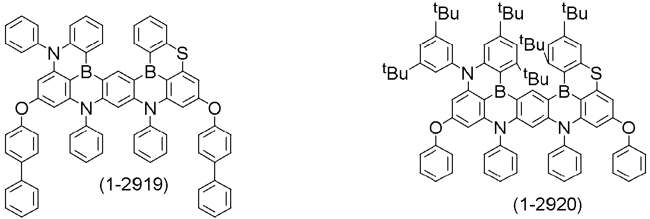

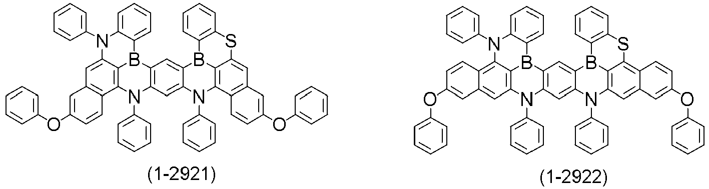

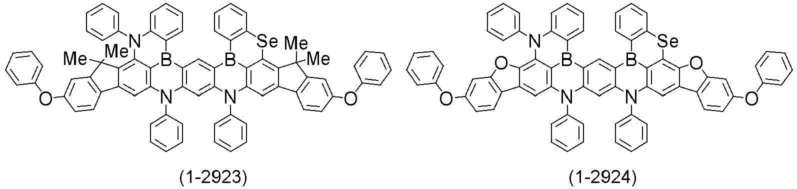

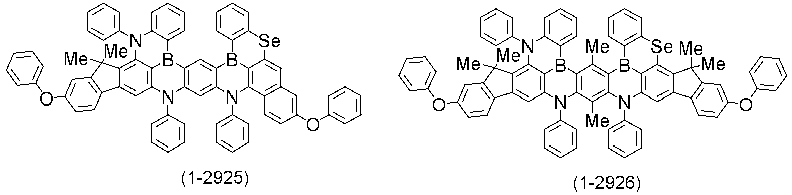

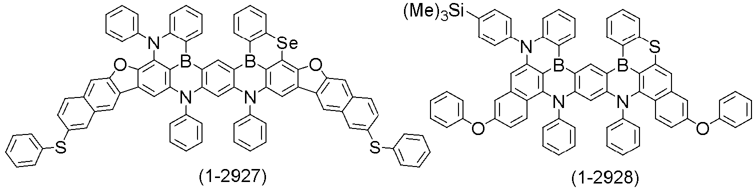

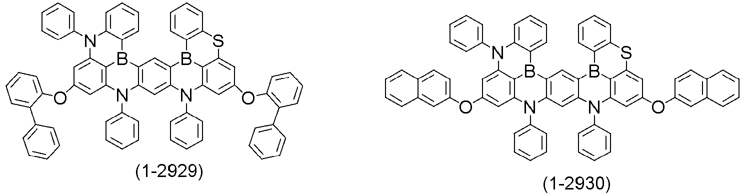

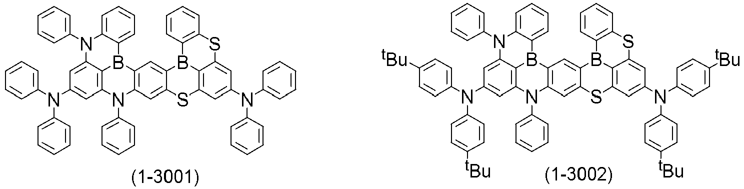

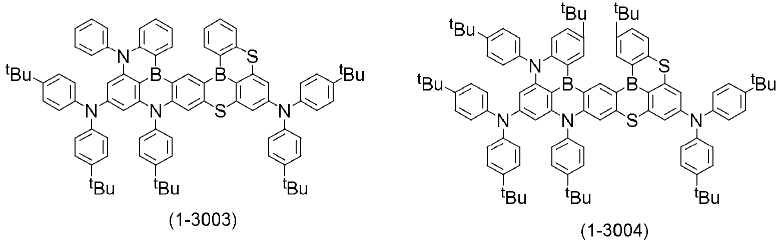

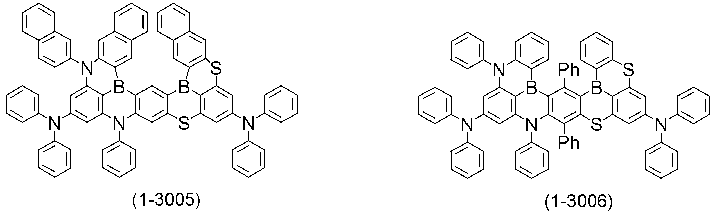

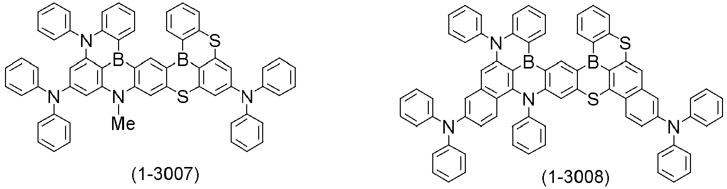

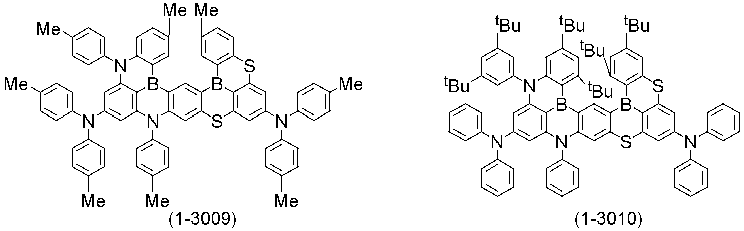

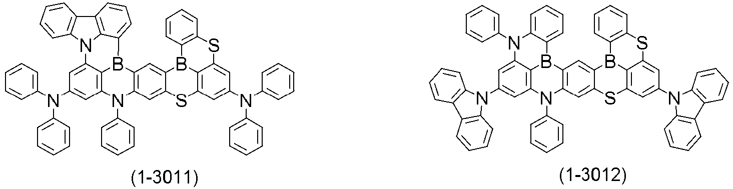

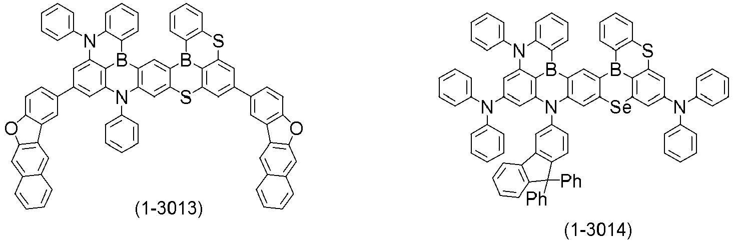

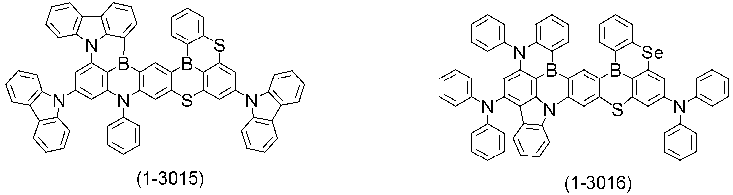

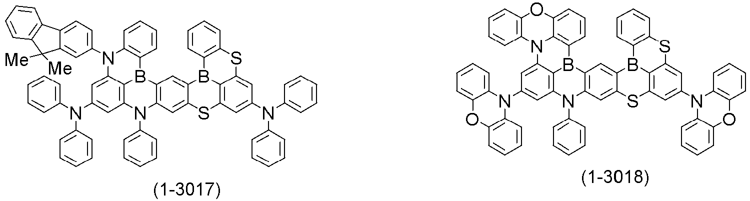

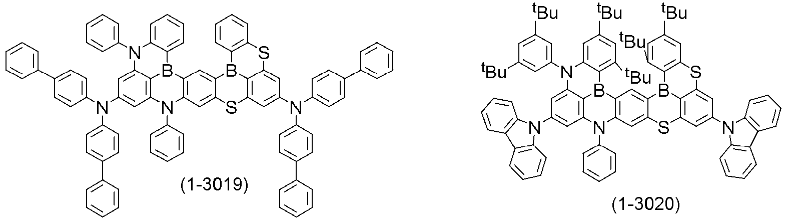

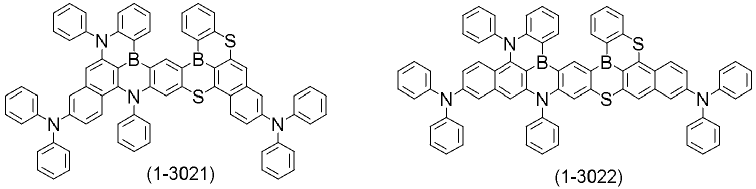

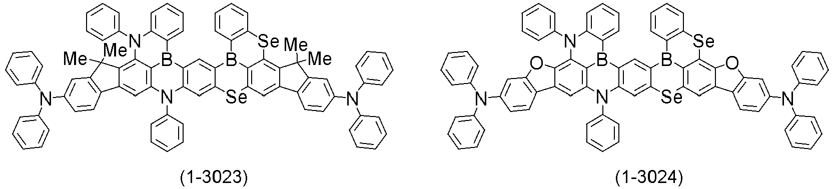

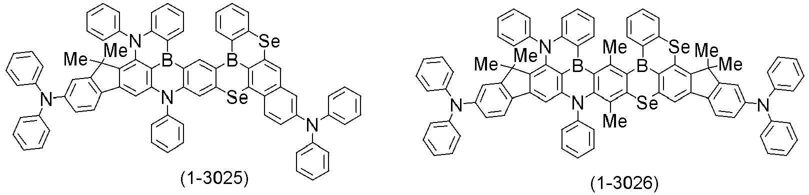

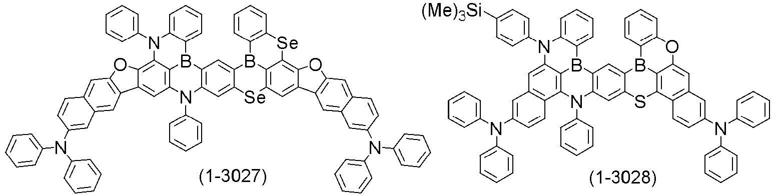

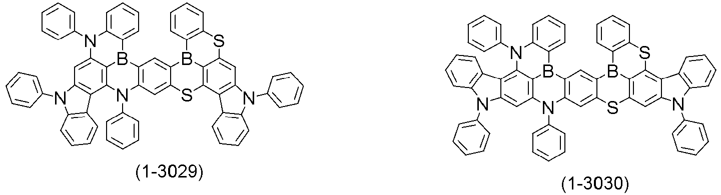

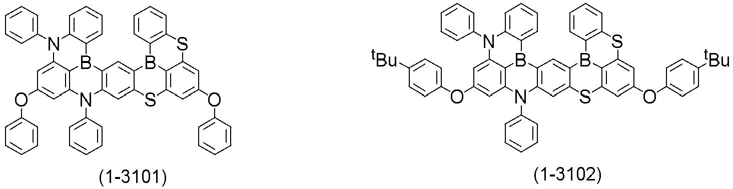

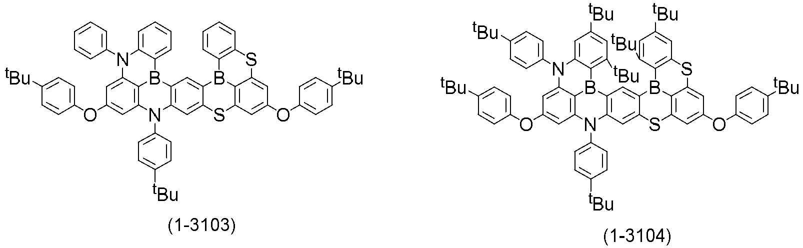

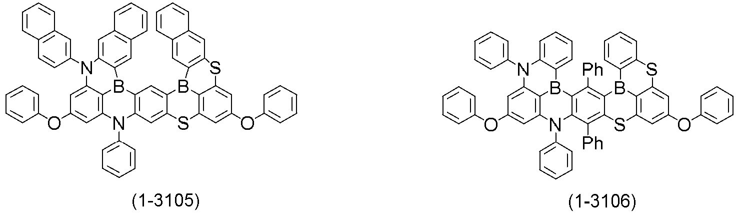

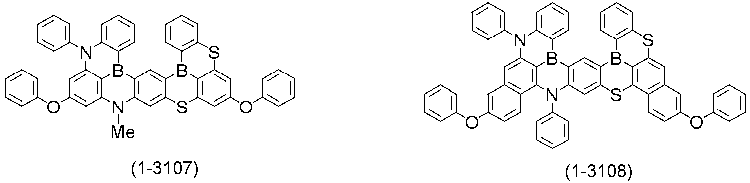

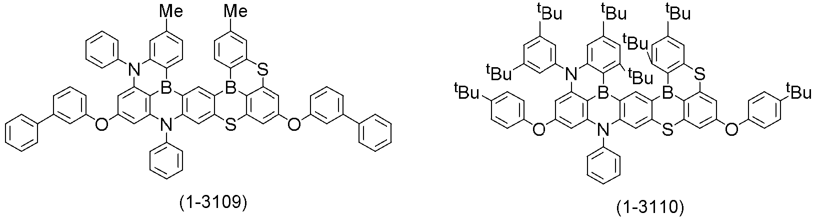

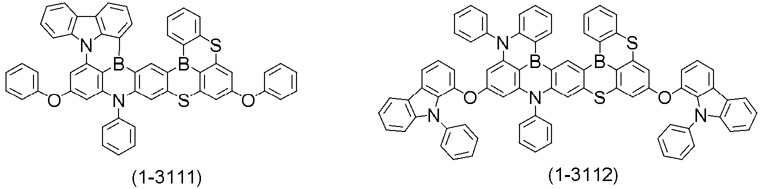

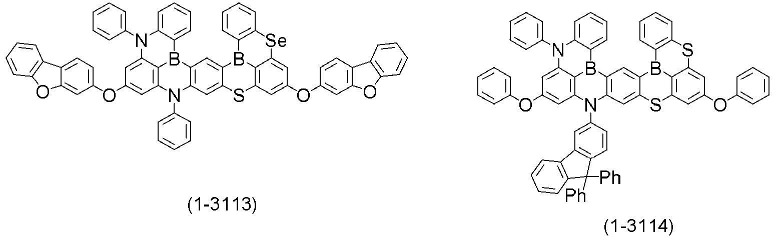

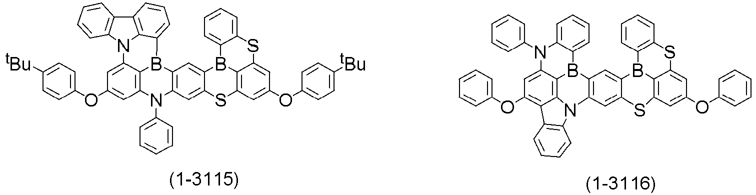

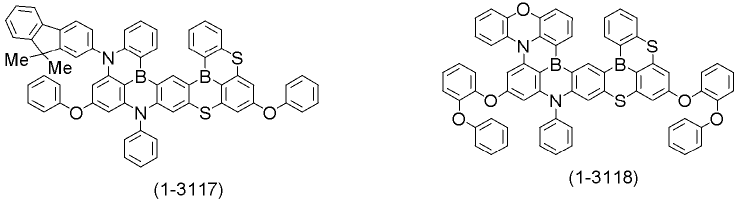

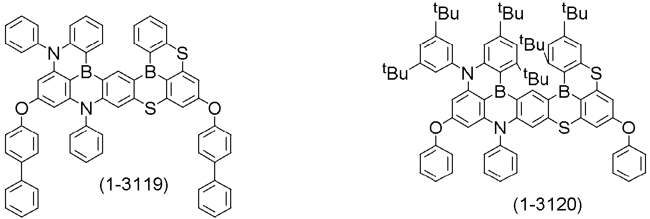

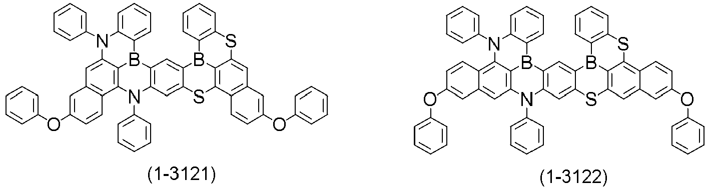

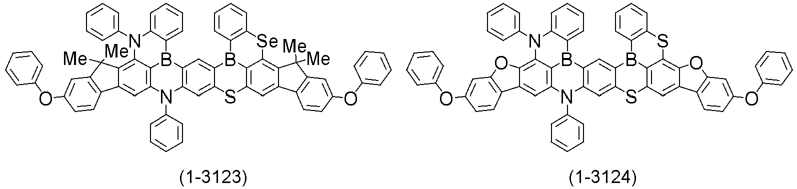

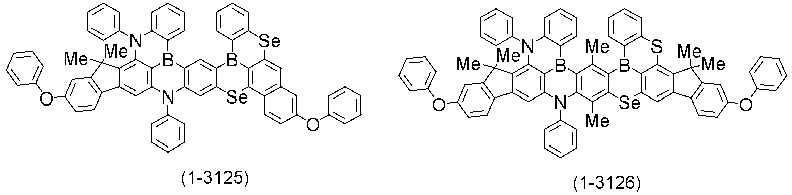

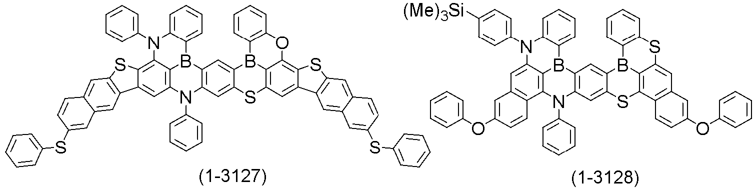

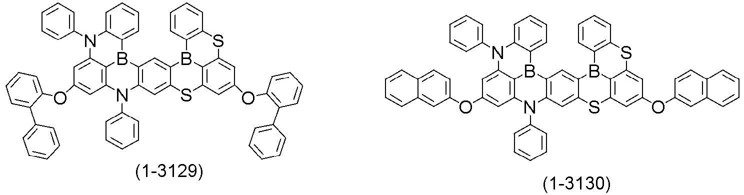

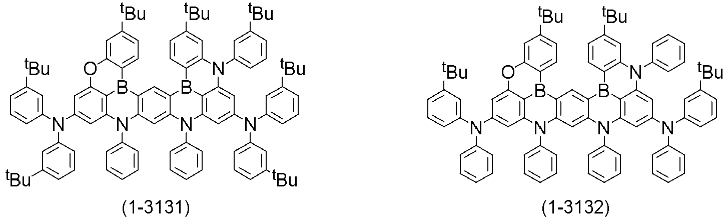

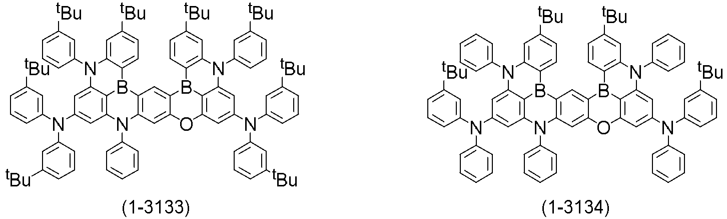

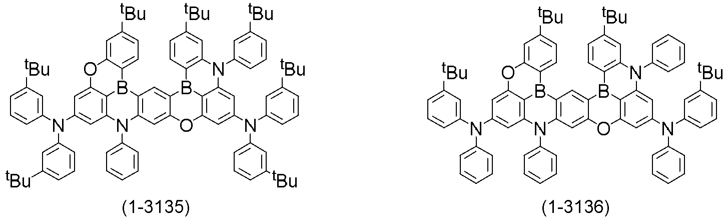

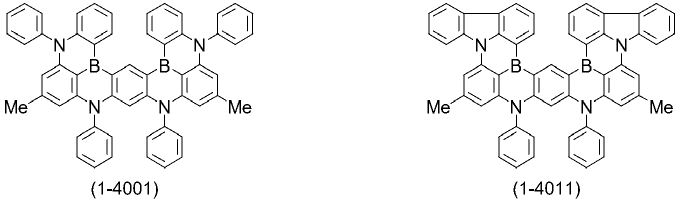

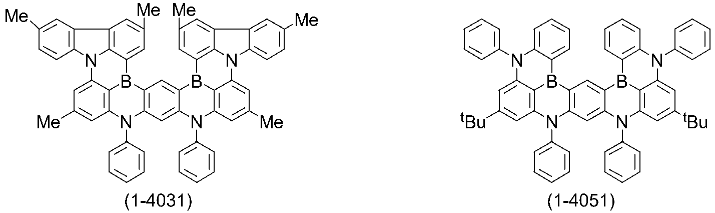

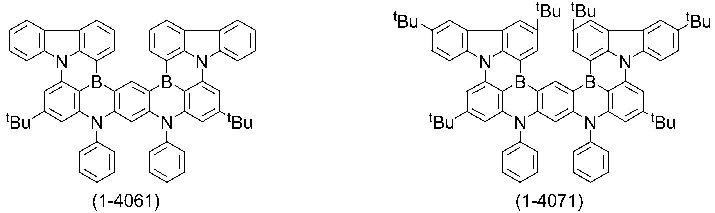

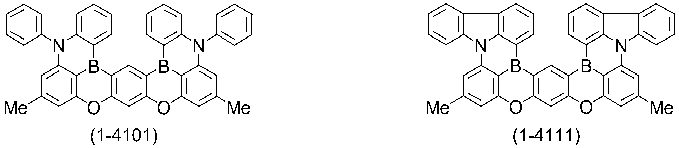

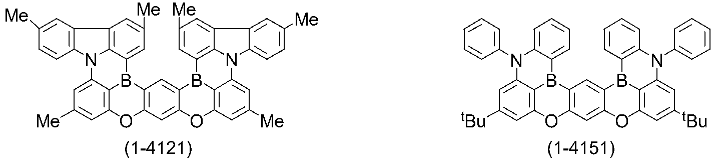

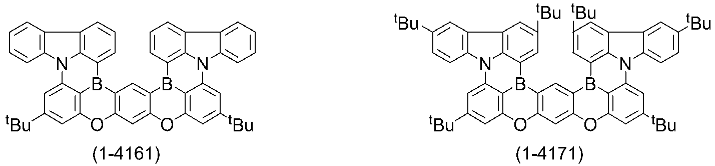

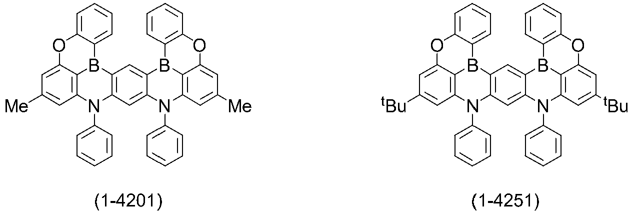

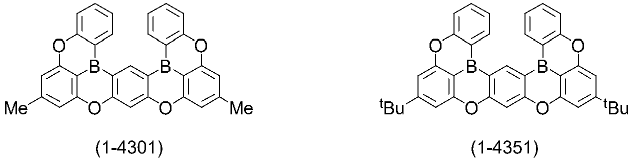

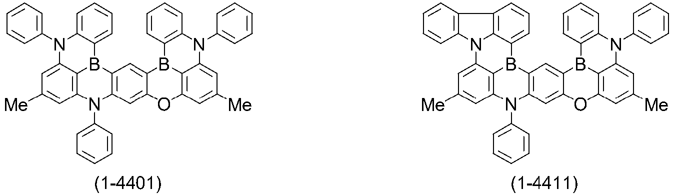

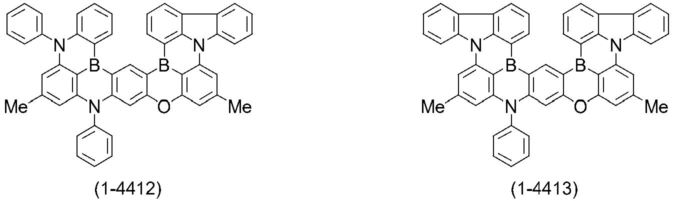

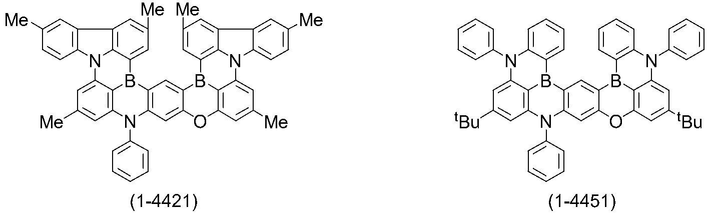

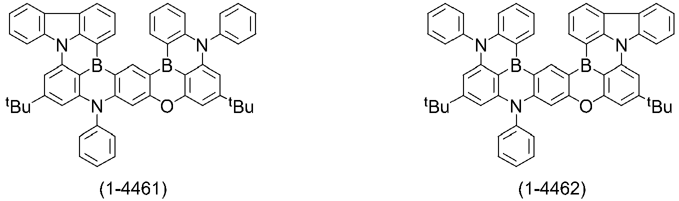

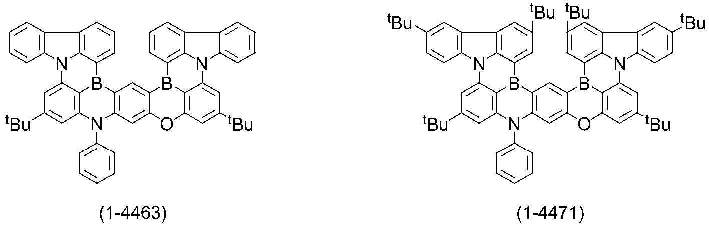

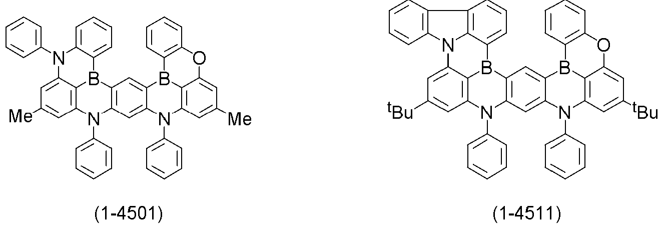

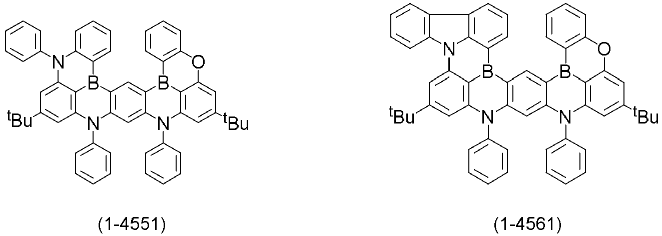

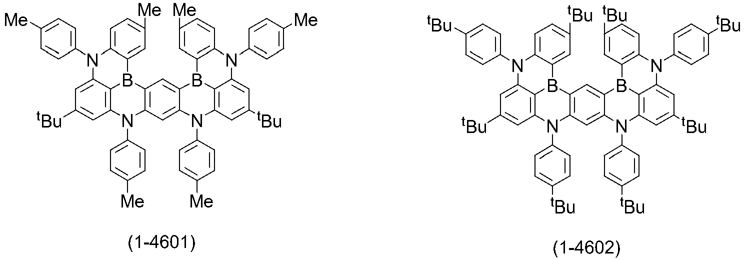

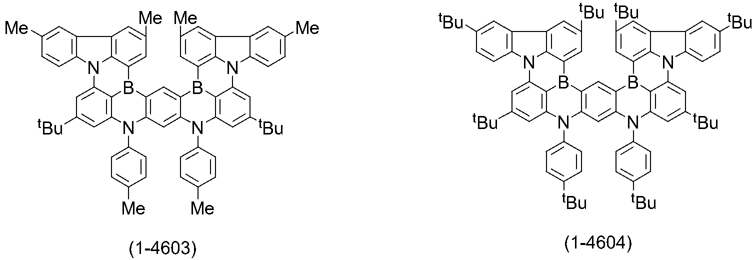

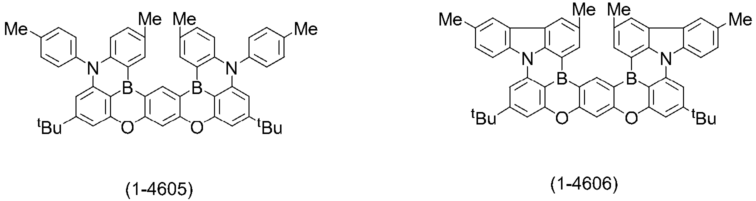

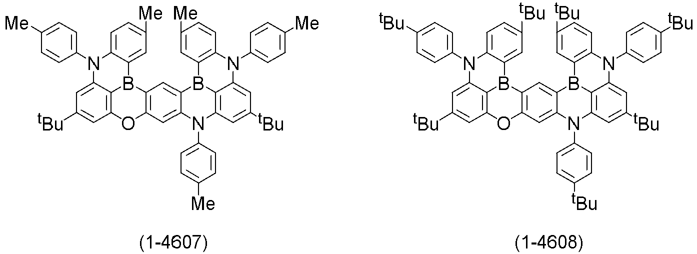

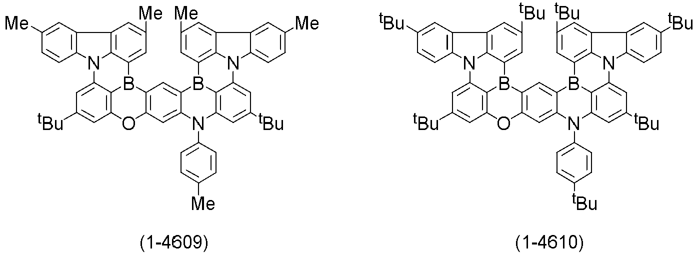

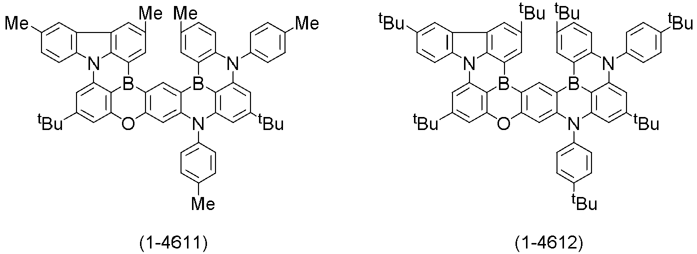

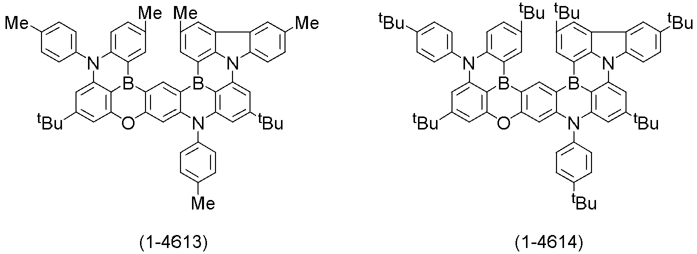

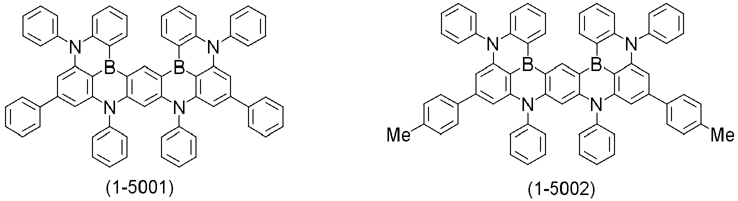

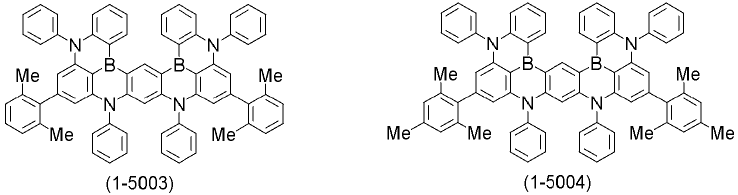

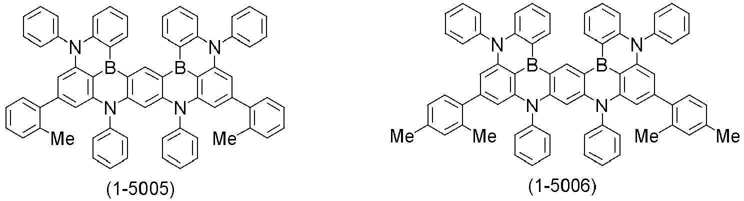

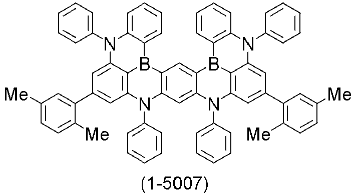

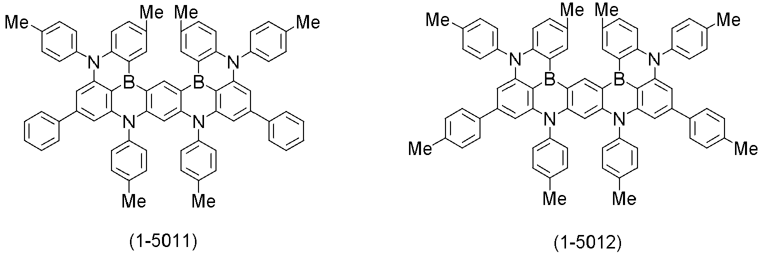

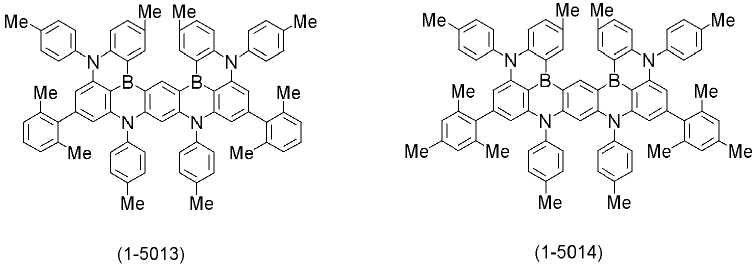

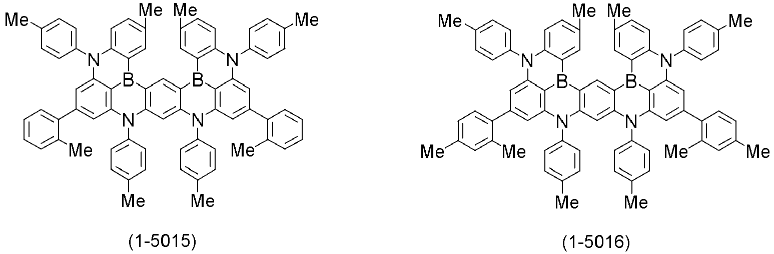

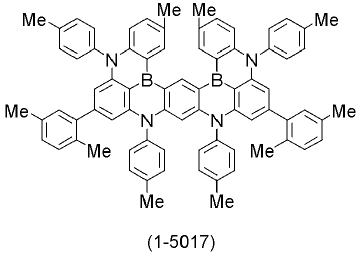

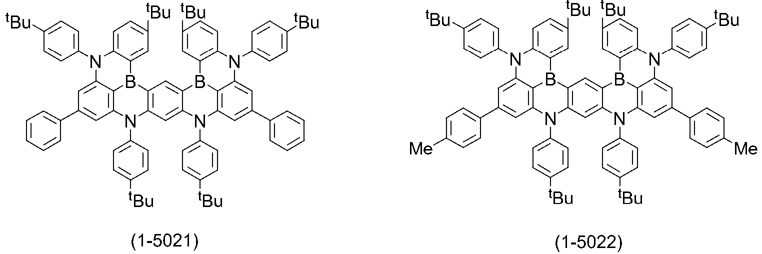

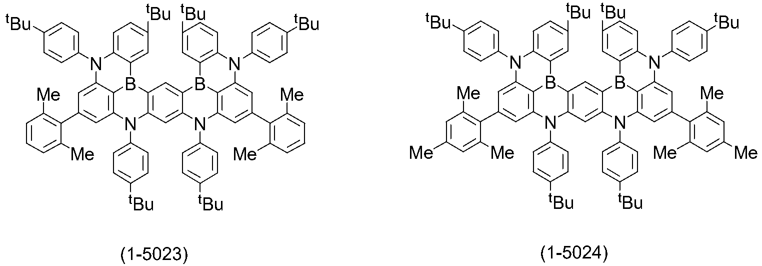

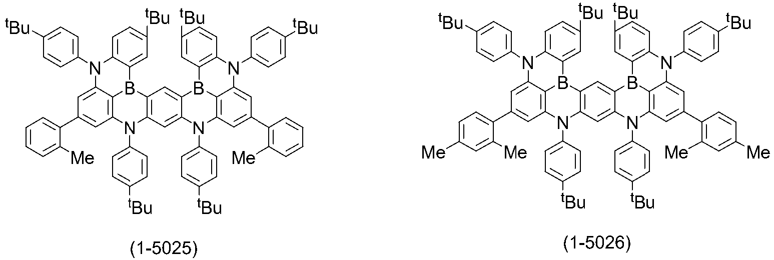

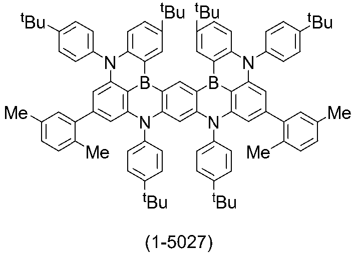

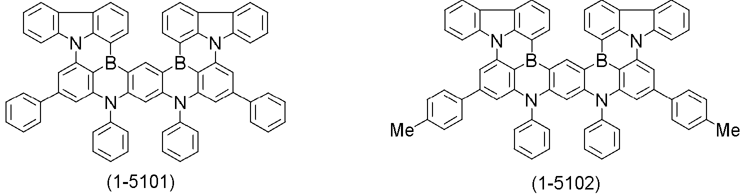

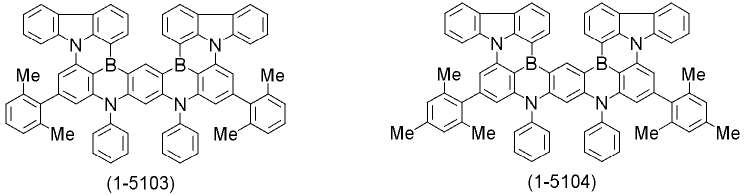

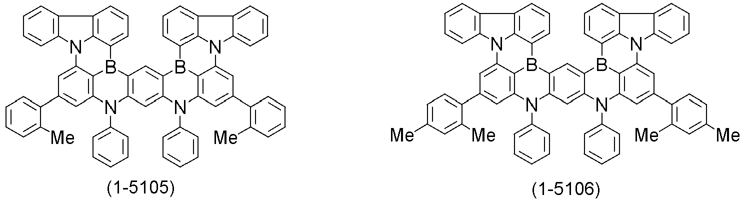

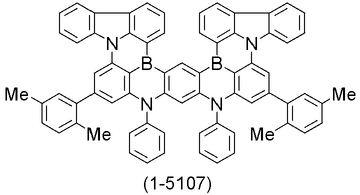

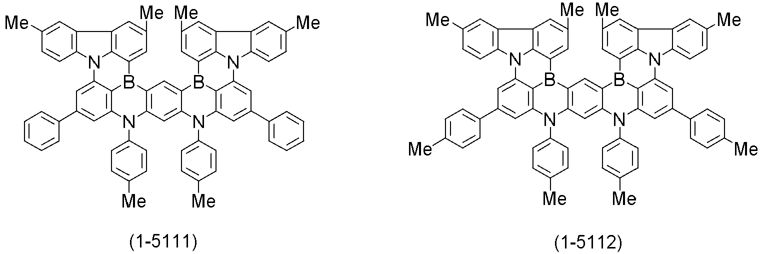

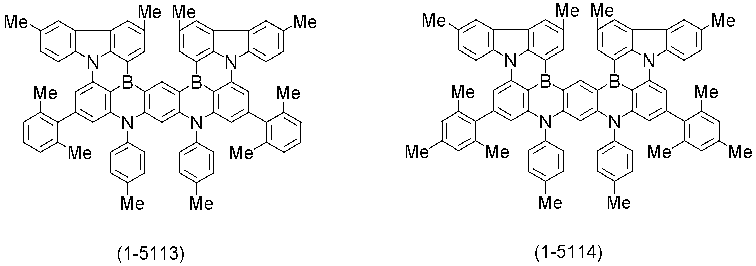

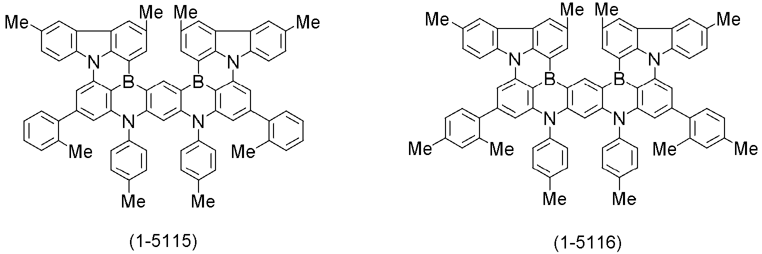

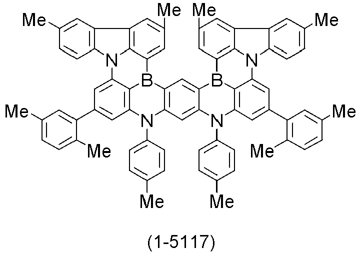

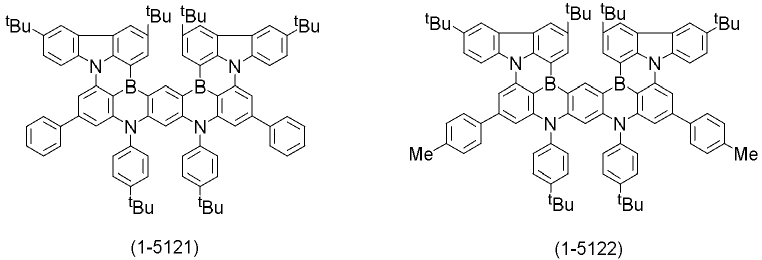

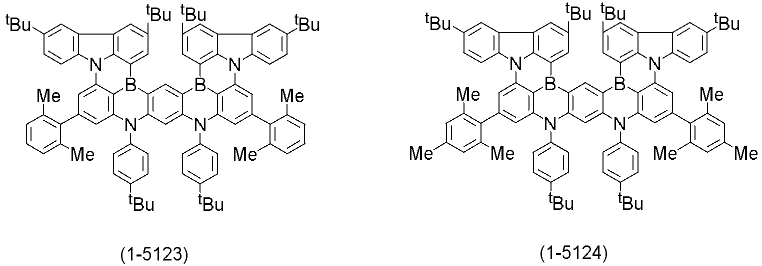

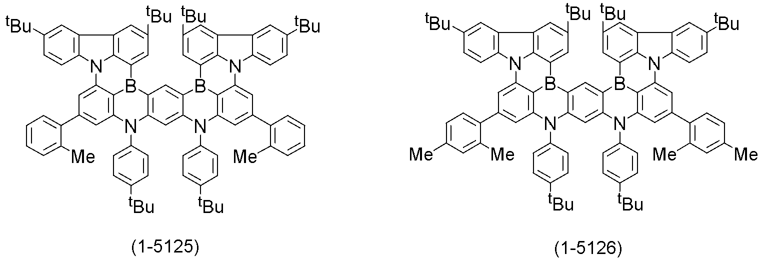

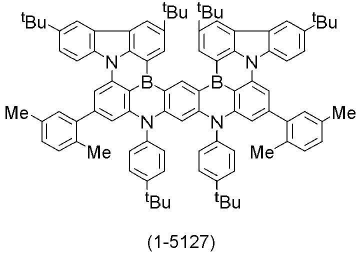

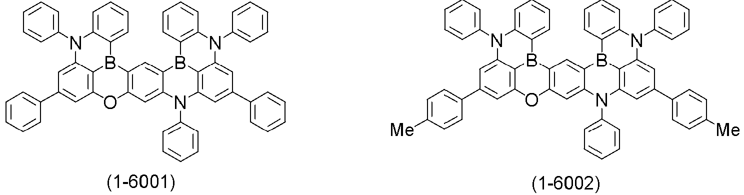

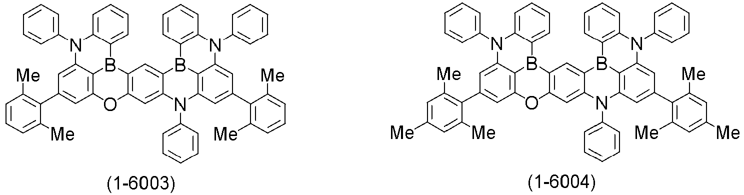

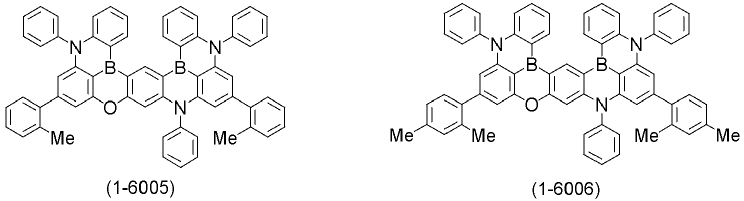

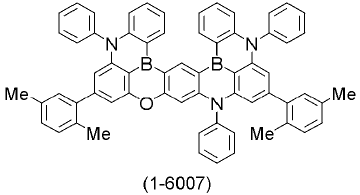

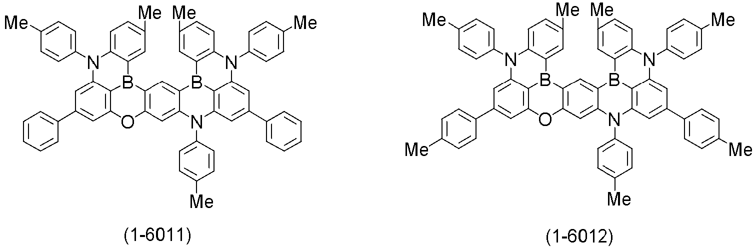

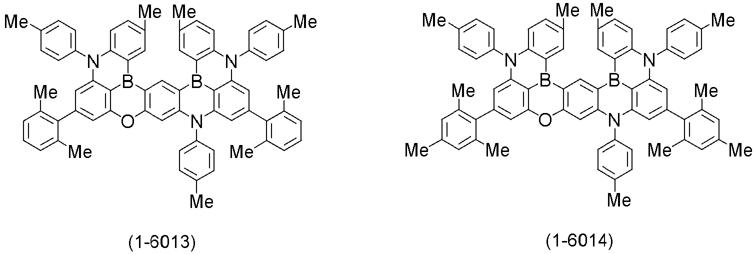

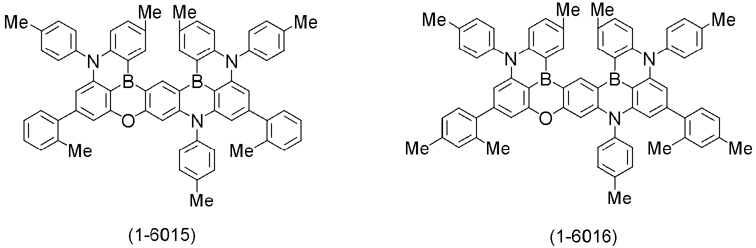

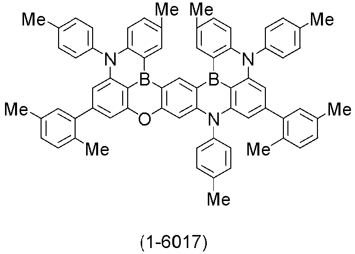

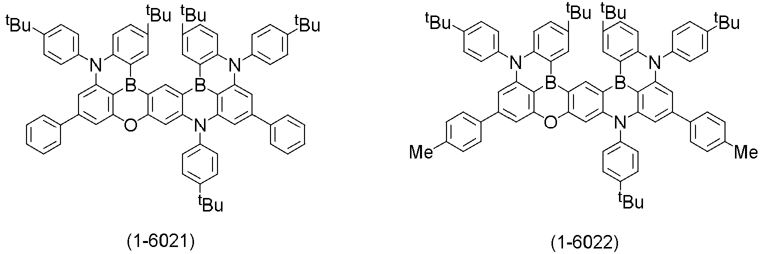

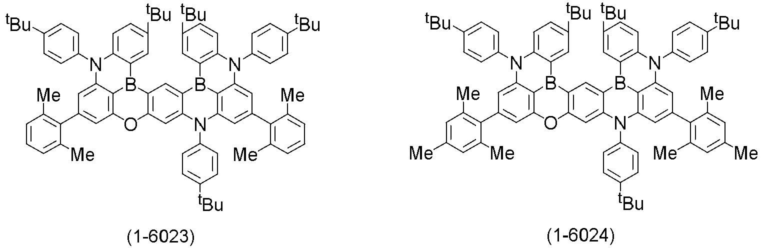

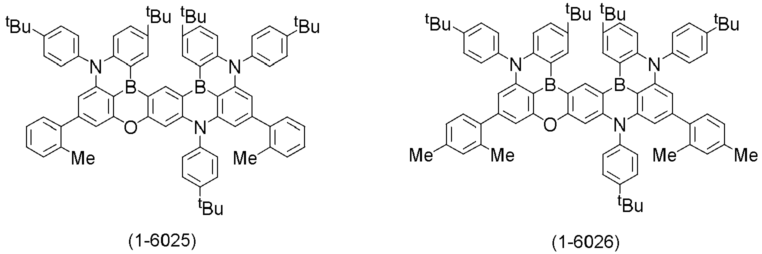

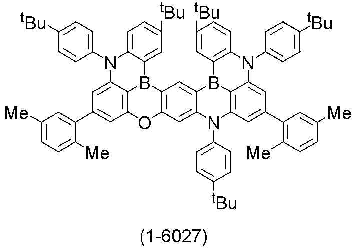

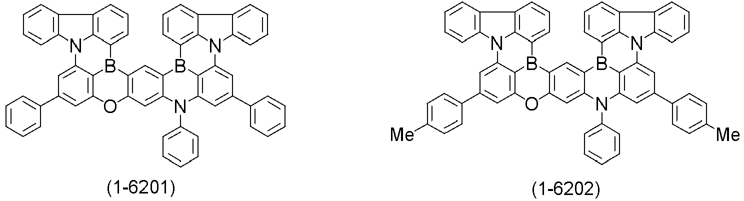

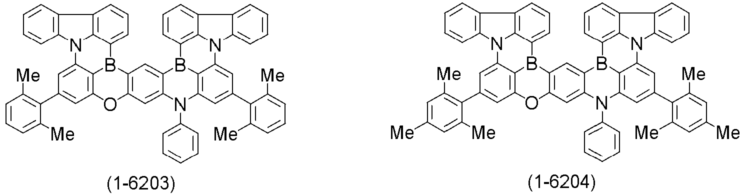

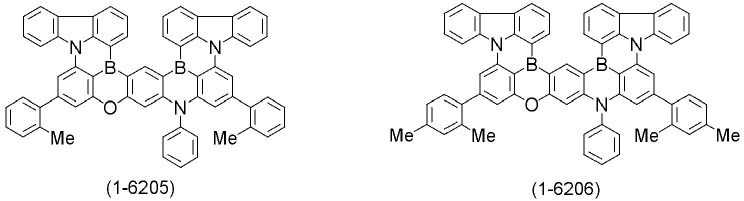

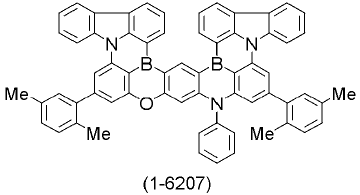

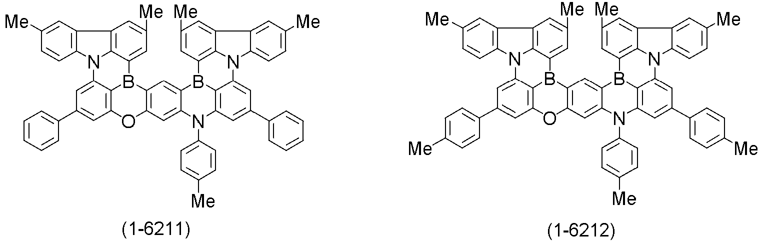

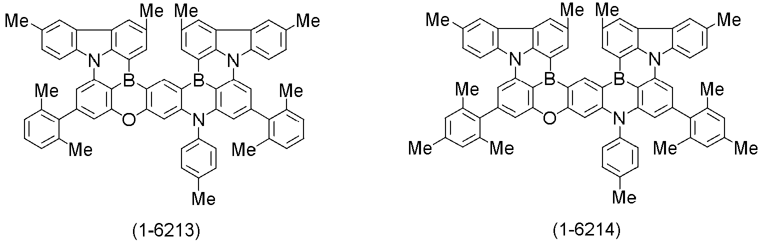

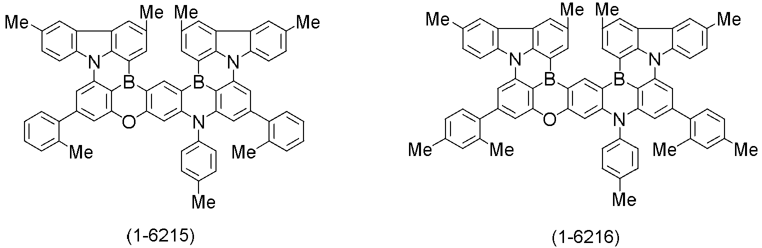

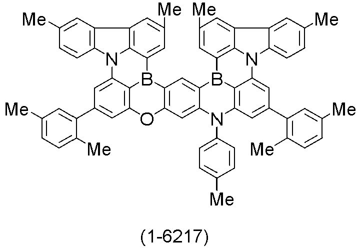

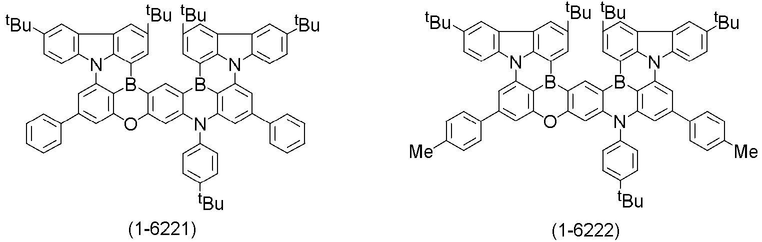

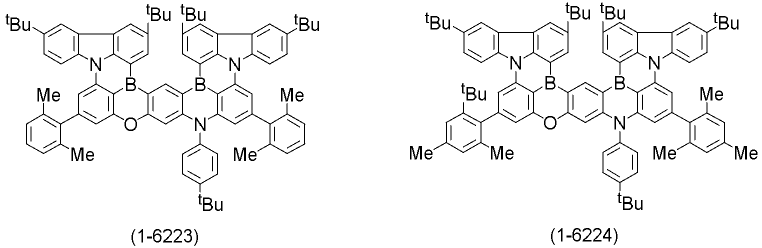

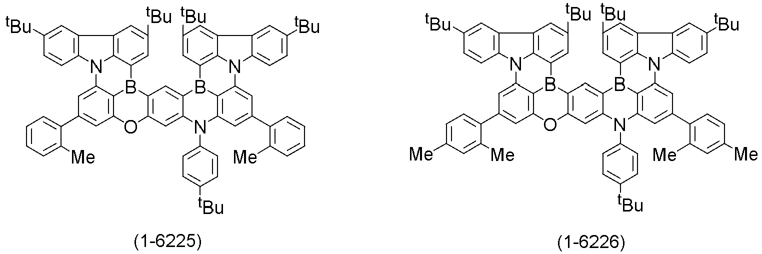

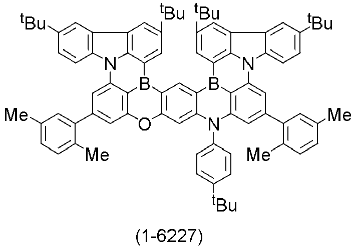

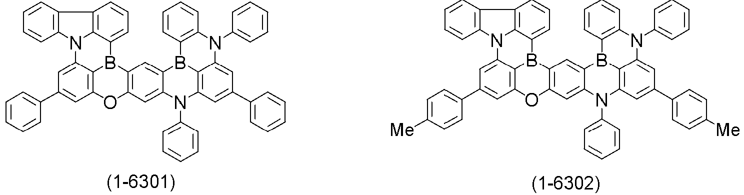

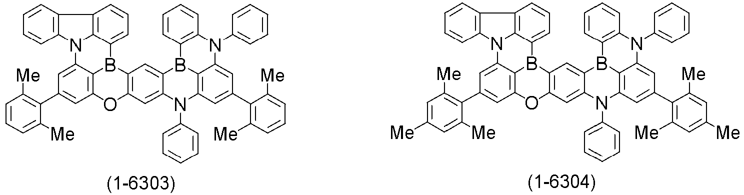

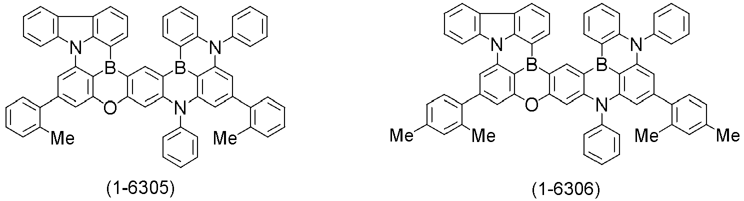

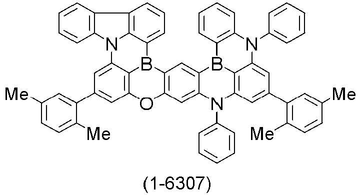

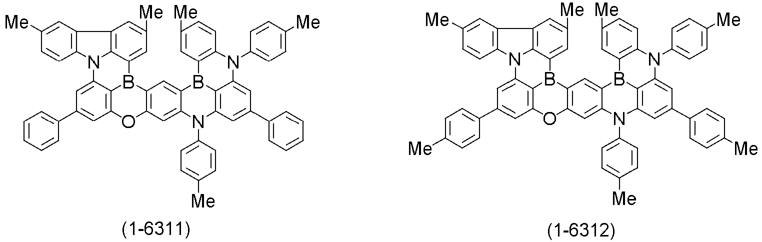

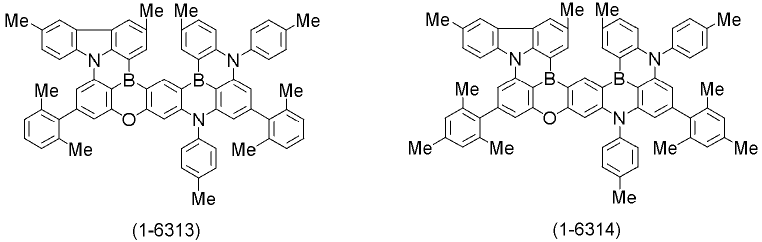

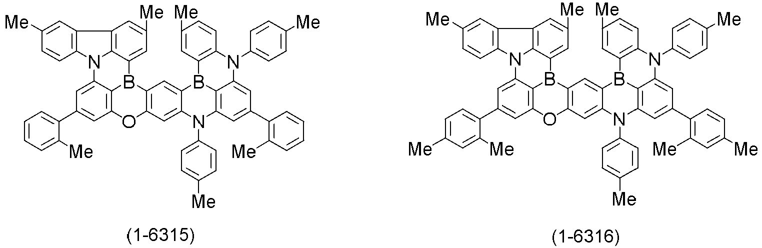

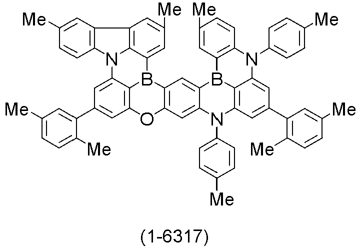

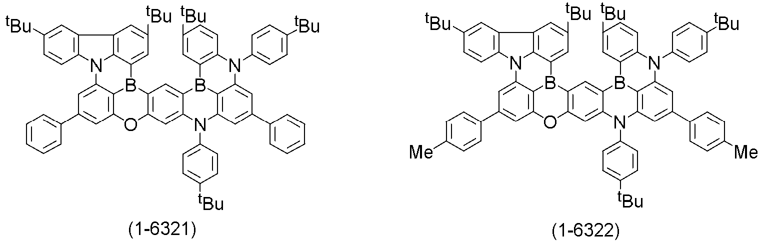

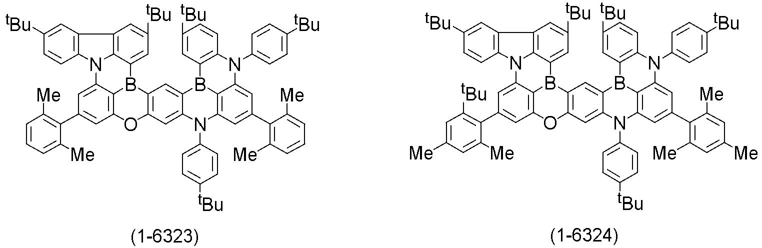

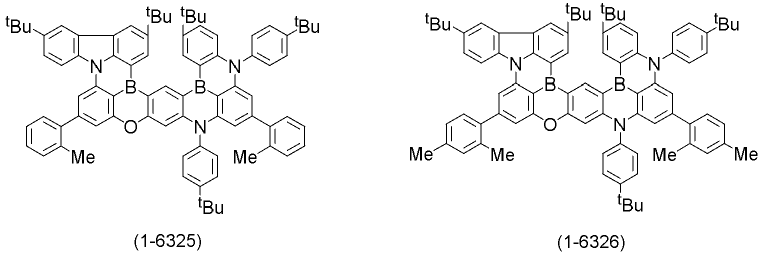

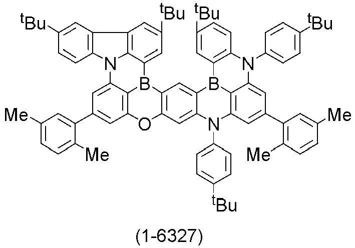

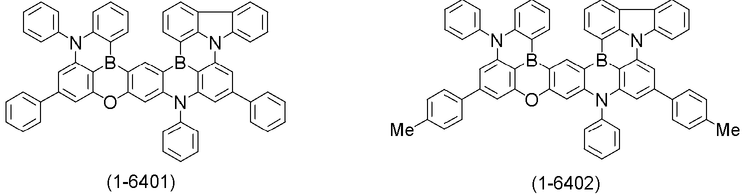

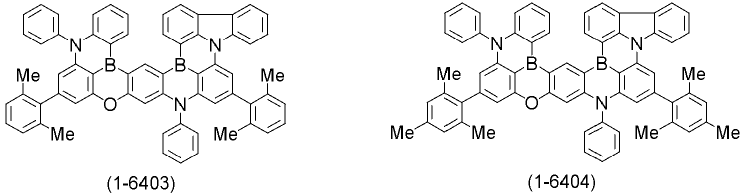

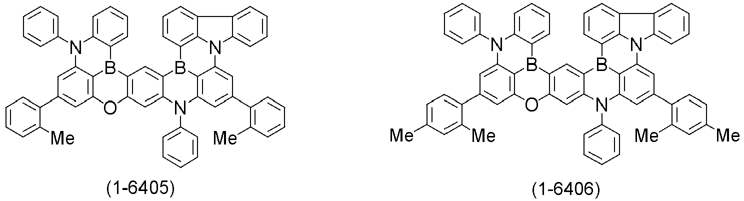

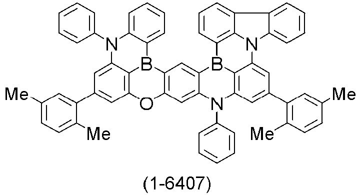

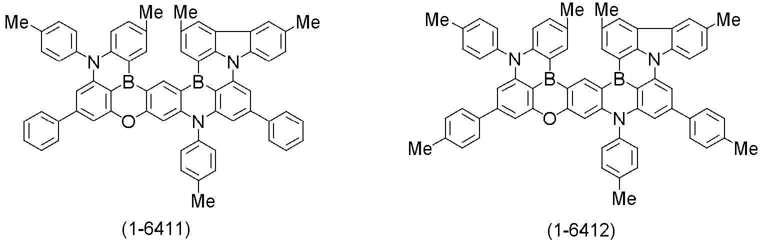

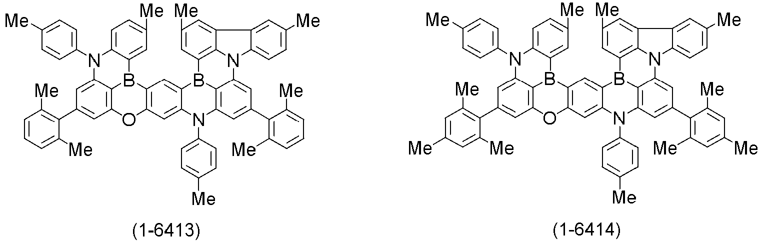

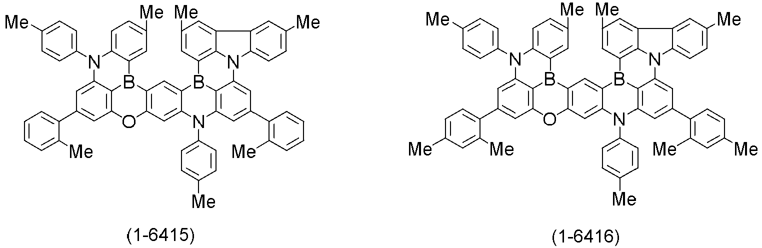

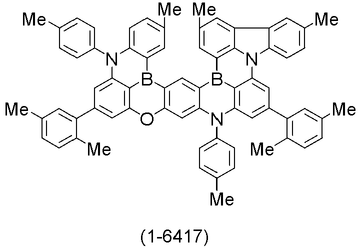

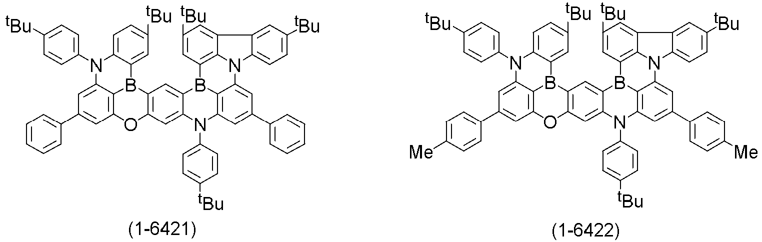

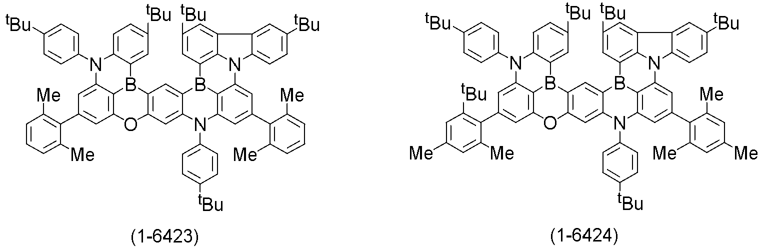

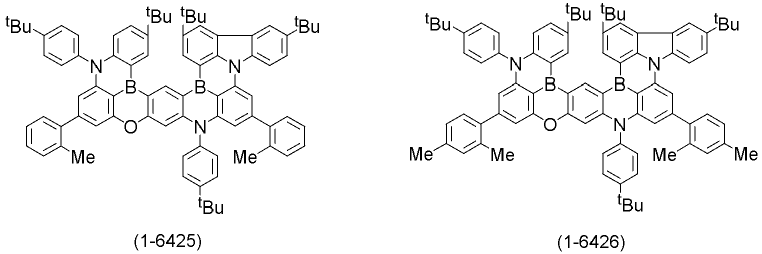

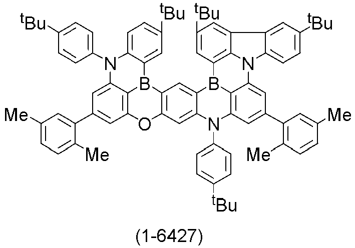

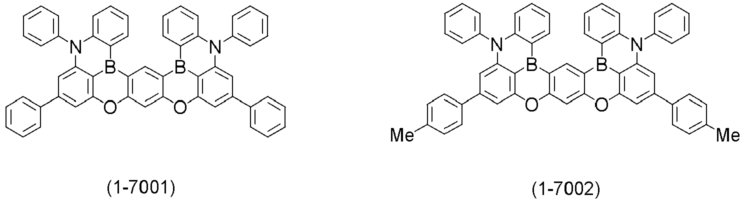

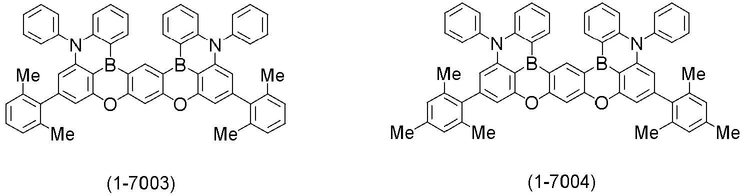

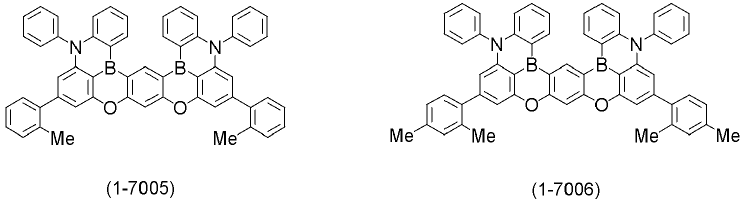

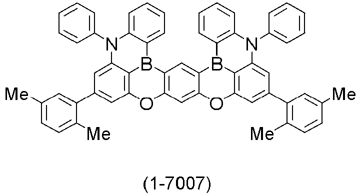

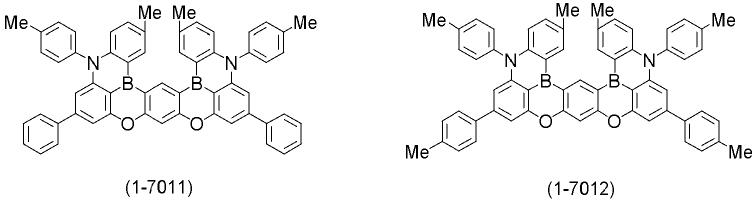

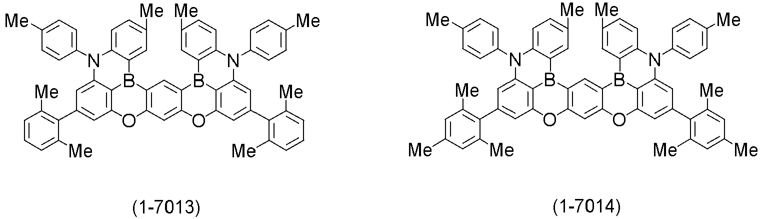

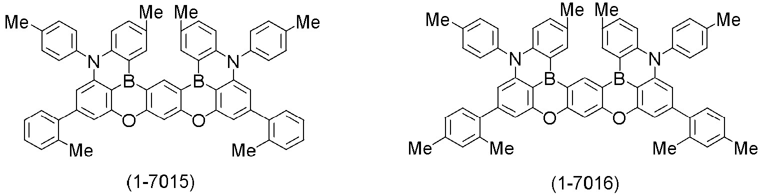

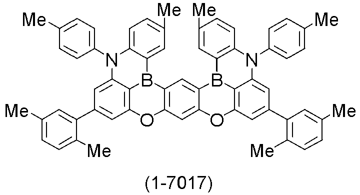

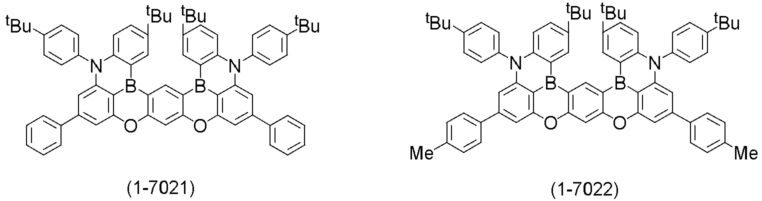

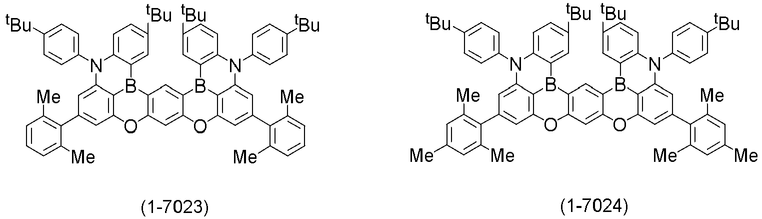

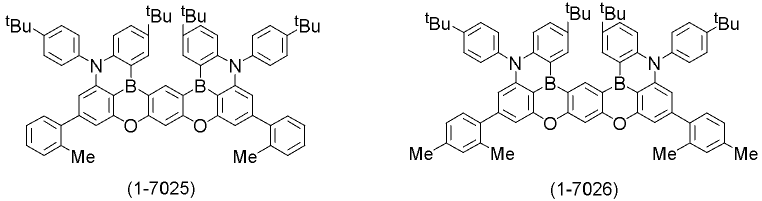

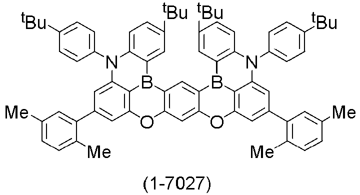

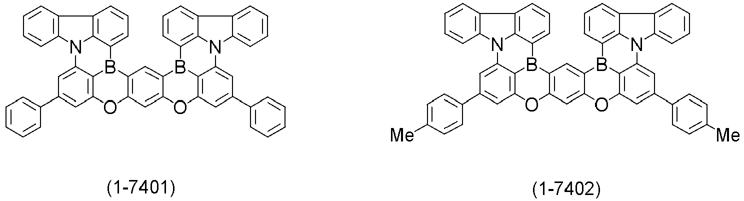

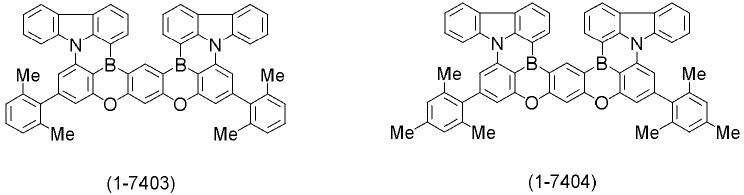

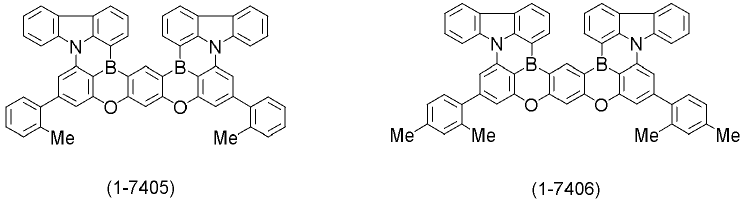

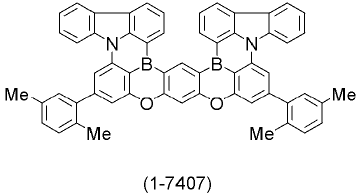

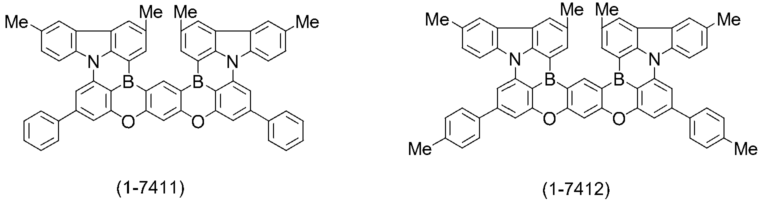

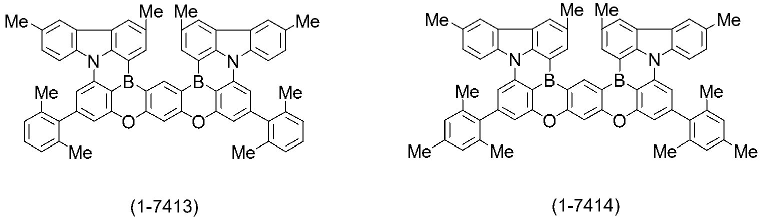

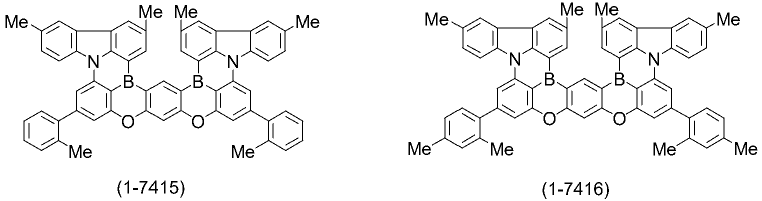

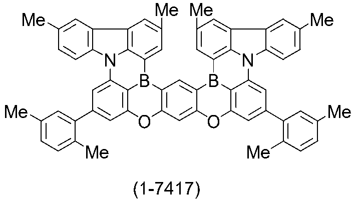

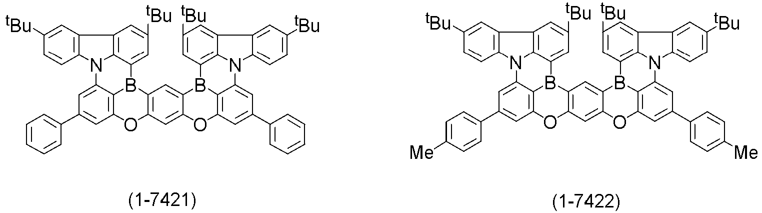

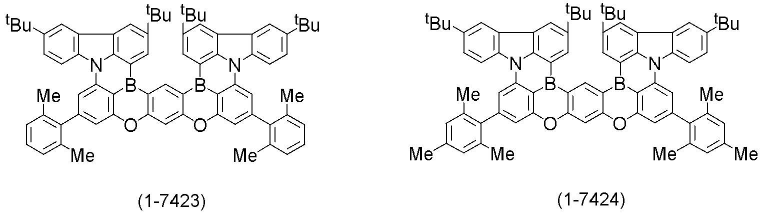

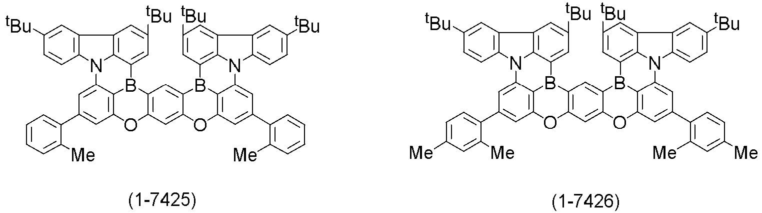

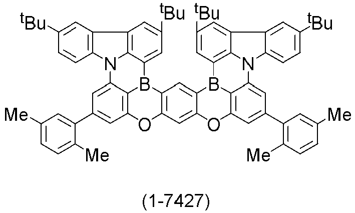

### 2. Method for manufacturing a polycyclic aromatic compound

Regarding a polycyclic aromatic compound represented by general formula (1) or (2), basically, an intermediate is manufactured by bonding the each ring structures (first reaction), and then a final product can be manufactured by bonding the each ring structures with a boron element (second reaction). In the first reaction, for example, a general etherification reaction such as a nucleophilic substitution reaction or an Ullmann reaction can be utilized, and a general amination reaction such as a Buchwald-Hartwig reaction can be utilized. In the second reaction, a Tandem Hetero-Friedel-Crafts reaction (continuous aromatic electrophilic substitution reaction, the same hereinafter) can be utilized. The definitions of each symbols in the formulas in the following schemes are the same as the definitions in general formula (1) or (2).

The second reaction is a reaction for introducing central element of boron that bonds the each rings as illustrated in the following scheme (1). First, hydrogen atoms between X¹ and X², X³ and X⁴ are ortho-metalated with n-butyllithium, sec-butyllithium, t-butyllithium, or the like. Subsequently, boron trichloride, boron tribromide, or the like is added thereto to perform lithium-boron metal exchange, and then a Brønsted base such as N,N-diisopropylethylamine is added thereto to induce a Tandem Bora-Friedel-Crafts reaction. Thus, a desired product can be obtained. In the second reaction, a Lewis acid such as aluminum trichloride may be added in order to accelerate the reaction.

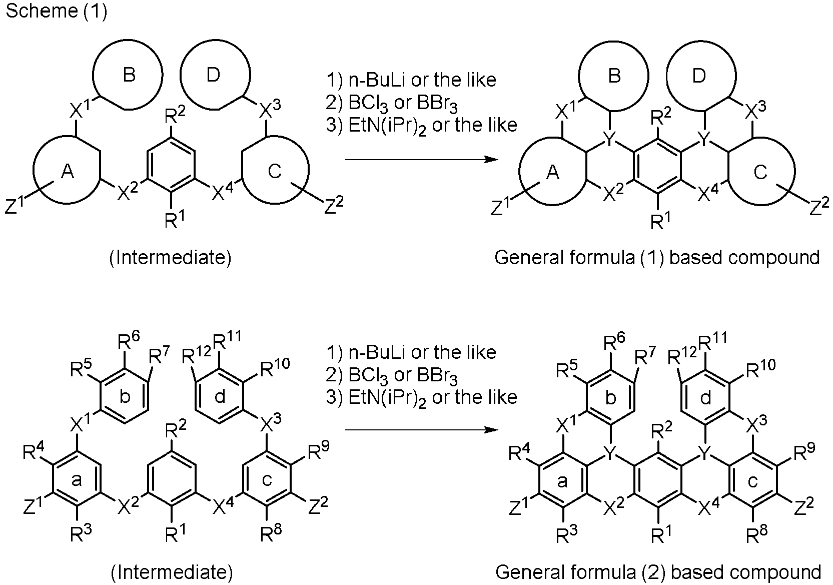

In scheme (1), lithium is introduced into a desired position by ortho-metalation. However, lithium can also be introduced into a desired position by halogen-metal exchange by introducing a halogen atom (Hal) to a position to which it is wished to introduce lithium, as in the following scheme (2). According to this method, a desired product can also be synthesized even in a case in which ortho-metalation cannot be achieved due to the influence of substituents, and therefore the method is useful.

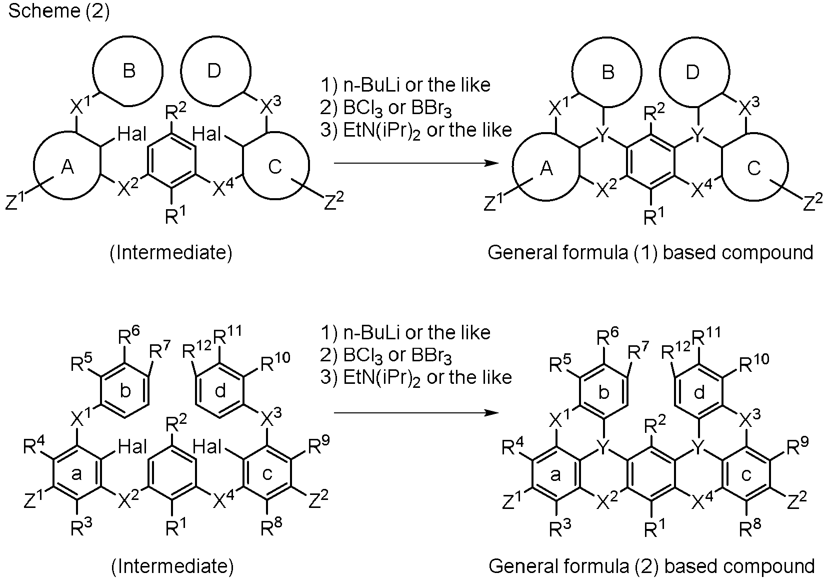

By appropriately selecting the above synthesis method and appropriately selecting raw materials to be used, it is possible to synthesize a polycyclic aromatic compound having a substituent at a desired position, in which Y is boron, and X¹, X², X³, and X⁴ are each independently >O, >N-R, >S or >Se.

Note that a location where a tandem Bora Friedel-Crafts reaction occurs may vary depending on, for example, rotation of an amino group in an intermediate, and therefore a by-product may be generated. In such a case, a target polycyclic aromatic compound can be isolated from such a mixture by chromatography, recrystallization, or the like.

Incidentally, examples of an ortho-metalation reagent used for the above schemes include an alkyllithium such as methyllithium, n-butyllithium, sec-butyllithium, or t-butyllithium; and an organic alkali compound such as lithium diisopropylamide, lithium tetramethylpiperidide, lithium hexamethyldisilazide, or potassium hexamethyldisilazide.

Incidentally, examples of a metal exchanging reagent for metal-"Y" (boron) used for the above schemes include a halide of boron such as trifluoride of boron, trichloride of boron, tribromide of boron, or triiodide of boron; an aminated halide of Y such as CIPN(NEt₂)₂; an alkoxylation product of Y; and an aryloxylation product of Y.

Incidentally, examples of the Brønsted base used for the above schemes include N,N-diisopropylethylamine, triethylamine, 2,2,6,6-tetramethylpiperidine, 1,2,2,6,6-pentamethylpiperidine, N,N-dimethylaniline, N,N-dimethyltoluidine, 2,6-lutidine, sodium tetraphenylborate, potassium tetraphenylborate, triphenylborane, tetraphenylsilane, Ar₄BNa, Ar₄BK, Ar₃B, and Ar₄Si (Ar represents an aryl such as phenyl).

Examples of a Lewis acid used for the above schemes include AlCl₃, AlBr₃, AlF₃, BF3 · OEt2, BCl₃, BBr₃, GaCl₃, GaBr₃, InCl₃, InBr₃, In(OTf)₃, SnCl₄, SnBr₄, AgOTf, ScCl₃, Sc(OTf)₃, ZnCl₂, ZnBr₂, Zn(OTf)₂, MgCl₂, MgBr₂, Mg(OTf)₂, LiOTf, NaOTf, KOTf, Me₃SiOTf, Cu(OTf)₂, CuCl₂, YCl₃, Y(OTf)₃, TiCl₄, TiBr₄, ZrCl₄, ZrBr₄, FeCl₃, FeBr₃, CoCl₃, and CoBr₃.

In the above schemes, a Bronsted base or a Lewis acid may be used in order to accelerate the Tandem Hetero Friedel-Crafts reaction. However, in a case where a halide of boron such as trifluoride of boron, trichloride of boron, tribromide of boron, or triiodide of boron is used, an acid such as hydrogen fluoride, hydrogen chloride, hydrogen bromide, or hydrogen iodide is generated along with progress of an aromatic electrophilic substitution reaction. Therefore, it is effective to use a Bronsted base that captures an acid. On the other hand, in a case where an aminated halide of boron or an alkoxylation product of boron is used, an amine or an alcohol is generated along with progress of the aromatic electrophilic substitution reaction. Therefore, in many cases, it is not necessary to use a Brønsted base. However, leaving ability of an amino group or an alkoxy group is low, and therefore it is effective to use a Lewis acid that promotes leaving of these groups.

A polycyclic aromatic compound represented by general formula (1) or (2) also includes compounds in which at least a portion of hydrogen atoms are substituted by cyanos, halogen atoms, or deuterium atoms. These compounds can be synthesized as described above using raw materials that are cyanated, halogenated, or deuterated at desired sites.

### 3. Organic device

The polycyclic aromatic compound according to an aspect of the present invention can be used as a material for an organic device. Examples of the organic device include an organic electroluminescent element, an organic field effect transistor, and an organic thin film solar cell.

### 3-1. Organic electroluminescent element

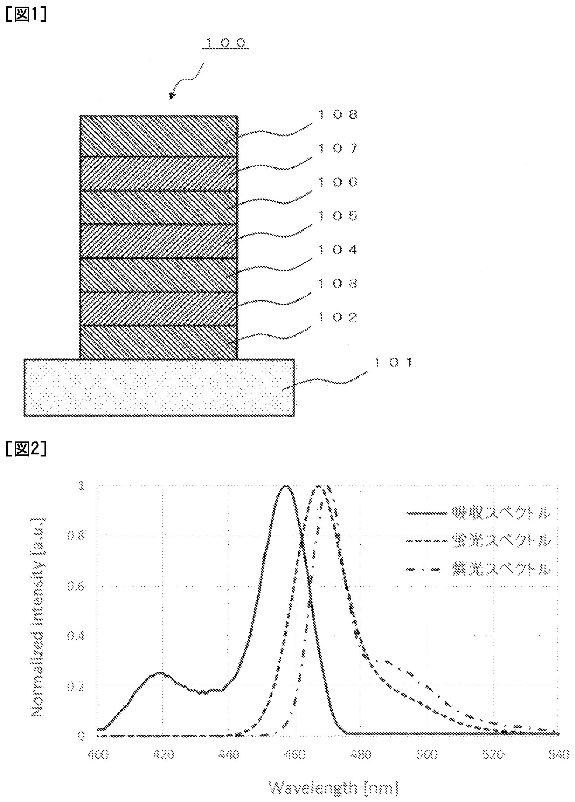

The polycyclic aromatic compound according to an aspect of the present invention can be used as, for example, a material for an organic electroluminescent element. Hereinafter, an organic EL element according to the present embodiment will be described in detail based on the drawings. FIG. 1 is a schematic cross-sectional view illustrating the organic EL element according to the present embodiment.

### <Structure of organic electroluminescent element>

An organic electroluminescent element 100 illustrated in FIG. 1 includes a substrate 101, a positive electrode 102 provided on the substrate 101, a hole injection layer 103 provided on the positive electrode 102, a hole transport layer 104 provided on the hole injection layer 103, a light emitting layer 105 provided on the hole transport layer 104, an electron transport layer 106 provided on the light emitting layer 105, an electron injection layer 107 provided on the electron transport layer 106, and a negative electrode 108 provided on the electron injection layer 107.

Incidentally, the organic electroluminescent element 100 may be constituted, by reversing the manufacturing order, to include, for example, the substrate 101, the negative electrode 108 provided on the substrate 101, the electron injection layer 107 provided on the negative electrode 108, the electron transport layer 106 provided on the electron injection layer 107, the light emitting layer 105 provided on the electron transport layer 106, the hole transport layer 104 provided on the light emitting layer 105, the hole injection layer 103 provided on the hole transport layer 104, and the positive electrode 102 provided on the hole injection layer 103.

Not all of the above layers are essential. The configuration includes the positive electrode 102, the light emitting layer 105, and the negative electrode 108 as a minimum constituent unit, while the hole injection layer 103, the hole transport layer 104, the electron transport layer 106, and the electron injection layer 107 are optionally provided. Furthermore, each of the above layers may be formed of a single layer or a plurality of layers.

A form of layers constituting the organic electroluminescent element may be, in addition to the above structure form of "substrate/positive electrode/hole injection layer/hole transport layer/light emitting layer/electron transport layer/electron injection layer/negative electrode", a structure form of "substrate/positive electrode/hole transport layer/light emitting layer/electron transport layer/electron injection layer/negative electrode", "substrate/positive electrode/hole injection layer/light emitting layer/electron transport layer/electron injection layer/negative electrode", "substrate/positive electrode/hole injection layer/hole transport layer/light emitting layer/electron injection layer/negative electrode", "substrate/positive electrode/hole injection layer/hole transport layer/light emitting layer/electron transport layer/negative electrode", "substrate/positive electrode/light emitting layer/electron transport layer/electron injection layer/negative electrode", "substrate/positive electrode/hole transport layer/light emitting layer/electron injection layer/negative electrode", "substrate/positive electrode/hole transport layer/light emitting layer/electron transport layer/negative electrode", "substrate/positive electrode/hole injection layer/light emitting layer/electron injection layer/negative electrode", "substrate/positive electrode/hole injection layer/light emitting layer/electron transport layer/negative electrode", "substrate/positive electrode/light emitting layer/electron transport layer/negative electrode", or "substrate/positive electrode/light emitting layer/electron injection layer/negative electrode".

### <Substrate in organic electroluminescent element>

The substrate 101 serves as a support of the organic electroluminescent element 100, and usually, quartz, glass, metals, plastics, and the like are used therefor. The substrate 101 is formed into a plate shape, a film shape, or a sheet shape according to a purpose, and for example, a glass plate, a metal plate, a metal foil, a plastic film, and a plastic sheet are used. Among these examples, a glass plate and a plate made of a transparent synthetic resin such as polyester, polymethacrylate, polycarbonate, or polysulfone are preferable. For a glass substrate, soda lime glass, alkali-free glass, and the like are used. The thickness is only required to be a thickness sufficient for maintaining mechanical strength. Therefore, the thickness is only required to be 0.2 mm or more, for example. The upper limit value of the thickness is, for example, 2 mm or less, and preferably 1 mm or less. Regarding a material of glass, glass having fewer ions eluted from the glass is desirable, and therefore alkali-free glass is preferable. However, soda lime glass which has been subjected to barrier coating with SiO₂ or the like is also commercially available, and therefore this soda lime glass can be used. Furthermore, the substrate 101 may be provided with a gas barrier film such as a dense silicon oxide film on at least one surface in order to increase a gas barrier property. Particularly in a case of using a plate, a film, or a sheet made of a synthetic resin having a low gas barrier property as the substrate 101, a gas barrier film is preferably provided.

### <Positive electrode in organic electroluminescent element>

The positive electrode 102 plays a role of injecting a hole into the light emitting layer 105. Incidentally, in a case where the hole injection layer 103 and/or the hole transport layer 104 are/is provided between the positive electrode 102 and the light emitting layer 105, a hole is injected into the light emitting layer 105 through these layers.

Examples of a material to form the positive electrode 102 include an inorganic compound and an organic compound. Examples of the inorganic compound include a metal (aluminum, gold, silver, nickel, palladium, chromium, and the like), a metal oxide (indium oxide, tin oxide, indium-tin oxide (ITO), indium-zinc oxide (IZO), and the like), a metal halide (copper iodide and the like), copper sulfide, carbon black, ITO glass, and Nesa glass. Examples of the organic compound include an electrically conductive polymer such as polythiophene such as poly(3-methylthiophene), polypyrrole, or polyaniline. In addition to these compounds, a material can be appropriately selected for use from materials used as a positive electrode of an organic electroluminescent element.

A resistance of a transparent electrode is not limited as long as a sufficient current can be supplied to light emission of a luminescent element. However, low resistance is desirable from a viewpoint of consumption power of the luminescent element. For example, an ITO substrate having a resistance of 300 Ω/□ or less functions as an element electrode. However, a substrate having a resistance of about 10 Ω/□ can be also supplied at present, and therefore it is particularly desirable to use a low resistance product having a resistance of, for example, 100 to 5 Ω/□, preferably 50 to 5 Ω/□. The thickness of an ITO can be arbitrarily selected according to a resistance value, but an ITO having a thickness of 50 to 300 nm is often used.

### <Hole injection layer and hole transport layer in organic electroluminescent element>

The hole injection layer 103 plays a role of efficiently injecting a hole that migrates from the positive electrode 102 into the light emitting layer 105 or the hole transport layer 104. The hole transport layer 104 plays a role of efficiently transporting a hole injected from the positive electrode 102 or a hole injected from the positive electrode 102 through the hole injection layer 103 to the light emitting layer 105. The hole injection layer 103 and the hole transport layer 104 are each formed by laminating and mixing one or more kinds of hole injection/transport materials, or by a mixture of a hole injection/transport material and a polymer binder. Furthermore, a layer may be formed by adding an inorganic salt such as iron(III) chloride to the hole injection/transport materials.

A hole injecting/transporting substance needs to efficiently inject/transport a hole from a positive electrode between electrodes to which an electric field is applied, and preferably has high hole injection efficiency and transports an injected hole efficiently. For this purpose, a substance which has low ionization potential, large hole mobility, and excellent stability, and in which impurities that serve as traps are not easily generated at the time of manufacturing and at the time of use, is preferable.

As a material to form the hole injection layer 103 and the hole transport layer 104, any compound can be selected for use among compounds that have been conventionally used as charge transporting materials for holes, p-type semiconductors, and known compounds used in a hole injection layer and a hole transport layer of an organic electroluminescent element.

Specific examples thereof include a heterocyclic compound including a carbazole derivative (N-phenylcarbazole, polyvinylcarbazole, and the like), a biscarbazole derivative such as bis(N-arylcarbazole) or bis(N-alkylcarbazole), a triarylamine derivative (a polymer having an aromatic tertiary amino in a main chain or a side chain, 1,1-bis(4-di-p-tolylaminophenyl)cyclohexane, N,N'-diphenyl-N,N'-di(3-methylphenyl)-4,4'-diaminobipheny l, N,N'-diphenyl-N,N'-dinaphthyl-4,4'-diaminobiphenyl, N,N'-diphenyl-N,N'-di(3-methylphenyl)-4,4'-diphenyl-1,1'-diamine, N,N'-dinaphthyl-N,N'-diphenyl-4,4'-dphenyl-1,1'-diamine, N⁴,N⁴'-diphenyl-N⁴,N⁴'-bis(9-phenyl-9H-carbazol-3-yl)-[1,1 '-biphenyl]-4,4'-diamine, N⁴,N⁴,N⁴',N⁴'-tetra[1,1'-biphenyl]-4-yl)-[1,1'-biphenyl]-4 ,4'-diamine, a triphenylamine derivative such as 4,4',4"-tris(3-methylphenyl(phenyl)amino)triphenylamine, a starburst amine derivative, and the like), a stilbene derivative, a phthalocyanine derivative (non-metal, copper phthalocyanine, and the like), a pyrazoline derivative, a hydrazone-based compound, a benzofuran derivative, a thiophene derivative, an oxadiazole derivative, a quinoxaline derivative (for example, 1,4,5,8,9,12-hexaazatriphenylene-2,3,6,7,10,11-hexacarbon itrile, and the like), and a porphyrin derivative, and a polysilane. Among the polymer-based materials, a polycarbonate, a styrene derivative, a polyvinylcarbazole, a polysilane, and the like having the above monomers in side chains are preferable. However, there is no particular limitation as long as a compound can form a thin film required for manufacturing a luminescent element, can inject a hole from a positive electrode, and can further transport a hole.

Furthermore, it is also known that electroconductivity of an organic semiconductor is strongly affected by doping into the organic semiconductor. Such an organic semiconductor matrix substance is formed of a compound having a good electron-donating property, or a compound having a good electron-accepting property. For doping with an electron-donating substance, a strong electron acceptor such as tetracyanoquinonedimethane (TCNQ) or 2,3,5,6-tetrafluorotetracyano-1,4-benzoquinonedimethane (F4TCNQ) is known (see, for example, "M. Pfeiffer, A. Beyer, T. Fritz, K. Leo, Appl. Phys. Lett., 73(22), 3202-3204 (1998)" and "J. Blochwitz, M. Pheiffer, T. Fritz, K. Leo, Appl. Phys. Lett., 73(6), 729-731 (1998)"). These compounds generate a so-called hole by an electron transfer process in an electron-donating type base substance (hole transporting substance). Electroconductivity of the base substance depends on the number and mobility of the holes fairly significantly. Known examples of a matrix substance having a hole transporting characteristic include a benzidine derivative (TPD and the like), a starburst amine derivative (TDATA and the like), and a specific metal phthalocyanine (particularly, zinc phthalocyanine (ZnPc) and the like) (JP 2005-167175 A).

### <Light emitting layer in organic electroluminescent element>

The light emitting layer 105 emits light by recombining a hole injected from the positive electrode 102 and an electron injected from the negative electrode 108 between electrodes to which an electric field is applied. A material to form the light emitting layer 105 is only required to be a compound which is excited by recombination between a hole and an electron and emits light (luminescent compound), and is preferably a compound which can form a stable thin film shape, and exhibits strong light emission (fluorescence) efficiency in a solid state. In the present invention, as a material for a light emitting layer, a polycyclic aromatic compound represented by the above general formula (1) can be used.

The light emitting layer may be formed of a single layer or a plurality of layers, and each layer is formed of a material for a light emitting layer (a host material and a dopant material). Each of the host material and the dopant material may be formed of a single kind, or a combination of a plurality of kinds. The dopant material may be included in the host material wholly or partially. Regarding a doping method, doping can be performed by a co-deposition method with a host material, or alternatively, a dopant material may be mixed in advance with a host material, and then vapor deposition may be carried out simultaneously, or a dopant material may be mixed in advance with a host material together with an organic solvent, and then a layer may be formed by a wet film formation method.

The amount of use of the host material depends on the kind of the host material, and may be determined according to a characteristic of the host material. The reference of the amount of use of the host material is preferably from 50 to 99.999% by weight, more preferably from 80 to 99.95% by weight, and still more preferably from 90 to 99.9% by weight with respect to the total amount of a material for a light emitting layer.

The amount of use of the dopant material depends on the kind of the dopant material, and may be determined according to a characteristic of the dopant material. The reference of the amount of use of the dopant is preferably from 0.001 to 50% by weight, more preferably from 0.05 to 20% by weight, and still more preferably from 0.1 to 10% by weight with respect to the total amount of a material for a light emitting layer. The amount of use within the above range is preferable, for example, from a viewpoint of being able to prevent a concentration quenching phenomenon.

Meanwhile, in an organic electroluminescent element using a thermally activated delayed fluorescent dopant material, the use amount of the dopant material preferably has a lower concentration in terms of preventing concentration quenching, but the use amount of the dopant material preferably has a higher concentration in terms of an efficiency of a thermally activated delayed fluorescent mechanism. Furthermore, in an organic electroluminescent element using a thermally activated delayed fluorescent assist dopant material, the use amount of a dopant material preferably has a lower concentration than the use amount of the assist dopant material in terms of an efficiency of a thermally activated delayed fluorescent mechanism of the assist dopant material.

When an assist dopant material is used, the use amounts of a host material, the assist dopant material, and a dopant material are usually 40 to 99.999% by weight, 59 to 1% by weight, and 20 to 0.001% by weight, preferably 60 to 99.99% by weight, 39 to 5% by weight, and 10 to 0.01% by weight, and more preferably 70 to 99.95% by weight, 29 to 10% by weight, and 5 to 0.05% by weight, respectively with respect to the entire material for a light emitting layer. The compound according to the present invention and a polymer compound thereof can also be used as an assist dopant material.

Examples of the host material include a fused ring derivative of anthracene, pyrene, or the like conventionally known as a luminous body, a bisstyryl derivative such as a bisstyrylanthracene derivative, a distyrylbenzene derivative, or the like, a tetraphenylbutadiene derivative, a cyclopentadiene derivative, a fluorene derivative, and a benzofluorene derivative.

T1 energy of the host material is preferably higher than T1 energy of a dopant or an assist dopant having the highest T1 energy in a light emitting layer from a viewpoint of promoting generation of TADF in the light emitting layer without inhibiting the generation. Specifically, T1 energy of the host is preferably 0.01 eV or more, more preferably 0.03 eV or more, and still more preferably 0.1 eV or more. A TADF active compound may be used as the host material.

Examples of the host material include a compound represented by the following general formula (3) and a compound represented by the following general formula (4).

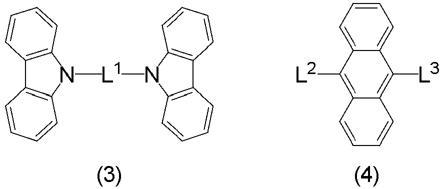

In the above formula (3), L¹ represents an arylene having 6 to 24 carbon atoms, preferably an arylene having 6 to 16 carbon atoms, more preferably an arylene having 6 to 12 carbon atoms, and particularly preferably an arylene having 6 to 10 carbon atoms. Specific examples include divalent groups of a benzene ring, a biphenyl ring, a naphthalene ring, a terphenyl ring, an acenaphthylene ring, a fluorene ring, a phenalene ring, a phenanthrene ring, a triphenylene ring, a pyrene ring, a naphthacene ring, a perylene ring, a pentacene ring, and the like.

In the above formula (4), L² and L³ represent each independently an aryl having 6 to 30 carbon atoms or a heteroaryl having 2 to 30 carbon atoms. As the aryl, an aryl having 6 to 24 carbon atoms is preferable, an aryl having 6 to 16 carbon atoms is more preferable, an aryl having 6 to 12 carbon atoms is further preferable, an aryl having 6 to 10 carbon atoms is particularly preferable. Specific examples include monovalent groups of a benzene ring, a biphenyl ring, a naphthalene ring, a terphenyl ring, an acenaphthylene ring, a fluorene ring, a phenalene ring, a phenanthrene ring, a triphenylene ring, a pyrene ring, a naphthacene ring, a perylene ring, a pentacene ring, and the like. As the heteroaryl, a heteroaryl having 2 to 25 carbon atoms is preferable, a heteroaryl having 2 to 20 carbon atoms is more preferable, a heteroaryl having 2 to 15 carbon atoms is more preferable, and a heteroaryl having 2 to 10 carbon atoms is particularly preferable. Specific examples include a pyrrole ring, an oxazole ring, an isoxazole ring, a thiazole ring, an isothiazole ring, an imidazole ring, an oxadiazole ring, a thiadiazole ring, a triazole ring, a tetrazole ring, a pyrazole ring, a pyridine ring, a pyrimidine ring, a Pyridazine ring, a pyrazine ring, a triazine ring, an indole ring, an isoindole ring, a 1H-indazole ring, a benzimidazole ring, a benzoxazole ring, a benzothiazole ring, a 1H-benzotriazole ring, a quinoline ring, an isoquinoline ring, a cinnoline ring, a quinazoline ring, a quinoxaline ring, a phthalazine ring, a naphthyridine ring, a purine ring, a pteridine ring, a carbazole ring, an acridine ring, a phenoxathiin ring, a phenoxazine ring, a phenothiazine ring, a phenazine ring, an indolizine ring, a furan ring, a benzofuran ring, an isobenzofuran ring, a dibenzofuran ring, a thiophene ring, a benzothiophene ring, a dibenzothiophene ring, a furazane ring, an oxadiazole ring, a thianthrene ring, and the like. At least one hydrogen atom in the compound represented by formula (3) or formula (4) may be substituted by an alkyl having 1 to 6 carbons, cyano, halogen atom, or deuterium atom.

Moreover, as a host material, a compound represented by following general formula (5) is mentioned, for example.

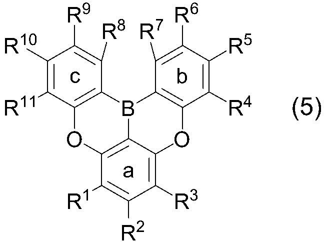

In the above formula (5),
R¹ to R¹¹ each independently represent a hydrogen atom, an aryl, a heteroaryl, a diarylamino, a diheteroarylamino, an arylheteroarylamino or alkyl (primary substituents); at least one hydrogen atom in these may be substituted by an aryl, a heteroaryl, a diarylamino, or an alkyl (secondary substituents);
Adjacent groups among R¹ to R¹¹ may be bonded to each other to form an aryl ring or a heteroaryl ring together with the ring a, ring b or ring c; at least one hydrogen atom in the ring thus formed may be substituted by an aryl, a heteroaryl, a diarylamino, a diheteroarylamino, an arylheteroarylamino, or an alkyl (primary substituents); at least one hydrogen atom in these may be substituted by an aryl, a heteroaryl, a diarylamino, or an alkyl (secondary substituents);
At least one hydrogen atom in the compound represented by the formula (5) each independently may be substituted by a halogen atom or a deuterium atom.

Preferably, in the above formula (5),
R¹ to R¹¹ each independently represent a hydrogen atom, an aryl having 6 to 30 carbon atoms, a heteroaryl having 2 to 30 carbon atoms, a diarylamino (the aryl is an aryl having 6 to 12 carbon atoms), or alkyl having 1 to 12 carbon atoms; at least one hydrogen atom in these may be substituted by an aryl having 6 to 30 carbon atoms, a heteroaryl having 2 to 30 carbon atoms, a diarylamino (the aryl is an aryl having 6 to 12 carbon atoms), or an alkyl having 1 to 12 carbon atoms;
Adjacent groups among R¹ to R¹¹ may be bonded to each other to form an aryl ring having 9 to 16 carbon atoms or a heteroaryl ring having 6 to 15 carbon atoms together with the ring a, ring b or ring c; at least one hydrogen atom in the ring thus formed may be substituted by an aryl having 6 to 30 carbon atoms, a heteroaryl having 2 to 30 carbon atoms, a diarylamino (the aryl is an aryl having 6 to 12 carbon atoms), or an alkyl having 1 to 12 carbon atoms; at least one hydrogen atom in these may be substituted by an aryl having 6 to 30 carbon atoms, a heteroaryl having 2 to 30 carbon atoms, a diarylamino (the aryl is an aryl having 6 to 12 carbon atoms), or an alkyl having 1 to 12 carbon atoms.

More preferably, in the above formula (5),
R¹ to R¹¹ each independently represent a hydrogen atom, an aryl having 6 to 16 carbon atoms, a heteroaryl having 2 to 15 carbon atoms, a diarylamino (the aryl is an aryl having 6 to 10 carbon atoms), or alkyl having 1 to 6 carbon atoms; at least one hydrogen atom in these may be substituted by an aryl having 6 to 16 carbon atoms, a heteroaryl having 2 to 15 carbon atoms, a diarylamino (the aryl is an aryl having 6 to 10 carbon atoms), or an alkyl having 1 to 6 carbon atoms;
Adjacent groups among R¹ to R¹¹ may be bonded to each other to form an aryl ring having 9 to 12 carbon atoms or a heteroaryl ring having 6 to 12 carbon atoms together with the ring a, ring b or ring c; at least one hydrogen atom in the ring thus formed may be substituted by an aryl having 6 to 16 carbon atoms, a heteroaryl having 2 to 15 carbon atoms, a diarylamino (the aryl is an aryl having 6 to 10 carbon atoms), or an alkyl having 1 to 6 carbon atoms; at least one hydrogen atom in these may be substituted by an aryl having 6 to 16 carbon atoms, a heteroaryl having 2 to 15 carbon atoms, a diarylamino (the aryl is an aryl having 6 to 10 carbon atoms), or an alkyl having 1 to 6 carbon atoms.

In the primary substituents and the secondary substituents, examples of "aryl" and "heteroaryl" in the aryl, the heteroaryl, the diarylamino, the diheteroarylamino, and the arylheteroarylamino include the following examples.

Specific example of "aryl" includes, for example, an aryl having 6 to 30 carbon atoms, preferably an aryl having 6 to 24 carbon atoms, more preferably an aryl having 6 to 20 carbon atoms, still more preferably an aryl having 6 to 16 carbon atoms, particularly preferably an aryl having 6 to 12 carbon atoms, most preferably an aryl having 6 to 10 carbon atoms. Specific examples include phenyl which is a monocyclic aryl; (2-, 3-, 4-)biphenylyl which are bicyclic aryls; (1-, 2-)naphthyl which are fused bicyclic aryls; terphenylyl (m-terphenyl-2'-yl, m-terphenyl-4'-yl, m-terphenyl-5'-yl, o-terphenyl-3'-yl, o-terphenyl-4'-yl, p-terphenyl-2'-yl, m-terphenyl-2-yl, m-terphenyl-3-yl, m-terphenyl-4-yl, o-terphenyl-2-yl, o-terphenyl-3-yl, o-terphenyl-4-yl, p-terphenyl-2-yl, p-terphenyl-3-yl, p-terphenyl-4-yl) which are tricyclic aryls; acenaphthylene-(1-, 3-, 4-, 5-)yl, fluorene-(1-,2-, 3-, 4-, 9-)yl, phenalene-(1-, 2-)yl, and (1-, 2-, 3-, 4-, 9-)phenanthryl which are fused tricyclic aryls; quaterphenylyl (5'-phenyl-m-terphenyl-2-yl, 5'-phenyl-m-terphenyl-3-yl, 5'-phenyl-m-terphenyl-4, m-quaterphenylyl) which are tetracyclic aryls; triphenylene-(1-, 2-)yl, pyrene-(1-, 2-, 4-)yl, and naphthacene- (1-, 2-, 5-)yl which are fused tetracyclic aryls; and perylene- (1-, 2-, 3-)yl and Pentacene- (1-, 2-, 5-, 6-)yl which are fused pentacyclic aryls.

Specific example of "heteroaryl" includes, for example, a heteroaryl having 2 to 30 carbon atoms, preferably a heteroaryl having 2 to 25 carbon atoms, more preferably a heteroaryl having 2 to 20 carbon atoms, still more preferably a heteroaryl having 2 to 15 carbon atoms, particularly preferably a heteroaryl having 2 to 10 carbon atoms. Specific examples include furyl, thienyl, pyrrolyl, oxazolyl, isoxazolyl, thiazolyl, isothiazolyl, imidazolyl, pyrazolyl, oxadiazolyl, furazanyl, thiadiazolyl, triazolyl, tetrazolyl, pyridyl, pyrimidinyl, pyridazinyl, pyrazinyl, triazinyl, benzofuranyl, isobenzofuranyl, benzo[b]thienyl, indolyl, isoindolyl, 1H-indazolyl, benzoimidazolyl, benzoxazolyl, benzothiazolyl, 1H-benzotriazolyl, quinolyl, isoquinolyl, cinnolyl, quinazolyl, quinoxalinyl, phthalazinyl, naphthyridinyl, purinyl, pteridinyl, carbazolyl, acridinyl, phenoxazinyl, phenothiazinyl, phenazinyl, phenoxathiinyl, thianthrenyl, and indolizinyl.

In the primary substituents and the secondary substituents, the "alkyl" may be either linear or branched, and examples thereof include a linear alkyl having 1 to 24 carbon atoms and a branched alkyl having 3 to 24 carbon atoms. An alkyl having 1 to 18 carbon atoms (branched alkyl having 3 to 18 carbon atoms) is preferable, an alkyl having 1 to 12 carbon atoms (branched alkyl having 3 to 12 carbon atoms) is more preferable, an alkyl having 1 to 6 carbon atoms (branched alkyl having 3 to 6 carbon atoms) is still more preferable, and an alkyl having 1 to 4 carbon atoms (branched alkyl having 3 or 4 carbon atoms) is particularly preferable, and methyl is most preferable. Specific examples include methyl, ethyl, n-propyl, isopropyl, n-butyl, isobutyl, s-butyl, t-butyl, n-pentyl, isopentyl, neopentyl, t-pentyl, n-hexyl, 1-methylpentyl, 4-methyl-2-pentyl, 3,3-dimethylbutyl, 2-ethylbutyl, n-heptyl, 1-methylhexyl, n-octyl, t-octyl, 1-methylheptyl, 2-ethylhexyl, 2-propylpentyl, n-nonyl, 2,2-dimethylheptyl, 2,6-dimethyl-4-heptyl, 3,5,5-trimethylhexyl, n-decyl, n-undecyl, 1-methyldecyl, n-dodecyl, n-tridecyl, 1-hexylheptyl, n-tetradecyl, n-pentadecyl, n-hexadecyl, n-heptadecyl, n-octadecyl, and n-eicosyl.

In the case the primary substituent is an aryl, the substitution position is preferably R¹, R³, R⁴, R⁵, R¹⁰ and R¹¹. For example, substitution to R¹ and R³, substitution to R⁵ and R¹⁰, and substitution to R⁴ and R¹¹ are more preferable. The aryl is preferably a phenyl group.

In the case the primary substituent is a heteroaryl, the substitution position is preferably R¹, R², R³, R⁴, R⁵, R⁶, R⁹, R¹⁰ and R¹¹. For example, substitution to R¹, substitution to R², substitution to R³, substitution to R¹ and R³, substitution to R⁴ and R¹¹, substitution to R⁵ and R¹⁰, and substitution to R⁶ and R⁹ are more preferable. The heteroaryl is preferably a carbazolyl group. This heteroaryl (for example, carbazolyl) may bond to the above position via a phenylene group.

Specific examples of the compound represented by formula (5) include, for example, compounds represented by the following structural formulas. In the formulas, "Me" is a methyl group.

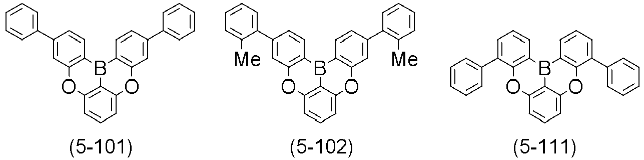

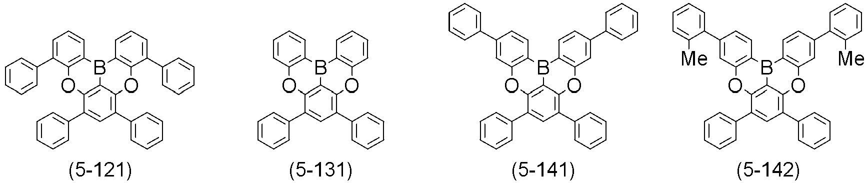

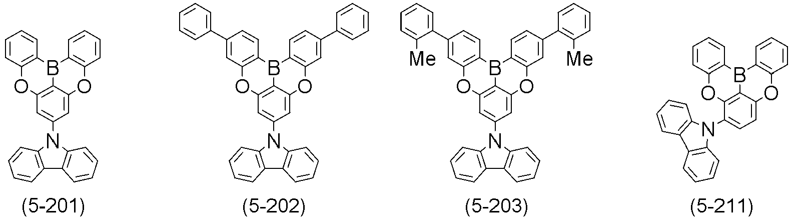

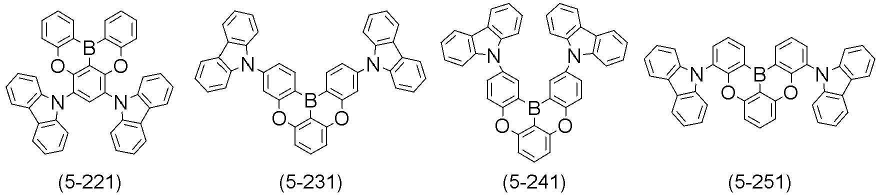

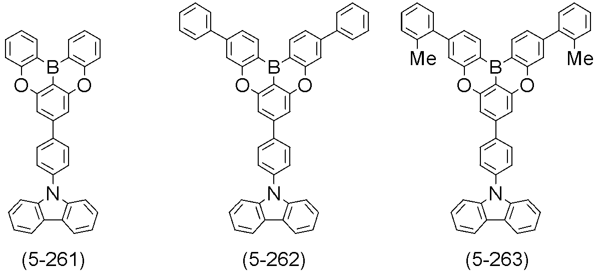

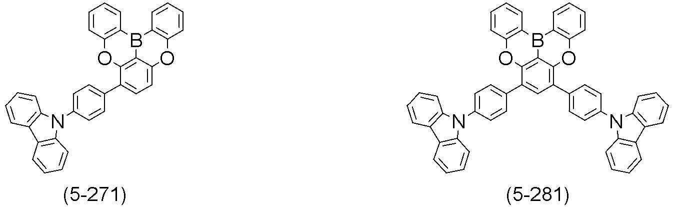

For a compound represented by formula (5), first, rings a to c are bonded via a bonding group (-O-) to manufacture an intermediate (first reaction), and then the rings a to c are bonded via B (boron) to manufacture a final product (second reaction). In the first reaction, a general etherification reaction such as a nucleophilic substitution reaction or an Ullmann reaction can be used. In the second reaction, a Tandem Hetero-Friedel-Crafts reaction (continuous aromatic electrophilic substitution reaction) can be used. Details of the first and second reactions can be referred to the description described in WO 2015/102118 A.

Regarding the host material, as other examples, host materials described in Advanced Materials, 2017, 29, 1605444, Journal of Material Chemistry C, 2016, 4, 11355-11381, Chemical Science, 2016, 7, 3355-3363, and Thin Solid Films, 2016, 619, 120-124 can be used. Since the TADF organic EL element requires high T1 energy as a host material of a light emitting layer, the host material for a phosphorescent organic EL element described in Chemistry Society Reviews, 2011, 40, 2943-2970 can also be used as a host material for the TADF organic EL element.

More specifically, the host compound has at least one structure selected from a partial structure (H-A) group represented by the following formulas. At least one hydrogen atom in each structure in the partial structure (H-A) group may be substituted by any structure in the partial structure (H-A) group or a partial structure (H-B) group, and at least one hydrogen atom in these structures may be substituted by a deuterium atom, a halogen atom, cyano, an alkyl having 1 to 4 carbon atoms (for example, methyl or t-butyl), trimethylsilyl, or phenyl.

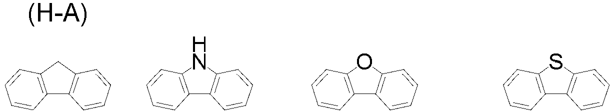

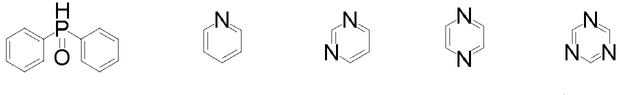

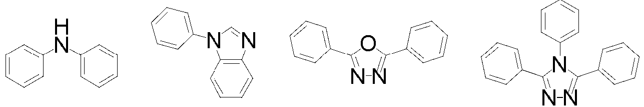

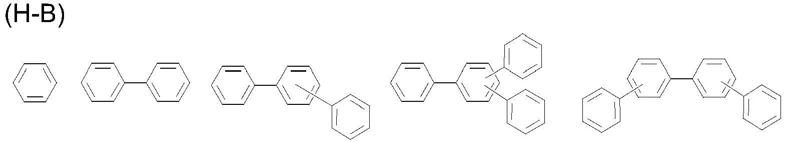

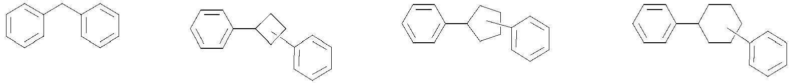

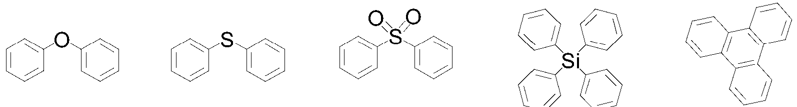

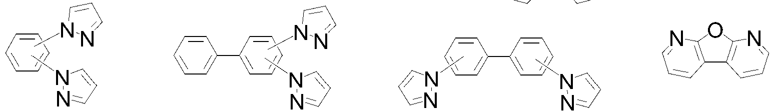

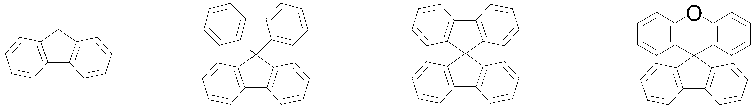

The host compound is preferably a compound represented by any one of structural formulas listed below. Among these compounds, the host compound is more preferably a compound having one to three structures selected from the above partial structure (H-A) group and one structure selected from the above partial structure (H-B) group, still more preferably a compound having a carbazole group as the partial structure (H-A) group, and particularly preferably a compound represented by the following formula (3-201), (3-202), (3-203), (3-204), (3-212), (3-221), (3-222), (3-261), or (3-262). Note that in the structural formulas listed below, at least one hydrogen atom may be substituted by a halogen atom, cyano, an alkyl having 1 to 4 carbon atoms (for example, methyl or t-butyl), phenyl, naphthyl, or the like.

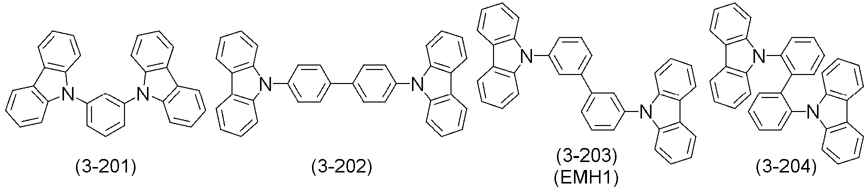

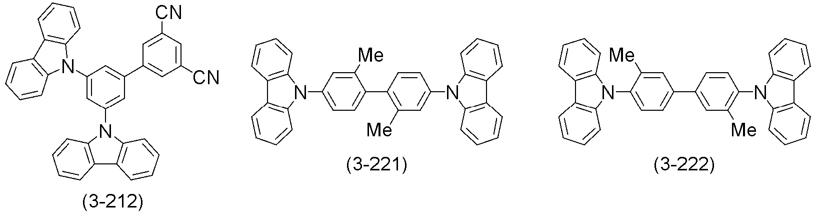

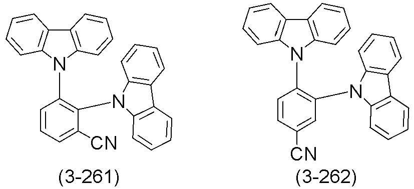

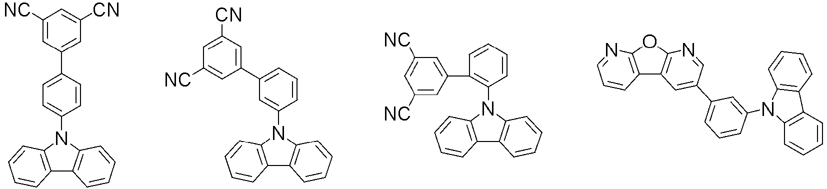

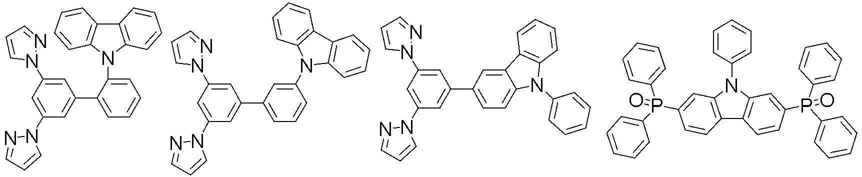

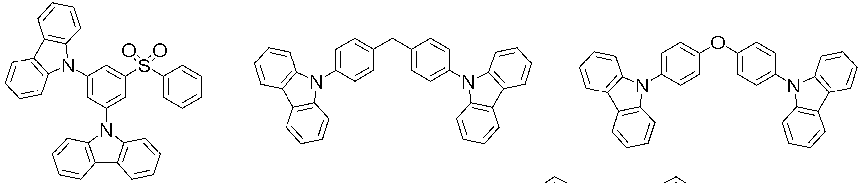

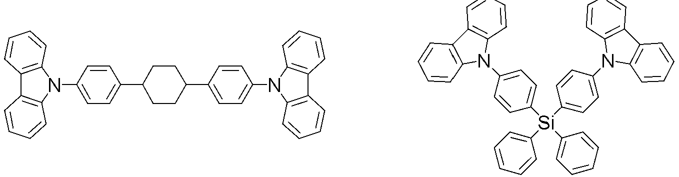

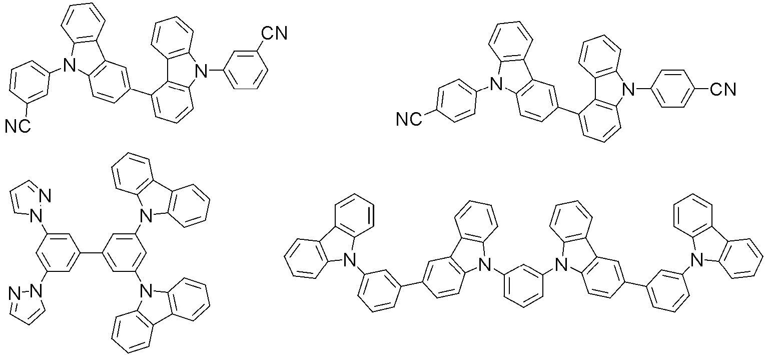

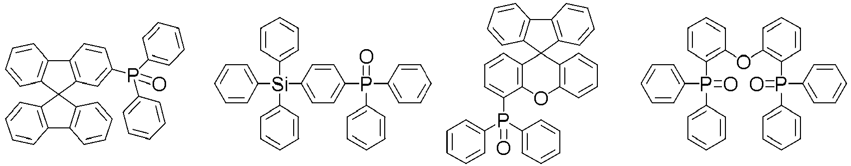

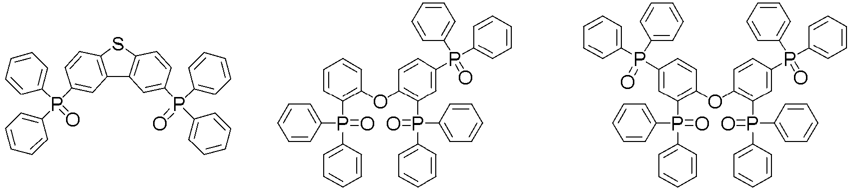

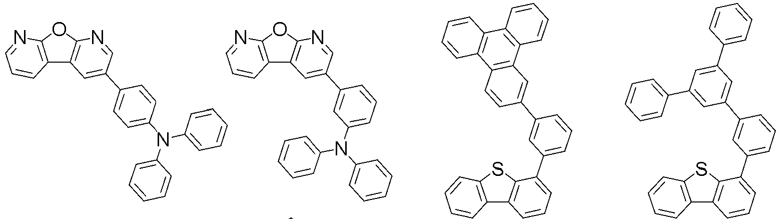

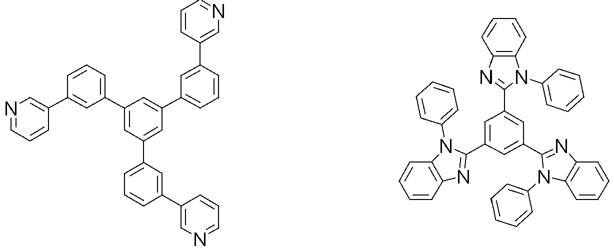

Also, the following polymer host material can be used.

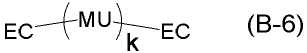

In formula (B-6), MU's each independently represent at least one selected from the group consisting of divalent groups of compounds represented by general formulas (B-1) to (B-5), two hydrogen atoms in MU are substituted by EC or MU, EC's each independently represent a hydrogen atom, an aryl, a heteroaryl, a diarylamino, a diheteroarylamino, an arylheteroarylamino, or an aryloxy, at least one hydrogen atom in these may be further substituted by an aryl, a heteroaryl, or a diarylamino, and k is an integer of 2 to 50000. K is preferably an integer of 100 to 40000, and more preferably an integer of 500 to 25000.

The compounds represented by the general formulas (B-1) to (B-5) are the following compounds.

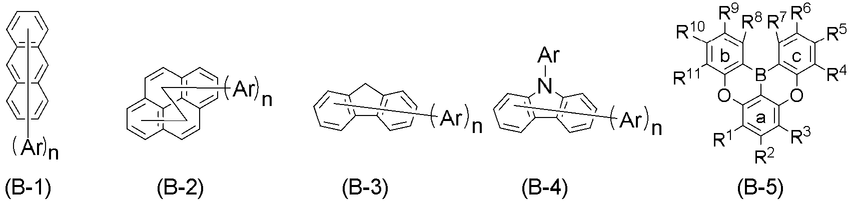

In the formulas (B-1) to (B-4), Ar's each independently represent a hydrogen atom, an aryl, a heteroaryl, a diarylamino, a diheteroarylamino, an arylheteroarylamino, or an aryloxy, at least one hydrogen atom in these may be further substituted by an aryl, a heteroaryl, or a diarylamino; adjacent groups among Ar's may be bonded to each other to form an aryl ring or a heteroaryl ring together with a mother skeleton of an anthracene ring, a pyrene ring, a fluorene ring, or a carbazole ring, at least one hydrogen atom in the ring thus formed may be substituted by an aryl, a heteroaryl, a diarylamino, a diheteroarylamino, an arylheteroarylamino, or an aryloxy. The specific description of each group can refer to the description in the polycyclic aromatic compound of general formula (1) or general formula (2). The "n" in the each formulas represents an integer of 1 to 6, preferably an integer of 1 to 4, more preferably an integer of 1 to 2, still more preferably 1.

In formulas (B-1) to (B-4), specific examples of "Ar" include, for example, monovalent groups of the structural formulas shown below, or groups having a combination of the following structures.

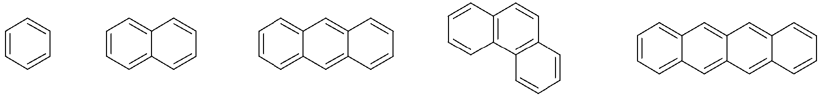

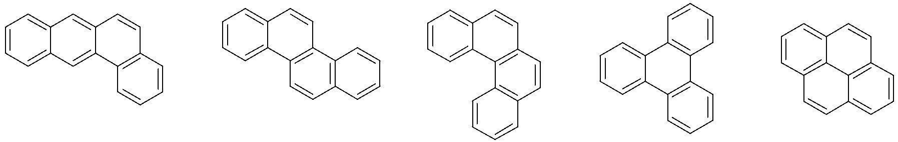

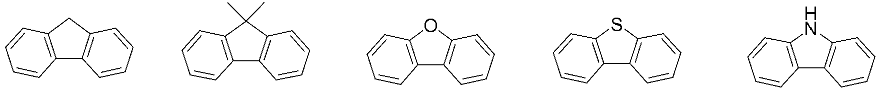

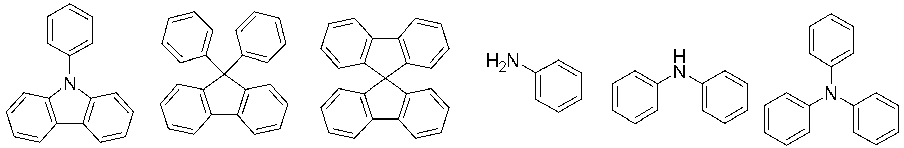

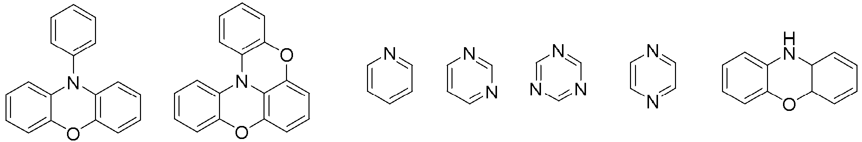

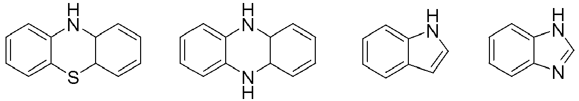

In the formula (B-5), R¹ to R¹¹ each independently represent a hydrogen atom, an aryl, a heteroaryl, a diarylamino, a diheteroarylamino, an arylheteroarylamino, or an aryloxy, at least one hydrogen atom in these may be further substituted by an aryl, a heteroaryl, or a diarylamino;
adjacent groups among R¹ to R¹¹ may be bonded to each other to form an aryl ring or a heteroaryl ring together with ring a, ring b, or ring c, at least one hydrogen atom in the ring thus formed may be substituted by an aryl, a heteroaryl, a diarylamino, a diheteroarylamino, an arylheteroarylamino, or an aryloxy, and at least one hydrogen atom in these may be further substituted by an aryl, a heteroaryl, or a diarylamino.

The specific description of each group can refer to the description in the polycyclic aromatic compound of general formula (1) or general formula (2).

At least one hydrogen atom in the compounds represented by formulas (B-1) to (B-5) may be substituted by a group represented by the following formula (FG-1), a group represented by the following formula (FG-2), an alkyl having 1 to 24 carbon atoms, a halogen atom, or a deuterium atom; further any -CH₂- in the alkyl may be substituted by -O- or -Si(CH₃)₂-, any -CH₂- excluding -CH₂- directly bonded to the compounds represented by the above formula (B-1) to (B-5) in the alkyl may be substituted by an arylene having 6 to 24 carbon atoms, and any hydrogen atom in the alkyl may be substituted by a fluorine atom.

At least one hydrogen atom of EC in formula (B-6) may be substituted by a group represented by the following general formula (FG-1), a group represented by the following general formula (FG-2), an alkyl having 1 to 24 carbon atoms, a halogen atom, or a deuterium atom, further any -CH₂- in the alkyl may be substituted by -O- or -Si(CH₃)₂-, any -CH₂- excluding -CH₂-directly bonded to EC in formula (B-6) in the alkyl may be substituted by an arylene having 6 to 24 carbon atoms, and any hydrogen atom in the alkyl may be substituted by a fluorine atom.

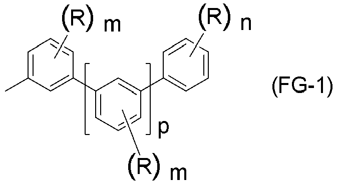

(In the formula (FG-1),
R's each independently represent a fluorine atom, a trimethylsilyl, a trifluoromethyl, an alkyl having 1 to 24 carbon atoms, or a cycloalkyl having 3 to 24 carbon atoms, any -CH₂- in the alkyl may be substituted by -O-, any -CH₂-excluding -CH₂- directly bonded to a phenyl or a phenylene in the alkyl may be substituted by an arylene having 6 to 24 carbon atoms, at least one hydrogen atom in the cycloalkyl may be substituted by an alkyl having 1 to 24 carbon atoms or an aryl having 6 to 12 carbon atoms,
when two adjacent R's each represent an alkyl or a cycloalkyl, these R's may be bonded to each other to form a ring,
m's each independently represent an integer of 0 to 4, n represents an integer of 0 to 5, and p represents an integer of 1 to 5.) 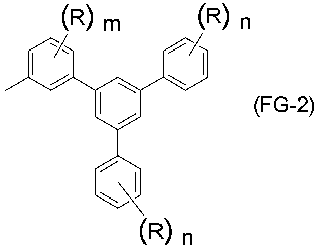
(In the formula (FG-2),
R's each independently represent a fluorine atom, a trimethylsilyl, a trifluoromethyl, an alkyl having 1 to 24 carbon atoms, a cycloalkyl having 3 to 24 carbon atoms, or an aryl having 6 to 12 carbon atoms, any -CH₂- in the alkyl may be substituted by -O-, any -CH₂- excluding -CH₂- directly bonded to a phenyl or a phenylene in the alkyl may be substituted by an arylene having 6 to 24 carbon atoms, at least one hydrogen atom in the cycloalkyl may be substituted by an alkyl having 1 to 24 carbon atoms or an aryl having 6 to 12 carbon atoms, at least one hydrogen atom in the aryl may be substituted by an alkyl having 1 to 24 carbon atoms,
when two adjacent R's each represent an alkyl or a cycloalkyl, these R's may be bonded to each other to form a ring,
m represents an integer of 0 to 4, and n's each independently represent an integer of 0 to 5.)

Examples of MU include divalent groups represented by the following general formulas (MU-1-1) to (MU-1-12), (MU-2-1) to (MU-2-202) (MU-3-1) to (MU-3-201), (MU-4-1) to (MU-4-122), and (MU-5-1) to MU-5-12). Examples of EC include groups represented by the following general formulas (EC-1) to (EC-29). In these groups, MU is bonded to MU or EC at * and EC is bonded to MU at *.

Furthermore, a compound represented by formula (B-6) preferably has at least one divalent group represented by formula (B-6-X1) in a molecule from a viewpoint of charge transport, and more preferably has a divalent group represented by formula (B-6-X1) in an amount of 10% or more with respect to the molecular weight of the compound represented by formula (B-6). Here, the divalent group represented by formula (B-6-X1) is bonded to MU or EC at *.

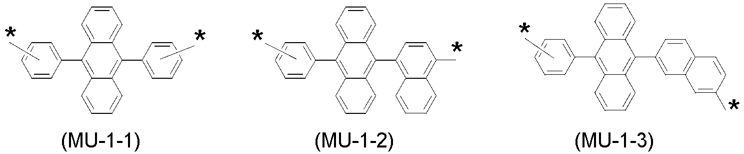

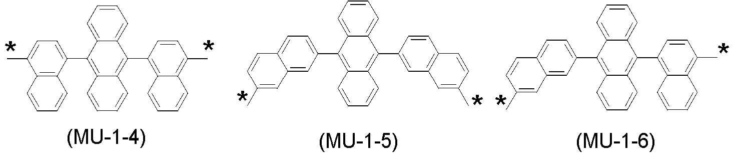

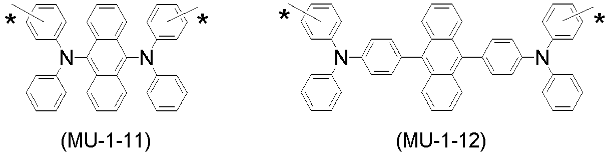

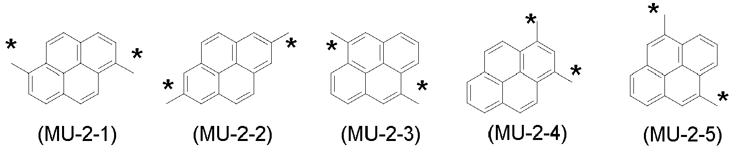

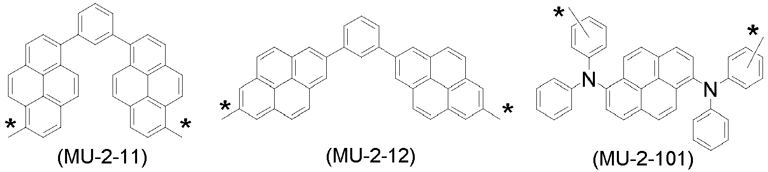

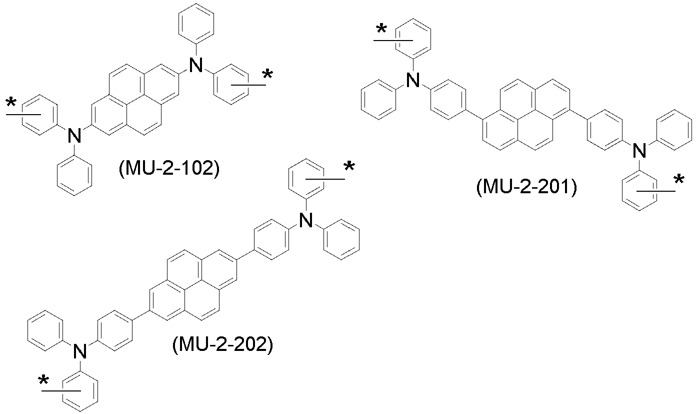

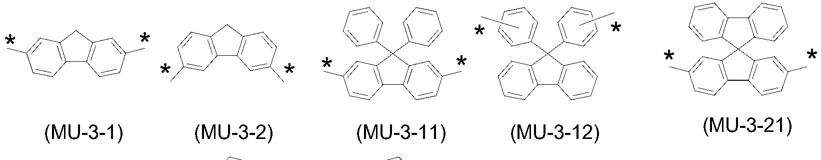

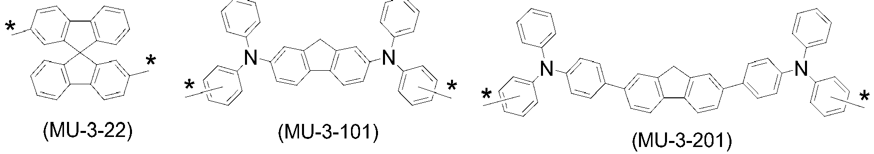

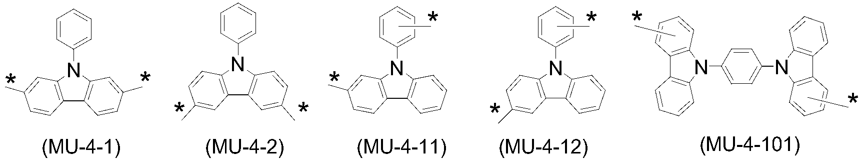

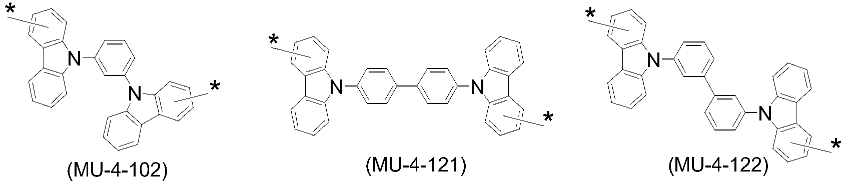

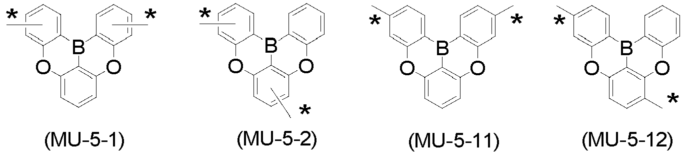

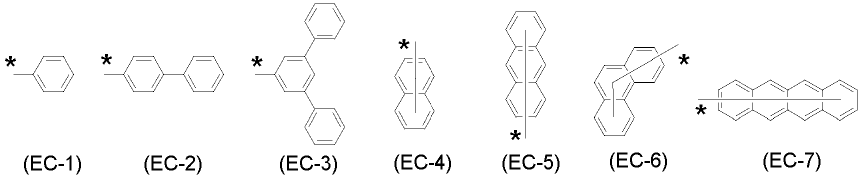

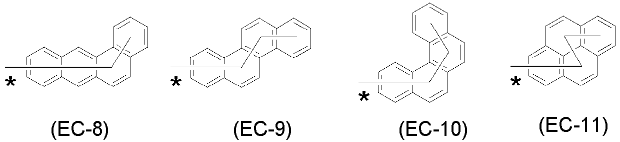

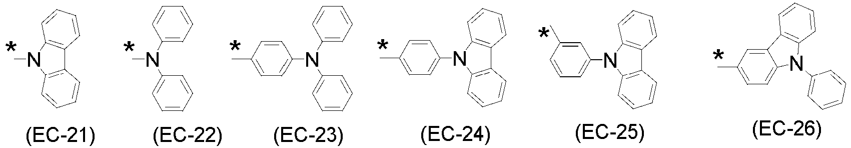

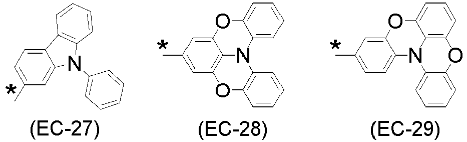

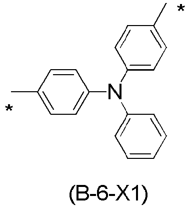

In a compound represented by formula (B-6), 10 to 100% of the total number of MU's (n) in a molecule preferably has an alkyl having 1 to 24 carbon atoms, 30 to 100% of the total number of MU's (n) in a molecule more preferably has an alkyl having 1 to 18 carbon atoms (branched alkyl having 3 to 18 carbon atoms), and 50 to 100% of the total number of MU's (n) in a molecule still more preferably has an alkyl having 1 to 12 carbons (branched alkyl having 3 to 12 carbons) from a viewpoint of solubility and coating film formability. Meanwhile, 10 to 100% of the total number of MU's (n) in a molecule preferably has an alkyl having 7 to 24 carbon atoms, and 30 to 100% of the total number of MU's (n) in a molecule more preferably has an alkyl having 7 to 24 carbon atoms (branched alkyl having 7 to 24 carbon atoms) from a viewpoint of in-plane orientation and charge transport.

The dopant material that can be used in combination with the polycyclic aromatic amino compound represented by the above general formula (1A) or (1B) is not particularly limited, and an existing compound can be used. The dopant material can be selected from among various materials depending on a desired color of emitted light. Specific examples thereof include a fused ring derivative such as phenanthrene, anthracene, pyrene, tetracene, pentacene, perylene, naphthopyrene, dibenzopyrene, rubrene, or chrysene, a benzoxazole derivative, a benzothiazole derivative, a benzimidazole derivative, a benzotriazole derivative, an oxazole derivative, an oxadiazole derivative, a thiazole derivative, an imidazole derivative, a thiadiazole derivative, a triazole derivative, a pyrazoline derivative, a stilbene derivative, a thiophene derivative, a tetraphenylbutadiene derivative, a cyclopentadiene derivative, a bisstyryl derivative such as a bisstyrylanthracene derivative or a distyrylbenzene derivative (JP 1-245087 A), a bisstyrylarylene derivative (JP 2-247278 A), a diazaindacene derivative, a furan derivative, a benzofuran derivative, an isobenzofuran derivative such as phenylisobenzofuran, dimesitylisobenzofuran, di(2-methylphenyl)isobenzofuran, di(2-trifluoromethylphenyl)isobenzofuran, or phenylisobenzofuran, a dibenzofuran derivative, a coumarin derivative such as a 7-dialkylaminocoumarin derivative, a 7-piperidinocoumarin derivative, a 7-hydroxycoumarin derivative, a 7-methoxycoumarin derivative, a 7-acetoxycoumarin derivative, a 3-benzothiazolylcoumarin derivative, a 3-benzimidazolylcoumarin derivative, or a 3-benzoxazolylcoumarin derivative, a dicyanomethylenepyran derivative, a dicyanomethylenethiopyran derivative, a polymethine derivative, a cyanine derivative, an oxobenzoanthracene derivative, a xanthene derivative, a rhodamine derivative, a fluorescein derivative, a pyrylium derivative, a carbostyryl derivative, an acridine derivative, an oxazine derivative, a phenylene oxide derivative, a quinacridone derivative, a quinazoline derivative, a pyrrolopyridine derivative, a furopyridine derivative, a 1,2,5-thiadiazolopyrene derivative, a pyromethene derivative, a perinone derivative, a pyrrolopyrrole derivative, a squarylium derivative, a violanthrone derivative, a phenazine derivative, an acridone derivative, a deazaflavine derivative, a fluorene derivative, and a benzofluorene derivative.

When the materials are exemplified for each emission color, examples of blue to bluish green dopant materials include an aromatic hydrocarbon compound and a derivative thereof, such as naphthalene, anthracene, phenanthrene, pyrene, triphenylene, perylene, fluorene, indene, or chrysene,; an aromatic heterocyclic compound and a derivative thereof, such as furan, pyrrole, thiophene, silole, 9-silafluorene, 9,9'-spirobisilafluorene, benzothiophene, benzofuran, indole, dibenzothiophene, dibenzofuran, imidazopyridine, phenanthroline, pyrazine, naphthyridine, quinoxaline, pyrrolopyridine, or thioxanthene, a distyrylbenzene derivative, a tetraphenylbutadiene derivative, a stilbene derivative, an aldazine derivative, a coumarin derivative, an azole derivative such as imidazole, thiazole, thiadiazole, carbazole, oxazole, oxadiazole, or triazole and a metal complex thereof, and an aromatic amine derivative represented by N,N'-diphenyl-N,N'-di(3-methylphenyl)-4,4'-diphenyl-1,1'-diamine.

Examples of green to yellow dopant materials include a coumarin derivative, a phthalimide derivative, a naphthalimide derivative, a perinone derivative, a pyrrolopyrrole derivative, a cyclopentadiene derivative, an acridone derivative, a quinacridone derivative, and a naphthacene derivative such as rubrene. Furthermore, suitable examples thereof include compounds obtained by introducing a substituent capable of making a wavelength longer, such as an aryl, a heteroaryl, an arylvinyl, an amino, or cyano, into the above compounds exemplified as the blue to bluish green dopant material.

Furthermore, examples of orange to red dopant materials include a naphthalimide derivative such as bis(diisopropylphenyl) perylene tetracarboxylic acid imide, a perinone derivative, a rare earth complex containing acetylacetone, benzoylacetone, or phenanthroline as a ligand, such as an Eu complex, 4-(dicyanomethylene)-2-methyl-6-(p-dimethylaminostyryl)-4 H-pyran and an analogue thereof, a metal phthalocyanine derivative such as magnesium phthalocyanine or aluminum chlorophthalocyanine, a rhodamine compound, a deazaflavine derivative, a coumarin derivative, a quinacridone derivative, a phenoxazine derivative, an oxazine derivative, a quinazoline derivative, a pyrrolopyridine derivative, a squarylium derivative, a violanthrone derivative, a phenazine derivative, a phenoxazone derivative, and a thiadiazolopyrene derivative. Furthermore, suitable examples thereof include compounds obtained by introducing a substituent capable of making a wavelength longer, such as an aryl, a heteroaryl, an arylvinyl, an amino, or cyano, into the above compounds exemplified as blue to bluish green and green to yellow dopant materials.

In addition, dopants can be appropriately selected for use from among compounds described in "Kagaku Kogyo (Chemical Industry) ", June 2004, p. 13, and reference documents described therein.

Among the dopant materials described above, particularly, an amine having a stilbene structure, a perylene derivative, a borane derivative, an aromatic amine derivative, a coumarin derivative, a pyran derivative, and a pyrene derivative are preferable.

An amine having a stilbene structure is represented by, for example, the following formula:

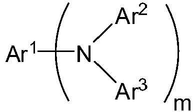

In the formula, Ar¹ represents an m-valent group derived from an aryl having 6 to 30 carbon atoms, and Ar² and Ar³ each independently represent an aryl having 6 to 30 carbon atoms, in which at least one of Ar¹ to Ar³ has a stilbene structure, Ar¹ to Ar³ may be substituted by an aryl, a heteroaryl, an alkyl, a trisubstituted silyl (silyl trisubstituted by an aryl and/or an alkyl), or cyano, and m represents an integer of 1 to 4.

The amine having a stilbene structure is more preferably a diaminostilbene represented by the following formula:

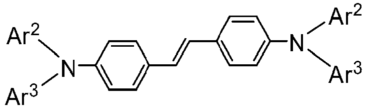

In the formula, Ar² and Ar³ each independently represent an aryl having 6 to 30 carbon atoms, and Ar² and Ar³ may be substituted by an aryl, a heteroaryl, an alkyl, a trisubstituted silyl (silyl trisubstituted by an aryl and/or an alkyl), or cyano.

Specific examples of the aryl having 6 to 30 carbon atoms include phenyl, naphthyl, acenaphthylenyl, fluorenyl, phenalenyl, phenanthrenyl, anthryl, fluoranthenyl, triphenylenyl, pyrenyl, chrysenyl, naphthacenyl, perylenyl, stilbenyl, distyrylphenyl, distyrylbiphenylyl, and distyrylfluorenyl.

Specific examples of the amine having a stilbene structure include N,N,N',N'-tetra(4-biphenylyl)-4,4'-diaminostilbene, N,N,N',N'-tetra(1-naphthyl)-4,4'-diaminostilbene, N,N,N',N'-tetra(2-naphthyl)-4,4'-diaminostilbene, N,N'-di(2-naphthyl)-N,N'-diphenyl-4,4'-diaminostilbene, N,N'-di(9-phenanthryl)-N,N'-diphenyl-4,4'-diaminostilbene, 4,4'-bis[4"-bis(diphenylamino)styryl]-biphenyl, 1,4-bis[4'-bis(diphenylamino)styryl]-benzene, 2,7-bis[4'-bis(diphenylamino)styryl]-9,9-dimethylfluorene, 4,4'-bis(9-ethyl-3-carbazovinylene)-biphenyl, and 4,4'-bis(9-phenyl-3-carbazovinylene)-biphenyl.

Amines having a stilbene structure described in JP 2003-347056 A, JP 2001-307884 A, and the like may also be used.

Examples of the perylene derivative include 3,10-bis(2,6-dimethylphenyl)perylene, 3,10-bis(2,4,6-trimethylphenyl)perylene, 3,10-diphenylperylene, 3,4-diphenylperylene, 2,5,8,11-tetra-t-butylperylene, 3,4,9,10-tetraphenylperylene, 3-(1'-pyrenyl)-8,11-di(t-butyl)perylene, 3-(9'-anthryl)-8,11-di(t-butyl)perylene, and 3,3'-bis(8,11-di(t-butyl)perylenyl).

Perylene derivatives described in JP 11-97178 A, JP 2000-133457 A, JP 2000-26324 A, JP 2001-267079 A, JP 2001-267078 A, JP 2001-267076 A, JP 2000-34234 A, JP 2001-267075 A, JP 2001-217077 A, and the like may also be used.

Examples of the borane derivative include 1,8-diphenyl-10-(dimesitylboryl)anthracene, 9-phenyl-10-(dimesitylboryl)anthracene, 4-(9'-anthryl)dimesitylborylnaphthalene, 4-(10'-phenyl-9'-anthryl)dimesitylborylnaphthalene, 9-(dimesitylboryl)anthracene, 9-(4'-biphenylyl)-10-(dimesitylboryl)anthracene, and 9-(4'-(N-carbazolyl)phenyl)-10-(dimesitylboryl)anthracene .

A borane derivative described in WO 2000/40586 A or the like may also be used.

The aromatic amine derivative is represented by, for example, the following formula:

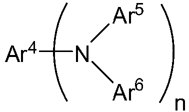

In the formula, Ar⁴ represents an n-valent group derived from an aryl having 6 to 30 carbon atoms, Ar⁵ and Ar⁶ each independently represent an aryl having 6 to 30 carbon atoms, Ar⁴ to Ar⁶ may be substituted by an aryl, a heteroaryl, an alkyl, a trisubstituted silyl (silyl trisubstituted by an aryl and/or an alkyl), or cyano, and n represents an integer of 1 to 4.

Particularly, Ar⁴ is a divalent group derived from anthracene, chrysene, fluorene, benzofluorene, or pyrene, Ar⁵ and Ar⁶ each independently represent an aryl having 6 to 30 carbon atoms, Ar⁴ to Ar⁶ may be substituted by an aryl, a heteroaryl, an alkyl, a trisubstituted silyl (silyl trisubstituted by an aryl and/or an alkyl), or cyano, and n represents 2.

Specific examples of the aryl having 6 to 30 carbon atoms include phenyl, naphthyl, acenaphthylenyl, fluorenyl, phenalenyl, phenanthryl, triphenylenyl, pyrenyl, naphthacenyl, perylenyl, and pentacenyl.

Examples of a chrysene-based aromatic amine derivative include N,N,N',N'-tetraphenylchrysene-6,12-diamine, N,N,N',N'-tetra(p-tolyl)chrysene-6,12-diamine, N,N,N',N'-tetra(m-tolyl)chrysene-6,12-diamine, N,N,N',N'-tetrakis(4-isopropylphenyl)chrysene-6,12-diamin e, N,N,N',N'-tetra(naphthalen-2-yl)chrysene-6,12-dimine, N,N'-diphenyl-N,N'-di(p-tolyl)chrysene-6,12-diamine, N,N'-diphenyl-N,N'-bis(4-ethylphenyl)chrysene-6,12-diamin e, N,N'-diphenyl-N,N'-bis(4-ethylphenyl)chrysene-6,12-diamin e, N,N'-diphenyl-N,N'-bis(4-isopropylphenyl)chrysene-6,12-di amine, N,N'-diphenyl-N,N'-bis(4-t-butylphenyl)chrysene-6,12-diam ine, and N,N'-bis(4-isopropylphenyl)-N,N'-di(p-tolyl)chrysene-6,12 -diamine.

Examples of a pyrene-based aromatic amine derivative include N,N,N',N'-tetraphenylpyrene-1,6-diamine, N,N,N',N'-tetra(p-tolyl)pyrene-1,6-diamine, N,N,N',N'-tetra(m-tolyl)pyrene-1,6-diamine, N,N,N',N'-tetrakis(4-isopropyophenyl)pyrene-1,6-diamine, N,N,N',N'-tetrakis(3,4-dimethylphenyl)pyrene-1,6-diamine, N,N'-diphenyl-N,N'-di(p-tolyl)pyrene-1,6-diamine, N,N'-diphenyl-N,N'-bis(4-ethylphenyl)pyrene-1,6-diamine, N,N'-diphenyl-N,N'-bis(4-ethylphenyl)pyrene-1,6-diamine, N,N'-diphenyl-N,N'-bis(4-isopropylphenyl)pyrene-1,6-diami ne, N,N'-diphenyl-N,N'-bis(4-t-butylphenyl)pyrene-1,6-diamine, N,N'-bis(4-isopropylphenyl)-N,N'-di(p-tolyl)pyrene-1,6-di amine, N,N,N',N'-tetrakis(3,4-dimethylphenyl)-3,8-diphenylpyrene -1,6-diamine, N,N,N,N-tetraphenylpyrene-1,8-diamine, N,N'-bis(biphenyl-4-yl)-N,N'-diphenylpyrene-1,8-diamine, and N¹,N⁶-diphenyl-N¹,N⁶-bis(4-trimethylsilanyl-phenyl)-1H,8H-pyrene-1,6-diamine.

Examples of an anthracene-based aromatic amine derivative include N,N,N,N-tetraphenylanthracene-9,10-diamine, N,N,N',N'-tetra(p-tolyl)anthracene-9,10-diamine, N,N,N',N'-tetra(m-tolyl)anthracene-9,10-diamine, N,N,N',N'-tetrakis(4-isopropylphenyl)anthracene-9,10-diam ine, N,N'-diphenyl-N,N'-di(p-tolyl)anthracene-9,10-diamine, N,N'-diphenyl-N,N'-di(m-tolyl)anthracene-9,10-diamine, N,N'-diphenyl-N,N'-bis(4-ethylphenyl)anthracene-9,10-diam ine, N,N'-diphenyl-N,N'-bis(4-ethylphenyl)anthracene-9,10-diam ine, N,N'-diphenyl-N,N'-bis(4-isopropylphenyl)anthracene-9,10-diamine, N,N'-diphenyl-N,N'-bis(4-t-butylphenyl)anthracene-9,10-di amine, N,N'-bis(4-isopropylphenyl)-N,N'-di(p-tolyl)anthracene-9, 10-diamine, 2,6-di-t-butyl-N,N,N',N'-tetra(p-tolyl)anthracene-9,10-di amine, 2,6-di-t-butyl-N,N'-diphenyl-N,N'-bis(4-isopropylphenyl)a nthracene-9,10-diamine, 2,6-di-t-butyl-N,N'-bis(4-isopropylphenyl)-N,N'-di(p-toly 1)anthracene-9,10-diamine, 2,6-dicyclohexyl-N,N'-bis(4-isopropylphenyl)-N,N'-di(p-to lyl)anthracene-9,10-diamine, 2,6-dicyclohexyl-N,N'-bis(4-isopropylphenyl)-N,N'-bis(4-t -butylphenyl)anthracene-9,10-diamine, 9,10-bis(4-diphenylaminophenyl)anthracene-9,10-bis(4-di(1 -naphthylamino)phenyl) anthracene, 9,10-bis(4-di(2-naphthylamino)phenyl)anthracene, 10-di-p-tolylamino-9-(4-di-p-tolylamino-1-naphthyl)anthra cene, 10-diphenylamino-9-(4-diphenylamino-1-naphthyl)anthracene, and 10-diphenylamino-9-(6-diphenylamino-2-naphthyl)anthracene .

Other examples include [4-(4-diphenylaminophenyl)naphthalen-1-yl]-diphenylamine, [6-(4-diphenylaminophenyl)naphthalen-2-yl]-diphenylamine, 4,4'-bis[4-diphenylaminonaphthalen-1-yl]biphenyl, 4,4'-bis[6-diphenylaminonaphthalen-2-yl]biphenyl, 4,4"-bis[4-diphenylaminonaphthalen-1-yl]-p-terphenyl, and 4,4"-bis[6-diphenylaminonaphthalen-2-yl]-p-terphenyl.

An aromatic amine derivative described in JP 2006-156888 A or the like may also be used.

Examples of the coumarin derivative include coumarin-6 and coumarin-334.

Coumarin derivatives described in JP 2004-43646 A, JP 2001-76876 A, JP 6-298758 A, and the like may also be used.

Examples of the pyran derivative include DCM and DCJTB described below.

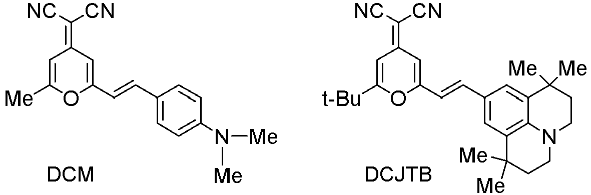

Pyran derivatives described in JP 2005-126399 A, JP 2005-097283 A, JP 2002-234892 A, JP 2001-220577 A, JP 2001-081090 A, JP 2001-052869 A, and the like may also be used.

The polycyclic aromatic compound represented by general formula (1) can also be used as a light emitting layer-forming composition together with an organic solvent. The composition includes at least one polycyclic aromatic compound as a first component; at least one host material as a second component; and at least one organic solvent as a third component. The first component functions as a dopant component of a light emitting layer obtained from the composition, and the second component functions as a host component of the light emitting layer. The third component functions as a solvent for dissolving the first component and the second component in the composition. At the time of application, the third component provides a smooth and uniform surface shape due to a controlled evaporation rate of the third component itself.

### <Organic solvent>

The light emitting layer-forming composition contains at least one organic solvent as a third component. By controlling an evaporation rate of an organic solvent at the time of film formation, it is possible to control and improve film formability, presence or absence of defects in a coating film, surface roughness, and smoothness. At the time of film formation using an ink jet method, by controlling meniscus stability at a pinhole of an ink jet head, ejection performance can be controlled and improved. In addition, by controlling a drying speed of a film and orientation of a derivative molecule, it is possible to improve electrical characteristics, luminescence characteristics, efficiency, and a lifetime of an organic EL element having a light emitting layer obtained from the light emitting layer-forming composition.

### (1) Physical properties of organic solvent

In the third component, the boiling point of at least one organic solvent is from 130°C to 300°C, more preferably from 140°C to 270°C, and still more preferably from 150°C to 250°C. A case where the boiling point is higher than 130°C is preferable from a viewpoint of ink jet ejection performance. A case where the boiling point is lower than 300°C is preferable from a viewpoint of defects in a coating film, surface roughness, a residual solvent, and smoothness. The third component more preferably contains two or more kinds of organic solvents from a viewpoint of good ink jet ejection performance, film formability, smoothness, and the small amount of a residual solvent. Meanwhile, in some cases, in consideration of transportability and the like, the third component may be a solid composition obtained by removing a solvent from the light emitting layer-forming composition.

Furthermore, a particularly preferable configuration is that the third component contains a good solvent (GS) and a poor solvent (PS) for the host material of the second component, and the boiling point (BP_{GS}) of the good solvent (GS) is lower than the boiling point (BP_{PS}) of the poor solvent (PS).

By adding a poor solvent having a high boiling point, a good solvent having a low boiling point is volatilized earlier at the time of film formation, and the concentration of contents in the composition and the concentration of the poor solvent are increased to promote prompt film formation. As a result, a coating film having few defects, less surface roughness, and high smoothness can be obtained.

A difference in solubility (S_{GS}-S_{PS}) is preferably 1% or more, more preferably 3% or more, and still more preferably 5% or more. A difference in boiling point (BP_{PS}-BP_{GS}) is preferably 10°C or more, more preferably 30°C or more, and still more preferably 50°C or more.

After the film formation, an organic solvent is removed from a coating film through a drying step such as evacuation, reduction in pressure, or heating. In a case of heating, heating is preferably performed at a glass transition temperature (Tg) of the first component + 30°C or lower from a viewpoint of improving coating film formability. Heating is preferably performed at a glass transition point (Tg) of the first component -30°C or higher from a viewpoint of reducing a residual solvent. Even when the heating temperature is lower than the boiling point of an organic solvent, the organic solvent is sufficiently removed because the film is thin. Drying may be performed a plurality of times at different temperatures, or a plurality of drying methods may be used in combination.

### (2) Specific examples of organic solvent

Examples of an organic solvent used in the light emitting layer-forming composition include an alkylbenzene-based solvent, a phenyl ether-based solvent, an alkyl ether-based solvent, a cyclic ketone-based solvent, an aliphatic ketone-based solvent, a monocyclic ketone-based solvent, a solvent having a diester skeleton, and a fluorine-containing solvent. Specific examples thereof include pentanol, hexanol, heptanol, octanol, nonanol, decanol, undecanol, dodecanol, tetradecanol, hexan-2-ol, heptan-2-ol, octan-2-ol, decan-2-ol, dodecan-2-ol, cyclohexanol, α-terpineol, β-terpineol, γ-terpineol, δ-terpineol, terpineol (mixture), ethylene glycol monomethyl ether acetate, propylene glycol monomethyl ether acetate, diethylene glycol dimethyl ether, dipropylene glycol dimethyl ether, diethylene glycol ethyl methyl ether, diethylene glycol isopropyl methyl ether, dipropylene glycol monomethyl ether, diethylene glycol diethyl ether, diethylene glycol monomethyl ether, diethylene glycol butyl methyl ether, tripropylene glycol dimethyl ether, triethylene glycol dimethyl ether, diethylene glycol monobutyl ether, ethylene glycol monophenyl ether, triethylene glycol monomethyl ether, diethylene glycol dibutyl ether, triethylene glycol butyl methyl ether, polyethylene glycol dimethyl ether, tetraethylene glycol dimethyl ether, p-xylene, m-xylene, o-xylene, 2,6-lutidine, 2-fluoro-m-xylene, 3-fluoro-o-xylene, 2-chlorobenzo trifluoride, cumene, toluene, 2-chloro-6-fluorotoluene, 2-fluoroanisole, anisole, 2,3-dimethylpyrazine, bromobenzene, 4-fluoroanisole, 3-fluoroanisole, 3-trifluoromethylanisole, mesitylene, 1,2,4-trimethylbenzene, t-butylbenzene, 2-methylanisole, phenetole, benzodioxole, 4-methylanisole, s-butylbenzene, 3-methylanisole, 4-fluoro-3-methylanisole, cymene, 1,2,3-trimethylbenzene, 1,2-dichlorobenzene, 2-fluorobenzonitrile, 4-fluorobellaterol, 2,6-dimethylanisole, n-butylbenzene, 3-fluorobenzonitrile, decalin (decahydronaphthalene), neopentylbenzene, 2,5-dimethylanisole, 2,4-dimethylanisole, benzonitrile, 3,5-dimethylanisole, diphenyl ether, 1-fluoro-3,5-dimethoxybenzene, methyl benzoate, isopentylbenzene, 3,4-dimethylanisole, o-tolunitrile, n-amylbenzene, veratrole, 1,2,3,4-tetrahydronaphthalene, ethyl benzoate, n-hexylbenzene, propyl benzoate, cyclohexylbenzene, 1-methylnaphthalene, butyl benzoate, 2-methylbiphenyl, 3-phenoxytoluene, 2,2'-vitrile, dodecylbenzene, dipentylbenzene, tetramethylbenzene, trimethoxy benzene, trimethoxytoluene, 2,3-dihydrobenzofuran, 1-methyl-4-(propoxymethyl) benzene, 1-methyl-4-(butyloxymethyl) benzene, 1-methyl-4-(pentyloxymethyl) benzene, 1-methyl-4-(hexyloxymethyl) benzene, 1-methyl-4-(heptyloxymethyl) benzenebenzyl butyl ether, benzyl pentyl ether, benzyl hexyl ether, benzyl heptyl ether, and benzyl octyl ether, but are not limited thereto. Furthermore, these solvents may be used singly or in a mixture thereof.

### <Optional components>

The light emitting layer-forming composition may contain an optional component as long as properties thereof are not impaired. Examples of an optional component include a binder and a surfactant.

### (1) Binder

The light emitting layer-forming composition may contain a binder. The binder forms a film at the time of film formation, and bonds the obtained film to a substrate. The binder also plays a role of dissolving, dispersing, and binding other components in the light emitting layer-forming composition.

Examples of a binder used in the light emitting layer-forming composition include an acrylic resin, polyethylene terephthalate, an ethylene-vinyl acetate copolymer, an ethylene-vinyl alcohol copolymer, an acrylonitrile-ethylene-styrene copolymer (AES) resin, an ionomer, chlorinated polyether, a diallyl phthalate resin, an unsaturated polyester resin, polyethylene, polypropylene, polyvinyl chloride, polyvinylidene chloride, polystyrene, polyvinyl acetate, Teflon, an acrylonitrile-butadiene-styrene copolymer (ABS) resin, an acrylonitrile-styrene copolymer (AS) resin, a phenol resin, an epoxy resin, a melamine resin, a urea resin, an alkyd resin, polyurethane, and a copolymer of the above resins and polymers, but are not limited thereto.

The binder used in the light emitting layer-forming composition may be used singly or in a mixture of a plurality of kinds thereof.

### (2) Surfactant

The light emitting layer-forming composition may contain, for example, a surfactant for controlling film surface uniformity of the light emitting layer-forming composition, solvent affinity of a film surface, and liquid repellency. The surfactant is classified into an ionic surfactant and a nonionic surfactant based on the structure of a hydrophilic group, and is further classified into an alkyl-based surfactant, a silicon-based surfactant, and a fluorine-based surfactant based on the structure of a hydrophobic group. The surfactant is classified into a monomolecule-based surfactant having a relatively small molecular weight and a simple structure, and a polymer-based surfactant having a large molecular weight and a side chain or a branched chain based on the structure of a molecule. The surfactant is classified into a single surfactant and a mixed surfactant obtained by mixing two or more kinds of surfactants with a base material based on the composition. As a surfactant that can be used in the light emitting layer-forming composition, all kinds of surfactants can be used.

Examples of the surfactant include Polyflow No. 45, Polyflow KL-245, Polyflow No. 75, Polyflow No. 90, Polyflow No. 95 (trade names, manufactured by Kyoeisha Chemical Co., Ltd.), Disperbyk 161, Disperbyk 162, Disperbyk 163, Disperbyk 164, Disperbyk 166, Disperbyk 170, Disperbyk 180, Disperbyk 181, Disperbyk 182, BYK 300, BYK 306, BYK 310, BYK 320, BYK 330, BYK 342, BYK 344, BYK 346 (trade names, manufactured by BYK Japan KK), KP-341, KP-358, KP-368, KF-96-50CS, KF-50-100CS (trade names, manufactured by Shin-Etsu Chemical Co., Ltd.), Surflon SC-101, Surflon KH-40 (trade names, manufactured by Seimi Chemical Co., Ltd.), Futargent 222F, Futargent 251, FTX-218 (trade names, manufactured by Neos Co., Ltd.), EFTOP EF-351, EFTOP EF-352, EFTOP EF-601, EFTOP EF-801, EFTOP EF-802 (trade names, manufactured by Mitsubishi Materials Corporation), Megafac F-470, Megafac F-471, Megafac F-475, Megafac R-08, Megafac F-477, Megafac F-479, Megafac F-553, Megafac F-554, (trade names, manufactured by DIC Corporation), fluoroalkyl benzene sulfonate, fluoroalkyl carboxylate, fluoroalkyl polyoxyethylene ether, fluoroalkyl ammonium iodide, fluoroalkyl betaine, fluoroalkyl sulfonate, diglycerin tetrakis(fluoroalkyl polyoxyethylene ether), a fluoroalkyl trimethyl ammonium salt, fluoroalkyl aminosulfonate, polyoxyethylene nonyl phenyl ether, polyoxyethylene octyl phenyl ether, polyoxyethylene alkyl ether, polyoxyethylene laurate, polyoxyethylene oleate, polyoxyethylene stearate, polyoxyethylene lauryl amine, sorbitan laurate, sorbitan palmitate, sorbitan stearate, sorbitan oleate, sorbitan fatty acid ester, polyoxyethylene sorbitan laurate, polyoxyethylene sorbitan palmitate, polyoxyethylene sorbitan stearate, polyoxyethylene sorbitan oleate, polyoxyethylene naphthyl ether, alkylbenzene sulfonate, and alkyl diphenyl ether disulfonate.

The surfactant may be used singly or in combination of two or more kinds thereof.

### <Composition and physical properties of light emitting layer-forming composition>

As for the contents of the components in the light emitting layer-forming composition, preferably, the content of the first component is from 0.0001% by weight to 2.0% by weight with respect to the total weight of the light emitting layer-forming composition, the content of the second component is from 0.0999% by weight to 8.0% by weight with respect to the total weight of the light emitting layer-forming composition, and the content of the third component is from 90.0% by weight to 99.9% by weight with respect to the total weight of the light emitting layer-forming composition from a viewpoint of good solubility of the components in the light emitting layer-forming composition, storage stability, film formability, high quality of a coating film obtained from the light emitting layer-forming composition, good ejection performance in a case of using an ink jet method, and good electrical characteristics, luminescent characteristics, efficiency, and a lifetime of an organic EL element having a light emitting layer manufactured using the composition.

More preferably, the content of the first component is from 0.005% by weight to 1.0% by weight with respect to the total weight of the light emitting layer-forming composition, the content of the second component is from 0.095% by weight to 4.0% by weight with respect to the total weight of the light emitting layer-forming composition, and the content of the third component is from 95.0% by weight to 99.9% by with respect to the total weight of the light emitting layer-forming composition. Still more preferably, the content of the first component is from 0.05% by weight to 0.5% by weight with respect to the total weight of the light emitting layer-forming composition, the content of the second component is from 0.25% by weight to 2.5% by weight with respect to the total weight of the light emitting layer-forming composition, and the content of the third component is from 97.0% by weight to 99.7% by with respect to the total weight of the light emitting layer-forming composition.

The light emitting layer-forming composition can be manufactured by appropriately selecting and performing stirring, mixing, heating, cooling, dissolving, dispersing, and the like of the above components by a known method. After preparation, filtration, removal of gas (also referred to as degassing), an ion exchange treatment, an inert gas replacement/encapsulation treatment, and the like may be appropriately selected and performed.

The light emitting layer-forming composition having a high viscosity brings about good film formability and good ejection performance in a case of using an ink jet method. Meanwhile, the lower viscosity makes it easier to make a thin film. Therefore, the viscosity of the light emitting layer-forming composition is preferably from 0.3 mPa·s to 3 mPa·s, and more preferably from 1 mPa·s to 3 mPa·s at 25°C. In the present invention, the viscosity is a value measured using a cone plate type rotational viscometer (cone plate type).

The light emitting layer-forming composition having a low surface tension brings about a coating film having good film formability and no defects. Meanwhile, the light emitting layer-forming composition having a high surface tension brings about good ink jet ejection performance. Therefore, the surface tension of the light emitting layer-forming composition is preferably from 20 mN/m to 40 mN/m, and more preferably from 20 mN/m to 30 mN/m at 25°C. In the present invention, the surface tension is a value measured using a hanging drop method.

### <Electron injection layer and electron transport layer in organic electroluminescent element>

The electron injection layer 107 plays a role of efficiently injecting an electron migrating from the negative electrode 108 into the light emitting layer 105 or the electron transport layer 106. The electron transport layer 106 plays a role of efficiently transporting an electron injected from the negative electrode 108, or an electron injected from the negative electrode 108 through the electron injection layer 107 to the light emitting layer 105. The electron transport layer 106 and the electron injection layer 107 are each formed by laminating and mixing one or more kinds of electron transport/injection materials, or by a mixture of an electron transport/injection material and a polymeric binder.

An electron injection/transport layer is a layer that manages injection of an electron from a negative electrode and transport of an electron, and is preferably a layer that has high electron injection efficiency and can efficiently transport an injected electron. For this purpose, a substance which has high electron affinity, large electron mobility, and excellent stability, and in which impurities that serve as traps are not easily generated at the time of manufacturing and at the time of use, is preferable. However, when a transport balance between a hole and an electron is considered, in a case where the electron injection/transport layer mainly plays a role of efficiently preventing a hole coming from a positive electrode from flowing toward a negative electrode side without being recombined, even if electron transporting ability is not so high, an effect of enhancing luminous efficiency is equal to that of a material having high electron transporting ability. Therefore, the electron injection/transport layer according to the present embodiment may also include a function of a layer that can efficiently prevent migration of a hole.

A material (electron transport material) for forming the electron transport layer 106 or the electron injection layer 107 can be arbitrarily selected for use from compounds conventionally used as electron transfer compounds in a photoconductive material, and known compounds that are used in an electron injection layer and an electron transport layer of an organic EL element.

A material used in an electron transport layer or an electron injection layer preferably includes at least one selected from a compound formed of an aromatic ring or a heteroaromatic ring including one or more kinds of atoms selected from carbon, hydrogen, oxygen, sulfur, silicon, and phosphorus atoms, a pyrrole derivative and a fused ring derivative thereof, and a metal complex having an electron-accepting nitrogen atom. Specific examples of the material include a fused ring-based aromatic ring derivative of naphthalene, anthracene, or the like, a styryl-based aromatic ring derivative represented by 4,4'-bis(diphenylethenyl)biphenyl, a perinone derivative, a coumarin derivative, a naphthalimide derivative, a quinone derivative such as anthraquinone or diphenoquinone, a phosphorus oxide derivative, a carbazole derivative, and an indole derivative. Examples of the metal complex having an electron-accepting nitrogen atom include a hydroxyazole complex such as a hydroxyphenyloxazole complex, an azomethine complex, a tropolone metal complex, a flavonol metal complex, and a benzoquinoline metal complex. These materials are used singly, but may also be used in a mixture with other materials.

Furthermore, specific examples of other electron transfer compounds include a pyridine derivative, a naphthalene derivative, an anthracene derivative, a phenanthroline derivative, a perinone derivative, a coumarin derivative, a naphthalimide derivative, an anthraquinone derivative, a diphenoquinone derivative, a diphenylquinone derivative, a perylene derivative, an oxadiazole derivative (1,3-bis[(4-t-butylphenyl)-1,3,4-oxadiazolyl]phenylene and the like), a thiophene derivative, a triazole derivative (N-naphthyl-2,5-diphenyl-1,3,4-triazole and the like), a thiadiazole derivative, a metal complex of an oxine derivative, a quinolinol-based metal complex, a quinoxaline derivative, a polymer of a quinoxaline derivative, a benzazole compound, a gallium complex, a pyrazole derivative, a perfluorinated phenylene derivative, a triazine derivative, a pyrazine derivative, a benzoquinoline derivative (2,2'-bis(benzo[h]quinolin-2-yl)-9,9'-spirobifluorene and the like), an imidazopyridine derivative, a borane derivative, a benzimidazole derivative (tris (N-phenylbenzimidazol-2-yl)benzene and the like), a benzoxazole derivative, a benzothiazole derivative, a quinoline derivative, an oligopyridine derivative such as terpyridine, a bipyridine derivative, a terpyridine derivative (1,3-bis(4'-(2,2':6'2"-terpyridinyl))benzene and the like), a naphthyridine derivative (bis(1-naphthyl)-4-(1,8-naphthyridin-2-yl)phenylphosphine oxide and the like), an aldazine derivative, a carbazole derivative, an indole derivative, a phosphorus oxide derivative, and a bisstyryl derivative.

Furthermore, a metal complex having an electron-accepting nitrogen atom can also be used, and examples thereof include a quinolinol-based metal complex, a hydroxyazole complex such as a hydroxyphenyloxazole complex, an azomethine complex, a tropolone-metal complex, a flavonol-metal complex, and a benzoquinoline-metal complex.

The materials described above are used singly, but may also be used in a mixture with other materials.

Among the above materials, a borane derivative, a pyridine derivative, a fluoranthene derivative, a BO-based derivative, an anthracene derivative, a benzofluorene derivative, a phosphine oxide derivative, a pyrimidine derivative, a carbazole derivative, a triazine derivative, a benzimidazole derivative, a phenanthroline derivative, and a quinolinol-based metal complex are preferable.

### <Borane derivative>

The borane derivative is, for example, a compound represented by the following general formula (ETM-1), and specifically disclosed in JP 2007-27587 A.

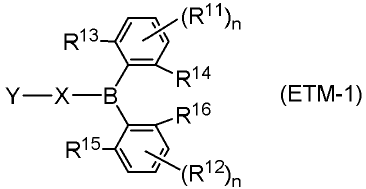

In the above formula (ETM-1), R¹¹ and R¹² each independently represent at least one of a hydrogen atom, an alkyl, an optionally substituted aryl, a substituted silyl, an optionally substituted nitrogen-containing heterocyclic ring, and cyano, R¹³ to R¹⁶ each independently represent an optionally substituted alkyl, or an optionally substituted aryl, X represents an optionally substituted arylene, Y represents an optionally substituted aryl having 16 or fewer carbon atoms, a substituted boryl, or an optionally substituted carbazolyl, and n's each independently represent an integer of 0 to 3.

Among compounds represented by the above general formula (ETM-1), a compound represented by the following general formula (ETM-1-1) and a compound represented by the following general formula (ETM-1-2) are preferable.

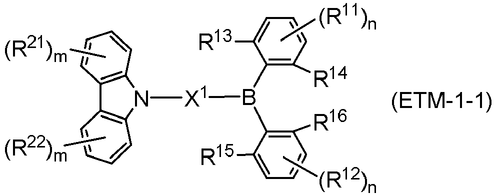

In formula (ETM-1-1), R¹¹ and R¹² each independently represent at least one of a hydrogen atom, an alkyl, an optionally substituted aryl, a substituted silyl, an optionally substituted nitrogen-containing heterocyclic ring, and cyano, R¹³ to R¹⁶ each independently represent an optionally substituted alkyl, or an optionally substituted aryl, R²¹ and R²² each independently represent at least one of a hydrogen atom, an alkyl, an optionally substituted aryl, a substituted silyl, an optionally substituted nitrogen-containing heterocyclic ring, and cyano, X¹ represents an optionally substituted arylene having 20 or fewer carbon atoms, n's each independently represent an integer of 0 to 3, and m's each independently represent an integer of 0 to 4.

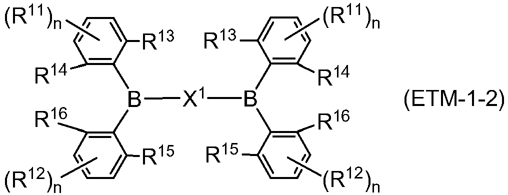

In formula (ETM-1-2), R¹¹ and R¹² each independently represent at least one of a hydrogen atom, an alkyl, an optionally substituted aryl, a substituted silyl, an optionally substituted nitrogen-containing heterocyclic ring, and cyano, R¹³ to R¹⁶ each independently represent an optionally substituted alkyl, or an optionally substituted aryl, X¹ represents an optionally substituted arylene having 20 or fewer carbon atoms, and n's each independently represent an integer of 0 to 3.

Specific examples of X¹ include divalent groups represented by the following formulas (X-1) to (X-9).

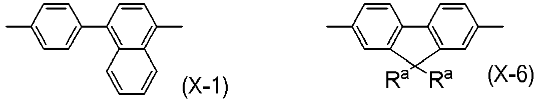

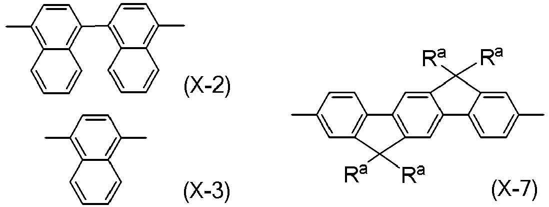

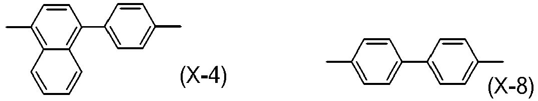

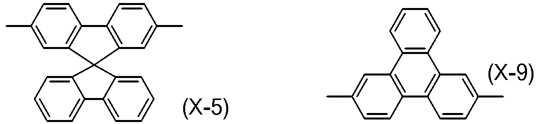

(In each formula, R^{a}'s each independently represent an alkyl group, or an optionally substituted phenyl group.)

Specific examples of this borane derivative include the following compounds.

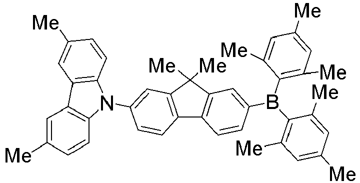

This borane derivative can be manufactured using known raw materials and known synthesis methods.

### <Pyridine derivative>

A pyridine derivative is, for example, a compound represented by the following formula (ETM-2), and preferably a compound represented by formula (ETM-2-1) or (ETM-2-2).

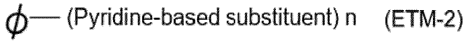

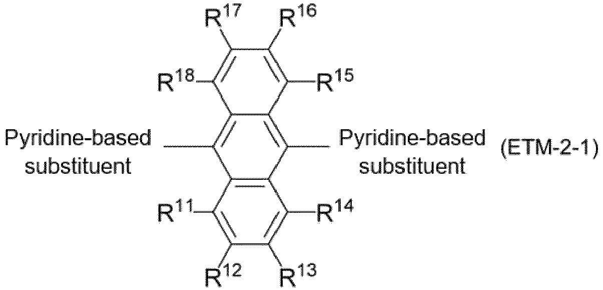

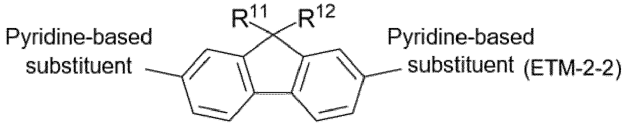

φ represents an n-valent aryl ring (preferably, an n-valent benzene ring, naphthalene ring, anthracene ring, fluorene ring, benzofluorene ring, phenalene ring, phenanthrene ring, or triphenylene ring), and n represents an integer of 1 to 4.

In the above formula (ETM-2-1), R¹¹ to R¹⁸ each independently represent a hydrogen atom, an alkyl (preferably, an alkyl having 1 to 24 carbon atoms), a cycloalkyl (preferably, a cycloalkyl having 3 to 12 carbon atoms), or an aryl (preferably, an aryl having 6 to 30 carbon atoms).

In the above formula (ETM-2-2), R¹¹ and R¹² each independently represent a hydrogen atom, an alkyl (preferably, an alkyl having 1 to 24 carbon atoms), a cycloalkyl (preferably, a cycloalkyl having 3 to 12 carbon atoms), or an aryl (preferably, an aryl having 6 to 30 carbon atoms), and R¹¹ and R¹² may be bonded to each other to form a ring.

In each formula, the "pyridine-based substituent" is any one of the following formulas (Py-1) to (Py-15), and the pyridine-based substituents may be each independently substituted by an alkyl having 1 to 4 carbon atoms. Furthermore, the pyridine-based substituent may be bonded to φ, an anthracene ring, or a fluorene ring in each formula via a phenylene group or a naphthylene group.

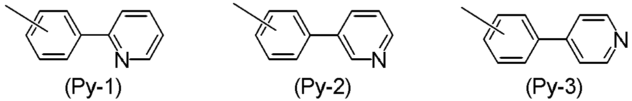

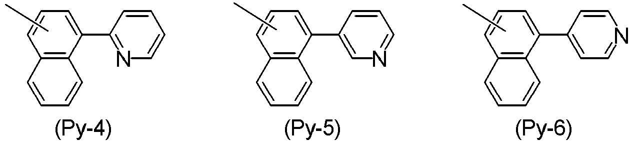

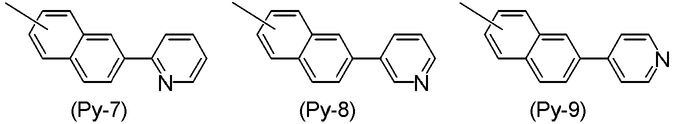

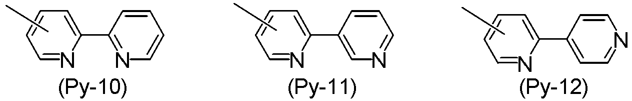

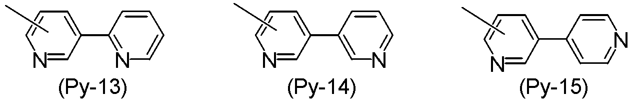

The pyridine-based substituent is any one of the above-formulas (Py-1) to (Py-15). However, among these formulas, the pyridine-based substituent is preferably any one of the following formulas (Py-21) to (Py-44).

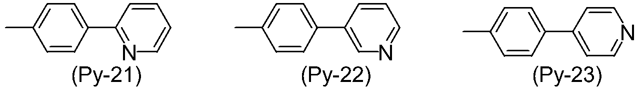

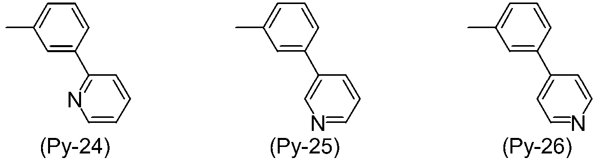

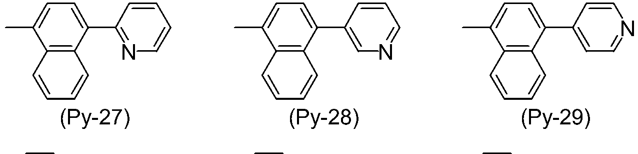

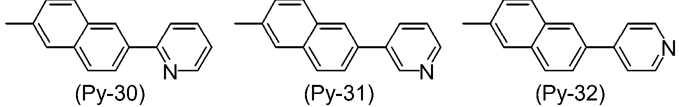

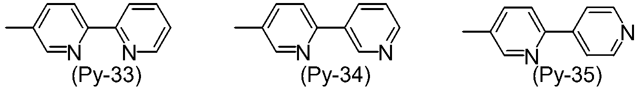

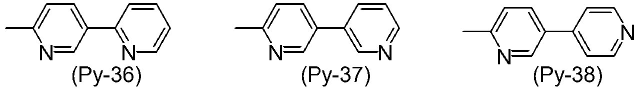

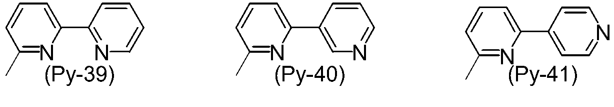

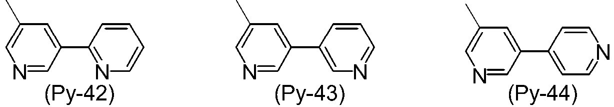

At least one hydrogen atom in each pyridine derivative may be substituted by a deuterium atom. Furthermore, one of the two "pyridine-based substituents" in the above formulas (ETM-2-1) and (ETM-2-2) may be substituted by an aryl.

The "alkyl" in R¹¹ to R¹⁸ may be either linear or branched, and examples thereof include a linear alkyl having 1 to 24 carbon atoms and a branched alkyl having 3 to 24 carbon atoms. A preferable "alkyl" is an alkyl having 1 to 18 carbon atoms (branched alkyl having 3 to 18 carbon atoms). A more preferable "alkyl" is an alkyl having 1 to 12 carbons (branched alkyl having 3 to 12 carbons). A still more preferable "alkyl" is an alkyl having 1 to 6 carbon atoms (branched alkyl having 3 to 6 carbon atoms). A particularly preferable "alkyl" is an alkyl having 1 to 4 carbon atoms (branched alkyl having 3 to 4 carbon atoms).

Specific examples of the "alkyl" include methyl, ethyl, n-propyl, isopropyl, n-butyl, isobutyl, s-butyl, t-butyl, n-pentyl, isopentyl, neopentyl, t-pentyl, n-hexyl, 1-methylpentyl, 4-methyl-2-pentyl, 3,3-dimethylbutyl, 2-ethylbutyl, n-heptyl, 1-methylhexyl, n-octyl, t-octyl, 1-methylheptyl, 2-ethylhexyl, 2-propylpentyl, n-nonyl, 2,2-dimethylheptyl, 2,6-dimethyl-4-heptyl, 3,5,5-trimethylhexyl, n-decyl, n-undecyl, 1-methyldecyl, n-dodecyl, n-tridecyl, 1-hexylheptyl, n-tetradecyl, n-pentadecyl, n-hexadecyl, n-heptadecyl, n-octadecyl, and n-eicosyl.

As the alkyl having 1 to 4 carbon atoms by which the pyridine-based substituent is substituted, the above description of the alkyl can be cited.

Examples of the "cycloalkyl" in R¹¹ to R¹⁸ include a cycloalkyl having 3 to 12 carbon atoms. A preferable "cycloalkyl" is a cycloalkyl having 3 to 10 carbons. A more preferable "cycloalkyl" is a cycloalkyl having 3 to 8 carbon atoms. A still more preferable "cycloalkyl" is a cycloalkyl having 3 to 6 carbon atoms.

Specific examples of the "cycloalkyl" include cyclopropyl, cyclobutyl, cyclopentyl, cyclohexyl, methylcyclopentyl, cycloheptyl, methylcyclohexyl, cyclooctyl, and dimethylcyclohexyl.

As the "aryl" in R¹¹ to R¹⁸, a preferable aryl is an aryl having 6 to 30 carbon atoms, a more preferable aryl is an aryl having 6 to 18 carbon atoms, a still more preferable aryl is an aryl having 6 to 14 carbon atoms, and a particularly preferable aryl is an aryl having 6 to 12 carbon atoms.

Specific examples of the "aryl having 6 to 30 carbon atoms" include phenyl which is a monocyclic aryl; (1-,2-)naphthyl which is a fused bicyclic aryl; acenaphthylene-(1-,3-,4-,5-)yl, a fluorene-(1-,2-,3-,4-,9-)yl, phenalene-(1-, 2-)yl, and (1-,2-,3-,4-,9-)phenanthryl which are fused tricyclic aryls; triphenylene-(1-, 2-)yl, pyrene-(1- ,2-, 4-)yl, and naphthacene- (1-, 2-, 5-)yl which are fused tetracyclic aryls; and perylene-(1-,2-,3-)yl and pentacene-(1-, 2-, 5-, 6-)yl which are fused pentacyclic aryls.

Preferable examples of the "aryl having 6 to 30 carbon atoms" include a phenyl, a naphthyl, a phenanthryl, a chrysenyl, and a triphenylenyl. More preferable examples thereof include a phenyl, a 1-naphthyl, a 2-naphthyl, and a phenanthryl. Particularly preferable examples thereof include a phenyl, a 1-naphthyl, and a 2-naphthyl.

R¹¹ and R¹² in the above formula (ETM-2-2) may be bonded to each other to form a ring. As a result, cyclobutane, cyclopentane, cyclopentene, cyclopentadiene, cyclohexane, fluorene, indene, or the like may be spiro-bonded to a 5-membered ring of a fluorene skeleton.

Specific examples of this pyridine derivative include the following compounds.

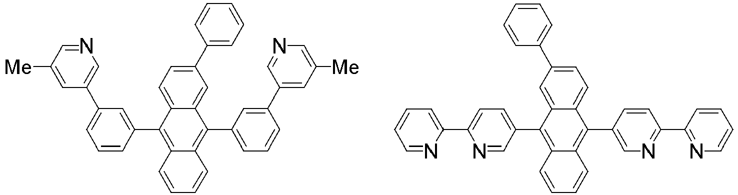

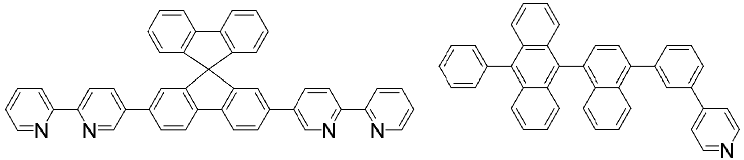

This pyridine derivative can be manufactured using known raw materials and known synthesis methods.

### <Fluoranthene derivative>

The fluoranthene derivative is, for example, a compound represented by the following general formula (ETM-3), and specifically disclosed in WO 2010/134352 A.

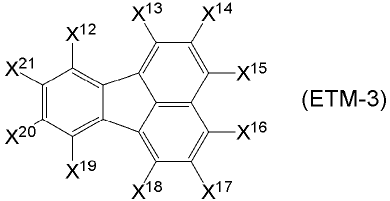

In the above formula (ETM-3), X¹² to X²¹ each represent a hydrogen atom, a halogen atom, a linear, branched or cyclic alkyl, a linear, branched or cyclic alkoxy, a substituted or unsubstituted aryl, or a substituted or unsubstituted heteroaryl.

Specific examples of this fluoranthene derivative include the following compounds.

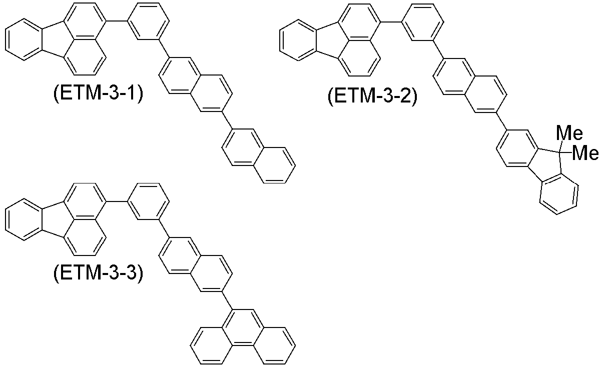

### <BO-based derivative>

The BO-based derivative is, for example, a polycyclic aromatic compound represented by the following formula (ETM-4) or a polycyclic aromatic compound multimer having a plurality of structures represented by the following formula (ETM-4).

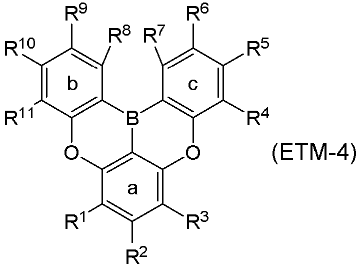

R¹ to R¹¹ each independently represent a hydrogen atom, an aryl, a heteroaryl, a diarylamino, a diheteroarylamino, an arylheteroarylamino, an alkyl, an alkoxy, or an aryloxy, while at least one hydrogen atom in these may be substituted by an aryl, a heteroaryl, or an alkyl.

Furthermore, adjacent groups among R¹ to R¹¹ may be bonded to each other to form an aryl ring or a heteroaryl ring together with the ring a, ring b, or ring c, and at least one hydrogen atom in the ring thus formed may be substituted by an aryl, a heteroaryl, a diarylamino, a diheteroarylamino, an arylheteroarylamino, an alkyl, an alkoxy, or an aryloxy, while at least one hydrogen atom in these may be substituted by an aryl, a heteroaryl, or an alkyl.

Furthermore, at least one hydrogen atom in a compound or structure represented by formula (ETM-4) may be substituted by a halogen atom or a deuterium atom.

For description of a substituent in formula (ETM-4), a form of ring formation, and a multimer formed by combining multiple structures of formula (ETM-4), the description of the polycyclic aromatic compound represented by the above general formula (1) or (1') and the multimer thereof can be cited.

Specific examples of this BO-based derivative include the following compounds.

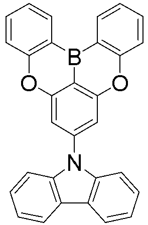

This BO-based derivative can be manufactured using known raw materials and known synthesis methods.

### <Anthracene derivative>

One of the anthracene derivatives is, for example, a compound represented by the following formula (ETM-5-1).

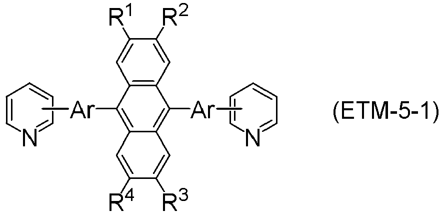

Ar's each independently represent a divalent benzene or naphthalene, R¹ to R⁴ each independently represent a hydrogen atom, an alkyl having 1 to 6 carbon atoms, a cycloalkyl having 3 to 6 carbon atoms, or an aryl having 6 to 20 carbon atoms.

Ar's can be each independently selected from a divalent benzene and naphthalene appropriately. Two Ar's may be different from or the same as each other, but are preferably the same from a viewpoint of easiness of synthesis of an anthracene derivative. Ar is bonded to pyridine to form "a moiety formed of Ar and pyridine". For example, this moiety is bonded to anthracene as a group represented by any one of the following formulas (Py-1) to (Py-12).

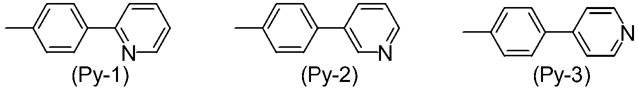

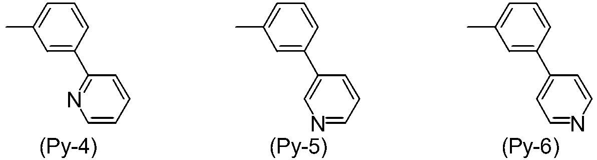

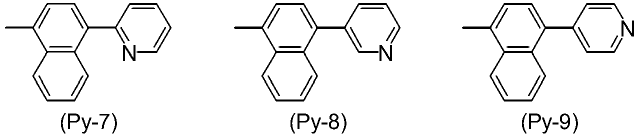

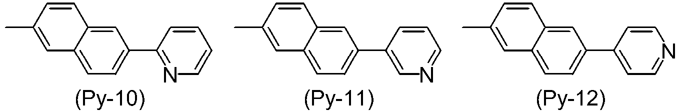

Among these groups, a group represented by any one of the above formulas (Py-1) to (Py-9) is preferable, and a group represented by any one of the above formulas (Py-1) to (Py-6) is more preferable. Two "moieties formed of Ar and pyridine" bonded to anthracene may have the same structure as or different structures from each other, but preferably have the same structure from a viewpoint of easiness of synthesis of an anthracene derivative. However, two "moieties formed of Ar and pyridine" preferably have the same structure or different structures from a viewpoint of element characteristics.

The alkyl having 1 to 6 carbon atoms in R¹ to R⁴ may be either linear or branched. That is, the alkyl having 1 to 6 carbon atoms is a linear alkyl having 1 to 6 carbon atoms or a branched alkyl having 3 to 6 carbon atoms. More preferably, the alkyl having 1 to 6 carbon atoms is an alkyl having 1 to 4 carbon atoms (branched alkyl having 3 to 4 carbon atoms). Specific examples thereof include methyl, ethyl, n-propyl, isopropyl, n-butyl, isobutyl, s-butyl, t-butyl, n-pentyl, isopentyl, neopentyl, t-pentyl, n-hexyl, 1-methylpentyl, 4-methyl-2-pentyl, 3,3-dimethylbutyl, and 2-ethylbutyl. Methyl, ethyl, n-propyl, isopropyl, n-butyl, isobutyl, s-butyl, and t-butyl are preferable. Methyl, ethyl, and t-butyl are more preferable.

Specific examples of the cycloalkyl having 3 to 6 carbon atoms in R¹ to R⁴ include cyclopropyl, cyclobutyl, cyclopentyl, cyclohexyl, methylcyclopentyl, cycloheptyl, methylcyclohexyl, cyclooctyl, and dimethylcyclohexyl.

For the aryl having 6 to 20 carbon atoms in R¹ to R⁴, an aryl having 6 to 16 carbon atoms is preferable, an aryl having 6 to 12 carbon atoms is more preferable, and an aryl having 6 to 10 carbon atoms is particularly preferable.

Specific examples of the "aryl having 6 to 20 carbon atoms" include phenyl, (o-, m-, p-) tolyl, (2,3-,2,4-,2,5-, 2,6-, 3,4-, 3,5-) xylyl, mesityl (2,4,6-trimethylphenyl), and (o-, m-, p-)cumenyl which are monocyclic aryls; (2-, 3-, 4-)biphenylyl which is a bicyclic aryl; (1-, 2-)naphthyl which is a fused bicyclic aryl; terphenylyl (m-terphenyl-2'-yl, m-terphenyl-4'-yl, m-terphenyl-5'-yl, o-terphenyl-3'-yl, o-terphenyl-4'-yl, p-terphenyl-2'-yl, m-terphenyl-2-yl, m-terphenyl-3-yl, m-terphenyl-4-yl, o-terphenyl-2-yl, o-terphenyl-3-yl, o-terphenyl-4-yl, p-terphenyl-2-yl, p-terphenyl-3-yl, p-terphenyl-4-yl) which is a tricyclic aryl; anthracene-(1-, 2-, 9-)yl, acenaphthylene-(1-, 3-, 4-, 5-)yl, fluorene-(1-, 2-, 3-, 4-, 9-)yl, phenalene-(1-, 2-)yl, and (1-, 2-, 3-, 4-, 9-)phenanthryl which are fused tricyclic aryls; triphenylene-(1-, 2-)yl, pyrene-(1-, 2-, 4-)yl, and tetracene-(1-, 2-, 5-)yl which are fused tetracyclic aryls; and perylene-(1-, 2-, 3-)yl which is a fused pentacyclic aryl.

The "aryl having 6 to 20 carbon atoms" is preferably a phenyl, a biphenylyl, a terphenylyl, or a naphthyl, more preferably a phenyl, a biphenylyl, a 1-naphthyl, a 2-naphthyl, or an m-terphenyl-5'-yl, still more preferably a phenyl, a biphenylyl, a 1-naphthyl, or a 2-naphthyl, and most preferably a phenyl.

One of the anthracene derivatives is, for example, a compound represented by the following formula (ETM-5-2).

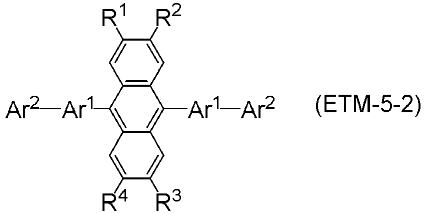

Ar¹'s each independently represent a single bond, a divalent benzene, naphthalene, anthracene, fluorene, or phenalene.

Ar²'s each independently represent an aryl having 6 to 20 carbon atoms. The same description as the "aryl having 6 to 20 carbon atoms" in the above formula (ETM-5-1) can be cited. An aryl having 6 to 16 carbon atoms is preferable, an aryl having 6 to 12 carbon atoms is more preferable, and an aryl having 6 to 10 carbon atoms is particularly preferable. Specific examples thereof include phenyl, biphenylyl, naphthyl, terphenylyl, anthracenyl, acenaphthylenyl, fluorenyl, phenalenyl, phenanthryl, triphenylenyl, pyrenyl, tetracenyl, and perylenyl.

R¹ to R⁴ each independently represent a hydrogen atom, an alkyl having 1 to 6 carbon atoms, a cycloalkyl having 3 to 6 carbon atoms, or an aryl having 6 to 20 carbon atoms. The same description as in the above formula (ETM-5-1) can be cited.

Specific examples of these anthracene derivatives include the following compounds.

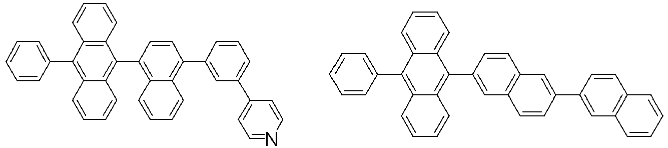

These anthracene derivatives can be manufactured using known raw materials and known synthesis methods.

### <Benzofluorene derivative>

The benzofluorene derivative is, for example, a compound represented by the following formula (ETM-6).

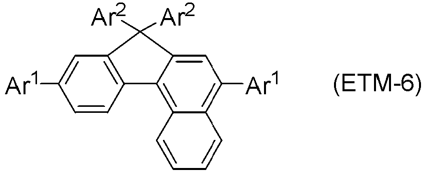

Ar¹'s each independently represent an aryl having 6 to 20 carbon atoms. The same description as the "aryl having 6 to 20 carbon atoms" in the above formula (ETM-5-1) can be cited. An aryl having 6 to 16 carbon atoms is preferable, an aryl having 6 to 12 carbon atoms is more preferable, and an aryl having 6 to 10 carbon atoms is particularly preferable. Specific examples thereof include phenyl, biphenylyl, naphthyl, terphenylyl, anthracenyl, acenaphthylenyl, fluorenyl, phenalenyl, phenanthryl, triphenylenyl, pyrenyl, tetracenyl, and perylenyl.

Ar²'s each independently represent a hydrogen atom, an alkyl (preferably, an alkyl having 1 to 24 carbon atoms), a cycloalkyl (preferably, a cycloalkyl having 3 to 12 carbon atoms), or an aryl (preferably, an aryl having 6 to 30 carbon atoms), and two Ar²'s may be bonded to each other to form a ring.

The "alkyl" in Ar² may be either linear or branched, and examples thereof include a linear alkyl having 1 to 24 carbon atoms and a branched alkyl having 3 to 24 carbon atoms. A preferable "alkyl" is an alkyl having 1 to 18 carbon atoms (branched alkyl having 3 to 18 carbon atoms). A more preferable "alkyl" is an alkyl having 1 to 12 carbons (branched alkyl having 3 to 12 carbons). A still more preferable "alkyl" is an alkyl having 1 to 6 carbon atoms (branched alkyl having 3 to 6 carbon atoms). A particularly preferable "alkyl" is an alkyl having 1 to 4 carbon atoms (branched alkyl having 3 to 4 carbon atoms). Specific examples of the "alkyl" include methyl, ethyl, n-propyl, isopropyl, n-butyl, isobutyl, s-butyl, t-butyl, n-pentyl, isopentyl, neopentyl, t-pentyl, n-hexyl, 1-methylpentyl, 4-methyl-2-pentyl, 3,3-dimethylbutyl, 2-ethylbutyl, n-heptyl, and 1-methylhexyl.

Examples of the "cycloalkyl" in Ar² include a cycloalkyl having 3 to 12 carbon atoms. A preferable "cycloalkyl" is a cycloalkyl having 3 to 10 carbons. A more preferable "cycloalkyl" is a cycloalkyl having 3 to 8 carbon atoms. A still more preferable "cycloalkyl" is a cycloalkyl having 3 to 6 carbon atoms. Specific examples of the "cycloalkyl" include cyclopropyl, cyclobutyl, cyclopentyl, cyclohexyl, methylcyclopentyl, cycloheptyl, methylcyclohexyl, cyclooctyl, and dimethylcyclohexyl.

As the "aryl" in Ar², a preferable aryl is an aryl having 6 to 30 carbon atoms, a more preferable aryl is an aryl having 6 to 18 carbon atoms, a still more preferable aryl is an aryl having 6 to 14 carbon atoms, and a particularly preferable aryl is an aryl having 6 to 12 carbon atoms.

Specific examples of the "aryl having 6 to 30 carbon atoms" include phenyl, naphthyl, acenaphthylenyl, fluorenyl, phenalenyl, phenanthryl, triphenylenyl, pyrenyl, naphthacenyl, perylenyl, and pentacenyl.

Two Ar²'s may be bonded to each other to form a ring. As a result, cyclobutane, cyclopentane, cyclopentene, cyclopentadiene, cyclohexane, fluorene, indene, or the like may be spiro-bonded to a 5-membered ring of a fluorene skeleton.

Specific examples of this benzofluorene derivative include the following compounds.

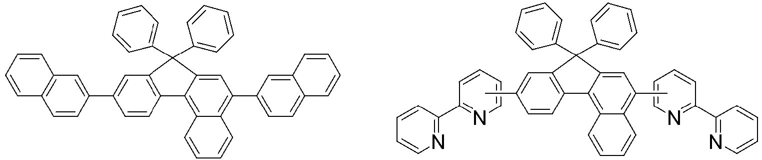

This benzofluorene derivative can be manufactured using known raw materials and known synthesis methods.

### <Phosphine oxide derivative>

The phosphine oxide derivative is, for example, a compound represented by the following formula (ETM-7-1). Details are also described in WO 2013/079217 A.

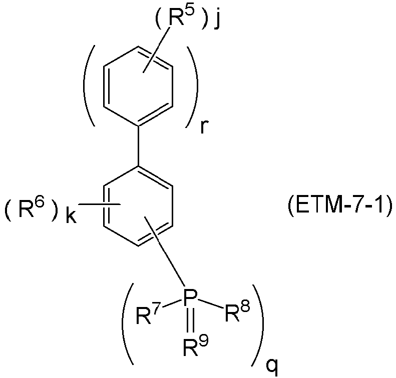

R⁵ represents a substituted or unsubstituted alkyl having 1 to 20 carbon atoms, an aryl having 6 to 20 carbon atoms, or a heteroaryl having 5 to 20 carbon atoms, R⁶ represents CN, a substituted or unsubstituted alkyl having 1 to 20 carbons, a heteroalkyl having 1 to 20 carbons, an aryl having 6 to 20 carbons, a heteroaryl having 5 to 20 carbons, an alkoxy having 1 to 20 carbons, or an aryloxy having 6 to 20 carbon atoms, R⁷ and R⁸ each independently represent a substituted or unsubstituted aryl having 6 to 20 carbon atoms or a heteroaryl having 5 to 20 carbon atoms, R⁹ represents an oxygen atom or a sulfur atom, j represents 0 or 1, k represents 0 or 1, r represents an integer of 0 to 4, and q represents an integer of 1 to 3.

The phosphine oxide derivative may be, for example, a compound represented by the following formula (ETM-7-2).

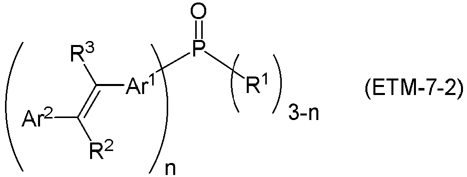

R¹ to R³ may be the same as or different from each other and are selected from a hydrogen atom, an alkyl group, a cycloalkyl group, an aralkyl group, an alkenyl group, a cycloalkenyl group, an alkynyl group, an alkoxy group, an alkylthio group, an aryl ether group, an aryl thioether group, an aryl group, a heterocyclic group, a halogen atom, cyano group, an aldehyde group, a carbonyl group, a carboxyl group, an amino group, a nitro group, a silyl group, and a fused ring formed with an adjacent substituent.

Ar¹'s may be the same as or different from each other, and represents an arylene group or a heteroarylene group. Ar²'s may be the same as or different from each other, and represents an aryl group or a heteroaryl group. However, at least one of Ar¹ and Ar² has a substituent or forms a fused ring with an adjacent substituent. n represents an integer of 0 to 3. When n is 0, no unsaturated structure portion is present. When n is 3, R¹ is not present.

Among these substituents, the alkyl group represents a saturated aliphatic hydrocarbon group such as a methyl group, an ethyl group, a propyl group, or a butyl group. This saturated aliphatic hydrocarbon group may be unsubstituted or substituted. The substituent in a case of being substituted is not particularly limited, and examples thereof include an alkyl group, an aryl group, and a heterocyclic group, and this point is also common to the following description. Furthermore, the number of carbon atoms in the alkyl group is not particularly limited, but is usually in a range of 1 to 20 from a viewpoint of availability and cost.

Furthermore, the cycloalkyl group represents a saturated alicyclic hydrocarbon group such as cyclopropyl, cyclohexyl, norbornyl, or adamantyl. This saturated alicyclic hydrocarbon group may be unsubstituted or substituted. The carbon number of the alkyl group moiety is not particularly limited, but is usually in a range of 3 to 20.

Furthermore, the aralkyl group represents an aromatic hydrocarbon group via an aliphatic hydrocarbon, such as a benzyl group or a phenylethyl group. Both the aliphatic hydrocarbon and the aromatic hydrocarbon may be unsubstituted or substituted. The carbon number of the aliphatic moiety is not particularly limited, but is usually in a range of 1 to 20.

Furthermore, the alkenyl group represents an unsaturated aliphatic hydrocarbon group containing a double bond, such as a vinyl group, an allyl group, or a butadienyl group. This unsaturated aliphatic hydrocarbon group may be unsubstituted or substituted. The carbon number of the alkenyl group is not particularly limited, but is usually in a range of 2 to 20.

Furthermore, the cycloalkenyl group represents an unsaturated alicyclic hydrocarbon group containing a double bond, such as a cyclopentenyl group, a cyclopentadienyl group, or a cyclohexene group. This unsaturated alicyclic hydrocarbon group may be unsubstituted or substituted.

Furthermore, the alkynyl group represents an unsaturated aliphatic hydrocarbon group containing a triple bond, such as an acetylenyl group. This unsaturated aliphatic hydrocarbon group may be unsubstituted or substituted. The carbon number of the alkynyl group is not particularly limited, but is usually in a range of 2 to 20.

Furthermore, the alkoxy group represents an aliphatic hydrocarbon group via an ether bond, such as a methoxy group. The aliphatic hydrocarbon group may be unsubstituted or substituted. The carbon number of the alkoxy group is not particularly limited, but is usually in a range of 1 to 20.

Furthermore, the alkylthio group is a group in which an oxygen atom of an ether bond of an alkoxy group is substituted by a sulfur atom.

Furthermore, the aryl ether group represents an aromatic hydrocarbon group via an ether bond, such as a phenoxy group. The aromatic hydrocarbon group may be unsubstituted or substituted. The carbon number of the aryl ether group is not particularly limited, but is usually in a range of 6 to 40.

Furthermore, the aryl thioether group is a group in which an oxygen atom of an ether bond of an aryl ether group is substituted by a sulfur atom.

Furthermore, the aryl group represents an aromatic hydrocarbon group such as a phenyl group, a naphthyl group, a biphenylyl group, a phenanthryl group, a terphenyl group, or a pyrenyl group. The aryl group may be unsubstituted or substituted. The carbon number of the aryl group is not particularly limited, but is usually in a range of 6 to 40.

Furthermore, the heterocyclic group represents a cyclic structural group having an atom other than a carbon atom, such as a furanyl group, a thiophenyl group, an oxazolyl group, a pyridyl group, a quinolinyl group, or a carbazolyl group. This cyclic structural group may be unsubstituted or substituted. The carbon number of the heterocyclic group is not particularly limited, but is usually in a range of 2 to 30.

Halogen refers to fluorine, chlorine, bromine, and iodine.

The aldehyde group, the carbonyl group, and the amino group can include a group substituted by an aliphatic hydrocarbon, an alicyclic hydrocarbon, an aromatic hydrocarbon, a heterocyclic ring, or the like.

Furthermore, the aliphatic hydrocarbon, the alicyclic hydrocarbon, the aromatic hydrocarbon, and the heterocyclic ring may be unsubstituted or substituted.

The silyl group represents, for example, a silicon compound group such as a trimethylsilyl group. This silicon compound group may be unsubstituted or substituted. The number of carbon atoms of the silyl group is not particularly limited, but is usually in a range of 3 to 20. Furthermore, the number of silicon atoms is usually 1 to 6.

The fused ring formed with an adjacent substituent is, for example, a conjugated or unconjugated fused ring formed between Ar¹ and R², Ar¹ and R³, Ar² and R², Ar² and R³, R² and R³, or Ar¹ and Ar². Here, when n is 1, two R¹'s may form a conjugated or unconjugated fused ring. These fused rings may contain a nitrogen atom, an oxygen atom, or a sulfur atom in the ring structure, or may be fused with another ring.

Specific examples of this phosphine oxide derivative include the following compounds.

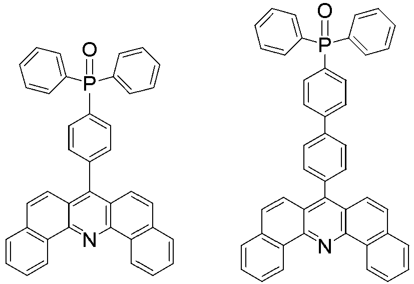

This phosphine oxide derivative can be manufactured using known raw materials and known synthesis methods.

### <Pyrimidine derivative>

The pyrimidine derivative is, for example, a compound represented by the following formula (ETM-8), and preferably a compound represented by the following formula (ETM-8-1). Details are also described in WO 2011/021689 A.

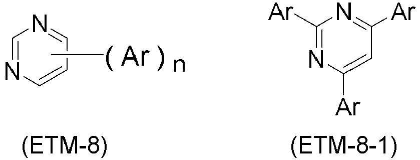

Ar's each independently represent an optionally substituted aryl or an optionally substituted heteroaryl. n represents an integer of 1 to 4, preferably an integer of 1 to 3, and more preferably 2 or 3.

Examples of the "aryl" as the "optionally substituted aryl" include an aryl having 6 to 30 carbon atoms. An aryl having 6 to 24 carbon atoms is preferable, an aryl having 6 to 20 carbon atoms is more preferable, and an aryl having 6 to 12 carbon atoms is still more preferable.

Specific examples of the "aryl" include phenyl which is a monocyclic aryl; (2-, 3-, 4-)biphenylyl which is a bicyclic aryl; (1-, 2-)naphthyl which is a fused bicyclic aryl; terphenylyl (m-terphenyl-2'-yl, m-terphenyl-4'-yl, m-terphenyl-5'-yl, o-terphenyl-3'-yl, o-terphenyl-4'-yl, p-terphenyl-2'-yl, m-terphenyl-2-yl, m-terphenyl-3-yl, m-terphenyl-4-yl, o-terphenyl-2-yl, o-terphenyl-3-yl, o-terphenyl-4-yl, p-terphenyl-2-yl, p-terphenyl-3-yl, p-terphenyl-4-yl) which is a tricyclic aryl; acenaphthylene-(1-, 3-, 4-, 5-)yl, fluorene-(1-, 2-, 3-, 4-, 9-)yl, phenalene-(1-, 2-)yl, and (1-, 2-, 3-, 4-, 9-)phenanthryl which are fused tricyclic aryls; quaterphenylyl-(5'-phenyl-m-terphenyl-2-yl, 5'-phenyl-m-terphenyl-3-yl, 5'-phenyl-m-terphenyl-4-yl, m-quaterphenylyl) which is a tetracyclic aryl; triphenylene-(1-, 2-)yl, pyrene-(1-, 2-, 4-)yl, and naphthacene- (1-, 2-, 5-)yl which are fused tetracyclic aryls; and perylene- (1-, 2-, 3-)yl and pentacene- (1-, 2-, 5-, 6-)yl which are fused pentacyclic aryls.

Examples of the "heteroaryl" as the "optionally substituted heteroaryl" include a heteroaryl having 2 to 30 carbon atoms. A heteroaryl having 2 to 25 carbon atoms is preferable, a heteroaryl having 2 to 20 carbon atoms is more preferable, a heteroaryl having 2 to 15 carbon atoms is still more preferable, and a heteroaryl having 2 to 10 carbon atoms is particularly preferable. Furthermore, examples of the "heteroaryl" include a heterocyclic ring containing 1 to 5 heteroatoms selected from an oxygen atom, a sulfur atom, and a nitrogen atom in addition to a carbon atom as a ring-constituting atom.

Specific examples of the "heteroaryl" include furyl, thienyl, pyrrolyl, oxazolyl, isoxazolyl, thiazolyl, isothiazolyl, imidazolyl, pyrazolyl, oxadiazolyl, furazanyl, thiadiazolyl, triazolyl, tetrazolyl, pyridyl, pyrimidinyl, pyridazinyl, pyrazinyl, triazinyl, benzofuranyl, isobenzofuranyl, benzo[b]thienyl, indolyl, isoindolyl, 1H-indazolyl, benzoimidazolyl, benzoxazolyl, benzothiazolyl, 1H-benzotriazolyl, quinolyl, isoquinolyl, cinnolyl, quinazolyl, quinoxalinyl, phthalazinyl, naphthyridinyl, purinyl, pteridinyl, carbazolyl, acridinyl, phenoxazinyl, phenothiazinyl, phenazinyl, phenoxathiinyl, thianthrenyl, and indolizinyl.

Furthermore, the above aryl and heteroaryl may be substituted, and may be each substituted by, for example, the above aryl or heteroaryl.

Specific examples of this pyrimidine derivative include the following compounds.

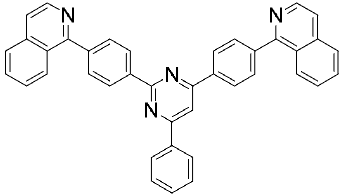

This pyrimidine derivative can be manufactured using known raw materials and known synthesis methods.

### <Carbazole derivative>

The carbazole derivative is, for example, a compound represented by the following formula (ETM-9), or a multimer obtained by bonding a plurality of the compounds with a single bond or the like. Details are described in US 2014/0197386 A.

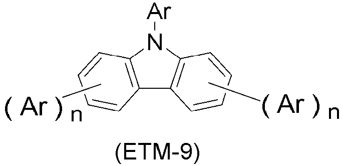

Ar's each independently represent an optionally substituted aryl or an optionally substituted heteroaryl. n represents an integer of 0 to 4, preferably an integer of 0 to 3, and more preferably 0 or 1.

Examples of the "aryl" as the "optionally substituted aryl" include an aryl having 6 to 30 carbon atoms. An aryl having 6 to 24 carbon atoms is preferable, an aryl having 6 to 20 carbon atoms is more preferable, and an aryl having 6 to 12 carbon atoms is still more preferable.

Specific examples of the "aryl" include phenyl which is a monocyclic aryl; (2-, 3-, 4-)biphenylyl which is a bicyclic aryl; (1-, 2-)naphthyl which is a fused bicyclic aryl; terphenylyl (m-terphenyl-2'-yl, m-terphenyl-4'-yl, m-terphenyl-5'-yl, o-terphenyl-3'-yl, o-terphenyl-4'-yl, p-terphenyl-2'-yl, m-terphenyl-2-yl, m-terphenyl-3-yl, m-terphenyl-4-yl, o-terphenyl-2-yl, o-terphenyl-3-yl, o-terphenyl-4-yl, p-terphenyl-2-yl, p-terphenyl-3-yl, p-terphenyl-4-yl) which is a tricyclic aryl; acenaphthylene-(1-, 3-, 4-, 5-)yl, fluorene-(1-, 2-, 3-, 4-, 9-)yl, phenalene-(1-, 2-)yl, and (1-, 2-, 3-, 4-, 9-)phenanthryl which are fused tricyclic aryls; quaterphenylyl-(5'-phenyl-m-terphenyl-2-yl, 5'-phenyl-m-terphenyl-3-yl, 5'-phenyl-m-terphenyl-4-yl, m-quaterphenylyl) which is a tetracyclic aryl; triphenylene-(1-, 2-)yl, pyrene-(1-, 2-, 4-)yl, and naphthacene- (1-, 2-, 5-)yl which are fused tetracyclic aryls; and perylene- (1-, 2-, 3-)yl and pentacene- (1-, 2-, 5-, 6-)yl which are fused pentacyclic aryls.

Examples of the "heteroaryl" as the "optionally substituted heteroaryl" include a heteroaryl having 2 to 30 carbon atoms. A heteroaryl having 2 to 25 carbon atoms is preferable, a heteroaryl having 2 to 20 carbon atoms is more preferable, a heteroaryl having 2 to 15 carbon atoms is still more preferable, and a heteroaryl having 2 to 10 carbon atoms is particularly preferable. Furthermore, examples of the "heteroaryl" include a heterocyclic ring containing 1 to 5 heteroatoms selected from an oxygen atom, a sulfur atom, and a nitrogen atom in addition to a carbon atom as a ring-constituting atom.

Specific examples of the "heteroaryl" include furyl, thienyl, pyrrolyl, oxazolyl, isoxazolyl, thiazolyl, isothiazolyl, imidazolyl, pyrazolyl, oxadiazolyl, furazanyl, thiadiazolyl, triazolyl, tetrazolyl, pyridyl, pyrimidinyl, pyridazinyl, pyrazinyl, triazinyl, benzofuranyl, isobenzofuranyl, benzo[b]thienyl, indolyl, isoindolyl, 1H-indazolyl, benzoimidazolyl, benzoxazolyl, benzothiazolyl, 1H-benzotriazolyl, quinolyl, isoquinolyl, cinnolyl, quinazolyl, quinoxalinyl, phthalazinyl, naphthyridinyl, purinyl, pteridinyl, carbazolyl, acridinyl, phenoxazinyl, phenothiazinyl, phenazinyl, phenoxathiinyl, thianthrenyl, and indolizinyl.

Furthermore, the above aryl and heteroaryl may be substituted, and may be each substituted by, for example, the above aryl or heteroaryl.

The carbazole derivative may be a multimer obtained by bonding a plurality of compounds represented by the above formula (ETM-9) with a single bond or the like. In this case, the compounds may be bonded with an aryl ring (preferably, a polyvalent benzene ring, naphthalene ring, anthracene ring, fluorene ring, benzofluorene ring, phenalene ring, phenanthrene ring or triphenylene ring) in addition to a single bond.

Specific examples of this carbazole derivative include the following compounds.

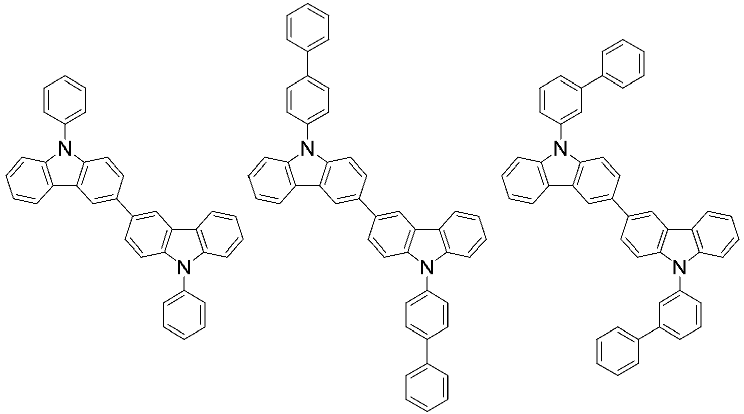

This carbazole derivative can be manufactured using known raw materials and known synthesis methods.

### <Triazine derivative>

The triazine derivative is, for example, a compound represented by the following formula (ETM-10), and preferably a compound represented by the following formula (ETM-10-1). Details are described in US 2011/0156013 A.

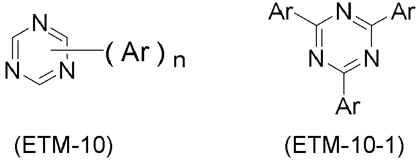

Ar's each independently represent an optionally substituted aryl or an optionally substituted heteroaryl. n represents an integer of 1 to 4, preferably an integer 1 to 3, more preferably 2 or 3.

Examples of the "aryl" as the "optionally substituted aryl" include an aryl having 6 to 30 carbon atoms. An aryl having 6 to 24 carbon atoms is preferable, an aryl having 6 to 20 carbon atoms is more preferable, and an aryl having 6 to 12 carbon atoms is still more preferable.

Specific examples of the "aryl" include phenyl which is a monocyclic aryl; (2-, 3-, 4-)biphenylyl which is a bicyclic aryl; (1-, 2-)naphthyl which is a fused bicyclic aryl; terphenylyl (m-terphenyl-2'-yl, m-terphenyl-4'-yl, m-terphenyl-5'-yl, o-terphenyl-3'-yl, o-terphenyl-4'-yl, p-terphenyl-2'-yl, m-terphenyl-2-yl, m-terphenyl-3-yl, m-terphenyl-4-yl, o-terphenyl-2-yl, o-terphenyl-3-yl, o-terphenyl-4-yl, p-terphenyl-2-yl, p-terphenyl-3-yl, p-terphenyl-4-yl) which is a tricyclic aryl; acenaphthylene-(1-, 3-, 4-, 5-)yl, fluorene-(1-, 2-, 3-, 4-, 9-)yl, phenalene-(1-, 2-)yl, and (1-, 2-, 3-, 4-, 9-)phenanthryl which are fused tricyclic aryls; quaterphenylyl-(5'-phenyl-m-terphenyl-2-yl, 5'-phenyl-m-terphenyl-3-yl, 5'-phenyl-m-terphenyl-4-yl, m-quaterphenylyl) which is a tetracyclic aryl; triphenylene-(1-, 2-)yl, pyrene-(1-, 2-, 4-)yl, and naphthacene- (1-, 2-, 5-)yl which are fused tetracyclic aryls; and perylene- (1-, 2-, 3-)yl and pentacene- (1-, 2-, 5-, 6-)yl which are fused pentacyclic aryls.

Examples of the "heteroaryl" as the "optionally substituted heteroaryl" include a heteroaryl having 2 to 30 carbon atoms. A heteroaryl having 2 to 25 carbon atoms is preferable, a heteroaryl having 2 to 20 carbon atoms is more preferable, a heteroaryl having 2 to 15 carbon atoms is still more preferable, and a heteroaryl having 2 to 10 carbon atoms is particularly preferable. Furthermore, examples of the "heteroaryl" include a heterocyclic ring containing 1 to 5 heteroatoms selected from an oxygen atom, a sulfur atom, and a nitrogen atom in addition to a carbon atom as a ring-constituting atom.

Specific examples of the "heteroaryl" include furyl, thienyl, pyrrolyl, oxazolyl, isoxazolyl, thiazolyl, isothiazolyl, imidazolyl, pyrazolyl, oxadiazolyl, furazanyl, thiadiazolyl, triazolyl, tetrazolyl, pyridyl, pyrimidinyl, pyridazinyl, pyrazinyl, triazinyl, benzofuranyl, isobenzofuranyl, benzo[b]thienyl, indolyl, isoindolyl, 1H-indazolyl, benzoimidazolyl, benzoxazolyl, benzothiazolyl, 1H-benzotriazolyl, quinolyl, isoquinolyl, cinnolyl, quinazolyl, quinoxalinyl, phthalazinyl, naphthyridinyl, purinyl, pteridinyl, carbazolyl, acridinyl, phenoxazinyl, phenothiazinyl, phenazinyl, phenoxathiinyl, thianthrenyl, and indolizinyl.

Furthermore, the above aryl and heteroaryl may be substituted, and may be each substituted by, for example, the above aryl or heteroaryl.

Specific examples of this triazine derivative include the following compounds.

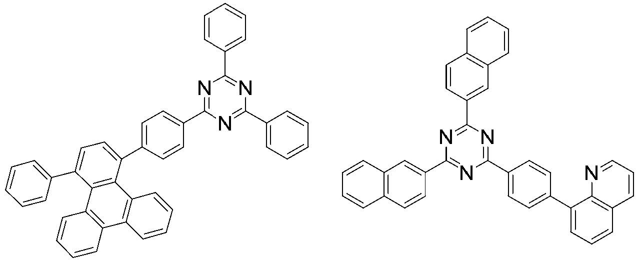

This triazine derivative can be manufactured using known raw materials and known synthesis methods.

### <Benzimidazole derivative>

The benzimidazole derivative is, for example, a compound represented by the following formula (ETM-11).
***ϕ*-(Benzimidazole-based substituent)**ₙ **(ETM-11)**

φ represents an n-valent aryl ring (preferably, an n-valent benzene ring, naphthalene ring, anthracene ring, fluorene ring, benzofluorene ring, phenalene ring, phenanthrene ring, or triphenylene ring), and n represents an integer of 1 to 4. A "benzimidazole-based substituent" is a substituent in which the pyridyl group in the "pyridine-based substituent" in the formulas (ETM-2), (ETM-2-1), and (ETM-2-2) is substituted by a benzimidazole group, and at least one hydrogen atom in the benzimidazole derivative may be substituted by a deuterium atom.

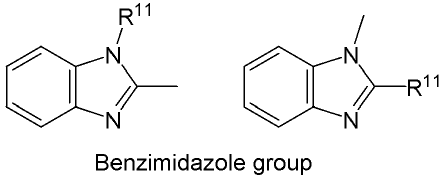

R¹¹ in the above benzimidazole represents a hydrogen atom, an alkyl having 1 to 24 carbon atoms, a cycloalkyl having 3 to 12 carbon atoms, or an aryl having 6 to 30 carbon atoms. The description of R¹¹ in the above formulas (ETM-2-1), and (ETM-2-2) can be cited.

Moreover, φ is preferably an anthracene ring or a fluorene ring. For the structure in this case, the description for the above formula (ETM-2-1) or (ETM-2-2) can be cited. For R¹¹ to R¹⁸ in each formula, the description for the above formula (ETM-2-1) or (ETM-2-2) can be cited. Furthermore, in the above formula (ETM-2-1) or (ETM-2-2), a form in which two pyridine-based substituents are bonded has been described. However, when these substituents are substituted by benzimidazole-based substituents, both the pyridine-based substituents may be substituted by benzimidazole-based substituents (that is, n = 2), or one of the pyridine-based substituents may be substituted by a benzimidazole-based substituent and the other pyridine-based substituent may be substituted by any one of R¹¹ to R¹⁸ (that is, n = 1). Moreover, for example, at least one of R¹¹ to R¹⁸ in the above formula (ETM-2-1) may be substituted by a benzimidazole-based substituent and the "pyridine-based substituent" may be substituted by any one of R¹¹ to R¹⁸.

Specific examples of this benzimidazole derivative include
1-phenyl-2-(4-(10-phenylanthracen-9-yl)phenyl)-1H-benzo[d ]imidazole,
2-(4-(10-(naphthalen-2-yl)anthracen-9-yl)phenyl)-1-phenyl -1H-benzo[d]imidazole,
2-(3-(10-(naphthalen-2-yl)anthracen-9-yl)phenyl)-1-phenyl -1H-benzo[d]imidazole,
5-(10-(naphthlen-2-yl)anthracen-9-yl)-1,2-diphenyl-1H-ben zo[d]imidazole,
1-(4-(10-(naphthalen-2-yl)anthracen-9-yl)phenyl)-2-phenyl -1H-benzo[d]imidazole,
2-(4-(9,10-di(naphthalen-2-yl)anthracen-2-yl)phenyl)-1-ph enyl-1H-benzo[d]imidazole,
1-(4-(9,10-di(naphthalen-2-yl)anthracen-2-yl)phenyl)-2-ph enyl-1H-benzo[d]imidazole, and
5-(9,10-di(naphthalen-2-yl)anthracen-2-yl)-1,2-diphenyl-1 H-benzo[d]imidazole.

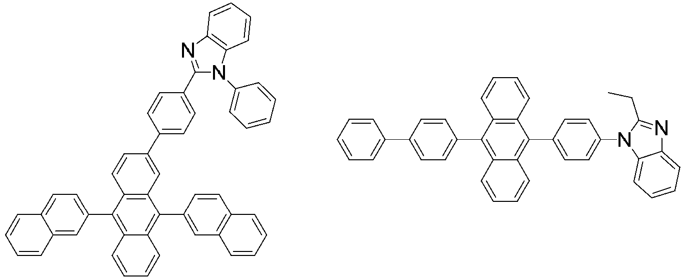

This benzimidazole derivative can be manufactured using known raw materials and known synthesis methods.

### <Phenanthroline derivative>

The phenanthroline derivative is, for example, a compound represented by the following formula (ETM-12) or (ETM-12-1). Details are described in WO 2006/021982 A.

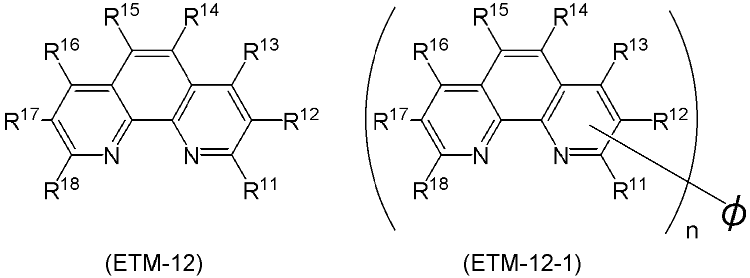

φ represents an n-valent aryl ring (preferably, an n-valent benzene ring, naphthalene ring, anthracene ring, fluorene ring, benzofluorene ring, phenalene ring, phenanthrene ring, or triphenylene ring), and n represents an integer of 1 to 4.

In each formula, R¹¹ to R¹⁸ each independently represent a hydrogen atom, an alkyl (preferably, an alkyl having 1 to 24 carbon atoms), a cycloalkyl (preferably, a cycloalkyl having 3 to 12 carbon atoms), or an aryl (preferably, an aryl having 6 to 30 carbon atoms). Furthermore, in the above formula (ETM-12-1), any one of R¹¹ to R¹⁸ is bonded to φ which is an aryl ring.

At least one hydrogen atom in each phenanthroline derivative may be substituted by a deuterium atom.

For the alkyl, cycloalkyl, and aryl in R¹¹ to R¹⁸, the description of R¹¹ to R¹⁸ in the above formula (ETM-2) can be cited. Furthermore, in addition to the above examples, examples of the φ include those having the following structural formulas. Note that R's in the following structural formulas each independently represent a hydrogen atom, methyl, ethyl, isopropyl, cyclohexyl, phenyl, 1-naphthyl, 2-naphthyl, biphenylyl, or terphenylyl.

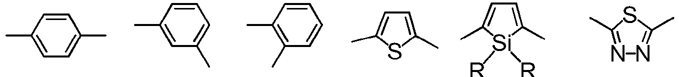

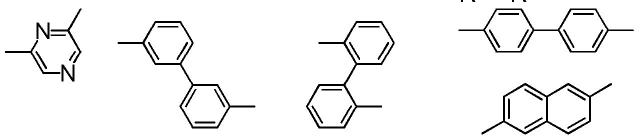

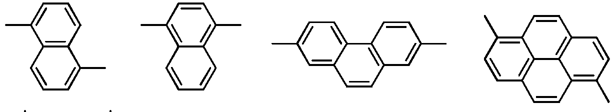

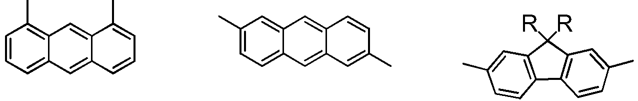

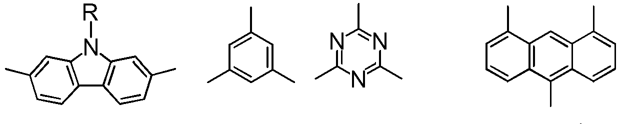

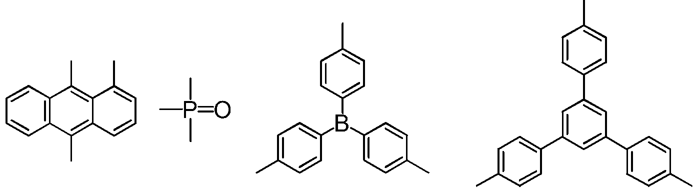

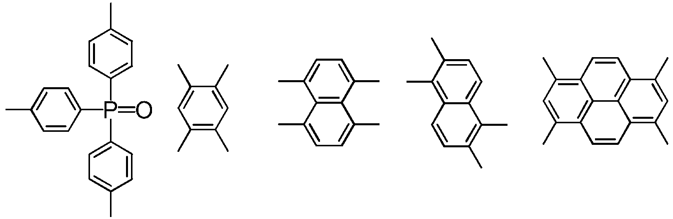

Specific examples of this phenanthroline derivative include 4,7-diphenyl-1,10-phenanthroline, 2,9-dimethyl-4,7-diphenyl-1,10-phenanthroline, 9,10-di(1,10-phenanthrolin-2-yl)anthracene, 2,6-di(1,10-phenanthrolin-5-yl)pyridine, 1,3,5-tri(1,10-phenanthrolin-5-yl)benzene, 9,9'-difluoro-bis(1,10-phenanthrolin-5-yl), bathocuproine, 1,3-bis(2-phenyl-1,10-phenanthrolin-9-yl) benzene, and the like.

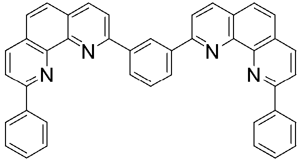

This phenanthroline derivative can be manufactured using known raw materials and known synthesis methods.

### <Quinolinol-based metal complex>

The quinolinol-based metal complex is, for example, a compound represented by the following general formula (ETM-13).

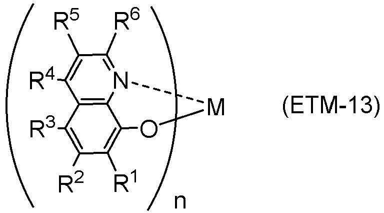

In the formula, R¹ to R⁶ represent a hydrogen atom or substituent, M represents Li, Al, Ga, Be, or Zn, and n represents an integer of 1 to 3.

Specific examples of the quinolinol-based metal complex include 8-quinolinol lithium, tris(8-quinolinolato) aluminum, tris(4-methyl-8-quinolinolato) aluminum, tris(5-methyl-8-quinolinolato) aluminum, tris(3,4-dimethyl-8-quinolinolato) aluminum, tris(4,5-dimethyl-8-quinolinolato) aluminum, tris(4,6-dimethyl-8-quinolinolato) aluminum, bis(2-methyl-8-quinolinolato) (phenolato) aluminum, bis(2-methyl-8-quinolinolato) (2-methylphenolato) aluminum, bis(2-methyl-8-quinolinolato) (3-methylphenolato) aluminum, bis(2-methyl-8-quinolinolato) (4-methylphenolato) aluminum, bis(2-methyl-8-quinolinolato) (2-phenylphenolato) aluminum, bis(2-methyl-8-quinolinolato) (3-phenylphenolato) aluminum, bis(2-methyl-8-quinolinolato) (4-phenylphenolato) aluminum, bis(2-methyl-8-quinolinolato) (2,3-dimethylphenolato) aluminum, bis(2-methyl-8-quinolinolato) (2,6-dimethylphenolato) aluminum, bis(2-methyl-8-quinolinolato) (3,4-dimethylphenolato) aluminum, bis(2-methyl-8-quinolinolato) (3,5-dimethylphenolato) aluminum, bis(2-methyl-8-quinolinolato) (3,5-di-t-butylphenolato) aluminum, bis(2-methyl-8-quinolinolato) (2,6-diphenylphenolato) aluminum, bis(2-methyl-8-quinolinolato) (2,4,6-triphenylphenolato) aluminum, bis(2-methyl-8-quinolinolato) (2,4,6-trimethylphenolato) aluminum, bis(2-methyl-8-quinolinolato)(2,4,5,6-tetramethylphenolat o) aluminum, bis(2-methyl-8-quinolinolato) (1-naphtholato) aluminum, bis(2-methyl-8-quinolinolato) (2-naphtholato) aluminum, bis(2,4-dimethyl-8-quinolinolato) (2-phenylphenolato) aluminum, bis(2,4-dimethyl-8-quinolinolato) (3-phenylphenolato) aluminum, bis(2,4-dimethyl-8-quinolinolato) (4-phenylphenolato) aluminum, bis(2,4-dimethyl-8-quinolinolato) (3,5-dimethylphenolato) aluminum, bis(2,4-dimethyl-8-quinolinolato) (3,5-di-t-butylphenolato) aluminum, bis(2-methyl-8-quinolinolato) aluminum-µ-oxo-bis(2-methyl-8-quinolinolato) aluminum, bis(2,4-dimethyl-8-quinolinolato) aluminum-µ-oxo-bis(2,4-dimethyl-8-quinolinolato)aluminum, bis(2-methyl-4-ethyl-8-quinolinolato) aluminum-µ-oxo-bis(2-methyl-4-ethyl-8-quinolinolato) aluminum, bis(2-methyl-4-methoxy-8-quinolinolato) aluminum-µ-oxo-bis(2-methyl-4-methoxy-8-quinolinolato) aluminum, bis(2-methyl-5-cyano-8-quinolinolato) aluminum-µ-oxo-bis(2-methyl-5-cyano-8-quinolinolato) aluminum, bis(2-methyl-5-trifluoromethyl-8-quinolinolato) aluminum-µ-oxo-bis(2-methyl-5-trifluoromethyl-8-quinolino lato) aluminum, and bis(10-hydroxybenzo[h]quinoline) beryllium.

This quinolinol-based metal complex can be manufactured using known raw materials and known synthesis methods.

### <Thiazole derivative and benzothiazole derivative>

The thiazole derivative is, for example, a compound represented by the following formula (ETM-14-1).
*ϕ*-(Thiazole-based substituent)ₙ **(ETM-14-1)**

The benzothiazole derivative is, for example, a compound represented by the following formula (ETM-14-2).
*ϕ*-(Benzothiazole-based substituent)ₙ **(ETM-14-2)**

φ in each formula represents an n-valent aryl ring (preferably, an n-valent benzene ring, naphthalene ring, anthracene ring, fluorene ring, benzofluorene ring, phenalene ring, phenanthrene ring, or triphenylene ring), and n represents an integer of 1 to 4. A "thiazole-based substituent" or a "benzothiazole-based substituent" is a substituent in which the pyridyl group in the "pyridine-based substituent" in the formulas (ETM-2), (ETM-2-1), and (ETM-2-2) is substituted by the following thiazole group or benzothiazole group, and at least one hydrogen atom in the thiazole derivative and the benzothiazole derivative may be substituted by a deuterium atom.

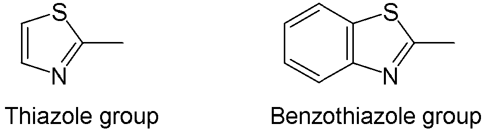

Moreover, φ is preferably an anthracene ring or a fluorene ring. For the structure in this case, the description for the above formula (ETM-2-1) or (ETM-2-2) can be cited. For R¹¹ to R¹⁸ in each formula, the description for the above formula (ETM-2-1) or (ETM-2-2) can be cited. Furthermore, in the above formula (ETM-2-1) or (ETM-2-2), a form in which two pyridine-based substituents are bonded has been described. However, when these substituents are substituted by thiazole-based substituents (or benzothiazole-based substituents), both the pyridine-based substituents may be substituted by thiazole-based substituents (or benzothiazole-based substituents) (that is, n = 2), or one of the pyridine-based substituents may be substituted by a thiazole-based substituent (or benzothiazole-based substituent) and the other pyridine-based substituent may be substituted by any one of R¹¹ to R¹⁸ (that is, n = 1). Moreover, for example, at least one of R¹¹ to R¹⁸ in the above formula (ETM-2-1) may be substituted by a thiazole-based substituent (or benzothiazole-based substituent) and the "pyridine-based substituent" may be substituted by any one of R¹¹ to R¹⁸.

These thiazole derivatives or benzothiazole derivatives can be manufactured using known raw materials and known synthesis methods.

An electron transport layer or an electron injection layer may further contain a substance that can reduce a material to form an electron transport layer or an electron injection layer. As this reducing substance, various substances are used as long as having reducibility to a certain extent. For example, at least one selected from the group consisting of an alkali metal, an alkaline earth metal, a rare earth metal, an oxide of an alkali metal, a halide of an alkali metal, an oxide of an alkaline earth metal, a halide of an alkaline earth metal, an oxide of a rare earth metal, a halide of a rare earth metal, an organic complex of an alkali metal, an organic complex of an alkaline earth metal, and an organic complex of a rare earth metal, can be suitably used.

Preferable examples of the reducing substance include an alkali metal such as Na (work function 2.36 eV), K (work function 2.28 eV), Rb (work function 2.16 eV), or Cs (work function 1.95 eV); and an alkaline earth metal such as Ca (work function 2.9 eV), Sr (work function 2.0 to 2.5 eV), or Ba (work function 2.52 eV). A substance having a work function of 2.9 eV or less is particularly preferable. Among these substances, an alkali metal such as K, Rb, or Cs is a more preferable reducing substance, Rb or Cs is a still more preferable reducing substance, and Cs is the most preferable reducing substance. These alkali metals have particularly high reducing ability, and can enhance emission luminance of an organic EL element or can lengthen a lifetime thereof by adding the alkali metals in a relatively small amount to a material to form an electron transport layer or an electron injection layer. Furthermore, as the reducing substance having a work function of 2.9 eV or less, a combination of two or more kinds of these alkali metals is also preferable, and particularly, a combination including Cs, for example, a combination of Cs with Na, a combination of Cs with K, a combination of Cs with Rb, or a combination of Cs with Na and K, is preferable. By inclusion of Cs, reducing ability can be efficiently exhibited, and emission luminance of an organic EL element is enhanced, or a lifetime thereof is lengthened by adding Cs to a material to form an electron transport layer or an electron injection layer.

### <Negative electrode in organic electroluminescent element>

The negative electrode 108 plays a role of injecting an electron to the light emitting layer 105 through the electron injection layer 107 and the electron transport layer 106.

A material to form the negative electrode 108 is not particularly limited as long as being a substance capable of efficiently injecting an electron to an organic layer. However, a material similar to a material to form the positive electrode 102 can be used. Among these materials, a metal such as tin, indium, calcium, aluminum, silver, copper, nickel, chromium, gold, platinum, iron, zinc, lithium, sodium, potassium, cesium, or magnesium, and an alloy thereof (a magnesium-silver alloy, a magnesium-indium alloy, an aluminum-lithium alloy such as lithium fluoride/aluminum, or the like) are preferable. In order to enhance element characteristics by increasing electron injection efficiency, lithium, sodium, potassium, cesium, calcium, magnesium, or an alloy containing these low work function-metals is effective. However, many of these low work function-metals are generally unstable in air. In order to ameliorate this problem, for example, a method for using an electrode having high stability obtained by doping an organic layer with a trace amount of lithium, cesium, or magnesium is known. Other examples of a dopant that can be used include an inorganic salt such as lithium fluoride, cesium fluoride, lithium oxide, or cesium oxide. However, the dopant is not limited thereto.

Furthermore, in order to protect an electrode, a metal such as platinum, gold, silver, copper, iron, tin, aluminum, or indium, an alloy using these metals, an inorganic substance such as silica, titania, or silicon nitride, polyvinyl alcohol, vinyl chloride, a hydrocarbon-based polymer compound, or the like may be laminated as a preferable example. These method for manufacturing an electrode are not particularly limited as long as being capable of conduction, such as resistance heating, electron beam deposition, sputtering, ion plating, or coating.

### <Binder that may be used in each layer>

The materials used in the above-described hole injection layer, hole transport layer, light emitting layer, electron transport layer, and electron injection layer can form each layer by being used singly. However, it is also possible to use the materials by dispersing the materials in a solvent-soluble resin such as polyvinyl chloride, polycarbonate, polystyrene, poly(N-vinylcarbazole), polymethyl methacrylate, polybutyl methacrylate, polyester, polysulfone, polyphenylene oxide, polybutadiene, a hydrocarbon resin, a ketone resin, a phenoxy resin, polyamide, ethyl cellulose, a vinyl acetate resin, an ABS resin, or a polyurethane resin; or a curable resin such as a phenolic resin, a xylene resin, a petroleum resin, a urea resin, a melamine resin, an unsaturated polyester resin, an alkyd resin, an epoxy resin, or a silicone resin.

### <Method for manufacturing organic electroluminescent element>

Each layer constituting an organic electroluminescent element can be formed by forming thin films of the materials to constitute each layer by methods such as a vapor deposition method, resistance heating deposition, electron beam deposition, sputtering, a molecular lamination method, a printing method, a spin coating method, a casting method, and a coating method. The film thickness of each layer thus formed is not particularly limited, and can be appropriately set according to a property of a material, but is usually within a range of 2 nm to 5000 nm. The film thickness can be usually measured using a crystal oscillation type film thickness analyzer or the like. In a case of forming a thin film using a vapor deposition method, deposition conditions depend on the kind of a material, an intended crystal structure and association structure of the film, and the like. It is preferable to appropriately set the vapor deposition conditions generally in ranges of a crucible for vapor deposition heating temperature of +50 to +400°C, a degree of vacuum of 10⁻⁶ to 10⁻³ Pa, a vapor deposition rate of 0.01 to 50 nm/sec, a substrate temperature of -150 to +300°C, and a film thickness of 2 nm to 5 µm.

As an example of a method for manufacturing an organic electroluminescent element, a method for manufacturing an organic electroluminescent element formed of positive electrode/hole injection layer/hole transport layer/light emitting layer including a host material and a dopant material/electron transport layer/electron injection layer/negative electrode will be described.

### <Deposition method>

A thin film of a positive electrode material is formed on an appropriate substrate to manufacture a positive electrode by a vapor deposition method or the like, and then thin films of a hole injection layer and a hole transport layer are formed on this positive electrode. A thin film is formed thereon by co-depositing a host material and a dopant material to obtain a light emitting layer. An electron transport layer and an electron injection layer are formed on this light emitting layer, and a thin film formed of a substance for a negative electrode is formed by a vapor deposition method or the like to obtain a negative electrode. An intended organic electroluminescent element is thereby obtained. Incidentally, in manufacturing the above organic EL element, it is also possible to manufacture the element by reversing the manufacturing order, that is, in order of a negative electrode, an electron injection layer, an electron transport layer, a light emitting layer, a hole transport layer, a hole injection layer, and a positive electrode.

### <Wet film formation method>

In the case of a light emitting layer-forming composition, a film is formed using a wet film formation method.

In the wet film formation method, generally, a coating film is formed through an applying step of applying a light emitting layer-forming composition onto a substrate and a drying step of removing a solvent from the applied light emitting layer-forming composition. According to a difference in the applying step, a method using a spin coater is referred to as a spin coating method, a method using a slit coater is referred to as a slit coating method, a method using a plate is referred to gravure, offset, reverse offset, and flexographic printing methods, a method using an ink jet printer is referred to as an ink jet method, and a method for spraying the composition is referred to as a spraying method. Examples of the drying step include methods of air drying, heating, and drying under reduced pressure. The drying step may be performed only once, or may be performed a plurality of times using different methods and conditions. Furthermore, different methods may be used in combination like calcination under reduced pressure.

The wet film formation method is a film formation method using a solution, and examples thereof include a part of printing methods (ink jet method), a spin coating method, a casting method, and a coating method. Unlike a vacuum deposition method, the wet film formation method does not need to use an expensive vacuum deposition apparatus, and a film can be formed under atmospheric pressure. In addition, the wet film formation method can increase an area and manufacture a product continuously, leading to reduction in manufacturing cost.

Meanwhile, as compared with the vacuum deposition method, lamination is difficult by the wet film formation method. In a case where a laminated film is manufactured using the wet film formation method, it is necessary to prevent dissolution of a lower layer due to a composition of an upper layer, and techniques of using a composition with controlled solubility, crosslinking the lower layer, using orthogonal solvents (solvents which are not dissolved in each other), and the like are used. However, even with these techniques, it may be difficult to use the wet film formation method for application to all the films.

Therefore, in general, a method is adopted in which only some of the layers are formed by the wet film formation method and the remaining layers are formed by the vacuum deposition method to manufacture an organic EL element.

For example, a procedure for partially applying the wet film formation method to manufacture an organic EL element will be described below.
(Procedure 1) Film formation of positive electrode by vacuum deposition method
(Procedure 2) Film formation of hole injection layer by wet film formation method
(Procedure 3) Film formation of hole transport layer by wet film formation method
(Procedure 4) Film formation of light emitting layer-forming composition containing host material and dopant material by wet film formation method
(Procedure 5) Film formation of electron transport layer by vacuum deposition method
(Procedure 6) Film formation of electron injection layer by vacuum deposition method
(Procedure 7) Film formation of negative electrode by vacuum deposition method

Through this procedure, an organic EL element formed of anode/hole injection layer/hole transport layer/light emitting layer including a host material and a dopant material/electron transport layer/electron injection layer/negative electrode is obtained.

### <Other film formation method>

For film formation of the light emitting layer-forming composition, a laser heating drawing method (LITI) can be used. LITI is a method for heating and depositing a compound attached to a base material with a laser, and the light emitting layer-forming composition can be used for a material to be applied to a base material.

### <Optional step>

A suitable treatment step, washing step, and drying step may be appropriately performed before and after each of the steps of film formation. Examples of the treatment step include an exposure treatment, a plasma surface treatment, an ultrasonic treatment, an ozone treatment, a washing treatment using a suitable solvent, and a heat treatment. Examples of the treatment step further include a series of steps for manufacturing a bank.

A photolithography technique can be used for manufacturing a bank. As a bank material that can be used for photolithography, a positive resist material and a negative resist material can be used. A patternable printing method such as an ink jet method, gravure offset printing, reverse offset printing, or screen printing can also be used. In this case, a permanent resist material can also be used.

Examples of a material used for a bank include a polysaccharide and a derivative thereof, a homopolymer and a copolymer of a hydroxyl-containing ethylenic monomer, a biopolymer compound, a polyacryloyl compound, polyester, polystyrene, polyimide, polyamideimide, polyetherimide, polysulfide, polysulfone, polyphenylene, polyphenyl ether, polyurethane, epoxy (meth)acrylate, melamine (meth)acrylate, polyolefin, cyclic polyolefin, an acrylonitrile-butadiene-styrene copolymer (ABS), a silicone resin, polyvinyl chloride, chlorinated polyethylene, chlorinated polypropylene, polyacetate, polynorbornene, a synthetic rubber, a fluorinated polymer such as polyfluorovinylidene, polytetrafluoroethylene, or polyhexafluoropropylene pyrene, a fluoroolefin-hydrocarbon olefin copolymer, and a fluorocarbon polymer, but are not limited thereto.

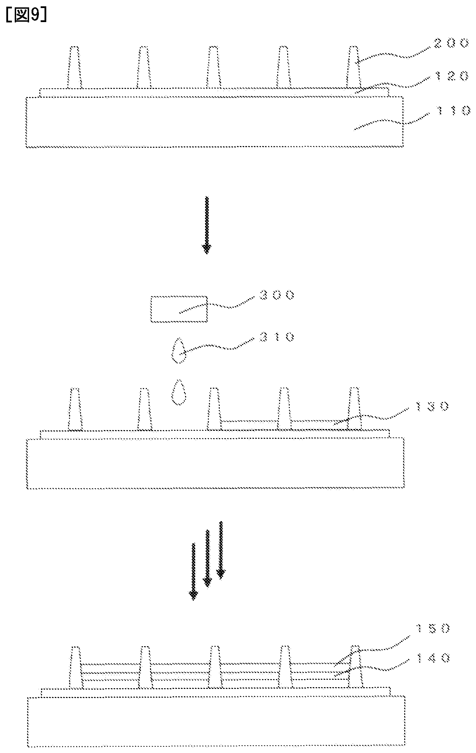

With reference to FIG. 9, a method for manufacturing an organic EL element on a substrate having a bank by an ink jet method will be described. First, a bank (200) is provided on an electrode (120) on a substrate (110). In this case, a coating film (130) can be manufactured by dropping an ink droplet (310) between the banks (200) from an ink jet head (300) and drying the ink droplet (310). If this process is repeated, a subsequent coating film (140) and a light emitting layer (150) are manufactured, and an electron transport layer, an electron injection layer, and an electrode are formed by a vacuum deposition method, an organic EL element in which a light emitting part is partitioned by a bank material can be manufactured.

In a case where a direct current voltage is applied to the organic electroluminescent element thus obtained, it is only required to apply the voltage by assuming a positive electrode as a positive polarity and assuming a negative electrode as a negative polarity. By applying a voltage of about 2 to 40 V, light emission can be observed from a transparent or semitransparent electrode side (the positive electrode or the negative electrode, or both the electrodes) . Furthermore, this organic EL element also emits light even in a case where a pulse current or an alternating current is applied. Note that a waveform of an alternating current applied may be any waveform.

### <Application examples of organic electroluminescent element>

Furthermore, the present invention can also be applied to a display apparatus including an organic electroluminescent element, a lighting apparatus including an organic electroluminescent element, or the like.

The display apparatus or lighting apparatus including an organic electroluminescent element can be manufactured by a known method such as connecting the organic electroluminescent element according to the present embodiment to a known driving apparatus, and can be driven by appropriately using a known driving method such as direct driving, pulse driving, or alternating driving.

Examples of the display apparatus include panel displays such as color flat panel displays; and flexible displays such as flexible organic electroluminescent (EL) displays (see, for example, JP 10-335066 A, JP 2003-321546 A, JP 2004-281086 A, and the like). Furthermore, examples of a display method of the display include a matrix method and/or a segment method. Note that the matrix display and the segment display may co-exist in the same panel.

In the matrix, pixels for display are arranged two-dimensionally as in a lattice form or a mosaic form, and characters or images are displayed by an assembly of pixels. The shape or size of a pixel depends on intended use. For example, for display of images and characters of a personal computer, a monitor, or a television, square pixels each having a size of 300 µm or less on each side are usually used. Furthermore, in a case of a large-sized display such as a display panel, pixels having a size in the order of millimeters on each side are used. In a case of monochromic display, it is only required to arrange pixels of the same color. However, in a case of color display, display is performed by arranging pixels of red, green and blue. In this case, typically, delta type display and stripe type display are available. For this matrix driving method, either a line sequential driving method or an active matrix method may be employed. The line sequential driving method has an advantage of having a simpler structure. However, in consideration of operation characteristics, the active matrix method may be superior. Therefore, it is necessary to use the line sequential driving method or the active matrix method properly according to intended use.

In the segment method (type), a pattern is formed so as to display predetermined information, and a determined region emits light. Examples of the segment method include display of time or temperature in a digital clock or a digital thermometer, display of a state of operation in an audio instrument or an electromagnetic cooker, and panel display in an automobile.

Examples of the lighting apparatus include a lighting apparatuses for indoor lighting or the like, and a backlight of a liquid crystal display apparatus (see, for example, JP 2003-257621 A, JP 2003-277741 A, and JP 2004-119211 A). The backlight is mainly used for enhancing visibility of a display apparatus that is not self-luminous, and is used in a liquid crystal display apparatus, a timepiece, an audio apparatus, an automotive panel, a display plate, a sign, and the like. Particularly, in a backlight for use in a liquid crystal display apparatus, among the liquid crystal display apparatuses, for use in a personal computer in which thickness reduction has been a problem to be solved, in consideration of difficulty in thickness reduction because a conventional type backlight is formed from a fluorescent lamp or a light guide plate, a backlight using the luminescent element according to the present embodiment is characterized by its thinness and lightweightness.

### 3-2. Other organic devices

The polycyclic aromatic compound according to an aspect of the present invention can be used for manufacturing an organic field effect transistor, an organic thin film solar cell, or the like, in addition to the organic electroluminescent element described above.

The organic field effect transistor is a transistor that controls a current by means of an electric field generated by voltage input, and is provided with a source electrode, a drain electrode, and a gate electrode. When a voltage is applied to the gate electrode, an electric field is generated, and the organic field effect transistor can control a current by arbitrarily damming a flow of electrons (or holes) that flow between the source electrode and the drain electrode. The field effect transistor can be easily miniaturized compared with a simple transistor (bipolar transistor), and is often used as an element constituting an integrated circuit or the like.

The structure of the organic field effect transistor is usually as follows. That is, a source electrode and a drain electrode are provided in contact with an organic semiconductor active layer formed using the polycyclic aromatic compound according to an aspect of the present invention, and it is only required that a gate electrode is further provided so as to interpose an insulating layer (dielectric layer) in contact with the organic semiconductor active layer. Examples of the element structure include the following structures.
(1) Substrate/gate electrode/insulator layer/source electrode and drain electrode/organic semiconductor active layer
(2) Substrate/gate electrode/insulator layer/organic semiconductor active layer/source electrode and drain electrode
(3) Substrate/organic semiconductor active layer/source electrode and drain electrode/insulator layer/gate electrode
(4) Substrate/source electrode and drain electrode/organic semiconductor active layer/insulator layer/gate electrode

An organic field effect transistor thus constituted can be applied as a pixel driving switching element of an active matrix driving type liquid crystal display or an organic electroluminescent display, or the like.

An organic thin film solar cell has a structure in which a positive electrode such as ITO, a hole transport layer, a photoelectric conversion layer, an electron transport layer, and a negative electrode are laminated on a transparent substrate of glass or the like. The photoelectric conversion layer has a p-type semiconductor layer on the positive electrode side, and has an n-type semiconductor layer on the negative electrode side. The polycyclic aromatic compound according to an aspect of the present invention can be used as a material for a hole transport layer, a p-type semiconductor layer, an n-type semiconductor layer, or an electron transport layer, depending on physical properties thereof. The polycyclic aromatic compound according to an aspect of the present invention can function as a hole transport material or an electron transport material in an organic thin film solar cell. The organic thin film solar cell may appropriately include a hole blocking layer, an electron blocking layer, an electron injection layer, a hole injection layer, a smoothing layer, and the like, in addition to the members described above. For the organic thin film solar cell, known materials used for an organic thin film solar cell can be appropriately selected and used in combination.

### EXAMPLE

Hereinafter, the present invention will be specifically described with reference to Examples, but the present invention is not limited by these Examples in any way. Compounds synthesized in Examples are illustrated below.

### Synthesis Example (1)

Synthesis of compound (1-1): N⁷, N⁷, N¹³, N¹³, 5,9,11,15-octaphenyl-5,9,11,15-tetrahydro-5,9,11,15-tetra aza-19b,20b-diboradinaphtho[3,2,1-de:1',2',3'-jk]pentacen e-7,13-diamine

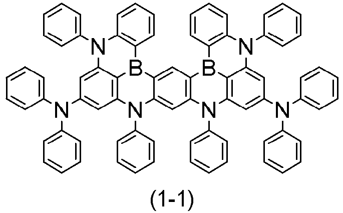

### [First stage]

In a nitrogen atmosphere, a flask containing 1,3-dibromobenzene (25.0 g, 106 mmol), aniline (20.3 ml, 223 mmol), tris(dibenzylideneacetone) dipalladium (0) (Pd₂(dba)₃) (971 mg, 1.06 mmol),
2,2'-bis(diphenylphosphino)-1,1'-binaphthyl (BINAP: 1.98 g, 3.18 mmol), NaOtBu (25.5 g, 265 mmol), and toluene (400 ml) was heated to 110°C and stirred for 18 hours. The reaction solution was cooled to room temperature, and was filtered using silica gel (eluent: toluene), and a solvent was distilled off under reduced pressure to obtain a crude product. The obtained crude product was dissolved in toluene. Thereafter, an appropriate amount of the resulting solution was distilled off under reduced pressure, and hexane was added to the residue to cause reprecipitation. As a result, N¹,N³-diphenylbenzene-1,3-diamine (16.5 g, yield 60%) was obtained as a white solid.

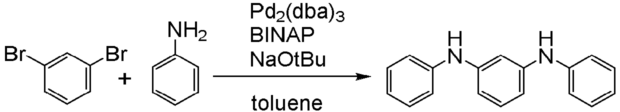

The structure of the compound thus obtained was identified with an NMR spectrum.

¹H-NMR(400MHz,CDCl₃):δ = 5.63(s,2H), 6.60(dd,2H), 6.74(t,1H), 6.90(t,2H), 7.06(d,4H), 7.12(t,1H), 7.24 (dt, 4H).

### [Second stage]

In a nitrogen atmosphere, a flask containing 1,3-dibromo-5-chlorobenzene (8.11 g, 30 mmol), diphenylamine (10.1 g, 60 mmol), Pd₂(dba)₃ (550 mg, 0.6 mmol), 2-dicyclohexylphenylphosphino-2',6'-dimethoxydiphenyl (SPhos: 0.493 g, 1.2 mmol), NaOtBu (8.60 g, 90 mmol), and toluene (300 ml) was heated to 80°C and stirred for 15 hours. The reaction solution was cooled to room temperature, and was filtered using silica gel (eluent: toluene), and a solvent was distilled off under reduced pressure to obtain a crude product. The obtained crude product was dissolved in toluene. Thereafter, the resulting solution was distilled off under reduced pressure to prepare a saturated solution, and hexane was added thereto to cause reprecipitation. As a result, 5-chloro-N¹,N¹,N³,N³-tetraphenylbenzene-1,3-diamine (5.66 g, yield 43%) was obtained as a white solid.

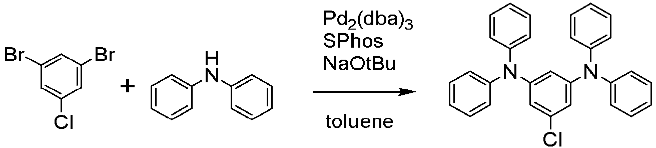

The structure of the compound thus obtained was identified with an NMR spectrum.

¹H-NMR(400MHz,CDCl₃):δ = 6.56(d,2H), 6.64(t,1H), 7.00(t,4H), 7.05(d,8H), 7.21(dd, 8H).

### [Third stage]

In a nitrogen atmosphere, a flask containing N¹,N³-diphenylbenzene-1,3-diamine (1.34 g, 5.1 mmol) synthesized in the first stage, 5-chloro-N¹,N¹,N³,N³-tetraphenyl benzene-1,3-diamine (4.80 g, 11 mmol) synthesized in the second stage, Pd₂(dba)₃ (0.140 g, 0.15 mmol), tri-tert-butylphosphine (60.7 mg, 0.30 mmol), NaOtBu (1.47 g, 15 mmol), and toluene (200 ml) was heated to 110°C and stirred for eight hours. The reaction solution was cooled to room temperature, and was filtered using silica gel (eluent: toluene), and a solvent was distilled off under reduced pressure to obtain a crude product. The obtained crude product was washed with hexane and methanol in this order to obtain N¹,N¹'-(1,3-phenylene) bis(N¹,N³,N³,N⁵,N⁵-pentaphenylbenzene-1,3,5-triamine (4.80 g, yield 87%) as a white solid.

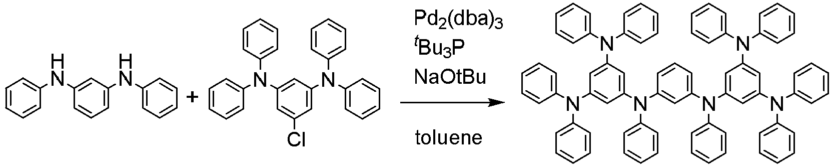

The structure of the compound thus obtained was identified with an NMR spectrum.

¹H-NMR(400MHz,CDCl₃):δ = 6.38(d,4H), 6.41(t,2H), 6.58(dd,2H), 6.70(t,1H), 6.88-6.90(m,14H), 6.85(t,1H), 6.99(d,16H), 7.08-7.15(m,20H).

### [Fourth stage]

In a nitrogen atmosphere at room temperature, boron tribromide (1.13 ml, 12 mmol) was added to a flask containing N¹,N¹'-(1,3-phenylene) bis(N¹,N³,N³,N⁵,N⁵-pentaphenylbenzene-1,3,5-triamine (3.24 g, 3.0 mmol) and orthodichlorobenzene (400 ml). After completion of dropwise addition, the temperature was raised to 180°C, and the mixture was stirred for 20 hours. Thereafter, the mixture was cooled again to room temperature, N-diisopropylethylamine (7.70 ml, 45 mmol) was added thereto, and the mixture was stirred until heat generation was settled. Thereafter, the reaction solution was distilled off under reduced pressure at 60°C to obtain a crude product. The obtained crude product was washed with acetonitrile, methanol, and toluene in this order, and purified by silica gel column chromatography (eluent: toluene). Thereafter, the crude product was recrystallized twice with o-dichlorobenzene, and then was subjected to sublimation purification at 440°C under a reduced pressure of 1 × 10⁻⁴ mmHg to obtain 1.17 g of compound (1-1).

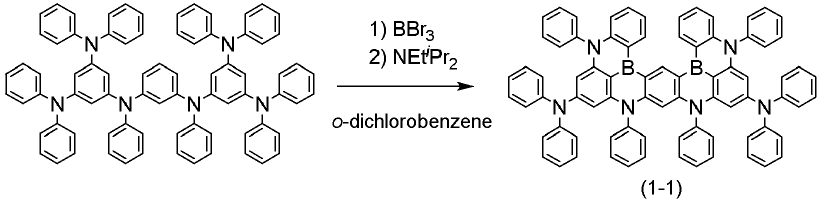

The structure of the compound thus obtained was identified with an NMR spectrum.

¹H-NMR(400MHz,CDCl₃):δ = 5.72 (s,2H), 5.74(s,2H), 5.86(s,1H), 6.83(d,2H), 6.88-6.93(m,12H), 7.05(t,8H), 7.12-7.19(m,6H), 7.24-7.26(m,4H), 7.05(d,4H), 7.12(dd,8H), 7.12-7.19(m,6H), 7.32(d,4H), 7.38(dd,2H), 7.42(t,2H), 7.46(dd,2H), 7.47(dd,4H), 9.30(d,2H), 10.5(s,1H).

¹³C-NMR(101MHz,CDCl₃):99.5(2C+2C), 103.4(1C), 116.8(2C), 120.0(2C), 123.1(4C), 125.3(8C), 127.1(2C), 127.6(2C), 128.5(8C), 129.6(4C), 129.8(4C), 130.2(4C+2C), 130.3(4C), 135.0(2C), 142.1(2C), 142.5(2C), 143.3(1C), 146.8(4C), 147.9(2C+2C), 148.0(2C), 150.1(2C), 151.1(2C).

### Synthesis Example (2)

Synthesis of compound (1-201):
N⁷,N⁷,N¹³,N¹³,5, 15-hexaphenyl-5, 15-dihydro-5, 15-diaza-9, 11-diox-19b,20b-diboradinaphtho[3,2,1-de:1',2',3'-jk]pentace ne-7,13-diamine

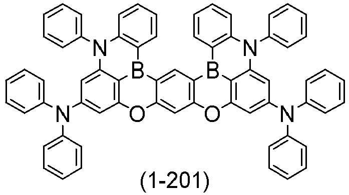

### [First stage]

In a nitrogen atmosphere, a flask containing 1,3-dibromo-5-fluorobenzene (15.5 g, 61 mmol), resorcinol (3.10 g, 29 mmol), potassium carbonate (10.0 g, 73 mmol), and N-methyl-2-pyrrolidone (NMP: 300 ml) was heated to 140°C and stirred for 13 hours. The reaction solution was cooled to room temperature, and NMP was distilled off under reduced pressure. Thereafter, water and toluene were added thereto, and the mixture was partitioned. Subsequently, the reaction solution was filtered using silica gel (eluent: toluene), and the solvent was distilled off under reduced pressure to obtain a crude product. The obtained crude product was washed with hexane to obtain 1,3-bis(3,5-dibromophenoxy) benzene (14.9 g, yield 89%).

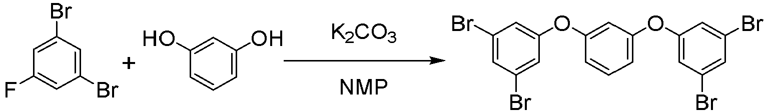

The structure of the compound thus obtained was identified with an NMR spectrum.

¹H-NMR(400MHz,CDCl₃):δ = 7.41(t,2H), 7.37(t,1H), 7.10(d,4H), 6.82(dd,2H), 6.70(t,1H).

### [Second stage]

In a nitrogen atmosphere, a flask containing 1,3-bis(3,5-dibromophenoxy) benzene (8.00 g, 14 mmol), diphenylamine (10.0 g, 59 mmol), Pd₂(dba)₃ (0.256 g, 0.28 mmol), tri-tert-butylphosphine (0.113 g, 0.56 mmol), NaOtBu (6.70 g, 70 mmol), and toluene (300 ml) was heated to 110°C and stirred for six hours. The reaction solution was cooled to room temperature, and was filtered using silica gel (eluent: toluene), and a solvent was distilled off under reduced pressure to obtain a crude product. The obtained crude product was washed with hexane to obtain 5,5'-(1,3-phenylenebis(oxy))
bis(N¹,N¹,N³,N³-tetraphenylbenzene-1,3-diamine (11.2 g, yield 86%) as a white solid.

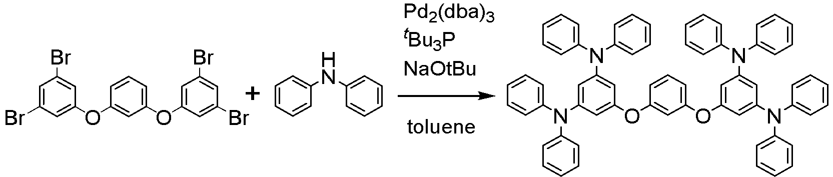

The structure of the compound thus obtained was identified with an NMR spectrum.

¹H-NMR(400MHz,CDCl₃):δ = 7.24-7.28(m,1H), 7.18(dd,16H), 7.05(d,16H), 6.94(t,8H), 6.57(t,2H), 6.54(d,1H), 6.51(d,2H), 6.29(d,4H).

### [Third stage]

In a nitrogen atmosphere at room temperature, boron tribromide (0.832 ml, 8.8 mmol)) was added to a flask containing 5,5'-(1,3-phenylenebis(oxy)) bis(N¹,N¹,N³,N³-tetraphenylbenzene-1,3-diamine (2.03 g, 2.2 mmol) and orthoxylene (500 ml). After completion of dropwise addition, the temperature was raised to 150°C, and the mixture was stirred for 24 hours. Thereafter, the mixture was cooled again to room temperature, N,N-diisopropylethylamine (5.60 ml, 33 mmol) was added thereto, and the mixture was stirred until heat generation was settled. Thereafter, the reaction solution was distilled off. Subsequently, the reaction solution was filtered using silica gel (eluent: toluene), and the solvent was distilled off under reduced pressure to obtain a crude product. The obtained crude product was filtered using silica gel column chromatography (eluent: toluene/hexane = 1/2 (volume ratio)), and the solvent was distilled off under reduced pressure to obtain a crude product. The crude product was washed with toluene to obtain compound (1-201) (50.0 mg, yield 2.4%).

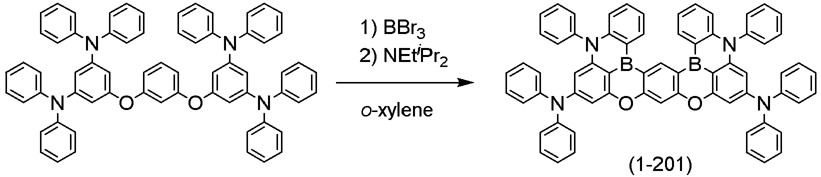

The structure of the compound thus obtained was identified with an NMR spectrum.

¹H-NMR(400MHz,CDCl₃):δ = 5.79(d,2H), 6.70(d,2H), 6.80(d,2H), 7.07(t,4H), 7.12(t,8H), 7.21-7.28(m,12H), 7.31(s,1H), 7.35(dd,2H), 7.40(t,2H), 7.44-7.51(m,6H), 9.12(d,2H), 10.2(s,1H).

¹³C-NMR(101MHz,CDCl₃):98.6(2C), 100.8(2C), 104.9(1C), 117.4(2C), 120.1(2C), 124.1(4C), 126.0(8C), 128.4(2C), 129.2(8C), 130.0(4C), 130.7(4C), 131.3(2C), 134.9(2C), 141.6(2C), 142.3(1C), 146.6(4C), 147.1(2C), 148.1(2C), 152.6(2C), 159.1(2C), 163.0(2C).

### Synthesis Example (3)

### Synthesis of compound (1-9):

### 2,18-dimethyl-N⁷,N⁷,N¹³,N¹³,9,11-hexaparatolyl-5,9,11,15-te trahydro-5,9,11,15-tetraaza-19b,20b-diboradinaphtho[3,2,1 -de:1',2',3'-jk]pentacene-7,13-diamine

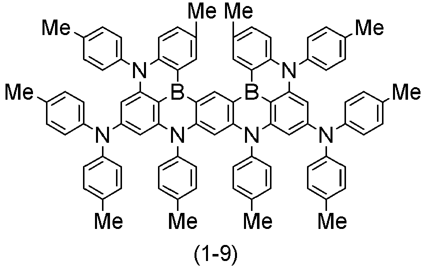

### [First stage]

In a nitrogen atmosphere, a flask containing 1,3-dibromobenzene (10.8 g, 1.9 mmol), paratoluidine (20.3 g, 190 mmol), Pd₂(dba)₃ (1.60 g, 1.8 mmol), tri-tert-butylphosphine (0.728 g, 3.6 mmol), NaOtBu (25.9 g, 270 mmol), and toluene (500 ml) was stirred at room temperature for 10 hours. Filtration was performed using reaction solution silica gel (eluent: toluene), and the solvent was distilled off under reduced pressure to obtain a crude product. The obtained crude product was washed with methanol to obtain N¹,N³-dipalatolylbenzene-1,3-diamine (19.3 g, yield 74%) as a white solid.

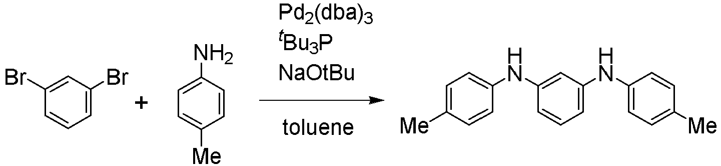

The structure of the compound thus obtained was identified with an NMR spectrum.

¹H-NMR(400MHz,CDCl₃):δ = 7.06-7.11(m,5H), 6.99(d,4H), 6.64(t,1H), 6.52(dd,2H), 5.54(s,2H), 2.29(s,6H).

### [Second stage]

In a nitrogen atmosphere, a flask containing 1,3-dibromo-5-chlorobenzene (13.5 g, 50 mmol), paraditolylamine (19.7 g, 0.10 mol), Pd₂(dba)₃ (1.15 g, 2.0 mmol),
2-dicyclohexylphenylphosphino-2',6'-dimethoxydiphenyl (0.986 g, 2.4 mmol), NaOtBu (14.5 g, 0.15 mol), and toluene (200 ml) was heated to 80°C and stirred for 15 hours. The reaction solution was filtered using silica gel (eluent: toluene), and the solvent was distilled off under reduced pressure to obtain a crude product. The obtained crude product was washed with methanol and hexane in this order to obtain
5-chloro-N¹,N¹,N³,N³-tetraparatolylbenzene-1,3-diamine (21.7 g, yield 86%) as a white solid.

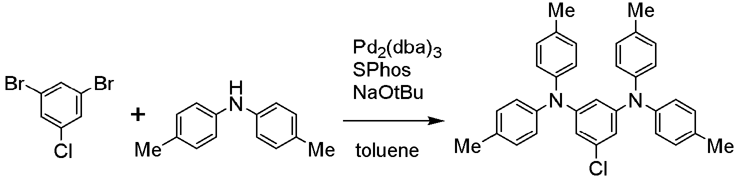

The structure of the compound thus obtained was identified with an NMR spectrum.

¹H-NMR(400MHz,CDCl₃):δ = 7.01(d,8H), 6.92(d,8H), 7.00(t,4H), 6.51(t,1H), 6.45(sd,2H), 2.28(s,12H).

### [Third stage]

In a nitrogen atmosphere, a flask containing N¹,N³-diparatolylbenzene-1,3-diamine (3.1 g, 11 mmol) synthesized in the first stage, 5-chloro-N¹,N¹,N³,N³-tetraparatolylbenzene-1,3-diamine synthesized in the second stage (11.2 g, 22 mmol), Pd₂(dba)₃ (0.503 g, 0.55 mmol), tri-tert-butylphosphine (0.223 g, 1.1 mmol), NaOtBu (3.20 g, 33 mmol), and toluene (300 ml) was heated to 110°C and stirred for 18 hours. The reaction solution was filtered using silica gel (eluent: toluene), and the solvent was distilled off under reduced pressure to obtain a crude product. The obtained crude product was washed with methanol and toluene in this order to obtain N¹,N¹'-(1,3-phenylene)
bis(N¹,N³,N³,N⁵,N⁵-pentaphenylbenzene-1,3,5-triamine (11.4 g, yield 85%) as a white solid.

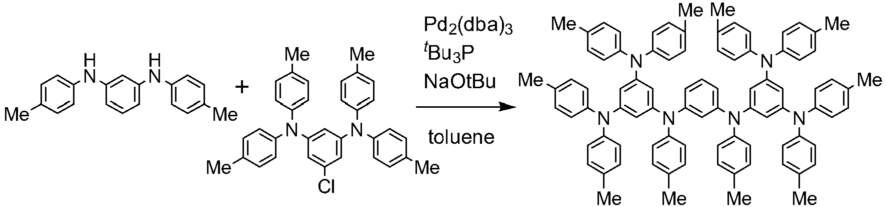

The structure of the compound thus obtained was identified with an NMR spectrum.

¹H-NMR(400MHz,CDCl₃):δ = 6.86-6.93(m,97H), 6.80(d,4H), 6.74(t,1H), 6.44(dd,2H), 6.30(d,4H), 6.29(t,2H), 2.23(s,6H), 2.20(s,24H).

### [Fourth stage]

In a nitrogen atmosphere at room temperature, boron tribromide (0.819 ml, 2.0 mmol) was added to a flask containing N¹,N¹'-(1,3-phenylene) bis(N¹,N³,N³,N⁵,N⁵-pentaphenylbenzene-1,3,5-triamine (0.661 g, 0.5 mmol) and orthodichlorobenzene (10 ml). After completion of dropwise addition, the temperature was raised to 180°C, and the mixture was stirred for 24 hours. Thereafter, the mixture was cooled again to room temperature, N,N-diisopropylethylamine (1.28 ml, 7.5 mmol) was added thereto, and the mixture was stirred until heat generation was settled. Thereafter, the reaction solution was distilled off under reduced pressure at 60°C. Subsequently, the reaction solution was filtered using silica gel (eluent: toluene), and the solvent was distilled off under reduced pressure to obtain a crude product. The obtained crude product was washed with toluene to obtain compound (1-9) (0.365 g, yield 59%).

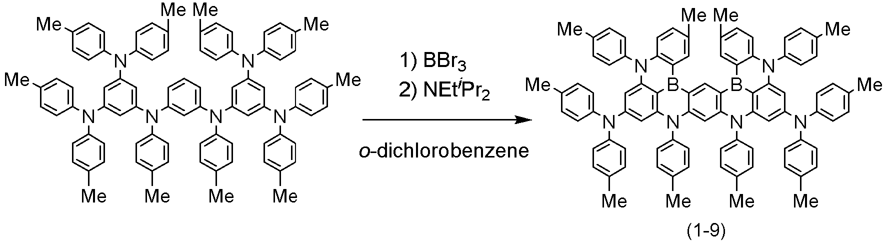

The structure of the compound thus obtained was identified with an NMR spectrum.

¹H-NMR(400MHz,CDCl₃):δ = δ = 2.32(s,12H), 2.39(s,6H), 2.47(s,6H), 2.59(s,6H), 5.47-5.51(m,4H), 5.97(s,1H), 6.80(d,2H), 6.87-6.94(m, 20H), 7.05(d,4H), 7.18(d,4H), 7.27(d,2H), 7.31(d,4H), 9.00(s,2H), 10.5(s,1H).

¹³C-NMR(126MHz, (CDCl₂)₂): = 20.4(4C), 20.6 (2C), 20.7(2C), 21.0(2C), 97.8(2C), 97.9(2C), 103.5(1C), 116.7(2C), 125.7(8C), 128.1(2C), 129.0(8C), 129.5(4C), 130.0(4C), 130.1(4C), 130.7(4C), 131.2(2C), 132.6(4C), 134.7(2C), 136.5(2C), 137.3(2C), 139.6(2C), 140.1(2C), 143.0(1C), 144.1(4C), 146.1(2C), 147.9(2C+2C), 150.1(2C), 151.1(2C).

### Synthesis Example (4)

### Synthesis of compound (1-101):

### 7,13-diphenoxy-5,9,11,15-tetraphenyl-5,9,11,15-tetrahydro -5,9,11,15-tetraaza-19b,20b-diboradinaphtho[3,2,1-de:1',2 ',3'-jk]pentacene

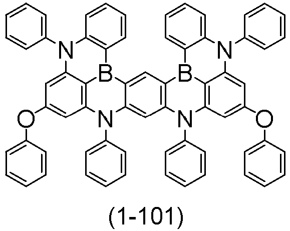

### [First stage]

In a nitrogen atmosphere, a flask containing 1-bromo-3-chloro-5-fluorobenzene (5.50 ml, 45 mmol), phenol (4.40 g, 47 mmol), potassium carbonate (9.30 g, 68 mmol), and NMP (300 ml) was heated to 150°C and stirred for 17 hours. The reaction solution was cooled to room temperature, and NMP was distilled off under reduced pressure. Thereafter, water and toluene were added thereto, and the mixture was partitioned. Subsequently, the mixture was filtered using silica gel (eluent: toluene), and the solvent was distilled off under reduced pressure to obtain 1-bromo-3-chloro-5-phenoxybenzene (12.2 g, yield 98%).

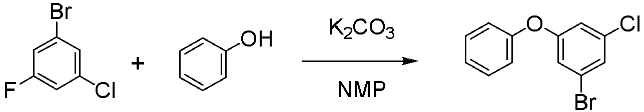

The structure of the compound thus obtained was identified with an NMR spectrum.

¹H-NMR(400MHz, CDCl₃):δ = 7.37(m,2H), 7.16-7.21(m,2H), 7.00-7.03(m,3H), 6.90(t,1H).

### [Second stage]

In a nitrogen atmosphere, a flask containing 1-bromo-3-chloro-5-phenoxybenzene (5.30 ml, 27 mmol), diphenylamine (4.80 g, 28 mmol), Pd₂(dba)₃ (0.247 g, 0.27 mmol), tri-tert-butylphosphine (109 mg, 0.54 mmol), NaOtBu (3.90 g, 41 mmol), and toluene (300 ml) was heated to 80°C and stirred for 14 hours. The reaction solution was filtered using silica gel (eluent: toluene), and the solvent was distilled off under reduced pressure to obtain
3-chloro-5-phenoxy-N,N-diphenylaniline (8.30 g, yield 83%) as a white solid.

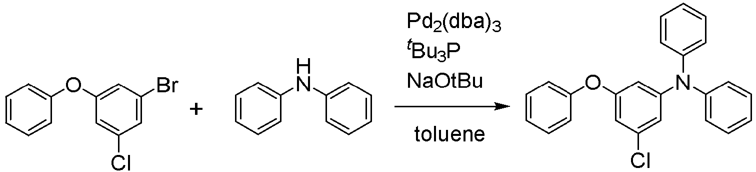

The structure of the compound thus obtained was identified with an NMR spectrum.

¹H-NMR(400MHz,CDCl₃):δ = 7.24-7.28(m,1H), 7.18(dd,16H), 7.05(d,16H), 6.94(t,8H), 6.57(t,2H), 6.54(d,1H), 6.51(d,2H), 6.29(d,4H).

### [Third stage]

In a nitrogen atmosphere, a flask containing N¹,N³-diphenylbenzene-1,3-diamine (1.56 g, 6.0 mmol), 3-chloro-5-phenoxy-N,N-diphenylaniline (4.69 g, 13 mmol), Pd₂(dba)₃ (0.110 g, 0.12 mmol), tri-tert-butylphosphine (49.0 mg, 0.24 mmol), NaOtBu (1.44 g, 15 mmol), and toluene (200 ml) was heated to 110°C and stirred for 18 hours. The reaction solution was filtered using silica gel (eluent: toluene), and the solvent was distilled off under reduced pressure to obtain a crude product. The obtained crude product was washed with methanol to obtain N¹,N¹'-(1,3-phenylene) bis(5-phenoxy-N¹,N³,N³-triphenylbenzene-1,3-diamine (4.9 g, yield 87%) as a white solid.

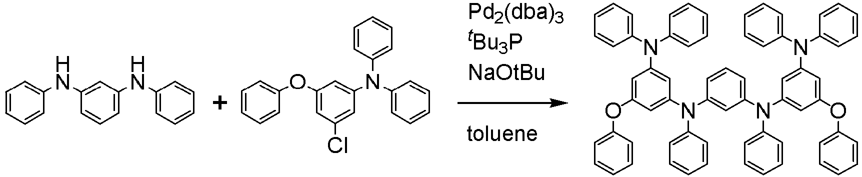

The structure of the compound thus obtained was identified with an NMR spectrum.

¹H-NMR(400MHz,CDCl₃):δ = 6.88-7.27(m,41H), 6.79(t,1H), 6.65(dd,2H), 6.51(t,1H), 6.30-6.32(m,4H).

### [Fourth stage]

In a nitrogen atmosphere at room temperature, boron tribromide (0.227 ml, 2.4 mmol) was added to a flask containing N¹,N¹'-(1,3-phenylene)
bis(5-phenoxy-N¹,N³,N³-triphenylbenzene-1,3-diamine (0.559 g, 0.60 mmol) and orthodichlorobenzene (10 ml). After completion of dropwise addition, the temperature was raised to 180°C, and the mixture was stirred for 24 hours.
Thereafter, the mixture was cooled again to room temperature, N,N-diisopropylethylamine (1.5 ml, 9 mmol) was added thereto, and the mixture was stirred until heat generation was settled. Thereafter, the reaction solution was distilled off under reduced pressure at 60°C. Subsequently, the reaction solution was filtered using silica gel (eluent: toluene), and the solvent was distilled off under reduced pressure to obtain a crude product. The obtained crude product was filtered using silica gel column chromatography (eluent: toluene/hexane = 1/2 (volume ratio)), and the solvent was distilled off under reduced pressure to obtain compound (1-101)(57.3 mg, yield 10%).

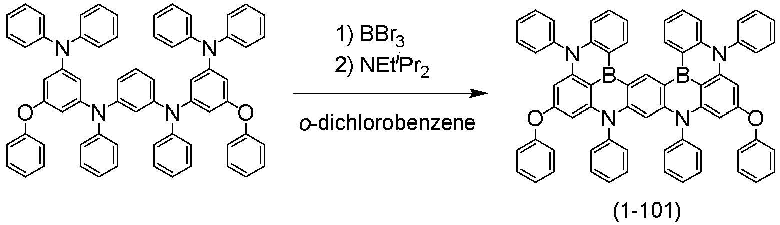

The structure of the compound thus obtained was identified with an NMR spectrum.

¹H-NMR(400MHz,CDCl₃):δ = 5.71-5.74(m,5H), 6.79(d,2H), 6.82(d,4H), 6.96(t,2H), 7.09(d,4H), 7.15(dd,4H), 7.28-7.38(m,12H), 7.45-7.52(m,4H), 7.61(t,4H), 9.24(d,2H), 10.5(s,1H).

¹³C-NMR(101MHz,CDCl₃):δ = 96.1(2C), 96.2(2C), 103.4(1C), 117.1(2C), 119.1(4C), 120.3(2C), 123.2(2C), 128.0(2C), 128.5(8C), 129.3(4C), 129.8(4C), 130.3(4C), 130.6(4C), 130.8(2C), 131.0(4C), 135.2(2C), 141.6(2C), 142.0(2C), 143.8(1C), 147.7(2C), 148.4(2C), 148.6(2C), 150.0(2C), 156.0(2C), 160.6(2C).

### Synthesis Example (5):

### Synthesis of compound (1-2001): N⁷,N⁷,N¹³,N¹³,5,9,15-tetrahydro-5,9,15-triaza-11-oxa-19b,20 b-diboradinaphtho[3,2,1-de:1',2',3'-jk]pentacene-7,13-dia mine

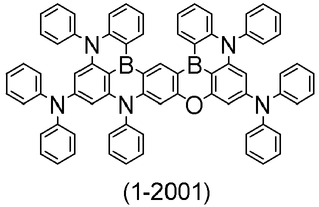

In a nitrogen atmosphere, a flask containing 1,3-dibromo-5-fluorobenzene (25.4 g, 0.10 mol), m-chlorophenol (16.7 g, 0.13 mol), cesium carbonate (40.1 g, 0.12 mol), and N-methylpiperidone (NMP, 300 ml) was heated to 120°C and stirred for 20 hours. The reaction solution was cooled to room temperature, and NMP was distilled off under reduced pressure. Thereafter, the residue was filtered using a silica gel short pass column (eluent: hexane), and the solvent was distilled off under reduced pressure to obtain a crude product. The obtained crude product was subjected to sublimation purification at 80°C under a reduced pressure of 1 × 10⁻⁴ mmHg to obtain 1,3-dibromo-5-(3-chlorophenoxy) benzene (27.7 g, yield 77%).

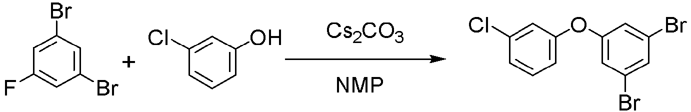

The structure of a compound thus obtained was identified by an NMR analysis.

¹H-NMR(400MHz, CDCl₃):δ = 6.90(d,1H), 7.02(s,1H), 7.07(s,2H), 7.15(d,1H), 7.29(t,1H), 7.41(s,1H).

In a nitrogen atmosphere, a flask containing 1,3-dibromo-5-(3-chlorophenoxy) benzene (10.2 g, 28 mmol), diphenylamine (10.6 g, 62 mmol), Pd₂(dba)₃ (131 mg, 0.14 mmol), tri-tert-butylphosphine (56.7 mg, 0.28 mmol), NaO^{t}Bu (6.37 g, 70 mmol), and toluene (300 ml) was heated to 80°C and stirred for 30 minutes. The reaction solution was cooled to room temperature and filtered using a Florisil short pass column (eluent: toluene). The solvent was distilled off under reduced pressure to obtain a crude product. The obtained crude product was washed with methanol to obtain 5-(3-chlorophenoxy) N¹,N¹,N³,N³-tetraphenylbenzene-1,3-diamine (12.6 g, yield 83%) as a white solid.

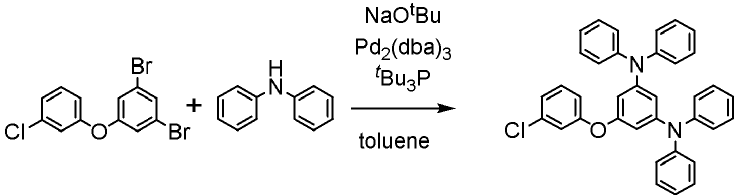

The structure of a compound thus obtained was identified by an NMR analysis.

¹H-NMR(400MHz,CDCl₃):δ = 6.28(d,2H), 6.56(t,1H), 6.82(dd,1H), 6.91(t,1H), 6.95-6.99(m,5H)7.07(d,8H), 7.15(t,1H), 7.21(t,8H).

In a nitrogen atmosphere, a flask containing 5-(3-chlorophenoxy) N¹,N¹,N³,N³-tetraphenylbenzene-1,3-diamine (10.2 g, 18 mmol), aniline (3.35 g, 36 mmol), Pd₂(dba)₃ (0.330 g, 0.36 mmol), 2-dicyclohexylphosphino-2',6'-dimethoxybiphenyl (0.296 g, 0.72 mmol), NaO^{t}Bu (5.19 g, 54 mmol), and toluene (200 ml) was heated 110°C and stirred for two hours. The reaction solution was cooled to room temperature and filtered using a Florisil short pass column (eluent: toluene). The solvent was distilled off under reduced pressure to obtain a crude product. The obtained crude product was washed with hexane and methanol in this order to obtain N¹,N¹,N³,N³-tetraphenyl 5-(3-(phenylamino) phenoxy) benzene-1,3-diamine (9.49 g, yield 89%) as a white solid.

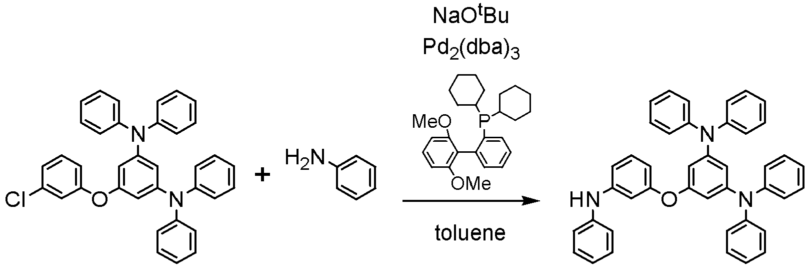

The structure of a compound thus obtained was identified by an NMR analysis.

¹H-NMR(400MHz,CDCl₃):δ = 5.65(s,1H), 6.34(t,2H), 6.47(d,1H), 6.55(dd,1H), 6.65(dd,2H), 6.94-6.98(m,5H), 7.03-7.08(m,10H), 7.10(t,1H), 7.19(t,8H), 7.27(t,2H).

In a nitrogen atmosphere, a flask containing N¹,N¹,N³,N³-tetraphenyl 5-(3-(phenylamino) phenoxy) benzene-1,3-diamine (4.29 g, 7.2 mmol), 5-chloro-N¹,N¹,N³,N³-tetraphenylbenzene-1,3-diamine (2.67 g, 6.0 mmol), Pd₂(dba)₃ (0.165 g, 0.18 mmol), tri-tert-butylphosphine (72.8 mg, 0.36 mmol), NaO^{t}Bu (1.15 g, 12 mmol), and toluene (200 ml) was heated to 110°C and stirred for 20 hours. The reaction solution was cooled to room temperature and filtered using a Florisil short pass column (eluent: toluene). The solvent was distilled off under reduced pressure to obtain a crude product. The obtained crude product was washed with acetonitrile to obtain N¹-(3-(3,5-bis) diphenylamino) phenoxy) phenol-(N¹,N³,N³,N⁵,N⁵-pentaphenylbenzene-1,3, 5-triamine (4.93 g, yield 82%) as a white solid.

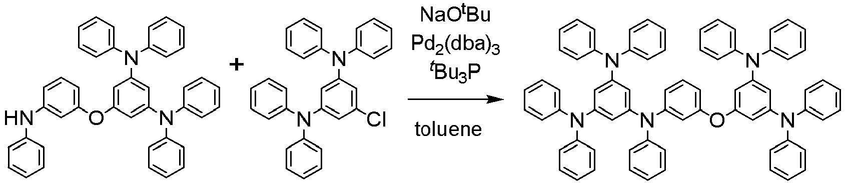

The structure of a compound thus obtained was identified by an NMR analysis.

¹H-NMR(500MHz,(CDCl₂)₂):δ = 6.28(d,2H), 6.38(d,2H), 6.40-6.42(m,2H), 6.52(s,1H), 6.58-6.60(m,2H), 6.86(t,4H), 6.92-7.07(m,24H), 7.11-7.20(m,18H).

In a nitrogen atmosphere at room temperature, boron tribromide (0.569 ml, 6.0 mmol) was added to a flask containing N¹-(3-(3,5-bis) diphenylamino) phenoxy) phenol-(N¹,N³,N³,N⁵,N⁵-pentaphenylbenzene-1,3, 5-triamine (1.05 g, 1.0 mmol) and chlorobenzene (50 ml). After completion of dropwise addition, the temperature was raised to 140°C, and the mixture was stirred for 24 hours. Thereafter, the mixture was cooled again to room temperature, N-diisopropylethylamine (3.13 ml, 18 mmol) was added thereto, and the mixture was stirred until heat generation was settled. Thereafter, the reaction solution was distilled off under reduced pressure at 60°C to obtain a crude product. The obtained crude product was washed with heptane to obtain compound (1-2001) (0.251 g, yield 24%).

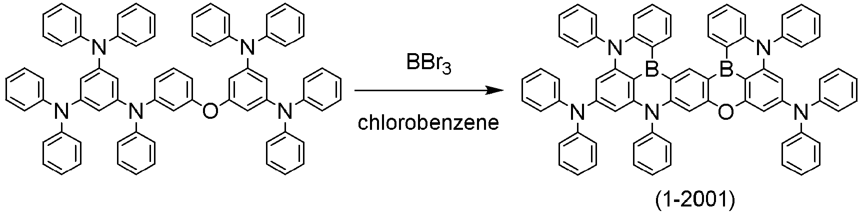

The structure of a compound thus obtained was identified by an NMR analysis.

¹H-NMR(500MHz, (CDCl₂)₂):δ = 5.67(s,1H), 5.68(s,1H), 5.75(d,1H), 6.51(d,1H), 6.58(s,1H), 6.77(m,2H), 6.92-7.12(m,18H), 7.18-7.51(m,21H), 9.17(m,2H), 10.3(s,1H).

¹³C-NMR(126MHz,(CDCl₂)₂):98.5(1C), 98.9(1C), 99.0(1C), 100.6(1C), 103.3(1C), 117.0(1C), 117.3(1C), 120.0(1C), 120.1(1C), 123.5(2C), 124.0(2C), 124.4(1C), 125.6(4C), 126.0(4C), 128.1(1C), 128.3(2C), 128.8(4C), 129.0(1C), 129.1(4C), 130.0(2C), 130.2(2C), 130.5(1C), 130.6(2C), 130.7(2C), 130.8(2C), 131.2(1C), 135.0(1C), 135.1(1C), 141.7(1C), 141.8(1C), 142.1(1C), 143.0(1C), 146.5(2C), 146.7(2C), 147.1(1C), 146.8(1C), 147.8(1C), 147.9(1C), 148.0(1C), 151.1(1C), 151.2(1C), 152.3(1C), 159.2(1C), 161.9(1C).

### Synthesis Example (6):

### Synthesis of compound (1-31):

### 2,18-dimethyl-N⁷,N⁷,N¹³, N¹³, 9,11-hexaparatolyl-5,9,11,15-te trahydro-5,9,11,15-tetraaza-19b,20b-diboradinaphtho[3,2,1 -de:1',2',3'-jk]pentacene-7,13-diamine

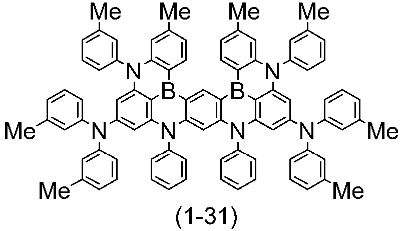

### [First stage]

In a nitrogen atmosphere, a flask containing 1,3-dibromo-5-chlorobenzene (13.7 g, 51 mmol), metaditolylamine (19.8 g, 0.10 mol), Pd₂(dba)₃ (0.93 g, 1.0 mmol),
2-dicyclohexylphenylphosphino-2',6'-dimethoxydiphenyl (SPhos: 0.838 g, 2.0 mmol), NaOtBu (14.6 g, 0.15 mol), and toluene (640 ml) was heated to 80°C and stirred for 1.5 hours. The reaction was stopped by adding water, and then extraction was performed using toluene. The crude product obtained by distilling off the solvent was purified using a silica gel column (eluent : heptane: toluene = 6 : 4 (volume ratio)) to obtain
5-chloro-N¹,N¹,N³,N³-tetrametatolylbenzene-1,3-diamine (27.0 g, yield 84%) as a white paste.

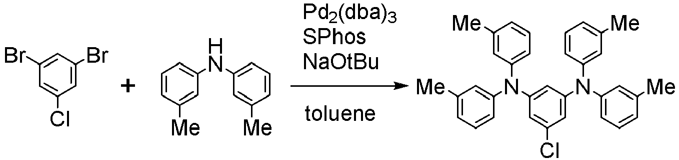

### [Second stage]

In a nitrogen atmosphere, a flask containing N¹,N³-diphenylbenzene-1,3-diamine (4.22 g, 16 mmol), 5-chloro-N¹,N¹,N³,N³-tetrametatolylbenzene-1,3-diamine (21.5 g, 43 mmol)), Pd-132 (0.12 g, 0.17 mmol), NaOtBu (3.89 g, 40 mmol), and toluene (80 ml) was heated to 110°C and stirred for two hours. The reaction was stopped by adding water, and then extraction was performed using toluene. The crude product obtained by distilling off the solvent was purified using a silica gel column (eluent: toluene), and the resulting crude product was reprecipitated with heptane to obtain N¹,N^{1'}-(1,3-phenylene)
bis (N¹-phenyl-N³, N³, N⁵, N⁵-tetrametatolylbenzene-1,3,5-triam ine (19.9 g, yield 80%) as a white solid.

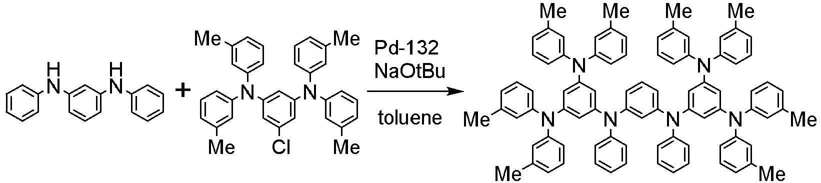

### [Third stage]

In a nitrogen atmosphere at room temperature, boron tribromide (0.819 ml, 2.0 mmol) was added to a flask containing N¹,N^{1'}-(1,3-phenylene)
bis (N¹-phenyl-N³,N³,N⁵,N⁵-tetrametatolylbenzene-1,3,5-triam ine (0.661 g, 0.5 mmol), and orthodichlorobenzene (10 ml). After completion of dropwise addition, the temperature was raised to 180°C, and the mixture was stirred for 24 hours. Thereafter, the mixture was cooled again to room temperature, N,N-diisopropylethylamine (1.28 ml, 7.5 mmol) was added thereto, and the mixture was stirred until heat generation was settled. Thereafter, the reaction solution was distilled off under reduced pressure at 60°C. Subsequently, the reaction solution was filtered using silica gel (eluent: toluene), and the solvent was distilled off under reduced pressure to obtain a crude product. The obtained crude product was washed with toluene to obtain compound (1-31) (0.365 g, yield 59%).

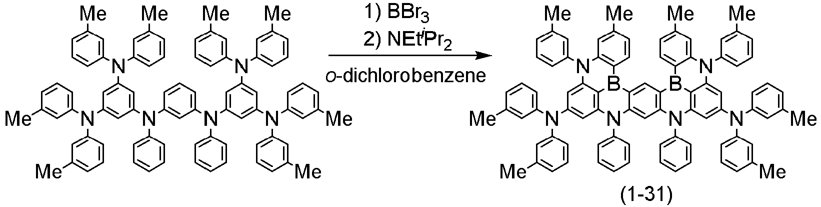

The structure of the compound thus obtained was identified with an NMR spectrum.

¹H-NMR(400MHz,CDCl₃) :δ = 2.32 (s, 12H), 2.39 (s, 6H), 2.47(s,6H), 2.59(s,6H), 5.47-5.51(m,4H), 5.97(s,1H), 6.80(d,2H), 6.87-6.94(m,20H), 7.05(d,4H), 7.18(d,4H), 7.27(d,2H), 7.31(d,4H), 9.00(s,2H), 10.5(s,1H).

¹³C-NMR(101MHz,CDCl₃):20.4(4C), 20.6(2C), 20.7(1C), 21.0(2C), 97.8(2C), 97.9(2C), 103.5(1C), 116.7(2C), 125.7(8C), 128.1(2C), 129.0(8C), 129.5(4C), 130.0(4C), 130.1(4C), 130.7(4C), 131.2(2C), 132.6(4C), 134.7(2C), 136.5(2C), 137.3(2C), 139.6(2C), 140.1(2C), 143.0(1C), 144.1(4C), 146.1(2C), 147.9(2C+2C), 150.1(2C), 151.1(2C).

Other compounds of the present invention can be synthesized by a method in accordance with those in Synthesis Examples described above, by appropriately changing the compounds of raw materials.

Next, evaluation of basic physical properties of the compounds of the present invention, and manufacturing and evaluation of an organic EL element using the compounds of the present invention will be described.

### <Evaluation of basic physical properties>

### Preparation of sample

When absorption characteristics and luminescence characteristics (fluorescence and phosphorescence) of a compound to be evaluated are evaluated, there are a case where the compound to be evaluated is dissolved in a solvent and evaluated in a solvent and a case where the compound to be evaluated is evaluated in a thin film state. Furthermore, in the case of evaluation in a thin film state, depending on a mode of use of a compound to be evaluated in an organic EL element, there are a case where only the compound to be evaluated is formed into a thin film to be evaluated and a case where the compound to be evaluated is dispersed in an appropriate matrix material, and is formed into a thin film to be evaluated.

As the matrix material, commercially available PMMA (polymethyl methacrylate) or the like can be used. For example, a thin film sample dispersed in PMMA can be manufactured by dissolving PMMA and a compound to be evaluated in toluene and then forming a thin film on a quartz transparent support substrate (10 mm × 10 mm) by a spin coating method.

A method for manufacturing a thin film sample when the matrix material is a host material will be described below. A quartz transparent support substrate (10 mm × 10 mm × 1.0 mm) is fixed to a substrate holder of a commercially available vapor deposition apparatus (manufactured by Showa Shinku Co., Ltd.), and a molybdenum vapor deposition boat containing a host material and a molybdenum vapor deposition boat containing a dopant material are attached thereto. Subsequently, a vacuum chamber is depressurized to 5 × 10⁻⁴ Pa, and the vapor deposition boat containing the host material and the vapor deposition boat containing the dopant material are heated simultaneously to perform vapor deposition so as to obtain an appropriate film thickness, and a mixed thin film of the host material and the dopant material is formed. The deposition rate is controlled according to a set weight ratio between the host material and the dopant material.

### Evaluation of absorption characteristics and luminescence characteristics

An absorption spectrum of the sample was measured using an ultraviolet-visible near-infrared spectrophotometer (manufactured by Shimadzu Corporation, UV-2600). A fluorescence spectrum or a phosphorescence spectrum of the sample was measured using a spectrofluorophotometer (manufactured by Hitachi High-Technologies Corporation, F-7000).

For measurement of the fluorescence spectrum, photoluminescence was measured by excitation at an appropriate excitation wavelength at room temperature. For measurement of the phosphorescence spectrum, the sample was measured while being immersed in liquid nitrogen (temperature 77 K) using an attached cooling unit. In order to observe the phosphorescence spectrum, delay time from excitation light irradiation to start of measurement was adjusted using an optical chopper. The sample was excited with an appropriate excitation wavelength and photoluminescence was measured.

A fluorescence quantum yield was measured using an absolute PL quantum yield measuring apparatus (C9920-02G manufactured by Hamamatsu Photonics Co., Ltd.).

### Evaluation of fluorescence lifetime (delayed fluorescence)

A fluorescence lifetime is measured at 300 K using a fluorescence lifetime measuring apparatus (manufactured by Hamamatsu Photonics K.K., C11367-01). Fast and slow components of a fluorescence lifetime are observed at a maximum emission wavelength measured at an appropriate excitation wavelength. In fluorescence lifetime measurement of a general organic EL material that emits fluorescence at room temperature, a slow component involving a triplet component derived from phosphorescence is rarely observed due to deactivation of the triplet component due to heat. A case where a slow component is observed in a compound to be evaluated indicates that triplet energy having a long excitation lifetime has moved to singlet energy due to thermal activation and is observed as delayed fluorescence.

### Calculation of energy gap (Eg)

An energy gap is calculated by Eg = 1240/A from a long wavelength edge A (nm) of an absorption spectrum obtained by the above method.

### Calculation of E_{S}, E_{T}, and ΔEST

Singlet excitation energy (E_{S}) is calculated by E_{S} = 1240/B from a maximum emission wavelength B (nm) of a fluorescence spectrum. Triplet excitation energy (E_{T}) is calculated by E_{T} = 1240/C from a maximum emission wavelength C (nm) of a phosphorescence spectrum.

ΔEST is defined as ΔEST = E_{S} - E_{T} which is an energy difference between E_{S} and E_{T}. ΔEST can also be calculated, for example, by a method described in "Purely organic electroluminescent material realizing 100% conversion from electricity to light", H. Kaji, H. Suzuki, T. Fukushima, K. Shizu, K. Katsuaki, S. Kubo, T. Komino, H. Oiwa, F. Suzuki, A. Wakamiya, Y. Murata, C. Adachi, Nat. Commun. 2015, 6, 8476.

### Evaluation of basic physical properties of compound (1-1)

### [Absorption characteristics]

A thin film forming substrate (made of quartz) in which compound (1-1) was dispersed in PMMA at a concentration of 1% by weight was prepared, and an absorption spectrum was measured (FIG. 2). As a result, a maximum absorption wavelength in a visible light region was 457 nm. A thin film forming substrate including only compound (1-1) was prepared, and an absorption spectrum thereof was measured. As a result, a long wavelength absorption edge of the absorption spectrum was 477 nm, and Eg was calculated to be 2.60 eV. It was found that compound (1-1) had an appropriate energy gap.

### [Luminescence characteristics]

For measurement of a fluorescence spectrum, a thin film forming substrate (made of quartz) in which compound (1-1) was dispersed in PMMA at a concentration of 1% by weight was prepared, and photoluminescence was measured by exciting the thin film forming substrate at an excitation wavelength of 340 nm (FIG. 2). As a result, a maximum emission wavelength was 467 nm. From this, E_{S} is calculated to be 2.66 eV. The same substrate was prepared, and a fluorescence quantum yield was measured by exciting the substrate at an excitation wavelength of 340 nm. As a result, the fluorescence quantum yield was as high as 92%.

For measurement of a phosphorescence spectrum, a thin film forming substrate (made of quartz) in which compound (1-1) was dispersed in PMMA at a concentration of 1% by weight was prepared, and photoluminescence was measured by exciting the thin film forming substrate at an excitation wavelength of 340 nm (FIG. 2). As a result, a maximum emission wavelength was 470 nm. From this, it was found that E_{T} was 2.64 eV, indicating a high value.

### ΔEST was calculated to be 0.02 eV.

From the above, it was confirmed that compound (1-1) was a material capable of achieving a high efficiency and a deep blue color. In particular, compound (1-1) can be expected as a thermally activated delayed fluorescent material because of having small ΔEST.

### Comparative compound 1

A compound of formula (1-2676) disclosed in WO 2015/102118 A was used as Comparative Compound 1. ΔEST was calculated in a similar manner to that in Example of Compound (1-1) except that Compound (1-1) of the present invention was changed to Comparative Compound 1. A maximum emission wavelength of a fluorescence spectrum was 469 nm, a maximum emission wavelength of a phosphorescence spectrum was 502 nm, and ΔEST was calculated to be 0.17 eV. This value of ΔEST is sufficiently small to obtain thermally activated delayed fluorescence, but is larger than compound (1-1) of the present invention, and is expected to have a lower external quantum efficiency than compound (1-1) with respect to an organic EL element configuration exhibiting thermally activated delayed fluorescence.

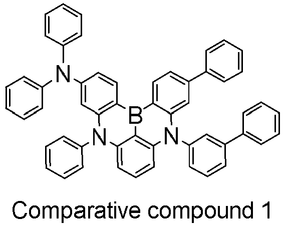

### Comparative Compound 2

A compound of formula (1-422) disclosed in WO 2015/102118 A was used as Comparative Compound 2. Evaluation was performed in a similar manner to that in Example of compound (1-1) except that compound (1-1) of the present invention was changed to Comparative Compound 2. As a result, a maximum emission wavelength of a fluorescence spectrum was 477 nm, which was 10 nm longer than that of compound (1-1), and a deep blue color could not be achieved.

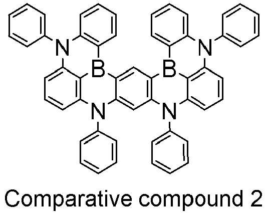

As described above, compound (1-1) has an appropriate energy gap and high triplet excitation energy, and therefore is the most suitable as a material for a light emitting layer. In particular, compound (1-1) can be expected as a thermally activated delayed fluorescent material for a light emitting layer because of having small ΔEST.

### Evaluation of basic physical properties of compound (1-201)

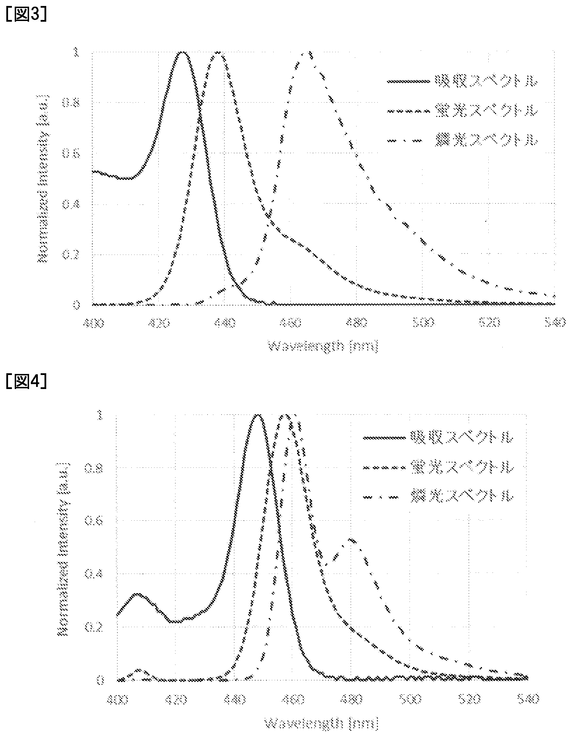

A thin film forming substrate in which compound (1-201) was dispersed in PMMA was prepared under the same conditions as compound (1-1), and an absorption spectrum and an emission spectrum were measured (FIG. 3). Note that an excitation wavelength was 375 nm when the emission spectrum was measured. As a result, a maximum emission wavelength of a fluorescence spectrum was 438 nm. The same substrate was prepared and excited with an excitation wavelength of 375 nm, and a fluorescence quantum yield was measured. As a result, the fluorescence quantum yield was as high as 87%. Furthermore, a maximum emission wavelength of a phosphorescence spectrum was 466 nm. From this, it was found that E_{T} was 2.66 eV, indicating a high value. ΔEST was calculated to be 0.17 eV.

From the above, it was confirmed that compound (1-201) was a material capable of achieving a high efficiency and a deep blue color. In particular, compound (1-1) can be expected as a thermally activated delayed fluorescent material because of having small ΔEST.

### Evaluation of basic physical properties of compound (1-101)

A thin film forming substrate in which compound (1-101) was dispersed in PMMA was prepared under the same conditions as compound (1-1), and an absorption spectrum and an emission spectrum were measured (FIG. 4). Note that an excitation wavelength was 407 nm when the emission spectrum was measured. As a result, a maximum emission wavelength of a fluorescence spectrum was 457 nm. The same substrate was prepared and excited with an excitation wavelength of 407 nm, and a fluorescence quantum yield was measured. As a result, the fluorescence quantum yield was as high as 91%. Furthermore, a maximum emission wavelength of a phosphorescence spectrum was 461 nm. From this, it was found that E_{T} was 2.69 eV, indicating a high value. ΔEST was calculated to be 0.02 eV.

From the above, it was confirmed that compound (1-101) was a material capable of achieving a high efficiency and a deep blue color. In particular, compound (1-1) can be expected as a thermally activated delayed fluorescent material because of having small ΔEST.

### Evaluation of basic physical properties of compound (1-9)

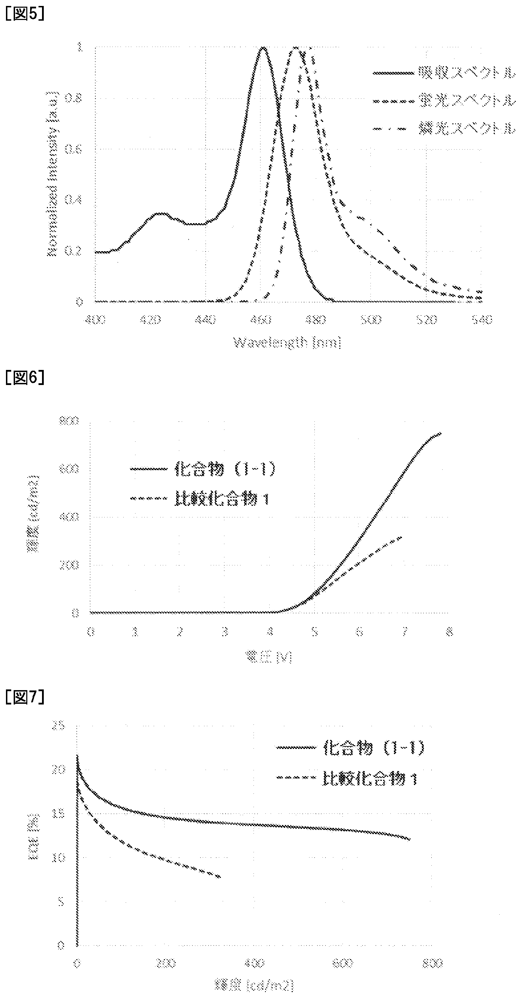

A thin film forming substrate in which compound (1-9) was dispersed in PMMA was prepared under the same conditions as compound (1-1), and an absorption spectrum and an emission spectrum were measured (FIG. 5). Note that an excitation wavelength was 374 nm when the emission spectrum was measured. As a result, a maximum emission wavelength of a fluorescence spectrum was 473 nm. The same substrate was prepared and excited with an excitation wavelength of 374 nm, and a fluorescence quantum yield was measured. As a result, the fluorescence quantum yield was as high as 89%. Furthermore, a maximum emission wavelength of a phosphorescence spectrum was 477 nm. From this, it was found that E_{T} was 2.60 eV, indicating a high value. ΔEST was calculated to be 0.02 eV.

From the above, it was confirmed that compound (1-9) was a material capable of achieving a high efficiency and a deep blue color. In particular, compound (1-1) can be expected as a thermally activated delayed fluorescent material because of having small ΔEST.

### <Evaluation of organic EL element>

As described above, the compound of the present invention is characterized by an appropriate energy gap (Eg), high triplet excitation energy (E_{T}), and small AEST. Therefore, for example, application thereof to a light emitting layer and a charge transport layer, particularly to the light emitting layer can be expected.

### Evaluation items and evaluation method

Examples of an evaluation item include a driving voltage (V), an emission wavelength (nm), CIE chromaticity (x, y), an external quantum efficiency (%), a maximum wavelength (nm) of an emission spectrum, and a half width (nm) thereof. For these evaluation items, a value at appropriate emission luminance can be used.

A quantum efficiency of a luminescent element includes an internal quantum efficiency and an external quantum efficiency. The internal quantum efficiency indicates a ratio at which external energy injected as electrons (or holes) into a light emitting layer of the luminescent element is purely converted into photons. Meanwhile, the external quantum efficiency is calculated based on the amount of these photons emitted to an outside of the luminescent element. Some of the photons generated in the light emitting layer are absorbed or reflected continuously inside the luminescent element, and are not emitted to the outside of the luminescent element. Therefore, the external quantum efficiency is lower than the internal quantum efficiency.

A method for measuring spectral radiance (emission spectrum) and an external quantum efficiency are as follows. Using a voltage/current generator R6144 manufactured by Advantest Corporation, a voltage was applied to cause the element to emit light. Using a spectral radiance meter SR-3AR manufactured by TOPCON Co., spectral radiance in a visible light region was measured from a direction perpendicular to a light emitting surface. Assuming that the light emitting surface is a perfectly diffusing surface, a numerical value obtained by dividing a spectral radiance value of each measured wavelength component by wavelength energy and multiplying the obtained value by π is the number of photons at each wavelength. Subsequently, the number of photons is integrated in the observed entire wavelength region, and this number is taken as the total number of photons emitted from the element. A numerical value obtained by dividing an applied current value by an elementary charge is taken as the number of carriers injected into the element. The external quantum efficiency is a numerical value obtained by dividing the total number of photons emitted from the element by the number of carriers injected into the element. Note that the half width of an emission spectrum is obtained as a width between upper and lower wavelengths where the intensity is 50% with a maximum emission wavelength as the center.

### Manufacture of organic EL element

Organic EL elements according to Examples and Comparative Examples were manufactured, and voltage was applied to measure current density, luminance, chromaticity, an external quantum efficiency, and the like. As configurations of the manufactured organic EL elements, the following four configurations of configuration A (Tables 1 and 3), configuration B (Table 2), configuration C (Table 4), and configuration D (Table 5) were selected and evaluated. Configurations A, C, and D are suitable for a thermally activated delayed fluorescent material, and configuration B is more general. Configuration A is an element configuration that can be expected to have a high efficiency described in the literature (Adv. Mater. 2016, 28, 2777-2781). Configuration C is an element configuration that can be expected to have a relatively high efficiency and long-term driving stability described in the literature (Scientific Reports, 6, 2016, 22463). Configuration D is an element configuration in which a host material different from configurations A and C described in the literature (Thin Solid Films, 619, 2016, 120-124) is applied. However, application of the compound of the present invention is not limited to these configurations, and the film thickness and constituent materials of each layer can be appropriately changed depending on the basic physical properties of the compound of the present invention.

**[Table 1]**

| (Configuration A of organic EL element) | | | | | | | |
|---|---|---|---|---|---|---|---|
| | Hole injection layer (40 nm) | Hole transport layer (15 nm) | Electron blocking layer (15 nm) | Light emitting layer (20 nm) | | Electron transport layer (40 nm) | Negative electrode (1 nm/ 100 nm) |
| | | | | Host | Dopant | | |
| Example 1 | HI | HT | EB | EMH1 | Compound (1-1) | ET | LiF/Al |
| Comparative Example 1 | HI | HT | EB | EMH1 | Comparative Compound 1 | ET | LiF/Al |

In Table 1, "HI" represents N,N'-diphenyl-N,N'-dinaphthyl-4,4'-diaminobiphenyl, "HT" represents 4,4',4"-tris(N-carbazolyl) triphenylamine, "EB" represents 1,3-bis(N-carbazolyl) benzene, "EMH1" represents 3,3'-bis(N-carbazolyl)-1,1'-biphenyl, and "ET" represents diphenyl [4-(triphenylsilyl) phenyl] phosphine oxide. Chemical structures thereof are indicated below together with the chemical structure of Comparative Compound 1.

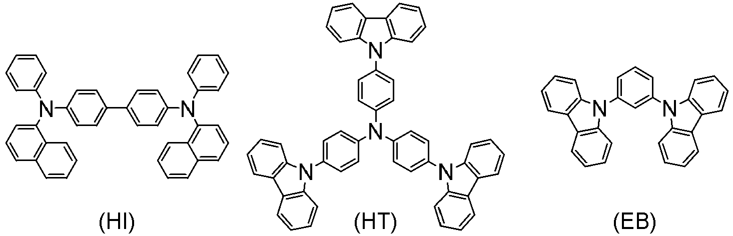

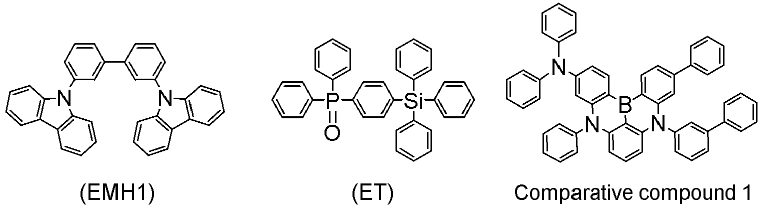

**[Table 2]**

| (Configuration B of organic EL element) | | | | | | | | | |
|---|---|---|---|---|---|---|---|---|---|
| | Hole injection layer | | Hole transport layer | | Light emitting layer 25 nm | | Electron transport layer | | Negative electrode 1 nm/ 100 nm |
| | 1 40 nm | 2 5 nm | 1 15 nm | 2 10 nm | Host | Dopant | 1 5 nm | 2 25 nm | |
| Example 2 | HI-1 | HAT-CN | HT-1 | HT-2 | EMH2 | Compound (1-1) | ET-1 | ET-2 +Liq | Liq/ MgAg |
| Comparative Example 2 | HI-1 | HAT-CN | HT-1 | HT-2 | EMH2 | Comparative Compound 1 | ET-1 | ET-2 +Liq | Liq/ MgAg |

In Table 2, "HI-1" represents N⁴,N^{4'}-diphenyl-N⁴,N^{4'}-bis (9-phenyl-9H-carbazol-3-yl) - [1, 1' -biphenyl]-4,4'-diamine, "HAT-CN" represents 1,4,5,8,9,12-hexaazatriphenylene hexacarbonitrile, "HT-1" represents
N-([1,1'-biphenyl]-4-yl)-9,9-dimethyl-N-(4-(9-phenyl-9H-c arbazol-3-yl) phenyl)-9H-fluorene-2-amine, "HT-2" represents N,N-bis(4-(dibenzo[b,d]furan-4-yl) phenyl)-[1,1':4',1"-terphenyl]-4-amine, "EMH2" represents 9-phenyl-10-(4-phenylnaphthalen-1-yl) anthracene, "ET-1" represents
4,6,8,10-tetraphenyl[1,4]benzoxaborinino[2,3,4-kl]phenoxa borinine, and "ET-2" represents
3,3'-((2-phenylanthracene-9,10-diyl) bis(4,1-phenylene)) bis(4-methylpyridine). Chemical structures thereof are indicated below together with the chemical structure of "Liq".

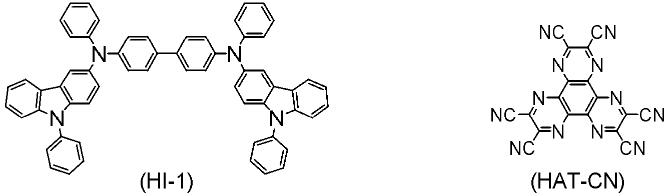

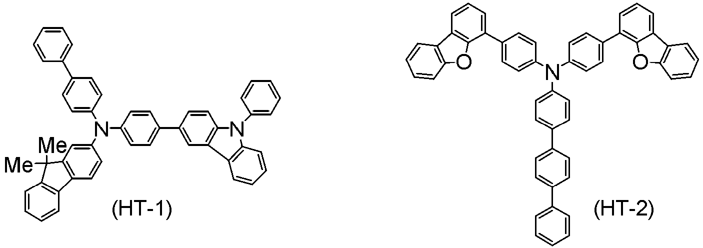

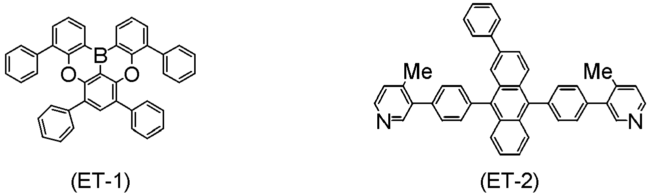

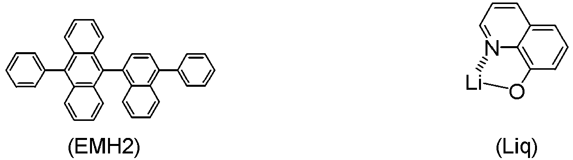

<Example 1>

### <Configuration A: element using compound (1-1) as dopant>

A glass substrate (manufactured by Opto Science, Inc.) having a size of 26 mm × 28 mm × 0.7 mm, which was obtained by forming a film of ITO having a thickness of 200 nm by sputtering and polishing the ITO film to 150 nm, was used as a transparent support substrate. This transparent support substrate was fixed to a substrate holder of a commercially available vapor deposition apparatus (manufactured by Sowa Shinku Co., Ltd.). Molybdenum vapor deposition boats containing HI, HT, EB, EMH1, compound (1-1), ET, and LiF, respectively, and a tungsten vapor deposition boat containing aluminum were attached thereto.

Layers described below were formed sequentially on the ITO film of the transparent support substrate. A vacuum chamber was depressurized to 5 × 10⁻⁴ Pa. First, HI was heated and vapor-deposited so as to have a film thickness of 40 nm. Thus, a hole injection layer was formed. Subsequently, HT was heated, and vapor deposition was heated and vapor-deposited so as to have a film thickness of 15 nm. Thus, a hole transport layer was formed. Subsequently, EB was heated, and vapor deposition was heated and vapor-deposited so as to have a film thickness of 15 nm. Thus, an electron blocking layer was formed. Subsequently, EMH1 and compound (1-1) were simultaneously heated and vapor-deposited so as to have a film thickness of 20 nm. Thus, a light emitting layer was formed. A vapor deposition rate was adjusted such that a weight ratio between EMH1 and compound (1-1) was approximately 99 : 1. Subsequently, ET was heated and vapor-deposited so as to have a film thickness of 40 nm. Thus, an electron transport layer was formed. The vapor deposition rate for each layer was 0.01 to 1 nm/sec.

Thereafter, LiF was heated and vapor-deposited at a vapor deposition rate of 0.01 to 0.1 nm/sec so as to have a film thickness of 1 nm. Subsequently, aluminum was heated and vapor-deposited so as to have a film thickness of 100 nm. Thus, a negative electrode was formed to obtain an organic EL element. At this time, the vapor deposition rate of aluminum was adjusted so as to be 1 nm to 10 nm/sec.

A direct current voltage was applied with the ITO electrode as a positive electrode and the aluminum electrode as a negative electrode, and luminance, chromaticity, and an external quantum efficiency were measured. The results are illustrated in FIGS. 6 and 7. Luminance at the time of application of 7 V achieved high luminance of 591 cd/m². An emission spectrum had a half width (FWHM) of 19 nm and a peak wavelength of 473 nm, and as chromaticity, CIE chromaticity (x, y) = (0.118, 0.104) and deep blue emission were obtained at the time of emission at 250 cd/m². External quantum efficiencies at the time of emission at 50 cd/m², 100 cd/m², and 250 cd/m² indicated high values of 16.8%, 15.7%, and 14.3%, respectively, and roll-off was small.

### <Comparative Example 1>

### <Configuration A: element using Comparative Compound 1 as dopant>

An EL element was obtained with a similar procedure and configuration to those in Example 1 except that the dopant was changed. The results are illustrated in FIGS. 6 and 7. Luminance at the time of application of 7 V was 322 cd/m², and as chromaticity, CIE chromaticity (x, y) = (0.126, 0.108) was obtained at the time of emission at 250 cd/m². External quantum efficiencies at the time of emission at 50 cd/m², 100 cd/m², and 250 cd/m² were 14.0%, 12.0%, and 9.0%, respectively. The achieved luminance was lower, the external quantum efficiency was lower, and the roll-off was larger than those in Example 1.

### <Example 2>

### <Configuration B: element using compound (1-1) as dopant>

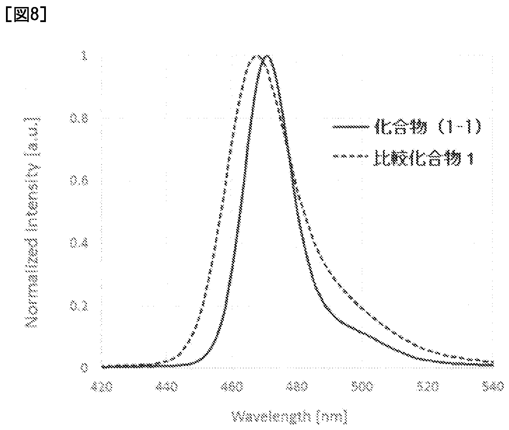

An EL element of configuration B was obtained with a similar procedure to that of configuration A. However, a vapor deposition rate was adjusted such that a weight ratio between EMH2 and compound (1-1) was approximately 98 : 2. As a result, an applied voltage at the time of emission at 1000 cd/m² was 4.1 V, an external quantum efficiency was 6.7%, an emission spectrum (FIG. 8) had a maximum emission wavelength of 471 nm and a half width of 18 nm, and CIE chromaticity (x, y) = (0.118, 0.106) was obtained. In particular, the half width of the emission spectrum was small, and a deep blue color could be achieved. With such a narrow half width, deep blue chromaticity and a cut in a low wavelength region can be achieved simultaneously, and it is possible to cope with device design that is friendly to eyes and biological rhythms.

### <Comparative Example 2>

### <Configuration B: element using Comparative Compound 1 as dopant>

An EL element was obtained with a similar procedure and configuration to those in Example 2 except that the dopant was changed. As a result, an applied voltage at the time of emission at 1000 cd/m² was 4.1 V, an external quantum efficiency was 6.6%, an emission spectrum (FIG. 8) had a maximum emission wavelength of 468 nm and a half width of 26 nm, and CIE chromaticity (x, y) = (0.124, 0.111) was obtained. The applied voltage and external quantum efficiency were equal to those in compound (1-1), but the half width was wider than that in compound (1-1).

The above compound (1-201), compound (1-101), and compound (1-9) can be evaluated by manufacturing organic EL elements with configurations A and B in a similar manner to compound (1-1).

**[Table 3]**

| (Configuration A of organic EL element) | | | | | | | |
|---|---|---|---|---|---|---|---|
| | Hole injection layer (40 nm) | Hole transport layer 1 (15 nm) | Hole transport layer 2 (15 nm) | Light emitting layer (20 nm) | | Electron transport layer (40 nm) | Negative electrode (1 nm/ 100 nm) |
| | | | | Host | Dopant | | |
| Comparative Example 3 | HI | HT | EB | EMH1 | Comparative Compound 2 | ET | LiF/Al |
| Example 3 | HI | HT | EB | EMH1 | Compound (1-9) | ET | LiF/Al |
| Example 4 | HI | HT | EB | EMH1 | Compound (1-31) | ET | LiF/Al |
| Example 5 | HI | HT | EB | EMH1 | Compound (1-2001) | ET | LiF/Al |

### <Comparative Example 3>

### <Configuration A: element using Comparative Compound 2 as dopant>

A glass substrate (manufactured by Opto Science, Inc.) having a size of 26 mm x 28 mm × 0.7 mm, which was obtained by forming a film of ITO having a thickness of 200 nm by sputtering and polishing the ITO film to 150 nm, was used as a transparent support substrate. This transparent support substrate was fixed to a substrate holder of a commercially available vapor deposition apparatus (manufactured by Sowa Shinku Co., Ltd.). Molybdenum vapor deposition boats containing HI, HT, EB, EMH1, Comparative Compound 2, ET, and LiF, respectively, and a tungsten vapor deposition boat containing aluminum were attached thereto.

Layers described below were formed sequentially on the ITO film of the transparent support substrate. A vacuum chamber was depressurized to 5 × 10⁻⁴ Pa. First, HI was heated and vapor-deposited so as to have a film thickness of 40 nm. Thus, a hole injection layer was formed. Subsequently, HT was heated and vapor-deposited so as to have a film thickness of 15 nm. Thus, a hole transport layer 1 was formed. Subsequently, EB was heated and vapor-deposited so as to have a film thickness of 15 nm. Thus, a hole transport layer 2 was formed. Subsequently, EMH1 and Comparative Compound 2 were simultaneously heated and vapor-deposited so as to have a film thickness of 20 nm. Thus, a light emitting layer was formed. A vapor deposition rate was adjusted such that a weight ratio between EMH1 and Comparative Compound 2 was approximately 99 : 1. Subsequently, ET was heated and vapor-deposited so as to have a film thickness of 40 nm. Thus, an electron transport layer was formed. The vapor deposition rate for each layer was 0.01 to 1 nm/sec. Thereafter, LiF was heated and vapor-deposited at a vapor deposition rate of 0.01 to 0.1 nm/sec so as to have a film thickness of 1 nm. Subsequently, aluminum was heated and vapor-deposited so as to have a film thickness of 100 nm. Thus, a negative electrode was formed to obtain an organic EL element. At this time, the vapor deposition rate of aluminum was adjusted so as to be 1 nm to 10 nm/sec.

A direct current voltage was applied with the ITO electrode as a positive electrode and the aluminum electrode as a negative electrode, and luminance, chromaticity, and an external quantum efficiency were measured. Emission spectra at the time of emission at 10 cd/m², 100 cd/m², and 250 cd/m² each had a half width (FWHM) of 18 nm and a peak wavelength of 480 nm, and very thin emission was observed. However, as chromaticity, CIE chromaticity (x, y) = (0.092, 0.224) was obtained because of the long peak wavelength, and pale blue emission was observed. An external quantum efficiency at the time of emission at 100 cd/m² was 4.9%.

### <Example 3>

### <Configuration A: element using compound (1-9) as dopant>

An EL element was obtained with a similar procedure and configuration to those in Comparative Example 3 except that the dopant was changed. An emission spectrum at the time of emission at 100 cd/m² had a half width (FWHM) of 21 nm and a peak wavelength of 473 nm, and very thin emission was observed. As chromaticity, CIE chromaticity (x, y) = (0.105, 0.210) was obtained, and slightly deeper blue emission than that of Comparative Example 3 was obtained. An external quantum efficiency at the time of emission at 100 cd/m² was 19.0%, which was higher than that of Comparative Example 3.

### <Example 4>

### <Configuration A: element using compound (1-31) as dopant>

An EL element was obtained with a similar procedure and configuration to those in Comparative Example 3 except that the dopant was changed.

### <Example 5>

### <Configuration A: element using compound (1-2001) as dopant>

An EL element was obtained with a similar procedure and configuration to those in Comparative Example 3 except that the dopant was changed. An emission spectrum at the time of emission at 100 cd/m² had a half width (FWHM) of 22 nm and a peak wavelength of 464 nm, and very thin emission was observed. As chromaticity, CIE chromaticity (x, y) = (0.132, 0.079) was obtained, and much deeper blue emission than that of Comparative Example 3 was obtained. An external quantum efficiency at the time of emission at 100 cd/m² was 14.0%, which was higher than that of Comparative Example 3.

**[Table 4]**

| (Configuration C of organic EL element) | | | | | | | |
|---|---|---|---|---|---|---|---|
| | Hole injection layer (10 nm) | Hole transport layer (30 nm) | Light emitting layer (30 nm) | | Electron transport layer 1 (10 nm) | Electron transport layer 2 (30 nm) | Negative electrode (1 nm/ 100 nm) |
| | | | Host | Dopant | | | |
| Example 6 | HAT-CN | Tris-PCz | EMH1 | Compound (1-1) | T2T | BPy-TP2 | LiF/Al |

In Table 4, "HAT-CN" represents
1,4,5,8,9,12-hexaazatriphenylene hexacarbonitrile, "Tris-PCz" represents
9, 9',9"-triphenyl-9H,9H',9H"-3,3',6',3"-tercarbazole, "T2T" represents2,4,6-tri[[1,1'-biphenyl]-3-yl]-1,3,5-triazine, and "BPy-TP2" represents 2,7-di([2,2'-bipyridin]-5-yl) triphenylene. Chemical structures thereof are indicated below.

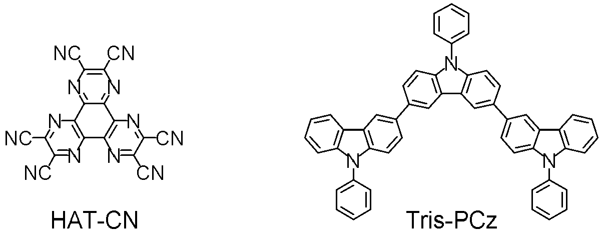

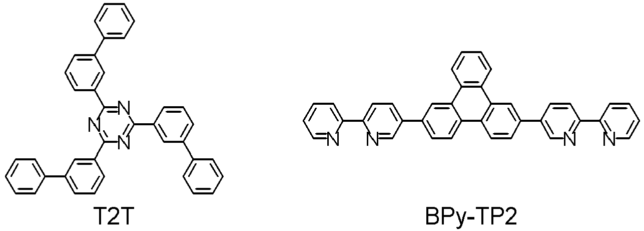

### <Example 6>

### <Configuration C: element using compound (1-1) as dopant>

A glass substrate (manufactured by Opto Science, Inc.) having a size of 26 mm × 28 mm × 0.7 mm, obtained by forming a film of ITO by sputtering and polishing the ITO film to 50 nm, was used as a transparent support substrate. This transparent support substrate was fixed to a substrate holder of a commercially available vapor deposition apparatus (manufactured by Choshu Industry). Tantalum vapor deposition crucibles containing HAT-CN, Tris-PCz, EMH1, compound (1-1), T2T, BPy-TP2, and LiF, respectively, and an aluminum nitride vapor deposition crucible containing aluminum were attached thereto.

Layers described below were formed sequentially on the ITO film of the transparent support substrate. A vacuum chamber was depressurized to 2.0 × 10⁻⁴ Pa. First, HAT-CN was heated and vapor-deposited so as to have a film thickness of 10 nm. Subsequently, Tris-PCz was heated and vapor-deposited so as to have a film thickness of 30 nm. Thus, a hole layer formed of two layers was formed. Subsequently, EMH1 and compound (1-1) were simultaneously heated and vapor-deposited so as to have a film thickness of 30 nm. Thus, a light emitting layer was formed. A vapor deposition rate was adjusted such that a weight ratio between EMH1 and compound (1-1) was approximately 90 : 10. Subsequently, T2T was heated and vapor-deposited so as to have a film thickness of 10 nm, and BPy-TP2 was vapor-deposited so as to have a film thickness of 30 nm. Thus, an electron transport layer formed of two layers was formed. The vapor deposition rate for each layer was 0.01 to 1 nm/sec. Thereafter, LiF was heated and vapor-deposited at a vapor deposition rate of 0.01 to 0.1 nm/sec so as to have a film thickness of 1 nm. Subsequently, aluminum was heated and vapor-deposited at a vapor deposition rate of 0.1 to 2 nm/sec so as to have a film thickness of 100 nm. Thus, a negative electrode was formed to obtain an organic EL element.

**[Table 5]**

| (Configuration D of organic EL element) | | | | | | | | |
|---|---|---|---|---|---|---|---|---|
| | Hole injection layer | Hole transport layer 1 (25 nm) | Hole transport layer 2 (10 nm) | Light emitting layer (30 nm) | | Electron transport layer 1 (10 nm) | Electron transport layer 2 (40 nm) | Negative electrode (1 nm/ 100 nm) |
| | | | | Host | Dopant | | | |
| | (10 nm) | | | | | | | |
| Example 7 | HAT -CN | Tris -PCz | EB | Compound (3-262) | Compound (1-1) | Compound (3-262) | BPy -TP2 | LiF/Al |

### <Example 7>

### <Configuration D: element using compound (1-1) as dopant>

A glass substrate (manufactured by Opto Science, Inc.) having a size of 26 mm × 28 mm × 0.7 mm, obtained by forming a film of ITO by sputtering and polishing the ITO film to 50 nm, was used as a transparent support substrate. This transparent support substrate was fixed to a substrate holder of a commercially available vapor deposition apparatus (manufactured by Choshu Industry). Tantalum vapor deposition crucibles containing HAT-CN, Tris-PCz, EB, compound (3-262), compound (1-1), BPy-TP2, and LiF, respectively, and an aluminum nitride vapor deposition crucible containing aluminum were attached thereto.

Layers described below were formed sequentially on the ITO film of the transparent support substrate. A vacuum chamber was depressurized to 2.0 × 10⁻⁴ Pa. First, HAT-CN was heated and vapor-deposited so as to have a film thickness of 10 nm. Subsequently, Tris-PCz was heated and vapor-deposited so as to have a film thickness of 25 nm. Subsequently, EB was heated and vapor-deposited so as to have a film thickness of 10 nm. Thus, a hole layer formed of three layers was formed. Subsequently, compounds (3-262) and (1-1) were simultaneously heated and vapor-deposited so as to have a film thickness of 30 nm. Thus, a light emitting layer was formed. A vapor deposition rate was adjusted such that a weight ratio between compounds (3-262) and (1-1) was approximately 90 : 10. Subsequently, compound (3-262) was heated and vapor-deposited so as to have a film thickness of 10 nm, and BPy-TP2 was vapor-deposited so as to have a film thickness of 40 nm. Thus, an electron transport layer formed of two layers was formed. The vapor deposition rate for each layer was 0.01 to 1 nm/sec. Thereafter, LiF was heated and vapor-deposited at a vapor deposition rate of 0.01 to 0.1 nm/sec so as to have a film thickness of 1 nm. Subsequently, aluminum was heated and vapor-deposited at a vapor deposition rate of 0.1 to 2 nm/sec so as to have a film thickness of 100 nm. Thus, a negative electrode was formed to obtain an organic EL element.

**[Table 6]**

| (Configuration A of organic EL element) | | | | | | | |
|---|---|---|---|---|---|---|---|
| | Hole injection layer (40 nm) | Hole transport layer 1 (15 nm) | Hole transport layer 2 (15 nm) | Light emitting layer (20 nm) | | Electron transport layer (40 nm) | Negative electrode (1 nm/ 100 nm) |
| | | | | Host | Dopant | | |
| Example 8 | HI | HT | EB | Compound (5-201) | Compound (1-1) | ET | LiF/Al |
| Example 9 | HI | HT | EB | Compound (5-102) | Compound (1-1) | ET | LiF/Al |
| Comparative Example 4 | HI | HT | EB | Compound (5-102) | Comparative Compound 1 | ET | LiF/Al |

In Table 6, compound (5-102) represents 3,11-di-o-tolyl-5,9-dioxa-13b-boranaphtho[3,2,1-de]anthra cene, and compound (5-201) represents 9-(5,9-dioxa-13b-boranaphtho[3,2,1-de]anthracen-7-yl)-9H-carbazole. Chemical structures thereof are indicated below.

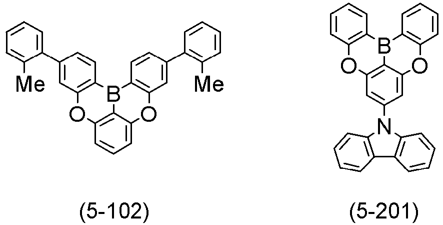

### <Example 8>

### <Configuration A: element using compound (1-1) as dopant and compound (5-201) as host>

A glass substrate (manufactured by Opto Science, Inc.) having a size of 26 mm × 28 mm × 0.7 mm, which was obtained by forming a film of ITO having a thickness of 200 nm by sputtering and polishing the ITO film to 150 nm, was used as a transparent support substrate. This transparent support substrate was fixed to a substrate holder of a commercially available vapor deposition apparatus (manufactured by Choshu Industry Co., Ltd.). Tantalum vapor deposition boats containing HI, HT, EB, compound (5-201), compound (1-1), and ET, respectively, and aluminum nitride vapor deposition boats containing LiF and aluminum, respectively, were attached thereto.

Layers described below were formed sequentially on the ITO film of the transparent support substrate. A vacuum chamber was depressurized to 5 × 10⁻⁴ Pa. First, HI was heated and vapor-deposited so as to have a film thickness of 40 nm. HT was heated and vapor-deposited so as to have a film thickness of 15 nm. EB was heated and vapor-deposited so as to have a film thickness of 15 nm. Thus, a hole layer formed of three layers was formed. Subsequently, compounds (5-201) and (1-1) were simultaneously heated and vapor-deposited so as to have a film thickness of 20 nm. Thus, a light emitting layer was formed. A vapor deposition rate was adjusted such that a weight ratio between compounds (5-201) and (1-1) was approximately 99 : 1. Subsequently, ET was heated and vapor-deposited so as to have a film thickness of 40 nm. Thus, an electron transport layer was formed. The vapor deposition rate for each layer was 0.01 to 1 nm/sec. Thereafter, LiF was heated and vapor-deposited at a vapor deposition rate of 0.01 to 0.1 nm/sec so as to have a film thickness of 1 nm. Subsequently, aluminum was heated and vapor-deposited so as to have a film thickness of 100 nm. Thus, a negative electrode was formed to obtain an organic EL element. At this time, the vapor deposition rate of aluminum was adjusted so as to be 1 nm to 10 nm/sec.

A direct current voltage was applied with the ITO electrode as a positive electrode and the aluminum electrode as a negative electrode, and luminance, chromaticity, and an external quantum efficiency were measured. An emission spectrum at the time of emission at 100 cd/m² had a half width (FWHM) of 21 nm and a peak wavelength of 473 nm, and emission with very high color purity was observed. As chromaticity, CIE chromaticity (x, y) = (0.116, 0.199) was obtained, and slightly deep blue emission was observed. An external quantum efficiency at the time of emission at 100 cd/m² was 33.6%, which was very high.

### <Example 9>

### <Configuration A: element using compound (1-1) as dopant and compound (5-102) as host>

An EL element was obtained with a similar procedure and configuration to those in Example 8 except that the host was changed to compound (5-102). An emission spectrum at the time of emission at 100 cd/m² had a half width (FWHM) of 21 nm and a peak wavelength of 471 nm, and emission with very high color purity was observed. As chromaticity, CIE chromaticity (x, y) = (0.118, 0.137) was obtained, and deep blue emission was observed. An external quantum efficiency at the time of emission at 100 cd/m² was 28.0%, which was very high.

### <Comparative Example 4>

### <Configuration A: element using Comparative Compound 1 as dopant and compound (5-102) as host>

An EL element was obtained with a similar procedure and configuration to those in Example 8 except that the dopant was changed to Comparative Compound 1 and the host was changed to compound (5-102). An emission spectrum at the time of emission at 100 cd/m² had a half width (FWHM) of 28 nm and a peak wavelength of 465 nm, and emission with lower color purity than those in Examples 8 and 9 was observed. As chromaticity, CIE chromaticity (x, y) = (0.128, 0.124) was obtained. Meanwhile, an external quantum efficiency at the time of light emission at 100 cd/m² was 15.4%, which was lower than those in Examples 8 and 9.

**[Table 7]**

| (Configuration A of organic EL element) | | | | | | | |
|---|---|---|---|---|---|---|---|
| | Hole injection layer (40 nm) | Hole transport layer 1 (15 nm) | Hole transport layer 2 (15 nm) | Light emitting layer (20 nm) | | Electron transport layer (30 nm) | Negative electrode (1 nm/ 100 nm) |
| | | | | Host | Dopant | | |
| Example 10 | HI | HT | EB | Compound (5-102) | Compound (1-1) | ET | LiF/Al |

### <Example 10>

### <Configuration A: element using compound (1-1) as dopant and compound (5-102) as host>

A glass substrate (manufactured by Opto Science, Inc.) having a size of 26 mm × 28 mm × 0.7 mm, which was obtained by forming a film of ITO having a thickness of 200 nm by sputtering and polishing the ITO film to 150 nm, was used as a transparent support substrate. This transparent support substrate was fixed to a substrate holder of a commercially available vapor deposition apparatus (manufactured by Choshu Industry Co., Ltd.). Tantalum vapor deposition boats containing HI, HT, EB, compound (5-102), compound (1-1), and ET, respectively, and aluminum nitride vapor deposition boats containing LiF and aluminum, respectively, were attached thereto.

Layers described below were formed sequentially on the ITO film of the transparent support substrate. A vacuum chamber was depressurized to 5 × 10⁻⁴ Pa. First, HI was heated and vapor-deposited so as to have a film thickness of 40 nm. HT was heated and vapor-deposited so as to have a film thickness of 15 nm. EB was heated and vapor-deposited so as to have a film thickness of 15 nm. Thus, a hole layer formed of three layers was formed. Subsequently, compounds (5-102) and (1-1) were simultaneously heated and vapor-deposited so as to have a film thickness of 20 nm. Thus, a light emitting layer was formed. A vapor deposition rate was adjusted such that a weight ratio between compounds (5-102) and (1-1) was approximately 99 : 1. Subsequently, ET was heated and vapor-deposited so as to have a film thickness of 30 nm. Thus, an electron transport layer was formed. The vapor deposition rate for each layer was 0.01 to 1 nm/sec. Thereafter, LiF was heated and vapor-deposited at a vapor deposition rate of 0.01 to 0.1 nm/sec so as to have a film thickness of 1 nm. Subsequently, aluminum was heated and vapor-deposited so as to have a film thickness of 100 nm. Thus, a negative electrode was formed to obtain an organic EL element. At this time, the vapor deposition rate of aluminum was adjusted so as to be 1 nm to 10 nm/sec.

A direct current voltage was applied with the ITO electrode as a positive electrode and the aluminum electrode as a negative electrode, and luminance, chromaticity, and an external quantum efficiency were measured. An emission spectrum at the time of emission at 100 cd/m² had a half width (FWHM) of 17 nm and a peak wavelength of 470 nm, and emission with very high color purity was observed. As chromaticity, CIE chromaticity (x, y) = (0.119, 0.122) was obtained, and deep blue emission was observed. An external quantum efficiency at the time of emission at 100 cd/m² was 30.1%, which was very high.

### Industrial Applicability

In the present invention, by providing a novel polycyclic aromatic compound, it is possible to increase options of a material for an organic EL element. Furthermore, by using a novel polycyclic aromatic compound as a material for an organic electroluminescent element, it is possible to provide an excellent organic EL element, a display apparatus including the organic EL element, a lighting apparatus including the organic EL element, and the like.

### Reference Signs List

- 100: Organic electroluminescent element
- 101: Substrate
- 102: Positive electrode
- 103: Hole injection layer
- 104: Hole transport layer
- 105: Light emitting layer
- 106: Electron transport layer
- 107: Electron injection layer
- 108: Negative electrode

## Claims

1. A polycyclic aromatic compound represented by the following general formula (1). 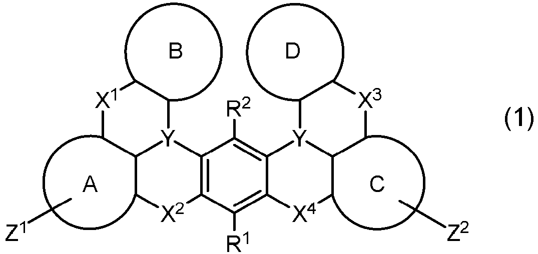
(In the above formula (1),
ring A, ring B, ring C, and ring D each independently represent an aryl ring or a heteroaryl ring; and at least one hydrogen atom in these rings may be substituted;
Y represents B (boron),
X¹, X², X³, and X⁴ each independently represent >0, >N-R, >S, or >Se; R in the moiety >N-R represents an optionally substituted aryl, an optionally substituted heteroaryl, or an optionally substituted alkyl; and R in the moiety >N-R may be bonded to the ring A, ring B, ring C, and/or ring D via a linking group or a single bond;
R¹ and R² each independently represent a hydrogen atom, an alkyl having 1 to 6 carbon atoms, an aryl having 6 to 12 carbon atoms, a heteroaryl having 2 to 15 carbon atoms, or a diarylamino (the aryl is an aryl having 6 to 12 carbon atoms) ;
Z¹ and Z² each independently represent an optionally substituted aryl, an optionally substituted heteroaryl, an optionally substituted diarylamino, an optionally substituted diheteroarylamino, an optionally substituted arylheteroarylamino, an optionally substituted alkyl, an optionally substituted cycloalkyl, an optionally substituted aryloxy, an optionally substituted heteroaryloxy, an optionally substituted arylthio, or an optionally substituted heteroarylthio; Z¹ may be bonded to the ring A via a linking group or a single bond; and Z² may be bonded to the ring C via a linking group or a single bond; and
at least one hydrogen atom in the compound represented by formula (1) may be substituted by cyano, a halogen atom, or a deuterium atom.)

2. The polycyclic aromatic compound according to claim 1, represented by the following general formula (2). 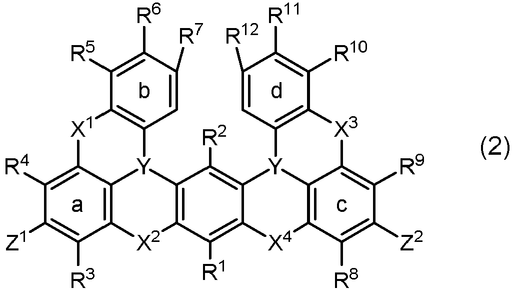
(In the above formula (2),
R³, R⁴, R⁵, R⁶, R⁷, R⁸, R⁹, R¹⁰, R¹¹, and R¹² each independently represent a hydrogen atom, an aryl, a heteroaryl, a diarylamino, a diheteroarylamino, an arylheteroarylamino, an alkyl, a cycloalkyl, an alkoxy, an aryloxy, a heteroaryloxy, an arylthio, a heteroarylthio, or an alkyl-substituted silyl; at least one hydrogen atom in these may be substituted by an aryl, a heteroaryl, or an alkyl; and adjacent groups among R⁵ to R⁷ and R¹⁰ to R¹² may be bonded to each other to form an aryl ring or a heteroaryl ring together with the ring b and/or ring d; at least one hydrogen atom in the ring thus formed may be substituted by an aryl, a heteroaryl, a diarylamino, a diheteroarylamino, an arylheteroarylamino, an alkyl, a cycloalkyl, an alkoxy, an aryloxy, a heteroaryloxy, an arylthio, a heteroarylthio, or an alkyl-substituted silyl; and at least one hydrogen atom in these may be substituted by an aryl, a heteroaryl, or an alkyl;
Y represents B (boron);
X¹, X², X³, and X⁴ each independently represent >0, >N-R, >S, or >Se; R in the moiety >N-R represents an aryl having 6 to 12 carbon atoms, a heteroaryl having 2 to 15 carbon atoms, or an alkyl having 1 to 6 carbon atoms; and R in the moiety >N-R may be bonded to the ring a, ring b, ring c and/or ring d via -O-, -S-, -C(-R)₂-, or a single bond; and R in the -C(-R)₂-represents a hydrogen atom or an alkyl having 1 to 6 carbon atoms;
R¹ and R² each independently represent a hydrogen atom, an alkyl having 1 to 6 carbon atoms, or an aryl having 6 to 12 carbon atoms;
Z¹ and Z² each independently represent an aryl, a heteroaryl, a diarylamino, a diheteroarylamino, an arylheteroarylamino, an alkyl, a cycloalkyl, an aryloxy, a heteroaryloxy, an arylthio, or a heteroarylthio; at least one hydrogen atom in these may be substituted by an aryl, a heteroaryl, an alkyl, or an alkyl-substituted silyl; Z¹ may be bonded to the ring a via -O-, -S-, -C(-R)₂-, or a single bond; Z² may be bonded to the ring c via -O-, -S-, -C(-R)₂-, or a single bond; and R in the -C(-R)₂- represents a hydrogen atom or an alkyl having 1 to 6 carbon atoms; and
at least one hydrogen atom in the compound represented by formula (2) may be substituted by cyano, a halogen atom, or a deuterium atom.)

3. A material for an organic device, comprising the polycyclic aromatic compound according to claim 1 or 2.

4. The material for an organic device according to claim 3, wherein the material for an organic device is a material for an organic electroluminescent element, a material for an organic field effect transistor, or a material for an organic thin film solar cell.

5. The material for an organic device according to claim 4, wherein the material for an organic electroluminescent element is a material for a light emitting layer.

6. A light emitting layer-forming composition for applying and forming a light emitting layer of an organic electroluminescent element, comprising:
at least one polycyclic aromatic compound according to claim 1 or 2 as a first component;
at least one host material as a second component; and
at least one organic solvent as a third component.

7. An organic electroluminescent element comprising: a pair of electrodes composed of a positive electrode and a negative electrode; and a light emitting layer disposed between the pair of electrodes and comprising the material for a light emitting layer according to claim 5.
